# EUROPEAN PATENT SPECIFICATION

(11) **EP 3 514 163 B1**
(45) Date of publication and mention of the grant of the patent: **13.05.2020**
(21) Application number: 19151905.7
(22) Date of filing: 15.01.2019
(51) Int. Cl.: C07F 15/00, C09K 11/06, H01L 51/00, H05B 33/14

(54) **ORGANOMETALLIC COMPOUND, ORGANIC LIGHT-EMITTING DEVICE INCLUDING THE SAME, AND DIAGNOSTIC COMPOSITION INCLUDING THE ORGANOMETALLIC COMPOUND**
ORGANOMETALLISCHE VERBINDUNG, ORGANISCHE LICHTEMITTIERENDE VORRICHTUNG DAMIT UND DIAGNOSEZUSAMMENSETZUNG MIT DER ORGANOMETALLISCHEN VERBINDUNG
COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(30) Priority: 23.01.2018 KR 20180008412
(43) Date of publication of application: 24.07.2019
(73) Proprietor: Samsung Electronics Co., Ltd., Suwon-si, Gyeonggi-do, 16677 (KR); Samsung SDI Co., Ltd., Gyeonggi-do (KR)
(72) Inventor: BAE, Hyejin, Suwon-si 16678 Gyeonggi-do (KR); NOH, Changho, Suwon-si 16678 Gyeonggi-do (KR); KWON, Eunsuk, Suwon-si 16678 Gyeonggi-do (KR); KIM, Sangmo, Suwon-si 16678 Gyeonggi-do (KR); MIN, Minsik, Suwon-si 16678 Gyeonggi-do (KR); PARK, Sangho, Suwon-si 16678 Gyeonggi-do (KR); RAI, Virendra Kumar, Suwon-si 16678 Gyeonggi-do (KR); SON, Jhunmo, Suwon-si 16678 Gyeonggi-do (KR); JUNG, Yongsik, Suwon-si 16678 Gyeonggi-do (KR)
(74) Representative: Elkington and Fife LLP

(56) References cited:
- WO-A1-2010/032663
- US-A1- 2017 040 554

## Description

### FIELD OF THE INVENTION

One or more embodiments relate to an organometallic compound, an organic light-emitting device including the organometallic compound, and a diagnostic composition including the organometallic compound.

### BACKGROUND OF THE INVENTION

Organic light-emitting devices (OLEDs) are self-emission devices, which have improved characteristics in terms of a viewing angle, a response time, brightness, a driving voltage, and a response speed, and which produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds, for example, phosphorescent compounds may be used for monitoring, sensing, and detecting biological materials such as various cells and proteins.

Various types of organic light emitting devices are known. However, there still remains a need in OLEDs having low driving voltage, high efficiency, high brightness, and long lifespan.

US 2017/0040554 discloses imidazophenanthridine ligands and metal complexes including the same. WO 2010/032663 discloses an organic electroluminescence element and a device, display device, lighting device including the same.

### SUMMARY OF THE INVENTION

Provided are an organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

According to an aspect of an embodiment, an organometallic compound is represented by Formula 1: 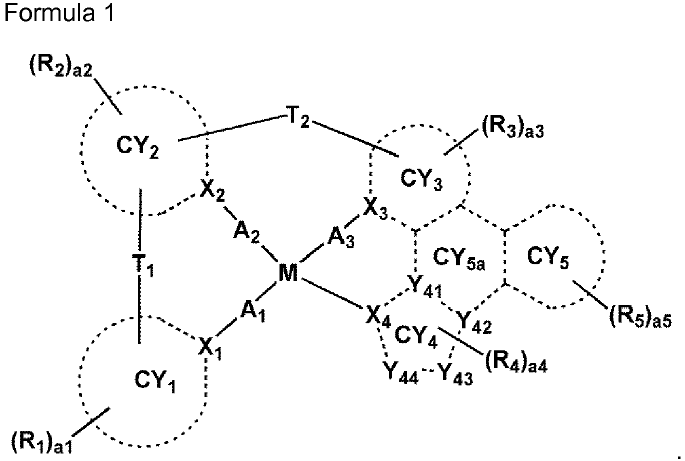 In Formula 1,
M may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
X₁ to X₄, Y₄₁, and Y₄₂ may each independently be C or N,
Y₄₃ and Y₄₄ may each independently be C, N, O, S, or Si,
A₁ to A₃ may each independently be a chemical bond, O, S, B(R'), N(R'), P(R'), C(R')(R"), Si(R')(R"), Ge(R')(R"), C(=O), B(R')(R"), N(R')(R"), or P(R')(R"), wherein, when A₁ is a chemical bond, X₁ may be directly bonded to M; when A₂ is a chemical bond, X₂ may be directly bonded to M; and when A₃ is a chemical bond, X₃ may be directly bonded to M,
two selected from a bond between X₁ or A₁ and M, a bond between M and X₂ or A₂, a bond between X₃ or A₃ and M, and a bond between X₄ and M are coordinate bonds, and the remaining two bonds are covalent bonds,
ring CY₁ to ring CY₃ and ring CY₅ may each independently be a C₅-C₃₀ carbocyclic group or a C₁-C₃₀ heterocyclic group,
ring CY₄ is a 5-membered ring, and three or more selected from X₄, Y₄₁, Y₄₂, Y₄₃, and Y₄₄ of ring CY₄ are each N,
ring CY₅ₐ is a 6-membered ring,
T₁ is a single bond, a double bond, *-N(R₆)-*', *-B(R₆)-*', *-P(R₆)-*', *-C(R₆)(R₇)-*,, *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', or *-C≡C-*',
T₂ is a single bond, a double bond, *-N(R₈)-*', *-B(R₈)-*', *-P(R₈)-*', *-C(R₈)(R₉)-*', *-Si(R₈)(R₉)*', *-Ge(R₈)(R₉)*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C≡C-*',
R₁ to R₉, R', and R" may each independently be selected from hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₇-C₆₀ aryl alkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroaryl alkyl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₃)(Q₉),
a1 to a3 and a5 may each independently be an integer of 0 to 20,
a4 may be an integer from 0 to 2,
two of a plurality of neighboring groups R₁ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₂ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₅ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of R₁ to Rg, R', and R" may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₁,
* and *" each indicate a binding site to a neighboring atom,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₇-C₆₀ aryl alkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroaryl alkyl group, the substituted C₂-C₆₀ alkyl heteroaryl group, the substituted monovalent non-aromatic condensed polycyclic group, and the substituted monovalent non-aromatic condensed heteropolycyclic group may be selected from:
   deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, - CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇) and -P(=O)(Q₁₈)(Q₁₉);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂, - CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), and -P(=O)(Q₂₈)(Q₂₉); and
   -N(Q₃₁)(Q₃₂), -Si(Q₃₃)(Q₃₄)(Q₃₅), -B(Q₃₆)(Q₃₇), and -P(=O)(Q₃₃)(Q₃₉),
   wherein Q₁ to Q₉, Q₁₁ to Q₁₉, Q₂₁ to Q₂₉, and Q₃₁ to Q₃₉ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, and a monovalent non-aromatic condensed heteropolycyclic group.

According to another aspect of an embodiment, an organic light-emitting device includes:
a first electrode,
a second electrode, and
an organic layer located between the first electrode and the second electrode,
wherein the organic layer includes an emission layer and at least one organometallic compound described above.

The organometallic compound may be included in the emission layer. The organometallic compound in the emission layer may function as a dopant.

According to another aspect of an embodiment, a diagnostic composition includes at least one organometallic compound represented by Formula 1.

### BRIEF DESCRIPTION OF THE DRAWINGS

These and/or other aspects will become apparent and more readily appreciated from the following description of the embodiments, taken in conjunction with the accompanying drawings in which:
FIG. 1 shows a schematic view of an organic light-emitting device according to an embodiment;
FIG. 2 is a graph of intensity (arbitrary units, a. u.) versus wavelength (nanometers, nm), showing photoluminescence (PL) spectra of Compounds 3 and 17;
FIG. 3 is a graph of intensity (arbitrary units, a. u.) versus wavelength (nanometers, nm), showing electroluminescence (EL) spectra of organic light-emitting devices of Example 1 and Comparative Example A; and
FIG. 4 is a graph of current density (milliamperes per square centimeter, mA/cm²) versus electric potential (volts, V), showing a graph of driving voltage vs current density of an organic light-emitting device of Example 1.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (*i.e*., the limitations of the measurement system). For example, "about" can mean within one or more standard deviations, or within ± 30%, 20%, 10%, 5% of the stated value.

In an embodiment, an organometallic compound is provided. The organometallic compound according to an embodiment is represented by Formula 1 below: 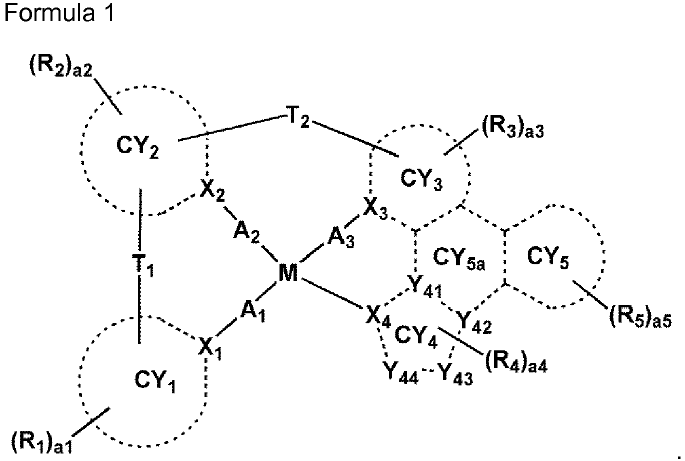 M in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In an embodiment, M may be Pt, Pd, or Au, but embodiments of the present disclosure are not limited thereto.

X₁ to X₄, Y₄₁, and Y₄₂ in Formula 1 may each independently be C or N, and Y₄₃ and Y₄₄ may each independently be C, N, O, S, or Si.

In one or more embodiments, in Formula 1,
i) X₁ and X₄ may each be N, and X₂ and X₃ may each be C; or
ii) X₁ and X₃ may each be C, and X₂ and X₄ may each be N, but X₁, X₃, X₂, and X₄ are not limited thereto.

A₁ to A₃ in Formula 1 may each independently be a chemical bond (for example, a coordinate bond, a covalent bond, or the like), O, S, B(R'), N(R'), P(R'), C(R')(R"), Si(R')(R"), Ge(R')(R"), C(=O), B(R')(R"), N(R')(R"), or P(R')(R"); when A₁ is a chemical bond, X₁ may directly bond to M; when A₂ is a chemical bond, X₂ may directly bond to M; and when A₃ is a chemical bond, X₃ may directly bond to M. R' and R" are the same as described above.

Regarding Formula 1, two bonds selected from a bond between X₁ or A₁ and M, a bond between X₂ or A₂ and M, a bond between X₃ or A₃ and M, and a bond between X₄ and M may be coordinate bonds, and the remaining two bonds may be covalent bonds. Thus, the organometallic compound represented by Formula 1 may be electrically neutral.

In one or more embodiments, in Formula 1,
A₁ to A₃ may each be a chemical bond, and i) a bond between X₁ and M and a bond between X₄ and M may each be a coordinate bond, and a bond between X₂ and M, and a bond between X₃ and M may each be a covalent bond; or ii) a bond between X₁ and M and a bond between X₃ and M may each be a covalent bond, and a bond between X₂ and M and a bond between X₄ and M may each be a coordinate bond, but these bonds are not limited thereto.

Regarding Formula 1, ring CY₁ to ring CY₃ and ring CY₅ may each independently be a C₅-C₃₀ carbocyclic group or a C₁-C₃₀ heterocyclic group, ring CY₄ may be a 5-membered ring, and ring CY₅ₐ may be a 6-membered ring. Herein, three or more (for example, 3 or 4) of X₄, Y₄₁, Y₄₂, Y₄₃, and Y₄₄ of ring CY₄ may be N.

In one or more embodiments, the ring CY₁ to ring CY₃ and ring CY₅ may each independently be selected from i) a first ring, ii) a second ring, iii) a condensed ring in which two or more first rings are condensed each other, iv) a condensed ring in which two or more second rings are condensed each other, and v) a condensed ring in which at least one first ring is condensed with at least one second ring, the first ring may be selected from a cyclopentane group, a cyclopentadiene group, a furan group, a thiophene group, a pyrrole group, a silole group, an oxazole group, an isoxazole group, an oxadiazole group, an isoxadiazole group, an oxatriazole group, a thiazole group, an isothiazole group, a thiadiazole group, an isothiadiazole group, a thiatriazole group, a pyrazole group, an imidazole group, a triazole group, a tetrazole group, an azasilole group, a diazasilole group, and a triazasilole group, and the second ring may be selected from an adamantane group, a norbornane group, a norbornene group, a cyclohexane group, a cyclohexene group, a benzene group, a pyridine group, a pyrimidine group, a pyrazine group, a pyridazine group, and a triazine group.

In one or more embodiments, ring CY₁ to ring CY₃ and ring CY₅ may each independently be selected from a benzene group, a naphthalene group, an anthracene group, a phenanthrene group, a triphenylene group, a pyrene group, a chrysene group, cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a 5,6,7,8-tetrahydroisoquinoline group, and a 5,6,7,8-tetrahydroquinoline group.

In one or more embodiments, regarding Formula 1,
ring CY₁ may be selected from an oxazole group, an isoxazole group, an oxadiazole group, an isozadiazole group, an oxatriazole group, a thiazole group, an isothiazole group, a thiadiazole group, an isothiadiazole group, a thiatriazole group, a pyrazole group, an imidazole group, a triazole group, a tetrazole group, an azasilole group, a diazasilole group, a triazasilole group, a benzimidazole group, a benzoxazole group, a benzthiazole group, a benzene group, a pyridine group, a pyrimidine group, a pyrazine group, a pyridazine group, a triazine group, a carbazole group, or an azacarbazole group, and/or
ring CY₂ may be a benzene group, a pyridine group, a pyrimidine group, a pyrazine group, a pyridazine group, a triazine group, a carbazole group, or an azacarbazole group, and/or
ring CY₃ and ring CY₅ may each independently be a benzene group, a pyridine group, a pyrimidine group, a pyrazine group, a pyridazine group, or a triazine group, but embodiments of the present disclosure are not limited thereto.

In one or more embodiments, ring CY₄ may be a triazole group or a tetrazole group, but embodiments of the present disclosure are not limited thereto.

In one or more embodiments, Y₄₃ in Formula 1 may be N, but embodiments of the present disclosure are not limited thereto.

T₁ in Formula 1 may be a single bond, a double bond, *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', or *-C≡C-*', T₂ may be a single bond, a double bond, *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C=C-*'. R₆ to R₉ are the same as described above. R₆ and R₇ may optionally be linked to each other via a single bond, a double bond, *-N(R_{8c})-*', *-B(R_{8c})-*'₃ *-P(R_{8c})-*', *-C(R_{8c})(R_{9c})-*', *-Si(R_{8c})(R_{9c})-*', *-S-*', *-Se-*', or *-O-*' to form a C₅-C₃₀ carbocyclic group unsubstituted or substituted with at least one R₁₀ₐ or a C₁-C₃₀ heterocyclic group unsubstituted or substituted with at least one R₁₀ₐ, and R₈ and R₉ may optionally be linked to each other via a single bond, a double bond, *-N(R_{8c})-*', *-B(R_{8c})-*', *-P(R_{8c})-*', *-C(R_{8c})(R_{9c})-*', *-Si(R_{8c})(R_{9c})-*', *-S-*', *-Se-*', or *-O-*' to form a C₅-C₃₀ carbocyclic group unsubstituted or substituted with at least one R₁₀ₐ or a C₁-C₃₀ heterocyclic group unsubstituted or substituted with at least one R₁₀ₐ. R_{8c} and R_{9c} are the same as described in connection with R₈ and R₉, respectively, the "C₅-C₃₀ carbocyclic group" and the "C₁-C₃₀ heterocyclic group" are the same as described in connection with ring CY₁, and R₁₀ₐ is the same as described in connection with R₁.

In an embodiment, T₂ in Formula 1 may be *-N(R₈)-*', *-B(R₈)-*', *-P(R₈)-*', *-C(R₃)(R₉)-*', *-Si(R₈)(R₉)*', *-Ge(R₈)(R₉)-*', *-S-*', *-Se-*', *-O-*', *-C(=O)-*', *-S(=O)-*', *-S(=O)₂-*", *-C(R₈)=*', *=C(R₈)-*', or *-C(=S)-*', and A₁ to A₃ may each be a chemical bond, but embodiments of the present disclosure are not limited thereto.

R₁ to R₉, R', and R" may each independently be selected from hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₇-C₆₀ aryl alkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroaryl alkyl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₃)(Q₉).

In an embodiment, R₁ to R₉, R', and R" may each independently be selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-N(Q₁)(Q₂), -Si(Q₃)(Q₄)(Q₅), -B(Q₆)(Q₇) and -P(=O)(Q₈)(Q₉);
Q₁ to Qg may each independently be selected from:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CH₃, -CD₂CD₃, -CD₂CD₂H, and -CD₂CDH₂;
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a C₁-C₁₀ alkyl group, and a phenyl group.

In one or more embodiments, R₁ to Rg, R', and R" may each independently be selected from hydrogen, deuterium, -F, a cyano group, a nitro group, -SF₅, -CH₃, -CD₃, - CD₂H, -CDH₂, -CF₃, -CF₂H, -CFH₂, a group represented by one of Formulae 9-1 to 9-19, and a group represented by one of Formulae 10-1 to 10-227, but are not limited thereto: 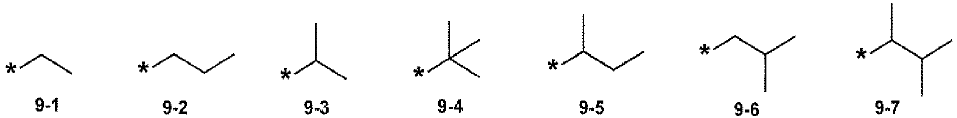 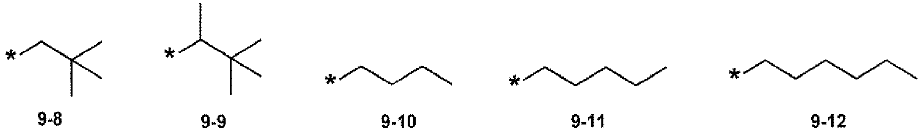 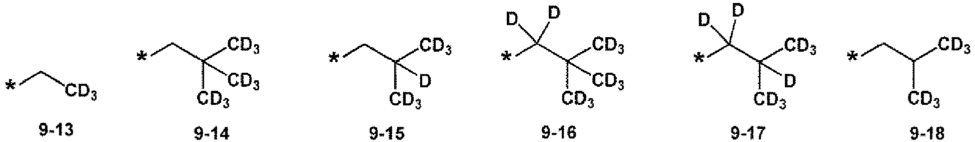 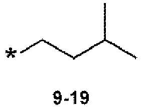 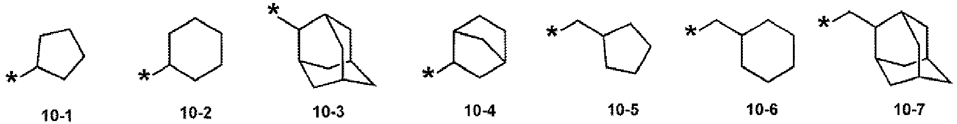 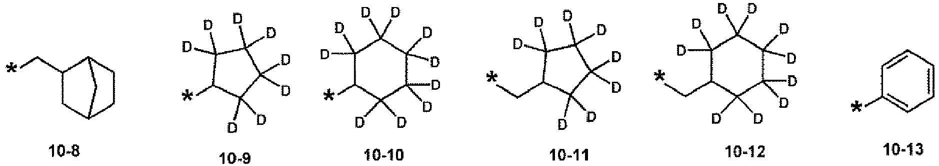 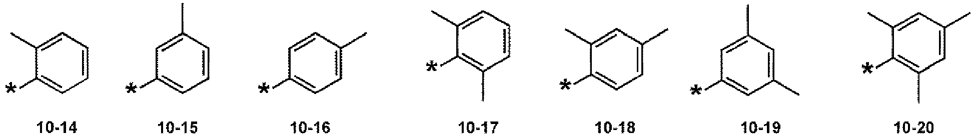 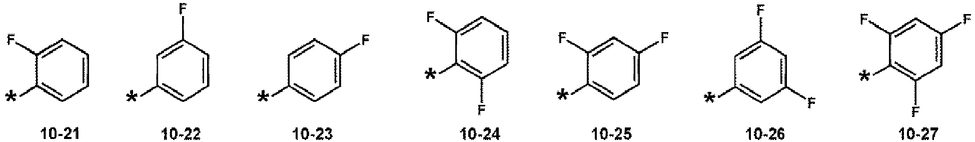 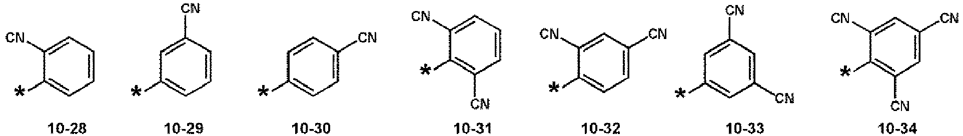 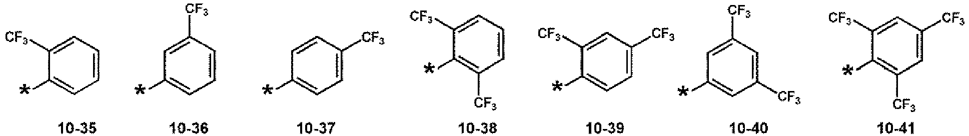 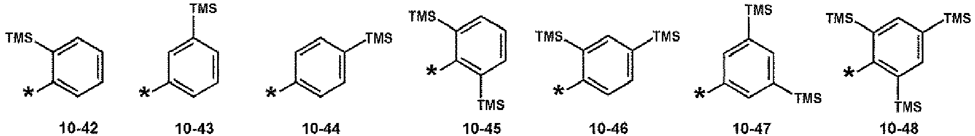 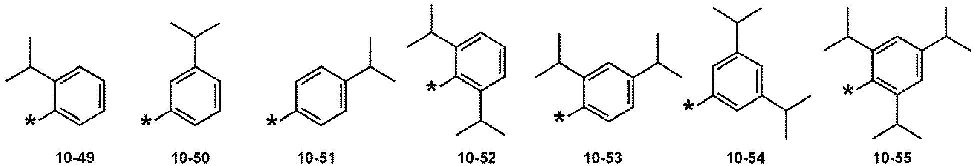 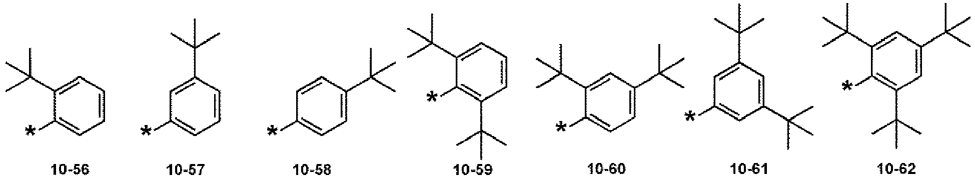 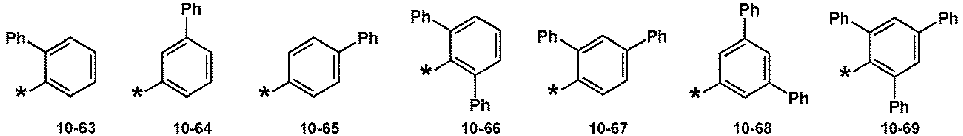 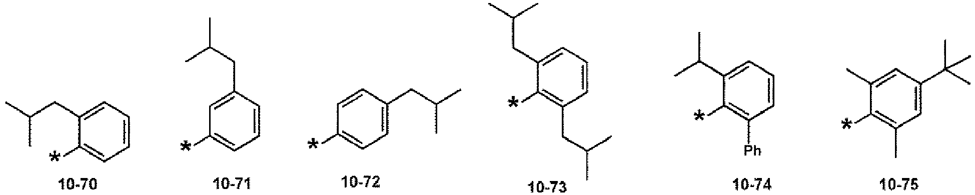 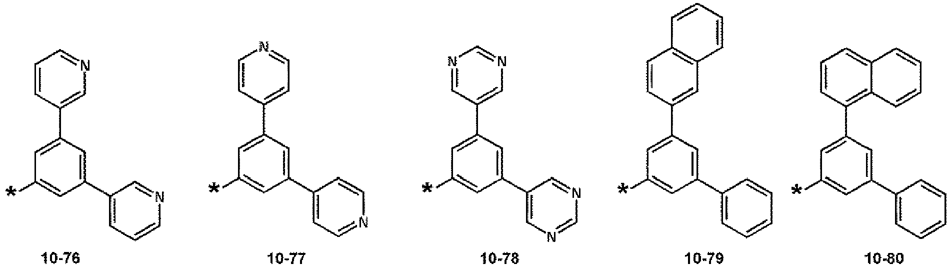 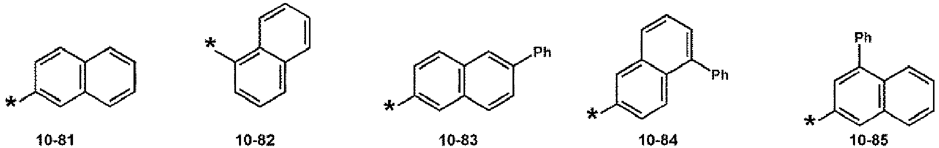 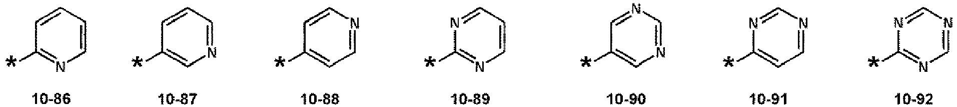 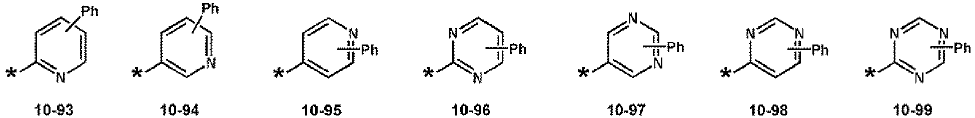 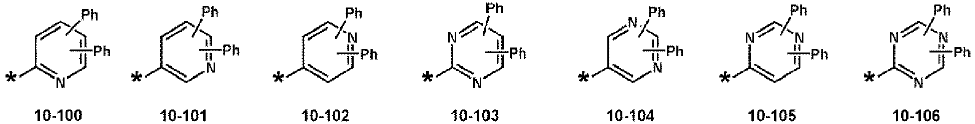 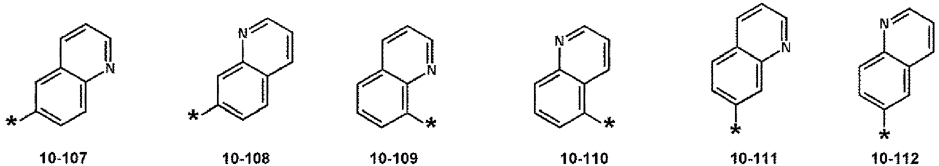 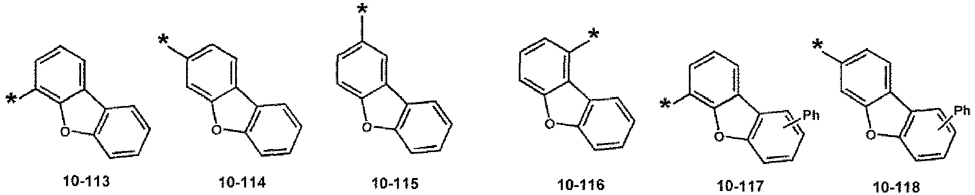 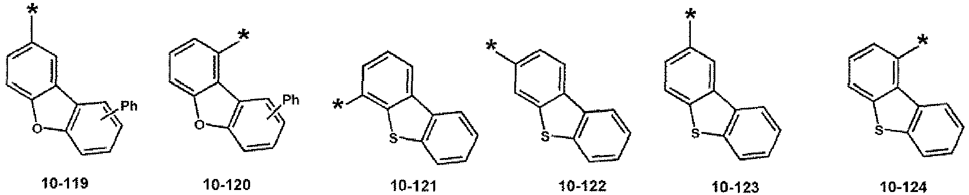 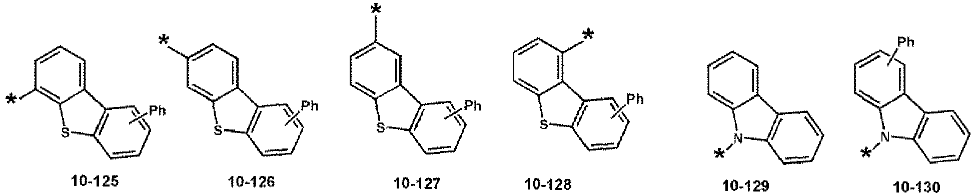 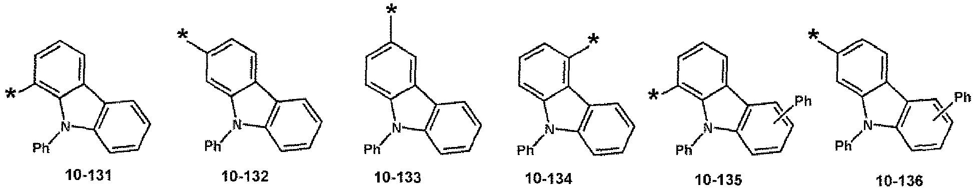 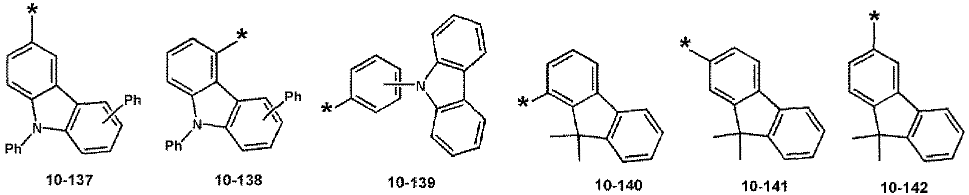 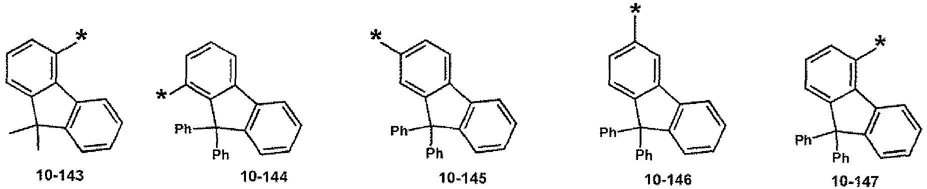 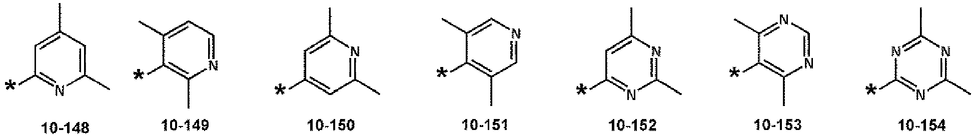 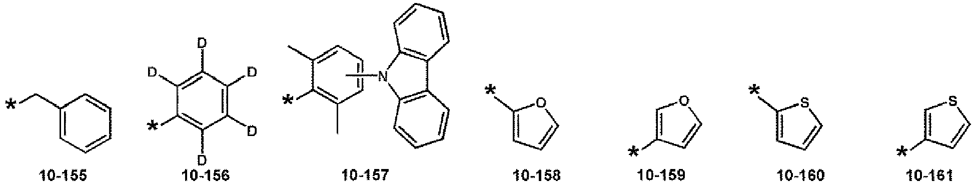 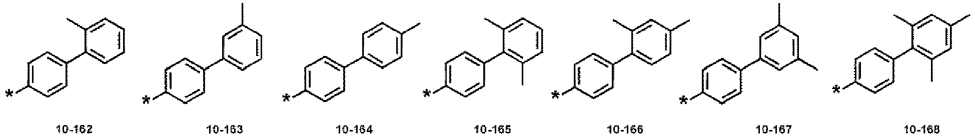 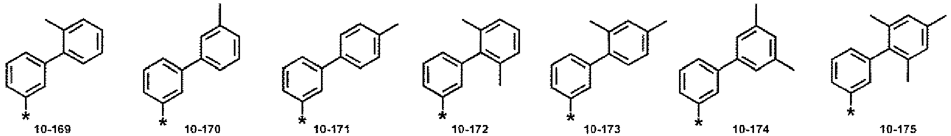 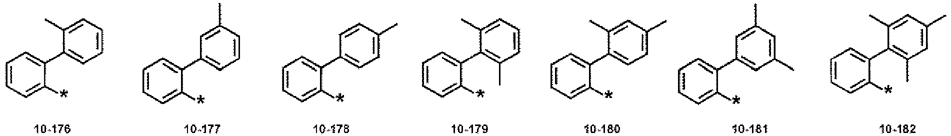 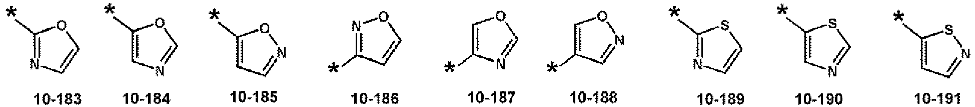 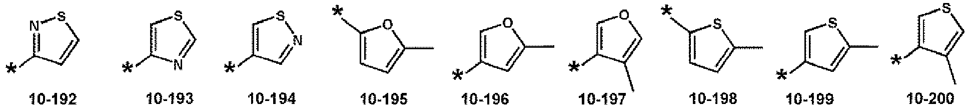 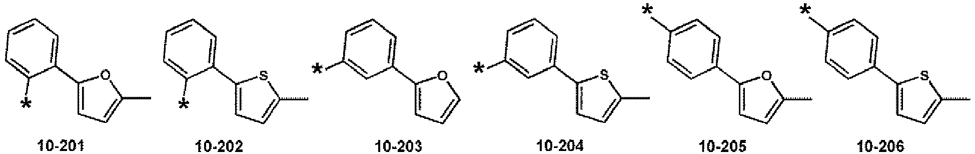 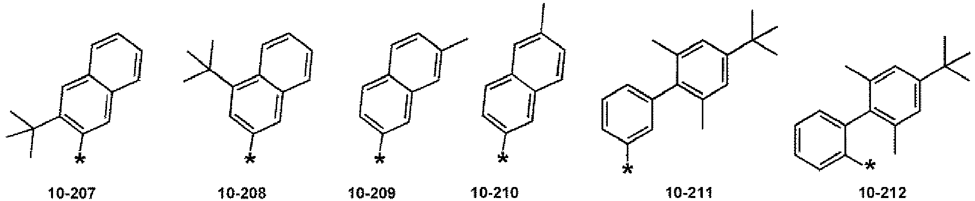 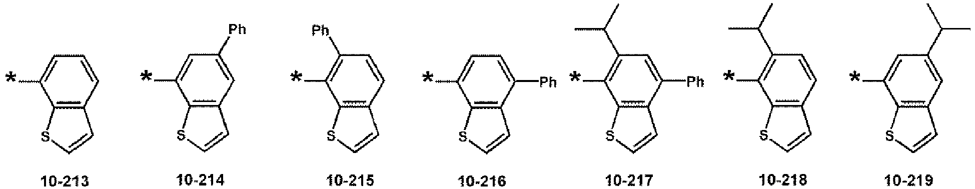 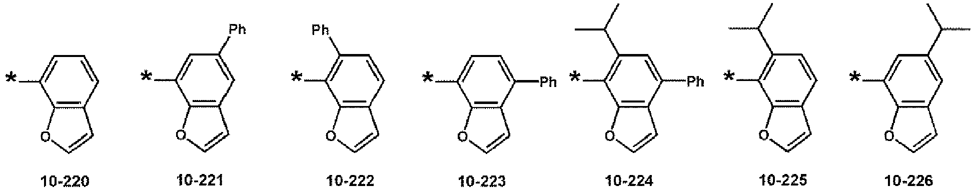 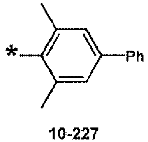
Regarding Formulae 9-1 to 9-19 and 10-1 to 10-227, * indicates a binding site to neighboring atoms, Ph is a phenyl group, and TMS is a trimethylsilyl group.
Regarding Formula 1, a1 to a3 and a5 indicate the numbers of R₁ to R₃ and R₅, respectively, and may each independently be an integer from 0 to 20 (for example, an integer from 0 to 7), and a4 indicates the number of R₄ and may be an integer from 0 to 2. When a1 is two or more, two or more groups R₁ may be identical to or different from each other, when a2 is two or more, two or more groups R₂ may be identical to or different from each other, when a3 is two or more, two or more groups R₃ may be identical to or different from each other, when a4 is two or more, two or more groups R₄ may be identical to or different from each other, and when a5 is two or more, two or more groups R₅ may be identical to or different from each other.
Regarding Formula 1, i) two of a plurality of neighboring groups R₁ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, ii) two of a plurality of neighboring groups R₂ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iii) two of a plurality of neighboring groups R₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iv) two of a plurality of neighboring groups R₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, v) two of a plurality of neighboring groups R₅ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, vi) two selected from R₁ to Rg, R', and R" may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ. The terms "C₅-C₃₀ carbocyclic group" and "C₁-C₃₀ heterocyclic group" as used herein are understood by referring to the desciption about ring CY₁, and R₁₀ₐ is understood by referring to the description about R₁.
* and *" each indicate a binding site to a neighboring atom.

In an embodiment, the organometallic compound represented by Formula 1 may satisfy
a) one of Condition 1, Condition 2, and Condition 3;
b) one of Condition 4 and Condition 5; or
c) one of Condition 1, Condition 2, and Condition 3, and one of Condition 4 and Condition 5:
   Condition 1
      A₁ and A₂ may each be a chemical bond,
      a moiety represented by 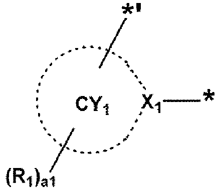 is represented by Formula A1-1,
      T₁ may be *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', or *-C≡C-*',
      a moiety represented by 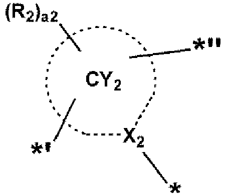 may be represented by Formula A2-1,
   Condition 2
      A₁ and A₂ may each be a chemical bond,
      a moiety represented by 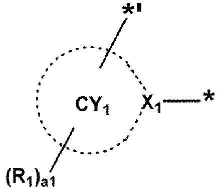 may be represented by Formula A1-2,
      T₁ may be a single bond,
      a moiety represented by 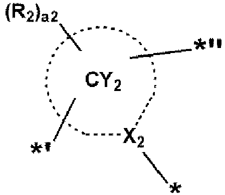 may be represented by Formula A2-1,
   Condition 3
      A₁ and A₂ may each be a chemical bond,
      a moiety represented by 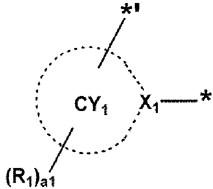 may be represented by Formula A1-1,
      T₁ may be a single bond,
      a moiety represented by 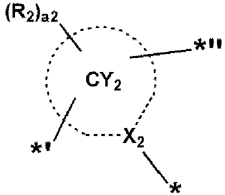 may be represented by Formula A2-3,
   Condition 4
      A₂ and A₃ may each be a chemical bond,
      a moiety represented by 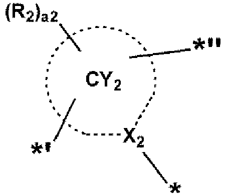 may be represented by Formula A2-1,
      T₂ may be *-N(R₈)-*', *-B(R₈)-*', *-P(R₈)-*', *-C(R₈)(R₉)*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C≡C-*',
   Condition 5
      A₂ and A₃ may each be a chemical bond,
      a moiety represented by 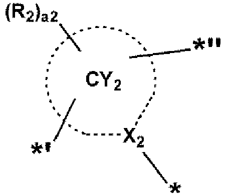 is represented by Formula A2-2,
      T₂ may be a single bond, 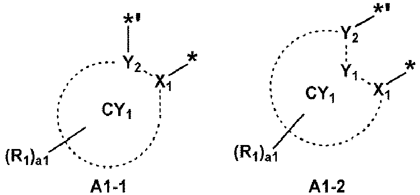 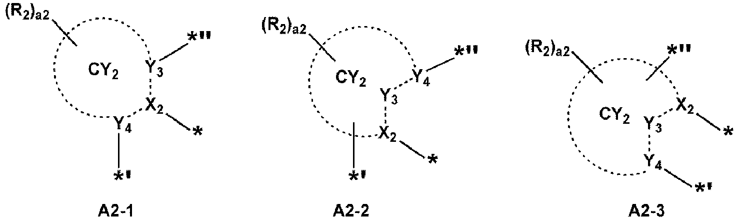
      In Formulae A1-1, A1-2, A2-1, A2-2, and A2-3,
      X₁, X₂, ring CY₁, ring CY₂, R₁, R₂, a1, and a2 are the same as described above, Y₁ to Y₄ may each independently be C or N, a bond between X₁ and Y₁, a bond between X₁ and Y₂, a bond between Y₁ and Y₂, a bond between X₂ and Y₄, a bond between X₂ and Y₃, and a bond between Y₃ and Y₄ may each independently be a single bond or a double bond,
         regarding Formulae A1-1 and A1-2, * indicates a binding site to A₁ or M in Formula 1 and *' indicates a binding site to T₁ in Formula 1, and
         regarding Formulae A2-1, A2-2, and A2-3, * indicates a binding site to A₂ or M in Formula 1, *' indicates a binding site to T₁ in Formula 1, and *" indicates a binding site to T₂ in Formula 1.

Since the organometallic compound represented by Formula 1 satisfies: a) one of Condition 1, Condition 2, and Condition 3; b) one of Condition 4 and Condition 5; or c) one of Condition 1, Condition 2, and Condition 3 and one of Condition 4 and Condition 5, a cyclometalated ring formed by M, ring CY₁, and ring CY₂ in Formula 1 and/or a cyclometalated ring formed by M, ring CY₂, and ring CY₃ in Formula 1 may constitute a 6-membered ring. Therefore, an angle formed by X₁-M-X₂ and/or an angle formed by X₂-M-X₃ in the organometallic compound may provide a metal complex structure having a small steric hindrance, thereby providing a planar tetracoordinate structure, which provides a structural stability to a material. Thus, the organometallic compound represented by Formula 1 may have excellent structural stability. Therefore, electronic devices, such as organic light-emitting devices, including the organometallic compound represented by Formula 1 may have long lifespans.

In one or more embodiments, in Formula 1, a moiety represented by 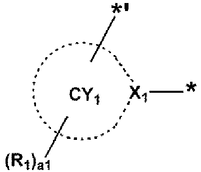 may be represented by one of Formulae A1-1(1) to A1-1(54) and A1-2(1) to A1-2(74): 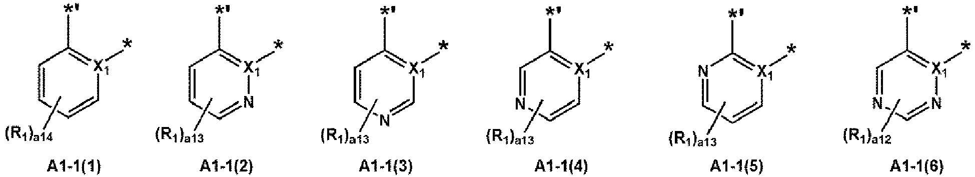 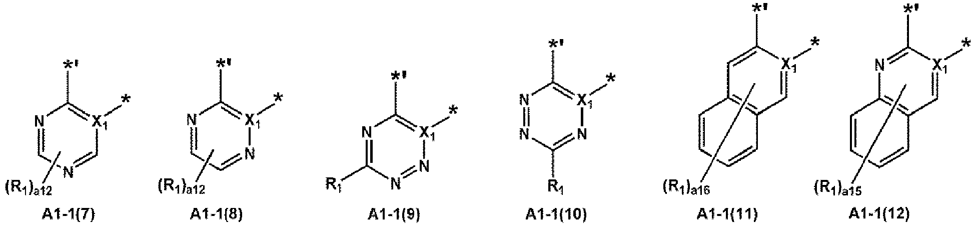 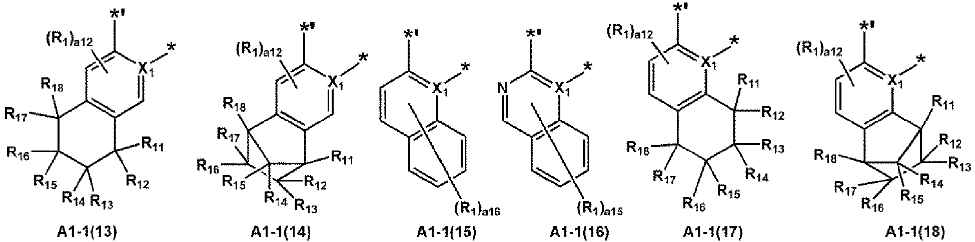 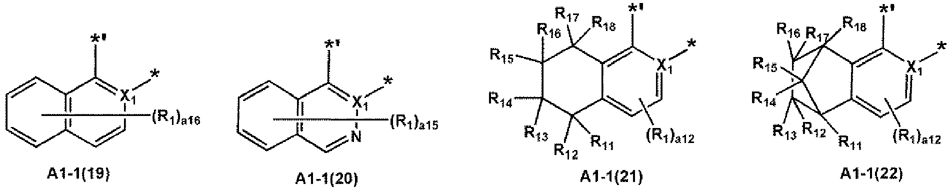 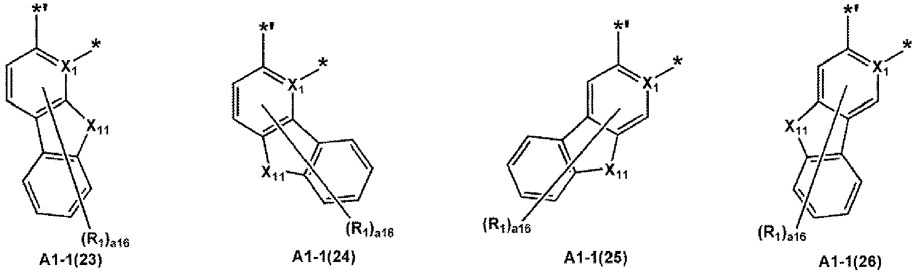 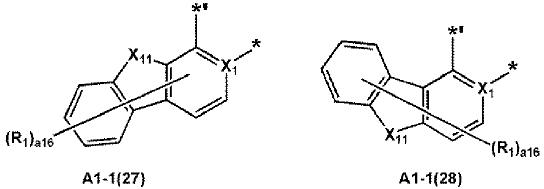 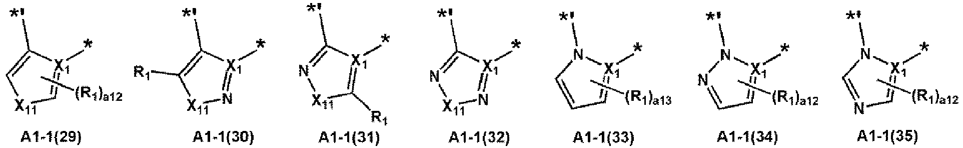 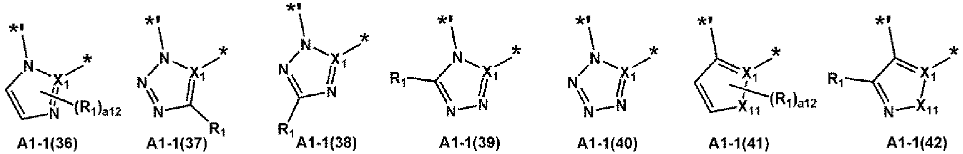 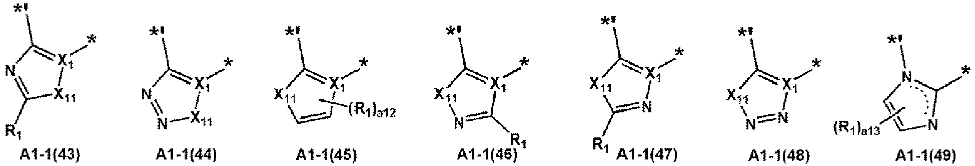 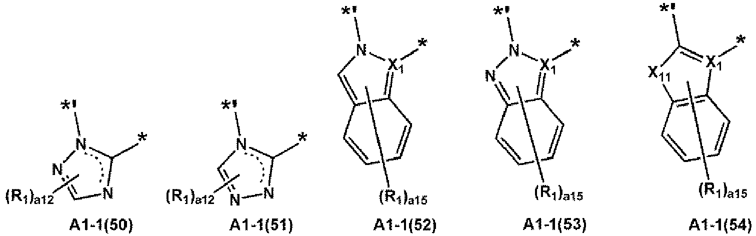 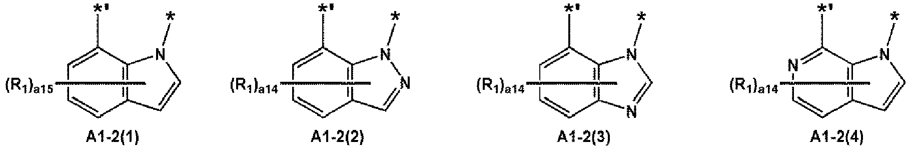 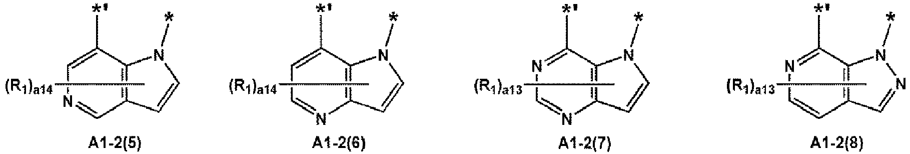 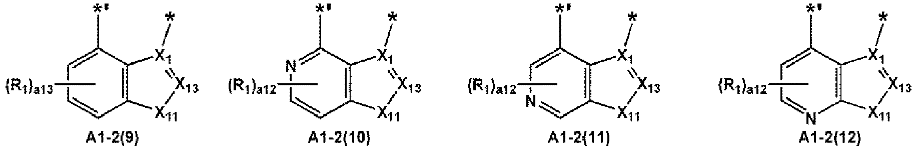 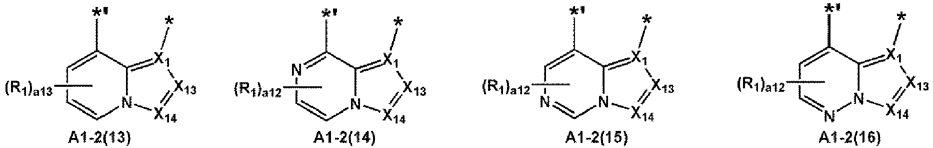 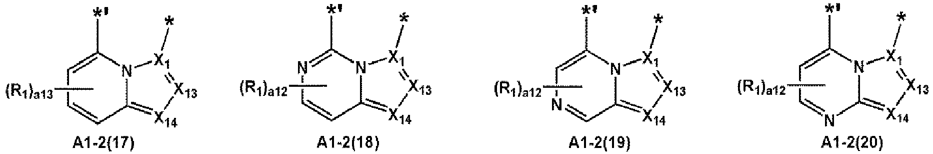 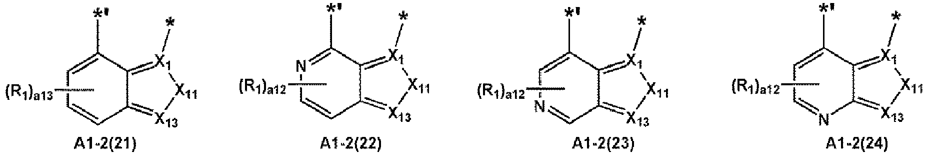 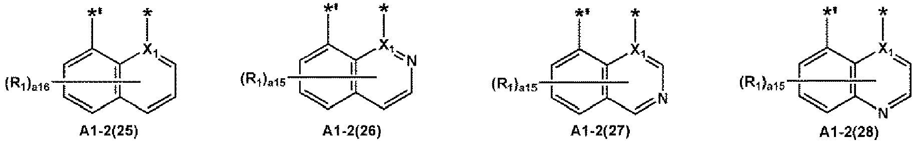 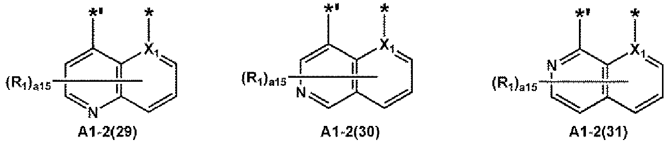 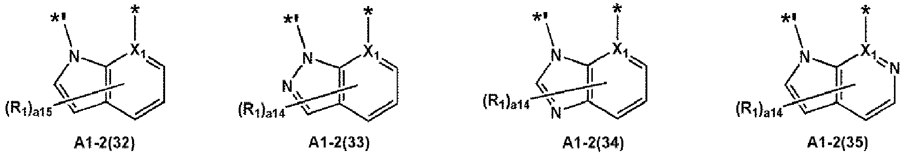 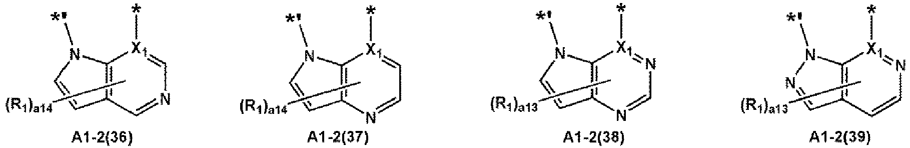 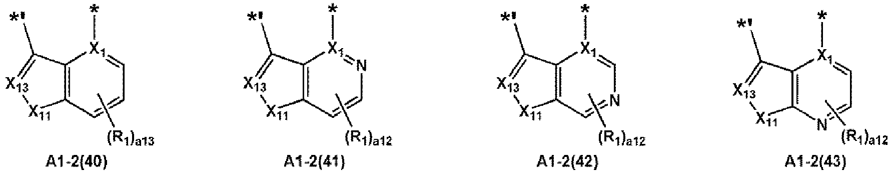 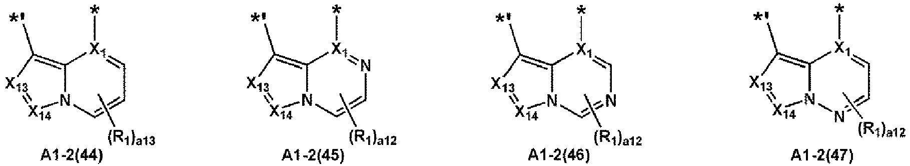 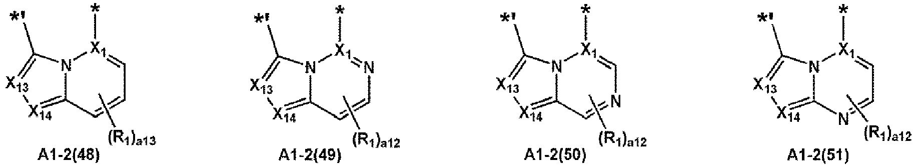 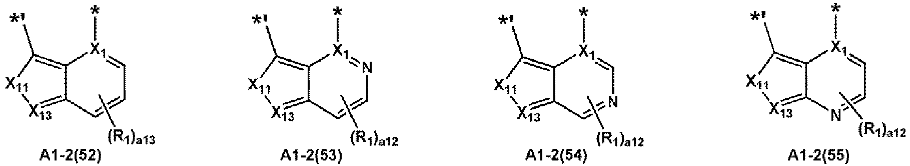 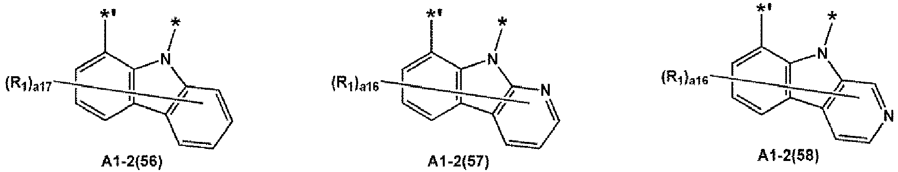 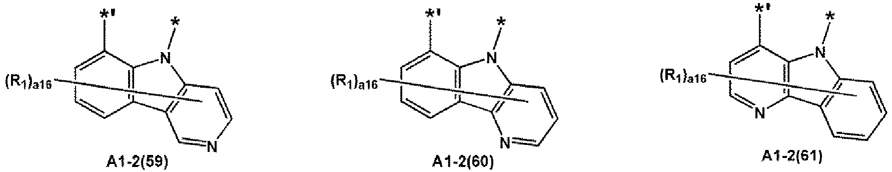 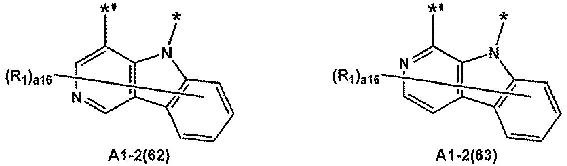 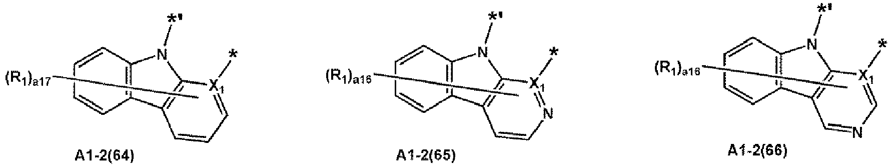 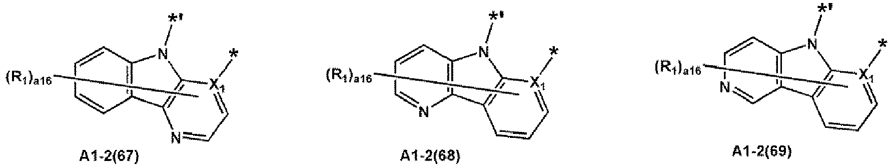 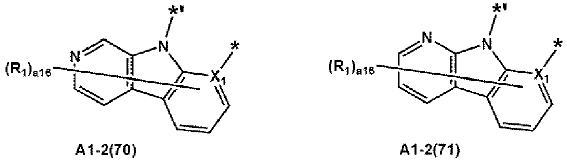 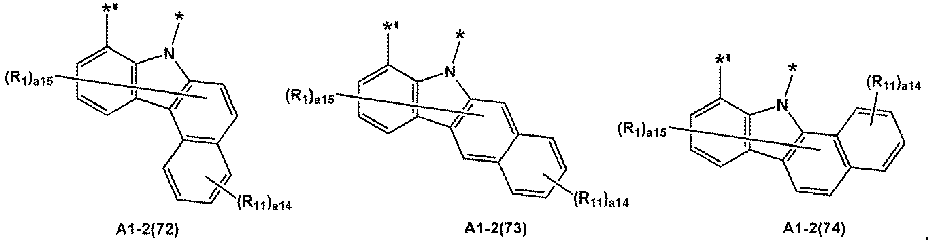
Regarding Formulae A1-1(1) to A1-1(54) and A₁-2(1) to A₁-2(74),
X₁ and R₁ are the same as described in the present specification,
X₁₁ may be O, S, N(R₁₁), C(R₁₁)(R₁₂), or Si(R₁₁)(R₁₂),
X₁₃ may be N or C(R₁₃),
X₁₄ may be N or C(R₁₄),
R₁₁ to R₁₈ are the same as described in connection with R₁,
a17 may be an integer from 0 to 7,
a16 may be an integer from 0 to 6,
a15 may be an integer from 0 to 5,
a14 may be an integer from 0 to 4,
a13 may be an integer from 0 to 3,
a12 may be an integer from 0 to 2,
* indicates a binding site to A₁ or M in Formula 1, and
*' indicates a binding site to T₁ in Formula 1.

In one or more embodiments, regarding Formula 1, 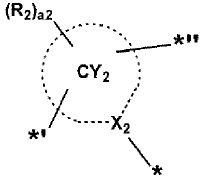 a moiety represented by may be represented by one of Formulae A2-1(1) to A2-1(17), A2-2(1) to A2-2(58), and A2-3(1) to A2-3(62): 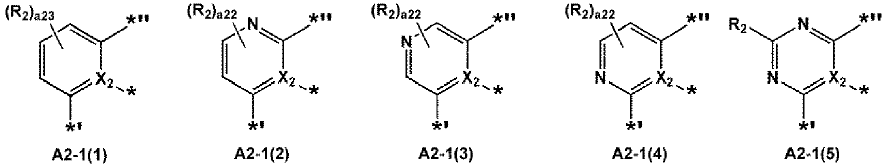 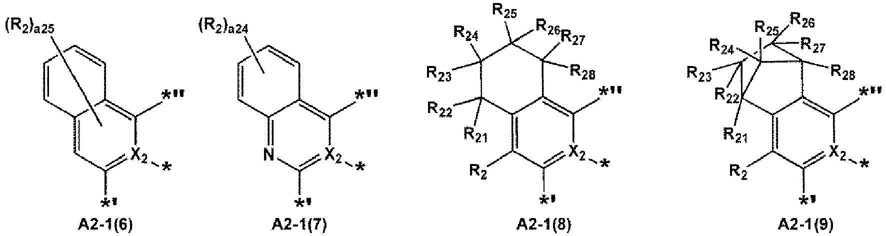 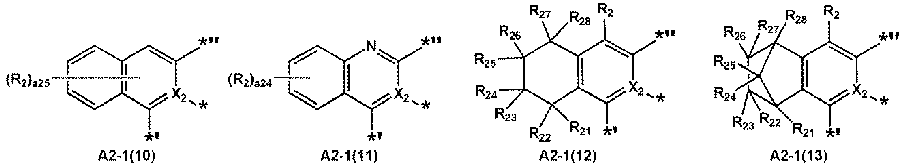 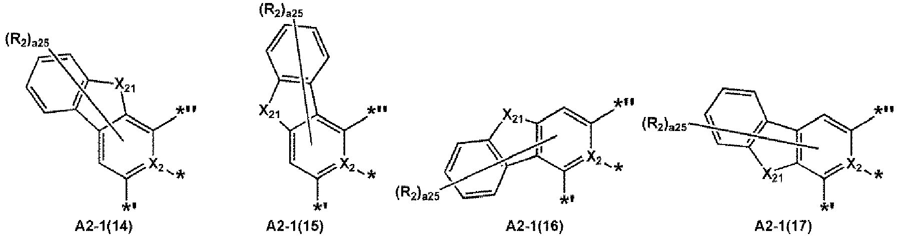 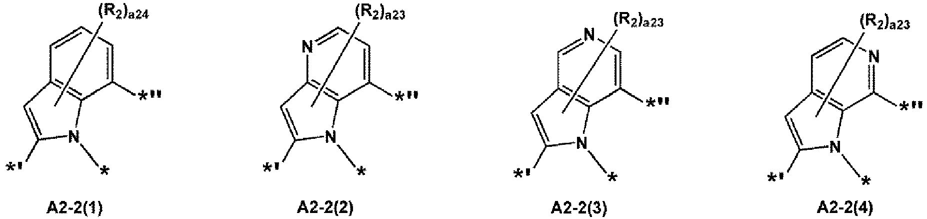 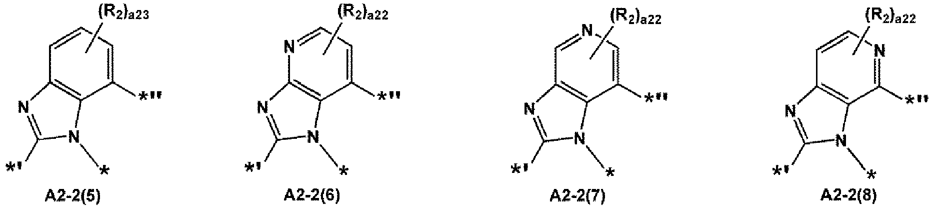 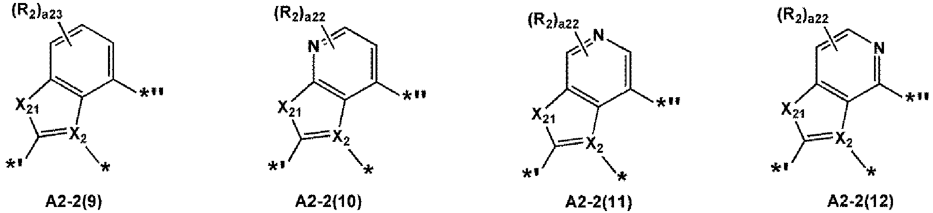 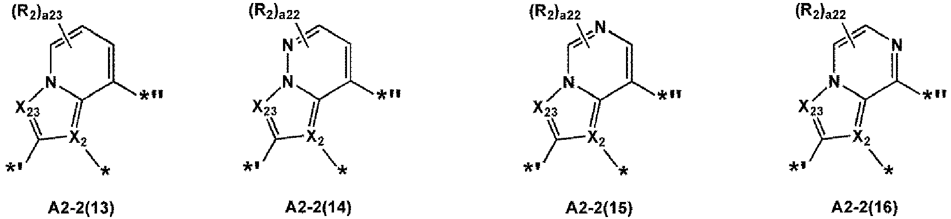 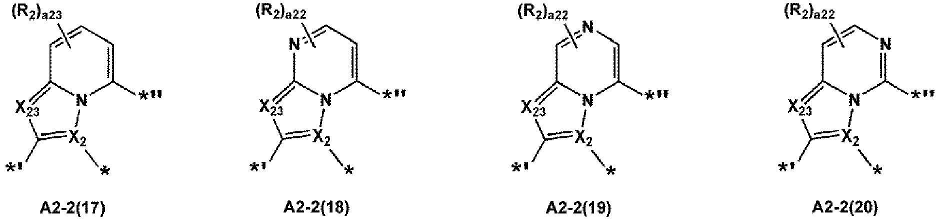 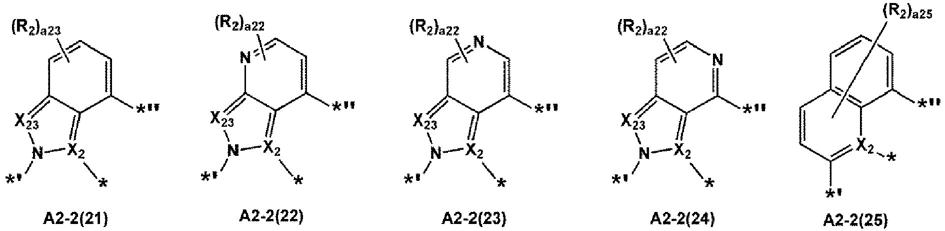 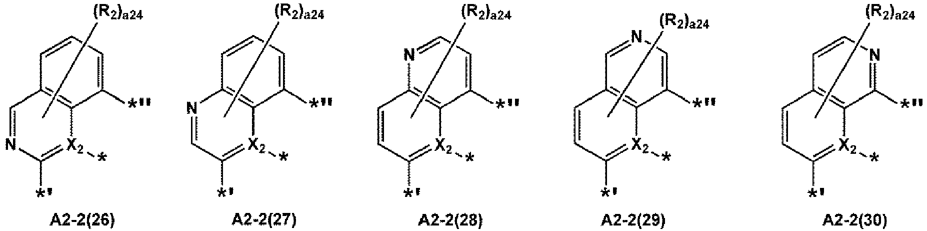 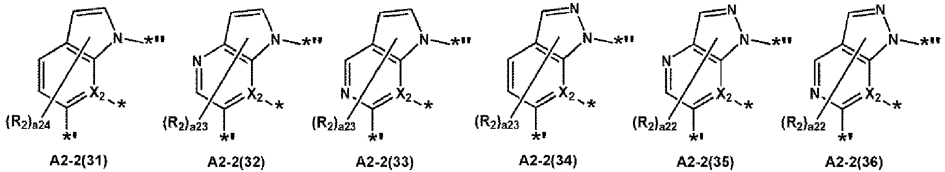 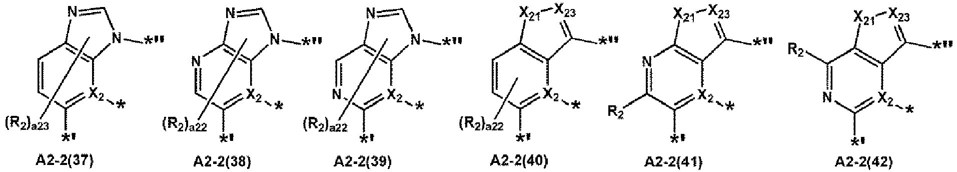 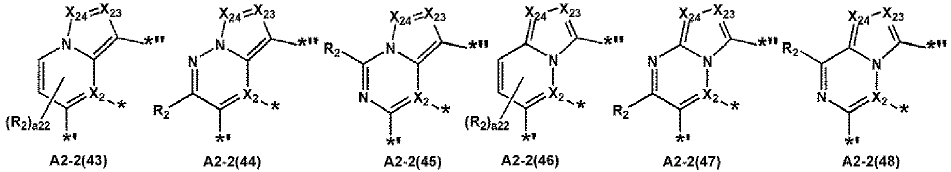 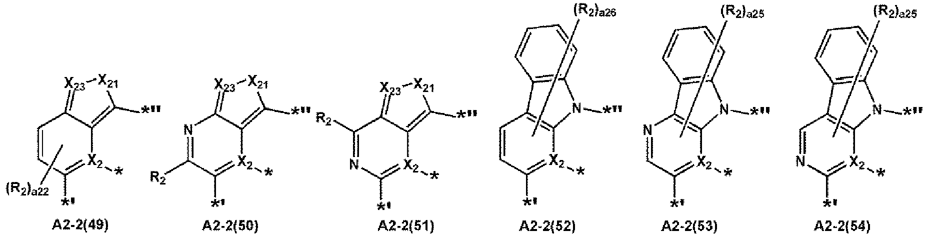 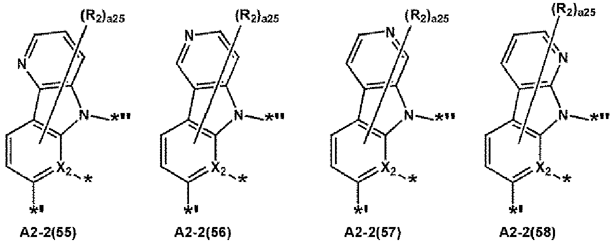 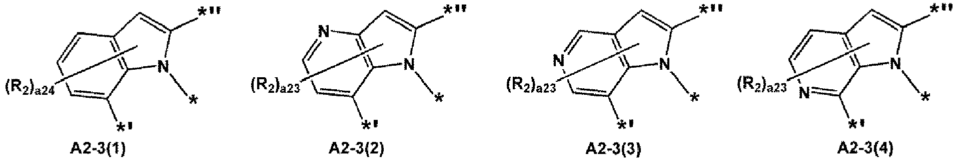 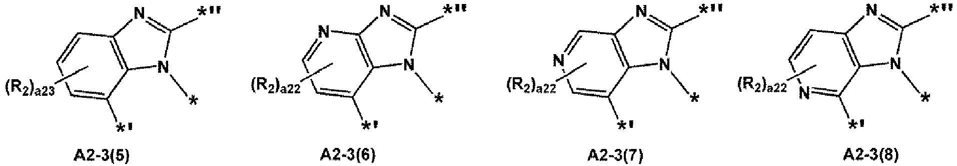 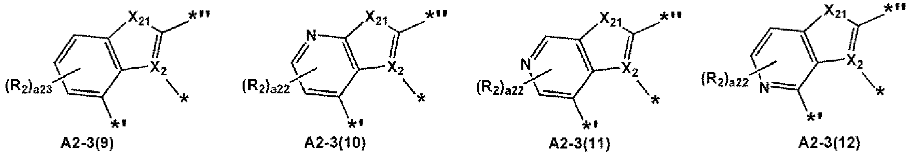 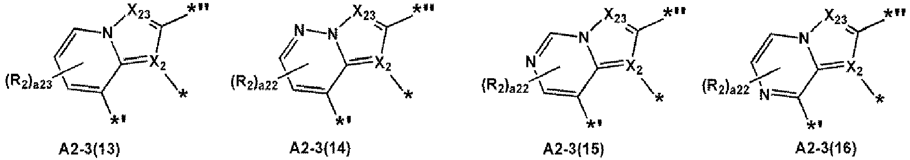 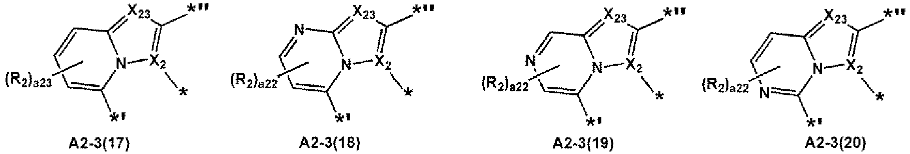 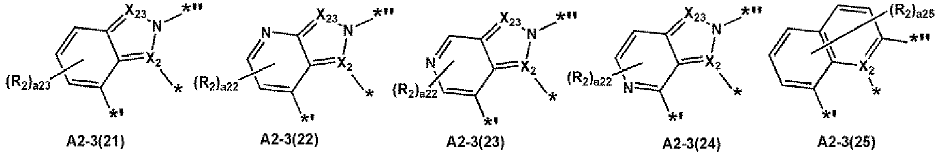 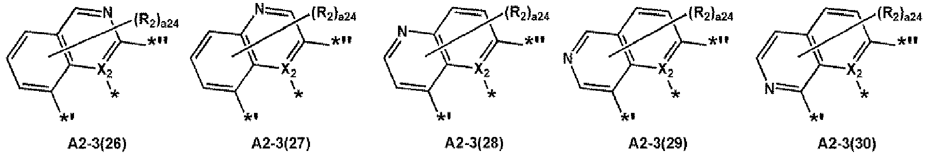 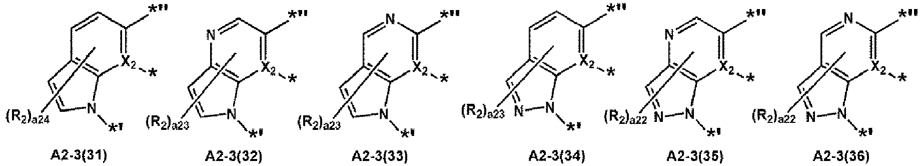 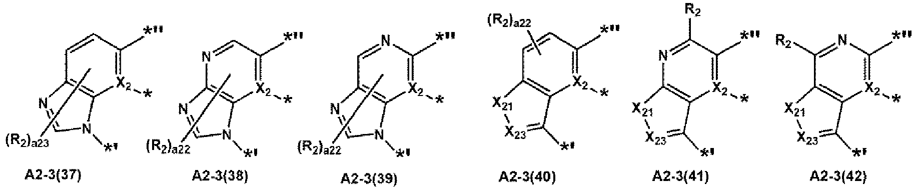 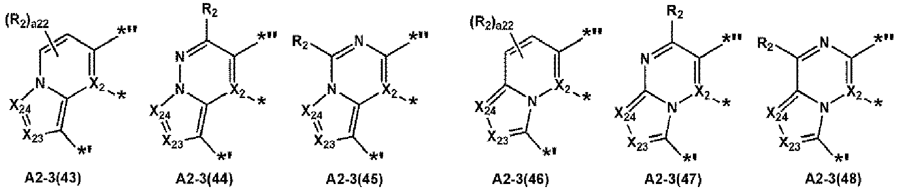 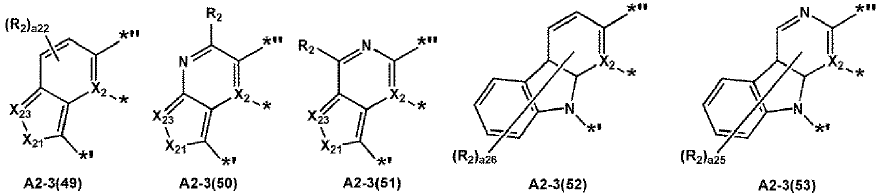 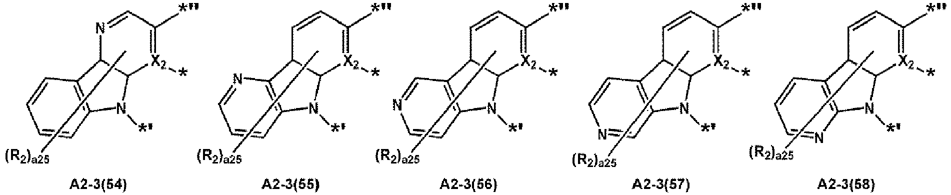 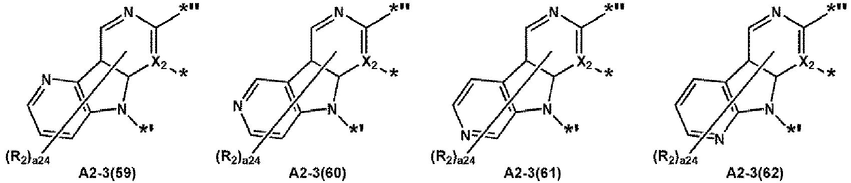
In Formulae A2-1(1) to A2-1(17), A2-2(1) to A2-2(58), and A2-3(1) to A2-3(62),
X₂ and R₂ are the same as described above,
X₂₁ may be O, S, N(R₂₁), C(R₂₁)(R₂₂), or Si(R₂₁)(R₂₂),
X₂₃ may be N or C(R₂₃),
X₂₄ may be N or C(R₂₄),
R₂₁ to R₂₈ are the same as described in connection with R₂,
a26 may be an integer from 0 to 6,
a25 may be an integer from 0 to 5,
a24 may be an integer from 0 to 4,
a23 may be an integer from 0 to 3,
a22 may be an integer from 0 to 2,
* indicates a binding site to A₂ or M in Formula 1,
*' indicates a binding site to T₁ in Formula 1, and
*" indicates a binding site to T₂ in Formula 1.

In one or more embodiments, regarding Formula 1, a moiety represented by 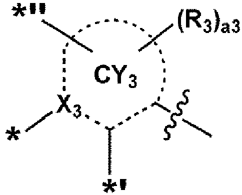 may be represented by one of Formulae A3-1(1) to A3-1 (12): 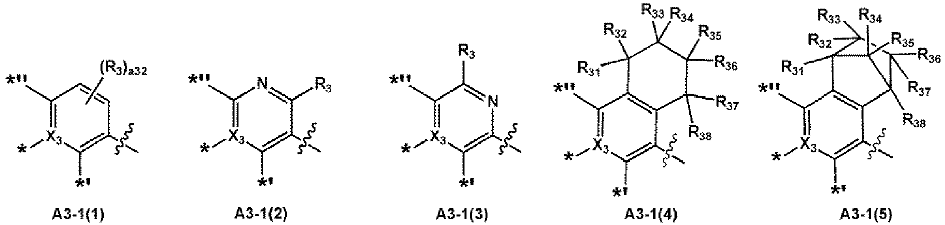 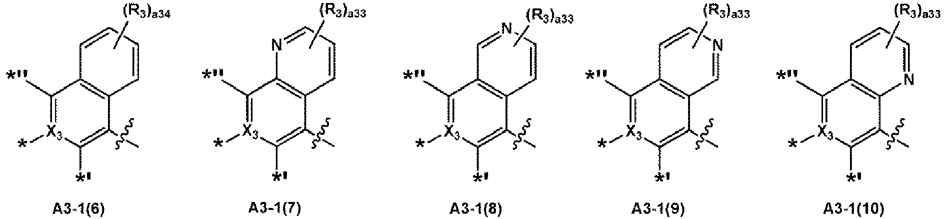 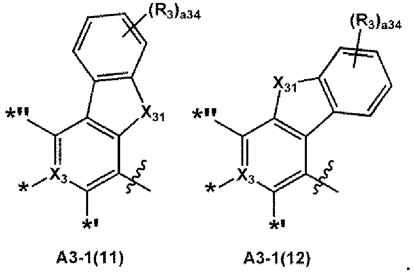
In Formulae A3-1(1) to A3-1(12),
X₃ and R₃ are the same as described above,
X₃₁ may be O, S, N(R₃₁), C(R₃₁)(R₃₂), or Si(R₃₁)(R₃₂),
R₃₁ to R₃₈ are the same as described in connection with R₃,
a34 may be an integer from 0 to 4,
a33 may be an integer from 0 to 3,
a32 may be an integer from 0 to 2,
* indicates a binding site to A₃ or M in Formula 1,
*" indicates a binding site to T₂ in Formula 1,
*' indicates a binding site to Y₄₁ in Formula 1, and
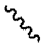 indicates a binding site to ring CY₅ in Formula 1.

In one or more embodiments, regarding Formula 1, a moiety represented by 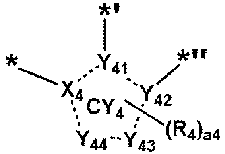 may be represented by one of Formulae A4-1(1) to A4-1(12): 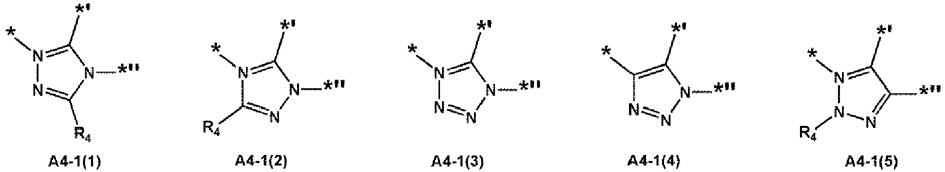 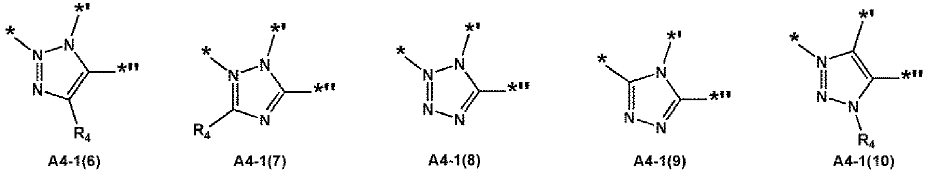 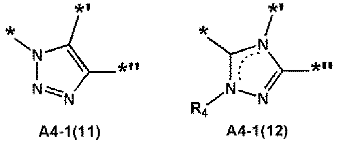
In Formulae A4-1(1) to A4-1(12),
X₄ and R₄ are the same as described above,
* indicates a binding site to M in Formula 1,
*' indicates a binding site to ring CY₃ in Formula 1, and
*" indicates a binding site to ring CY₅ in Formula 1.

In one or more embodiments, regarding Formula 1, a moiety represented by 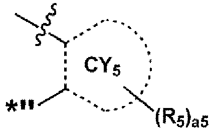 may be represented by a group selected from Formulae A5-1(1) to A5-1(8): 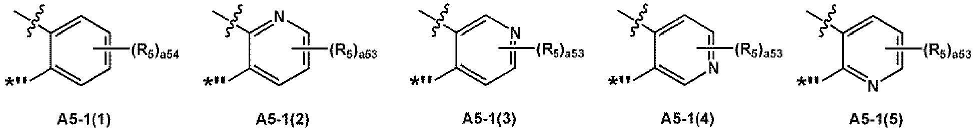 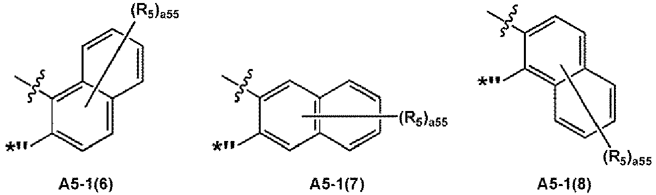
In Formulae A5-1(1) to A5-1(8),
R₅ is the same as described above,
a55 may be an integer from 0 to 5,
a54 may be an integer from 0 to 4,
a53 may be an integer from 0 to 3,
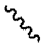 indicates a binding site to ring CY₃ in Formula 1, and
*" indicates a binding site to Y₄₂ in Formula 1.

In one or more embodiments, regarding Formula 1,
a moiety represented by 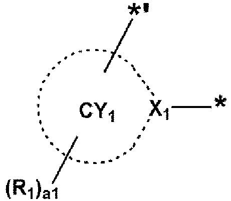 may be represented by one of Formulae CY1-1 to CY1-59 (and/or),
a moiety represented by 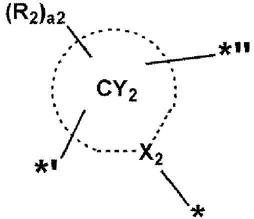 may be represented by one of Formulae CY2-1 to CY2-34 (and/or),
a moiety represented by 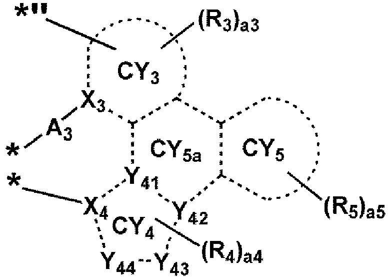 may be represented by one of Formulae CY3-1 to CY3-6: 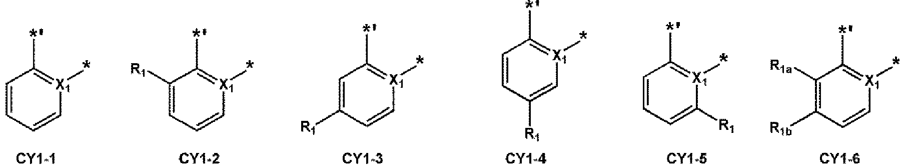 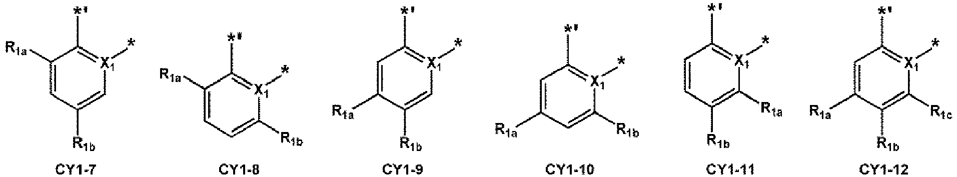 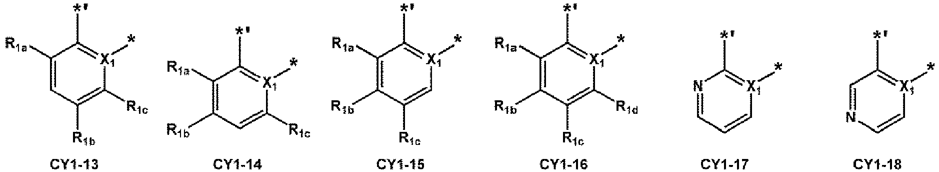 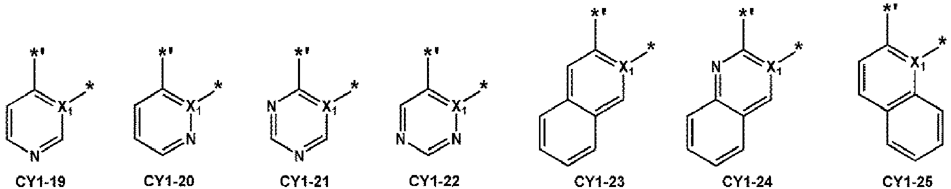 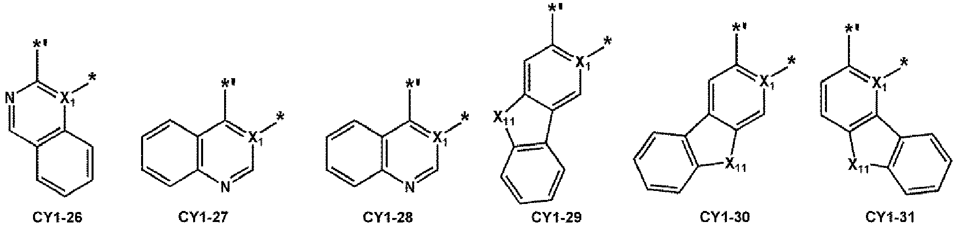 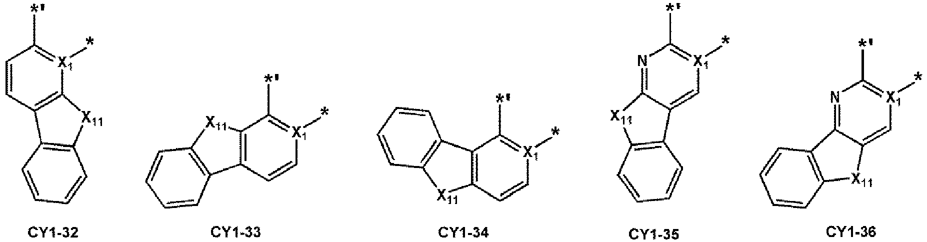 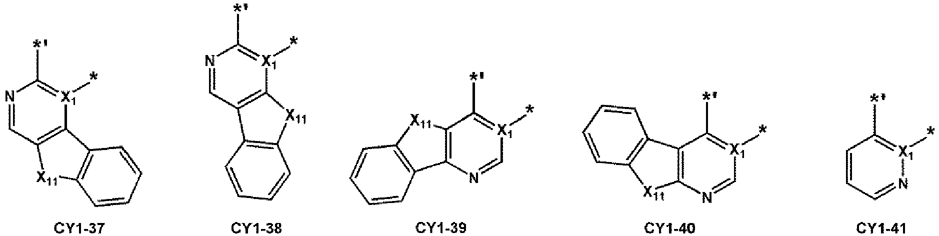 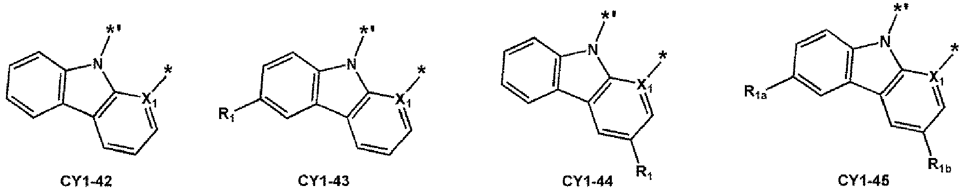 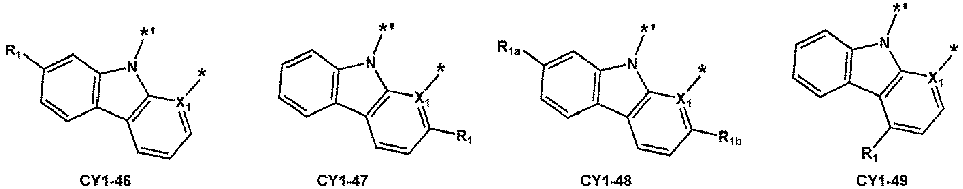 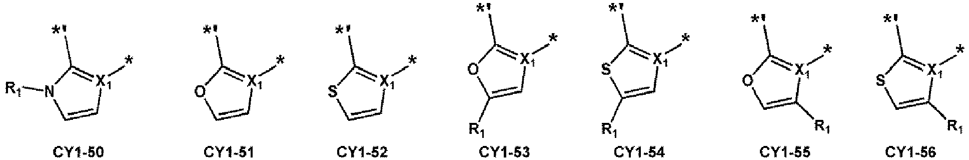 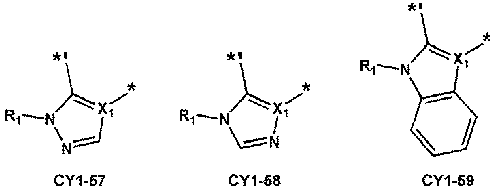 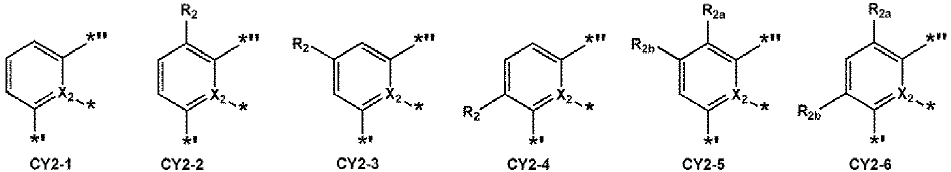 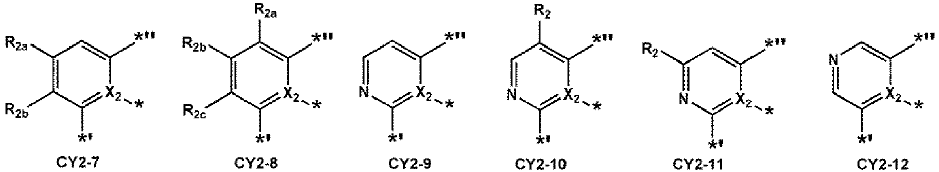 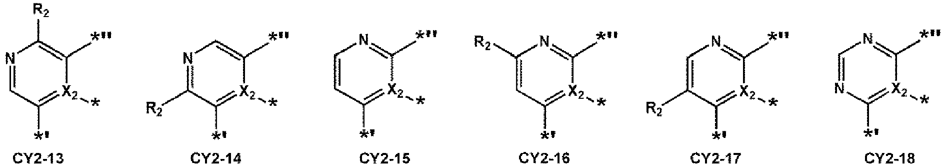 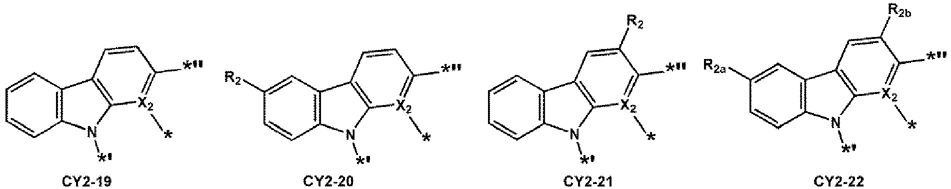 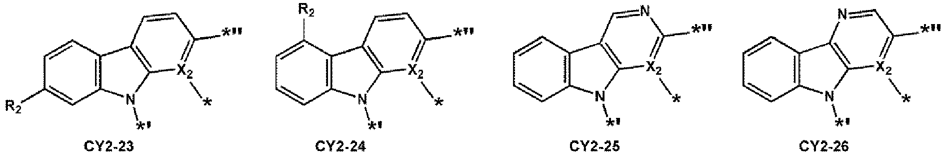 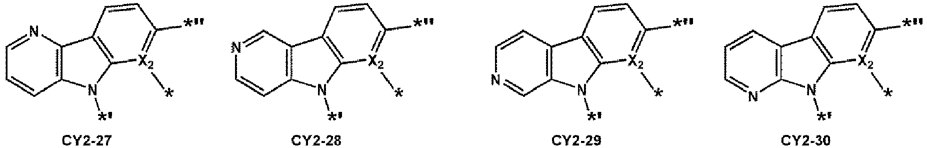 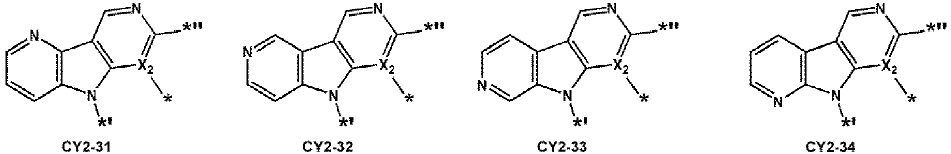 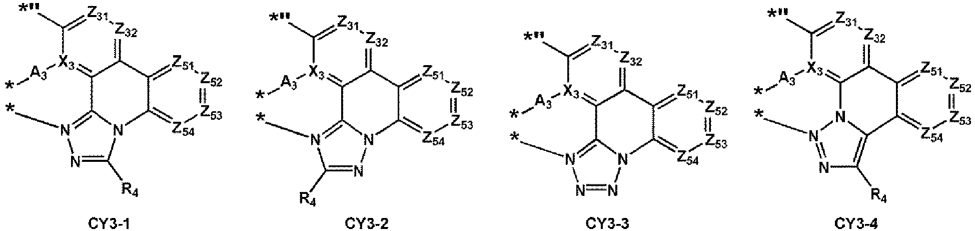 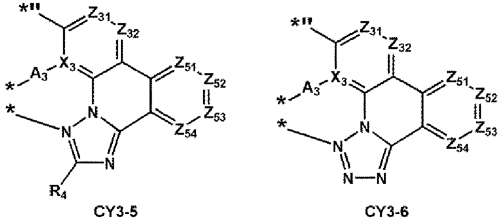
In Formulae CY1-1 to CY1-59, CY2-1 to CY2-34, and CY3-1 to CY3-6,
A₃, X₁ to X₃, and R₁ to R₄ are the same as described above,
X₁₁ may be O, S, N(R₁₁), C(R₁₁)(R₁₂), or Si(R₁₁)(R₁₂),
R₁ₐ to R_{1d}, R₁₁, and R₁₂ are the same as described in connection with R₁,
R₂ₐ to R_{2c} are the same as described in connection with R₂,
Z₃₁ may be N or C(R₃₁), and Z₃₂ may be N or C(R₃₂),
R₃₁ and R₃₂ are the same as described in connection with R₃,
Z₅₁ may be N or C(R₅₁), Z₅₂ may be N or C(R₅₂), Z₅₃ may be N or C(R₅₃), Z₅₄ may be N or C(R₅₄),
R₅₁ to R₅₄ are the same as described in connection with R₅,
each of R₁, R₂, R₁ₐ to R_{1d}, and R₂ₐ to R_{2c} are not hydrogen,
regarding Formulae CY1-1 to CY1-59, * indicates a binding site to A₁ or M in Formula 1, and *' indicates a binding site to T₁ in Formula 1,
regarding Formulae CY2-1 to CY2-34, * indicates a binding site to A₂ or M in Formula 1, *' indicates a binding site to T₁ in Formula 1, and *" indicates a binding site to T₂ in Formula 1, and
regarding Formulae CY3-1 to CY3-6, two * each indicate a binding site to M in Formula 1, and *" indicates a binding site to T₂ in Formula 1.

In one or more embodiments, the organometallic compound may be represented by Formula 1-1 or 1-2: 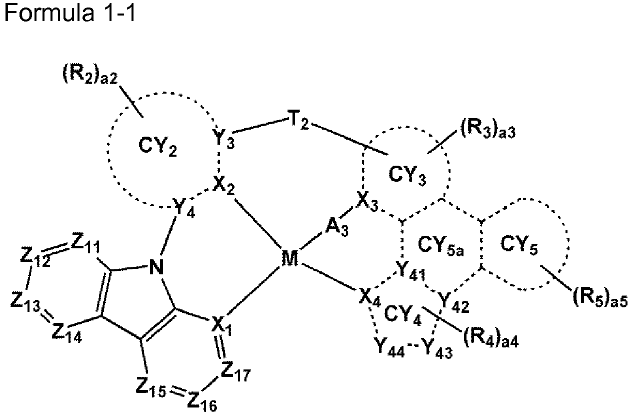 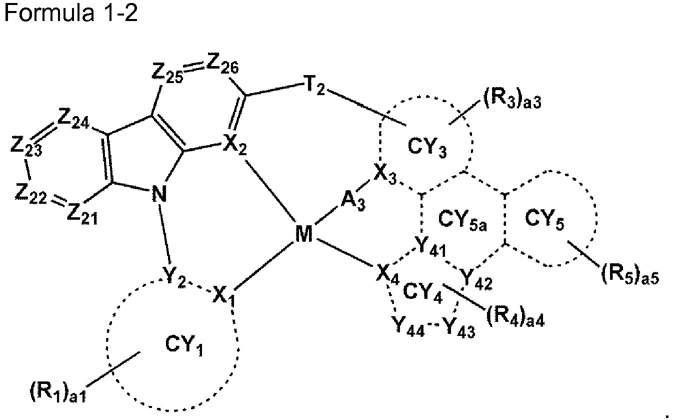
In Formulae 1-1 and 1-2,
M, X₁ to X₄, Y₄₁ to Y₄₄, A₃, ring CY₁ to CY₅, ring CY₅ₐ, R₁ to R₅, and a1 to a5 are the same as described above,
T₂ may be *-N(R₈)-*', *-B(R₈)-*', *-P(R₈)-*', *-C(R₈)(R₉)*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', or *-C(=S)-*', and R₈ and R₉ are the same as described above,
Y₂ to Y₄ may each independently be C or N,
a bond between X₂ and Y₃, a bond between X₂ and Y₄, and a bond between X₁ and Y₂ may each independently be single bond or a double bond,
Z₁₁ may be N or C(R₁₁), Z₁₂ may be N or C(R₁₂), Z₁₃ may be N or C(R₁₃), Z₁₄ may be N or C(R₁₄), Z₁₅ may be N or C(R₁₅), Z₁₆ may be N or C(R₁₆), Z₁₇ may be N or C(R₁₇), Z₂₁ may be N or C(R₂₁), Z₂₂ may be N or C(R₂₂), Z₂₃ may be N or C(R₂₃), Z₂₄ may be N or C(R₂₄), Z₂₅ may be N or C(R₂₅), Z₂₆ may be N or C(R₂₆),
R₁₁ to R₁₇ are the same as described in connection with R₁, and
R₂₁ to R₂₆ are the same as described in connection with R₂.

In one or more embodiments, the organometallic compound may be represented by Formula 1-1(1) or 1-2(1): 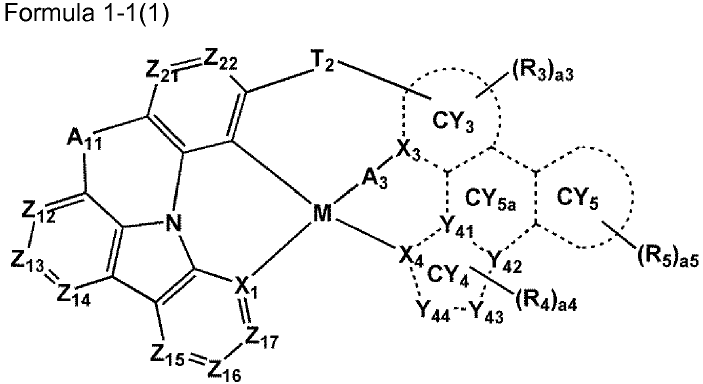 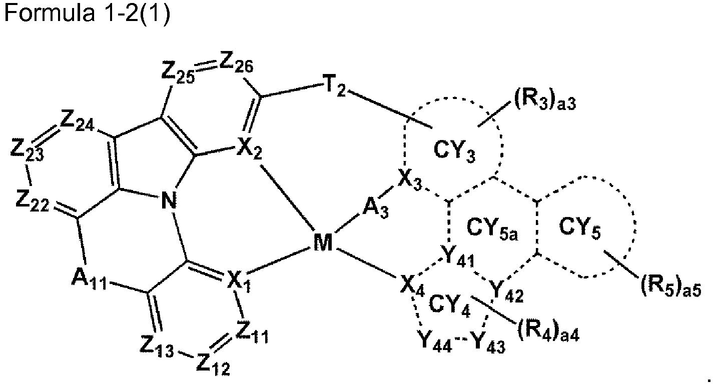
In Formulae 1-1(1) and 1-2(1),
M, X₁ to X₄, Y₄₁ to Y₄₄, A₃, ring CY₃ to CY₅, ring CY₅ₐ, R₃ to R₅, and a3 to a5 are the same as described above,
T₂ may be *-N(R₈)-*', *-B(R₈)-*', *-P(R₈)-*', *-C(R₈)(R₉)*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', or *-C(=S)-*', and R₈ and R₉ are the same as described above,
Z₁₁ may be N or C(R₁₁), Z₁₂ may be N or C(R₁₂), Z₁₃ may be N or C(R₁₃), Z₁₄ may be N or C(R₁₄), Z₁₅ may be N or C(R₁₅), Z₁₆ may be N or C(R₁₆), Z₁₇ may be N or C(R₁₇), Z₂₁ may be N or C(R₂₁), Z₂₂ may be N or C(R₂₂), Z₂₃ may be N or C(R₂₃), Z₂₄ may be N or C(R₂₄), Z₂₅ may be N or C(R₂₅), Z₂₆ may be N or C(R₂₆),
R₁₁ to R₁₇ are the same as described in connection with R₁, and
R₂₁ to R₂₆ are the same as described in connection with R₂,
A₁₁ may be *-N(R₈ₐ)-*', *-B(R₈ₐ)-*', *-P(R₈ₐ)-*', *-C(R₈ₐ)(R₉ₐ)-*', *-Si(R₈ₐ)(R₉ₐ)-*', *-Ge(R₈ₐ)(R₉ₐ)-*', *-S-*', *-Se-*', *-O-*', *-C(=O)-*', *-S(=O)-*', *-S(=O)₂-*', *-C(R₈ₐ)=*', *=C(R₈ₐ)-*', *-C(R₈ₐ)=C(R₉ₐ)-*', *-C(=S)-*', or *-C≡C-*', and R₈ₐ and R₉ₐ are respectively, the same as described in connection with R₈ and R₉.

In one or more embodiments, the organometallic compound may be represented by Formulae 1A: 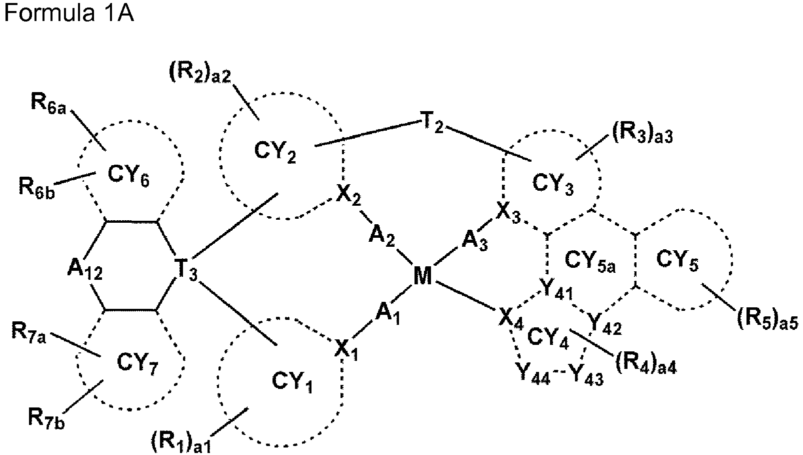
wherein, in Formula 1A,
M, X₁ to X₄, Y₄₁ to Y₄₄, A₁ to A₃, ring CY₁ to CY₅, ring CY₅ₐ, T₂, R₁ to R₅, and a1 to a5 are the same as described above,
T₃ may be C, Si, or Ge,
ring CY₆ and ring CY₇ are the same as described in connection with ring CY₁,
R₆ₐ, R_{6b}, R₇ₐ, and R_{7b} may be the same as described in connection with R₁,
A₁₂ may be a single bond, *-N(R_{8b})-*', *-B(R_{8b})-*', *-P(R_{8b})-", *-C(R_{8b})(R_{9b})-*', *-Si(R_{8b})(R_{9b})-*', *-Ge(R_{8b})(R_{9b})-*', *-S-*', *-Se-*', *-O-*', *-C(=O)-*', *-S(=O)-*', *-S(=O)₂-*', *-C(R_{8b})=*', *=C(R_{8b})-*', *-C(R_{8b})=C(R_{9b})-*', *-C(=S)-*', or *-C≡C-*', and R_{8b} and R_{9b} are the same as described in connection with R₈ and R₉.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" as used herein respectively mean a heterocycle having a backbone of "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group", in which at least one of carbon forming a ring is substituted with nitrogen.

In one or more embodiments, the organometallic compound may be one of Compounds 1 to 196:

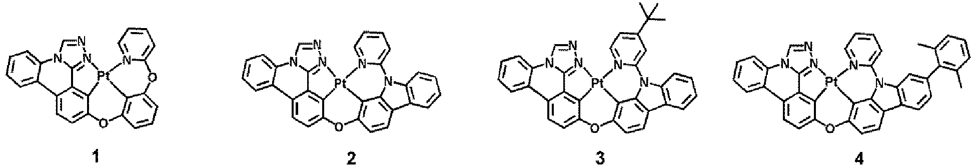

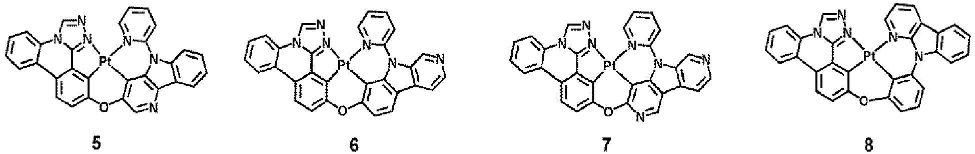

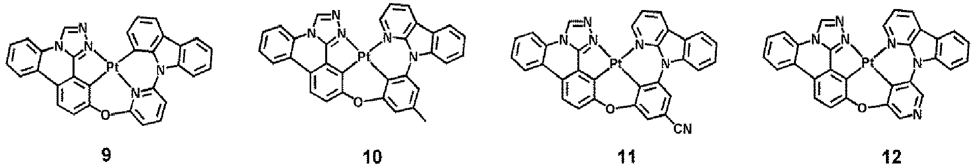

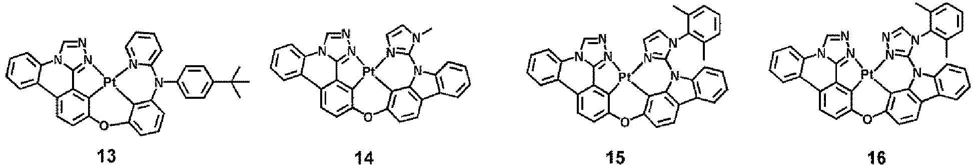

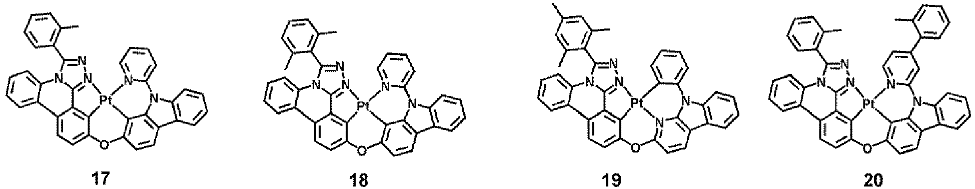

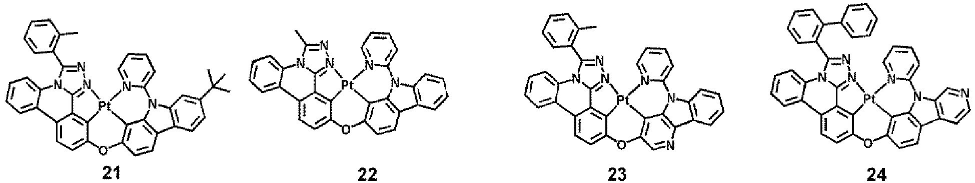

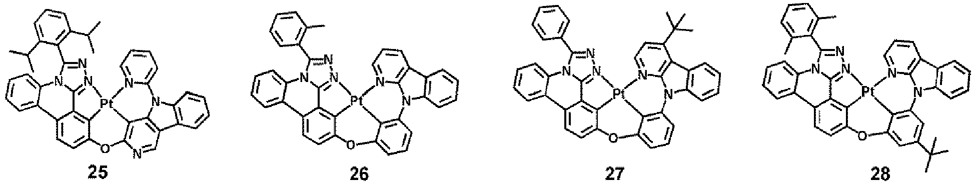

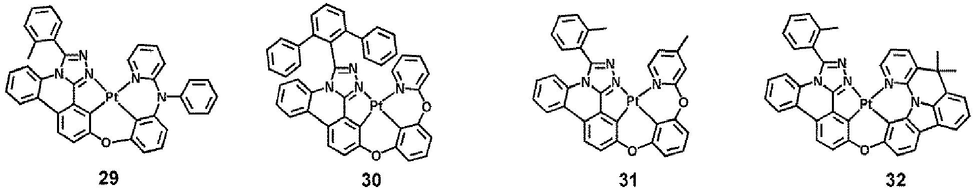

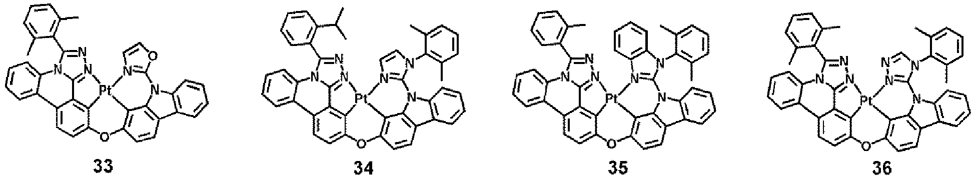

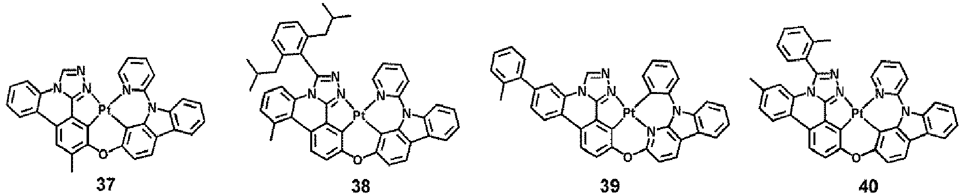

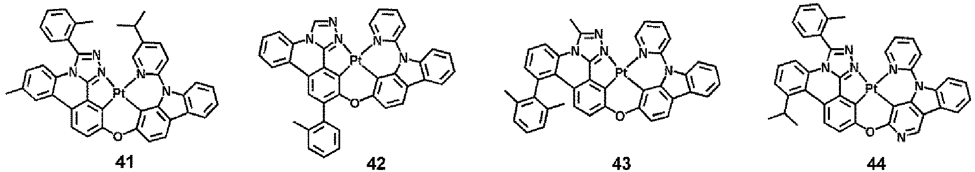

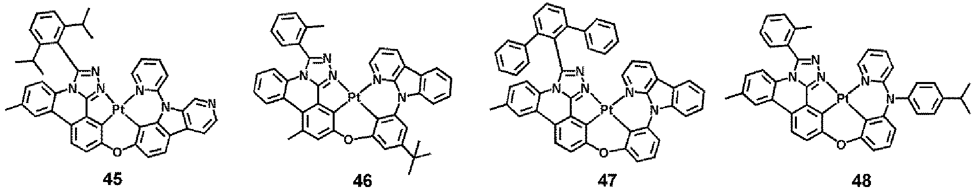

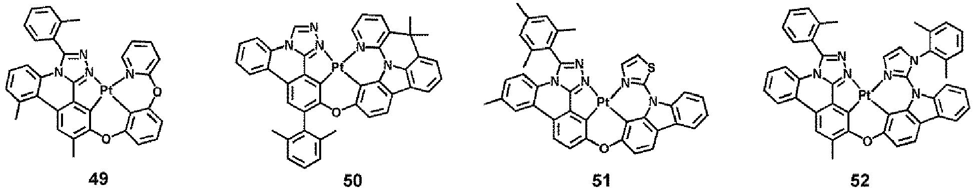

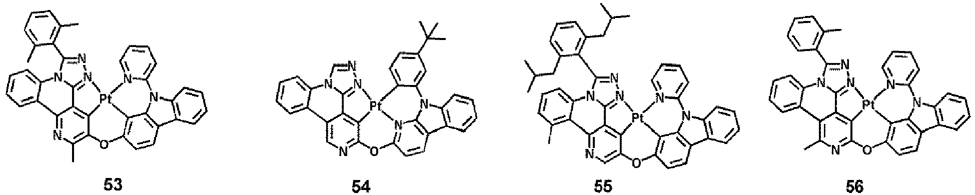

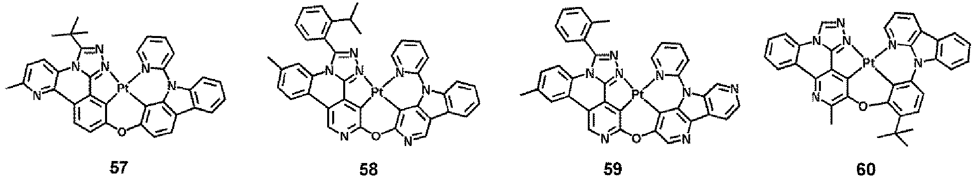

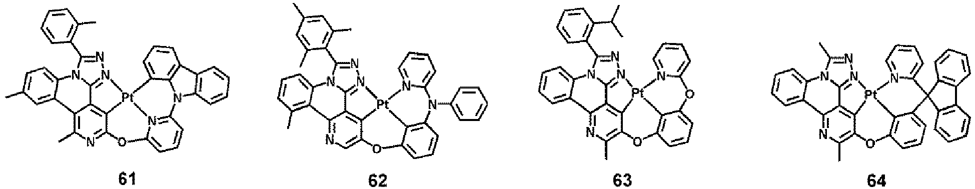

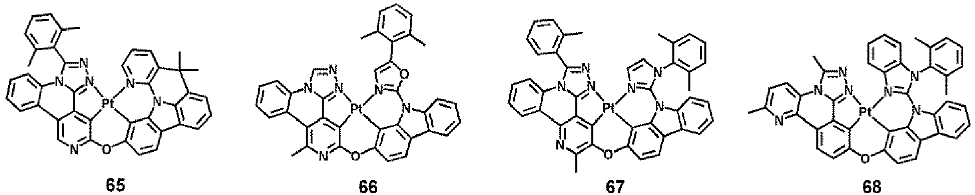

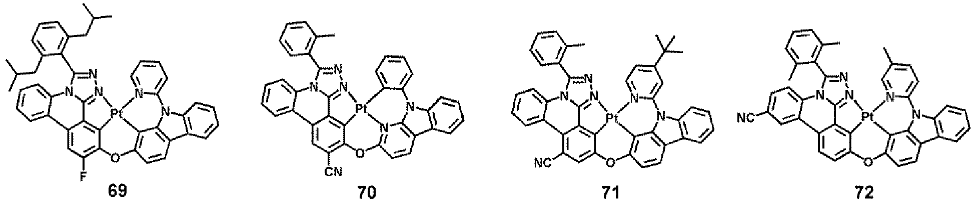

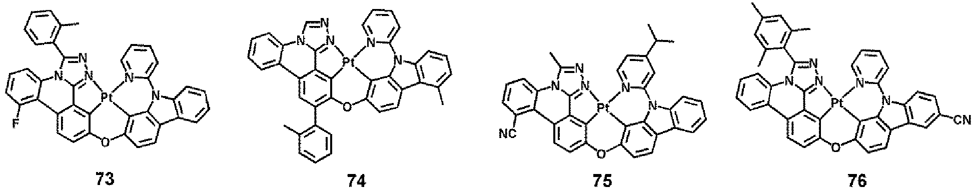

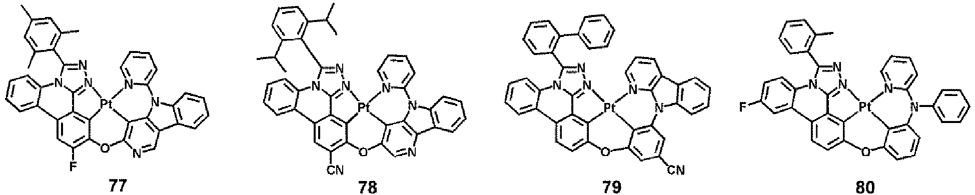

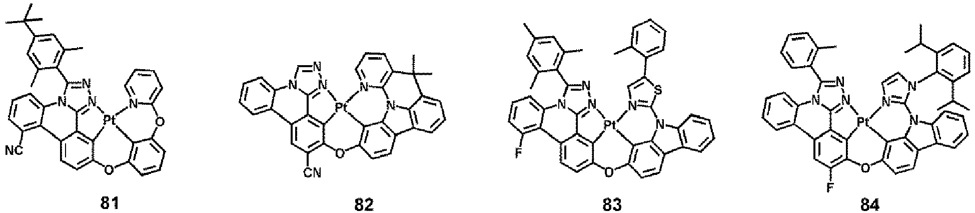

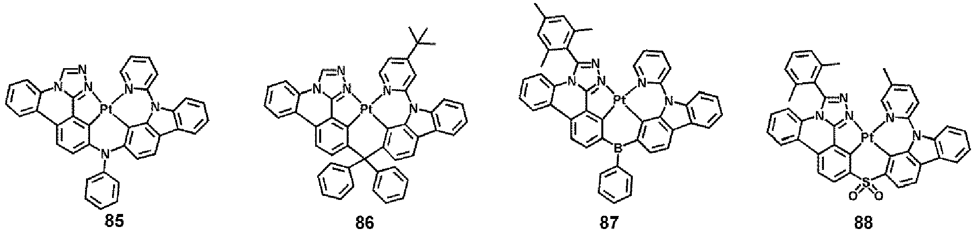

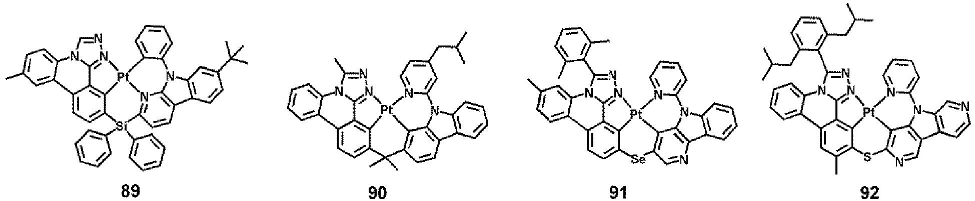

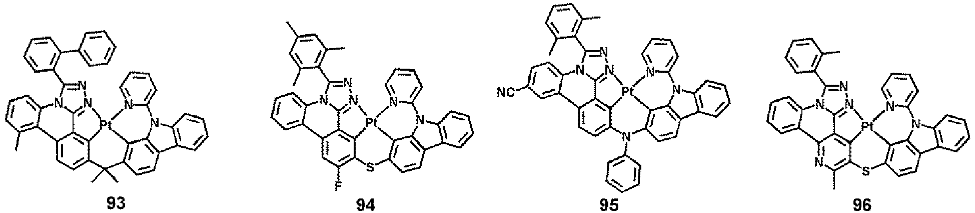

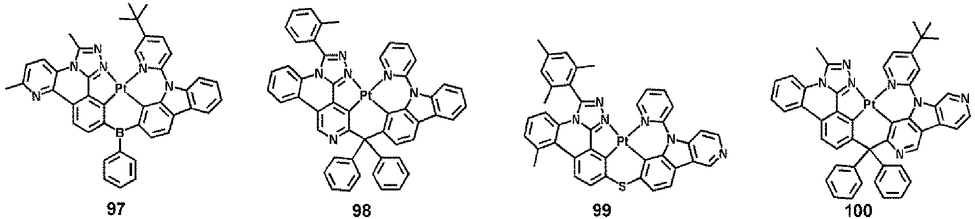

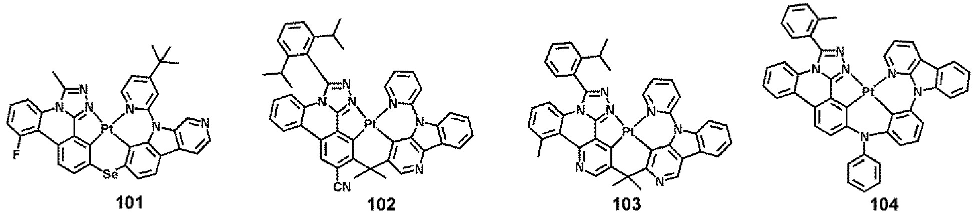

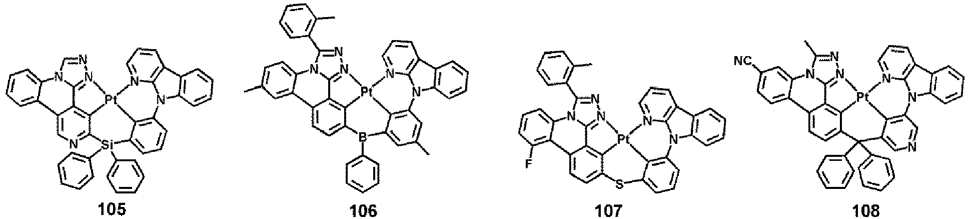

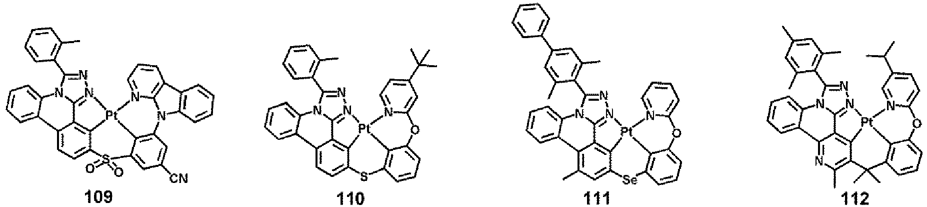

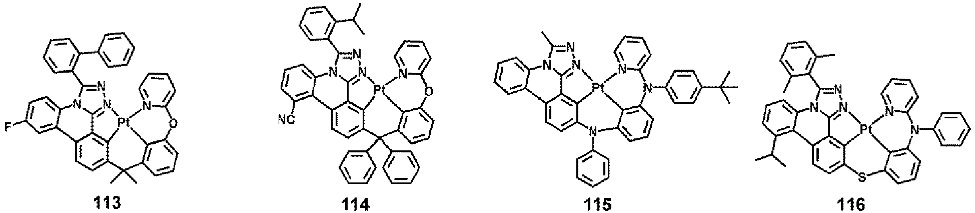

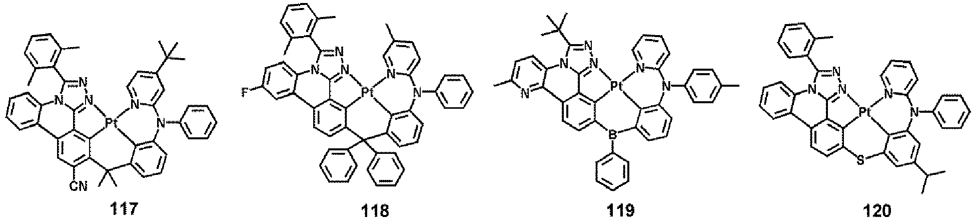

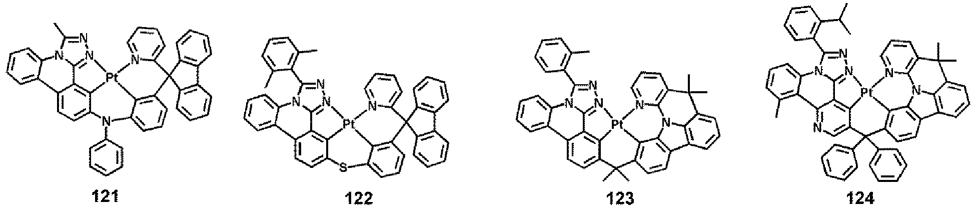

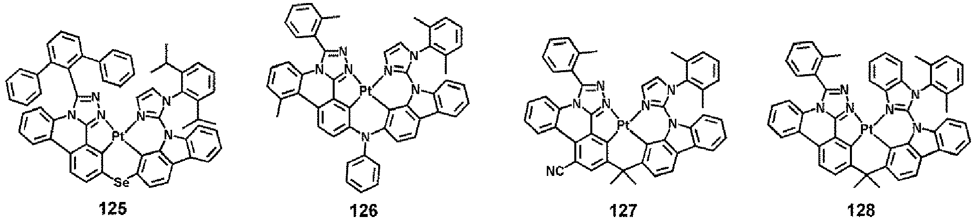

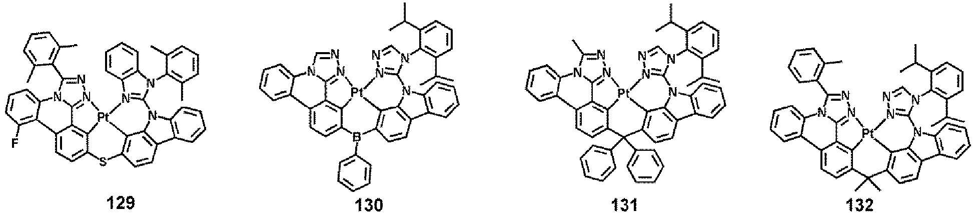

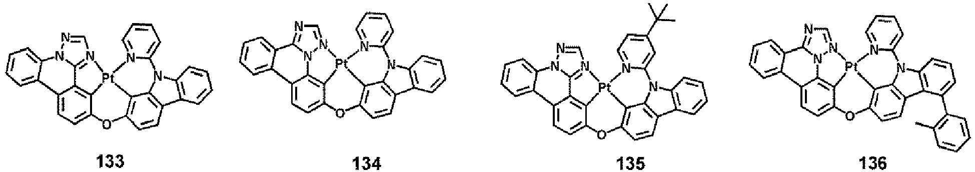

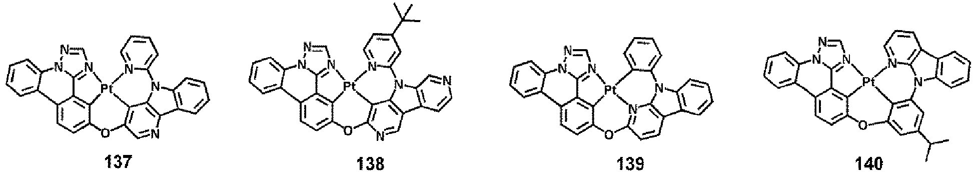

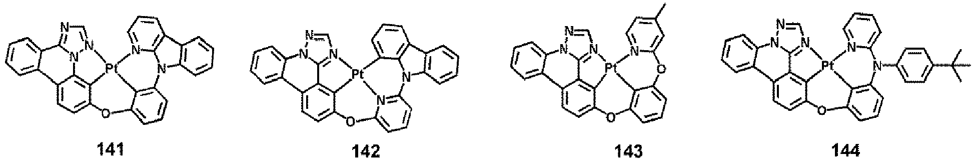

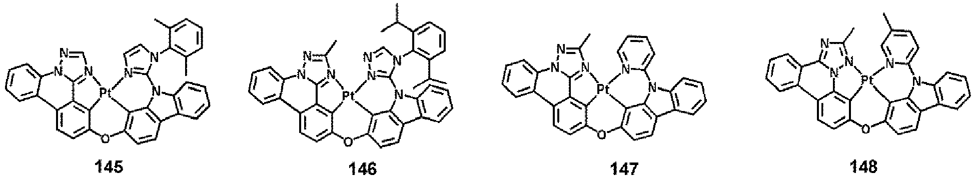

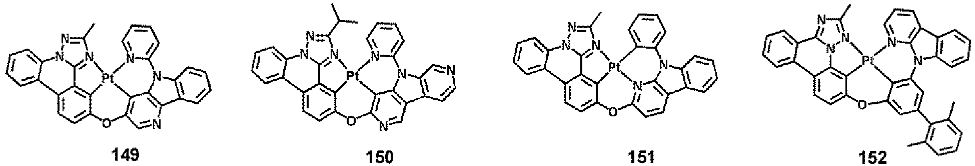

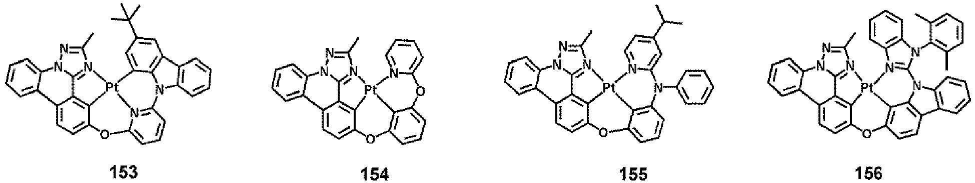

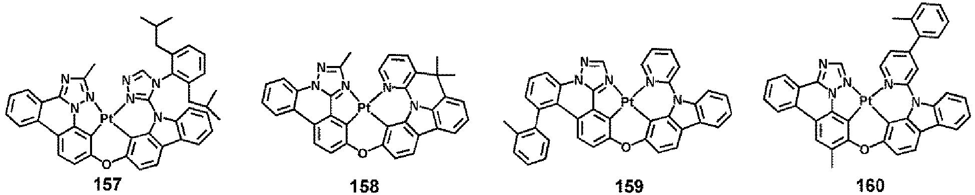

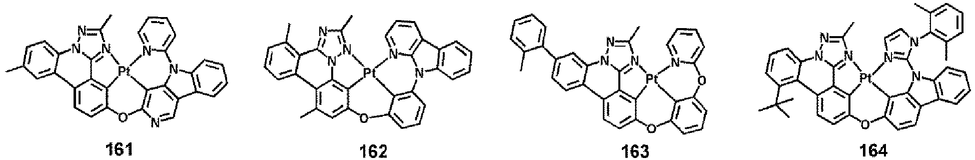

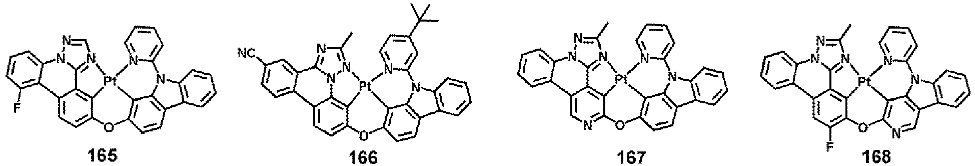

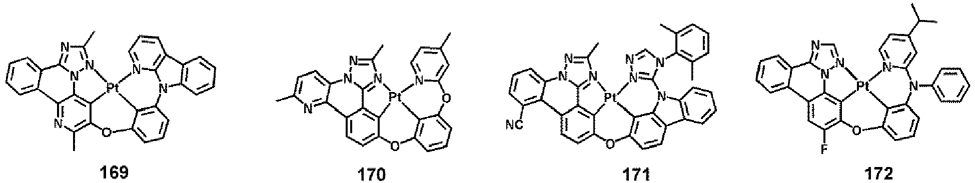

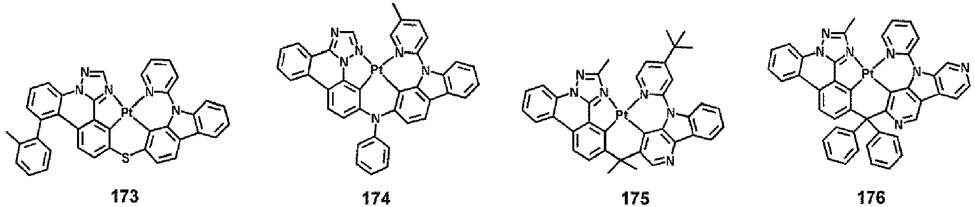

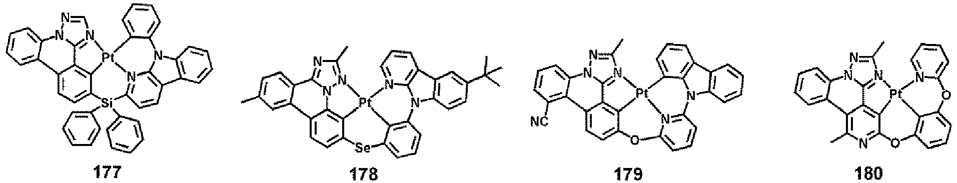

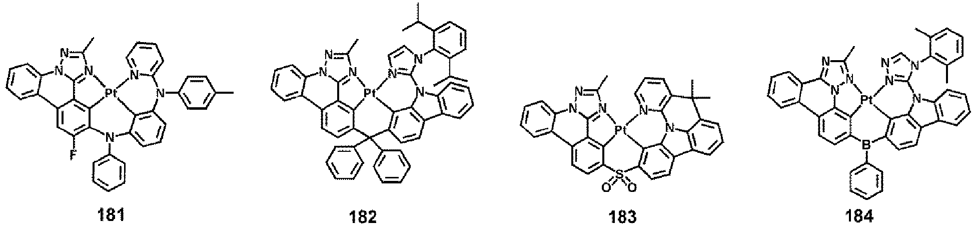

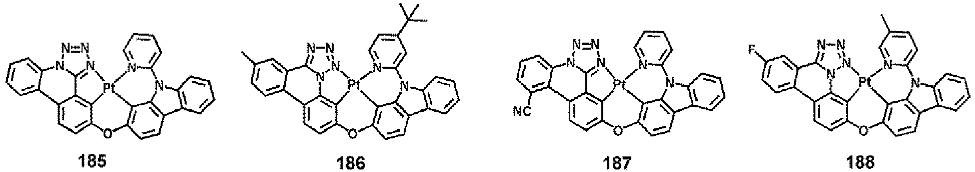

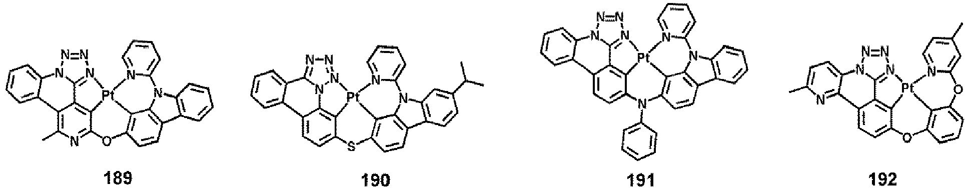

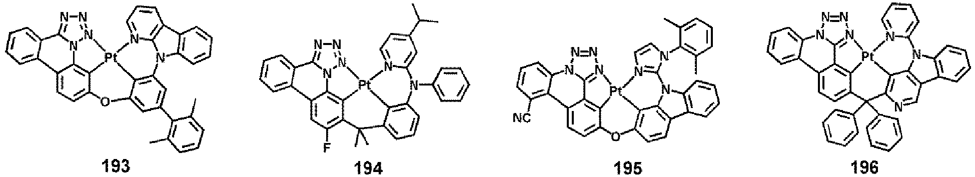

A peak of the photoluminescence spectrum of the organometallic compound in a solution (for example, toluene) may have a maximum emission wavelength (also referred to as peak emission wavelength) from about 420 nanometers (nm) to about 500 nm, for example, from about 440 nm to about 470 nm (for example, from about 455 nm to about 465 nm), and a full width at half maximum (FWHM) from about 30 nm to about 80 nm, for example, about 30 nm to about 60 nm (for example, about 30 nm to about 45 nm). Accordingly, the organometallic compound may emit blue light with excellent color purity.

Three or more of X₄, Y₄₁, Y₄₂, Y₄₃, and Y₄₄ of ring CY₄ in Formula 1 may each be N. For example, ring CY₄ may be a triazole group or a tetrazole group, but embodiments of the present disclosure are not limited thereto. Thus, distortion in a molecular structure of the organometallic compound represented by Formula 1 in an excited state may be minimized, leading to emission of light having a peak with a relatively narrow FWHM. Accordingly, non-radiative decay is minimized and high photoluminescence quantum yield (PLQY) may be obtained. The organometallic compound represented by Formula 1 may have a relatively high T₁ energy level (for example, from about 2.69 eV to about 2.80 eV). Accordingly, an electronic device including the organometallic compound represented by Formula 1, for example, an organic light-emitting device including the organometallic compound represented by Formula 1 may effectively emit light having high emission efficiency and high color purity (for example, deep blue light).

Formula 1 has ring CY₅ₐ as defined herein. ring CY₅ₐ is a ring formed by connecting rings CY₃ to CY₅ one another, and due to the inclusion of ring CY₅ₐ, the organometallic compound represented by the Formula 1 may have a strong molecular structure having stability against charges and heat. Therefore, electronic devices, such as organic light-emitting devices, including the organometallic compound represented by Formula 1 may have long lifespans.

M in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au) (for example, Pt, Pd or Au), and the organometallic compound of Formula 1 may have a tetradentate ligand. Accordingly, the organometallic compound represented by Formula 1 may have a square-planar coordination structure and a high radiative decay rate. Thus, an electronic device including the organometallic compound, for example, an organic light-emitting device including the organometallic compound may effectively emit blue light having high emission efficiency and high color purity.

For example, the highest occupied molecular orbital (HOMO), lowest unoccupied molecular orbital (LUMO), and triplet (T₁) energy levels of some of the compounds described above were evaluated by using a DFT method of Gaussian program (structurally optimized at a level of B3LYP, 6-31G(d,p)). Evaluation results are shown in Table 1 below.

**Table 1**

| Compound No. | HOMO (eV) | LUMO (eV) | T₁ (eV) |
|---|---|---|---|
| 2 | -4.88 | -1.35 | 2.67 |
| 3 | -4.82 | -1.30 | 2.64 |
| 4 | -4.89 | -1.37 | 2.67 |
| 17 | -4.82 | -1.28 | 2.67 |
| A | -4.76 | -1.31 | 2.63 |
| B | -4.99 | -1.59 | 2.31 |

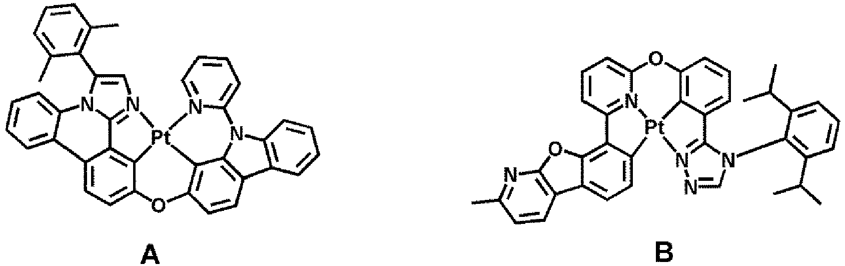

From Table 1, it was confirmed that the organometallic compound represented by Formula 1 has a higher T₁ energy level than Compounds A and B. Accordingly, the organometallic compound represented by Formula 1 may have electrical characteristics that are suitable for an electronic device, for example, a dopant of an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is located between the first electrode and the second electrode, wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan and/or a low roll-off ratio, and excellent color purity.

The organometallic compound represented by Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host).

In an embodiment, light emitted by an emission layer of an organic light-emitting device in which the emission layer includes the organometallic compound is blue light, the CIE y coordinate of the blue light may be in a range of about 0.10 to about 0.340, for example, about 0.120 to about 0.280. Accordingly, an organic light-emitting device that emits high-quality blue light may be realized.

The expression "(an organic layer) includes at least one organometallic compound represented by Formula 1" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include only Compound 1 as the organometallic compound. In this regard, Compound 1 may be included only in the emission layer of the organic light-emitting device. In one or more embodiments, the organic layer may include, as the organometallic compound, Compound 1 and Compound 2. In this regard, Compound 1 and Compound 2 may be included in an identical layer (for example, Compound 1 and Compound 2 may all be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region located between the first electrode and the emission layer and an electron transport region located between the emission layer and the second electrode, wherein the hole transport region includes a hole injection layer, a hole transport layer, an electron blocking layer, a buffer layer, or any combination thereof, and wherein the electron transport region includes a hole blocking layer, an electron transport layer, an electron injection layer, or any combination thereof.

The term "organic layer" as used herein refers to a single layer and/or a plurality of layers located between the first electrode and the second electrode of the organic light-emitting device. The "organic layer" may include, in addition to an organic compound, an organometallic complex including metal.

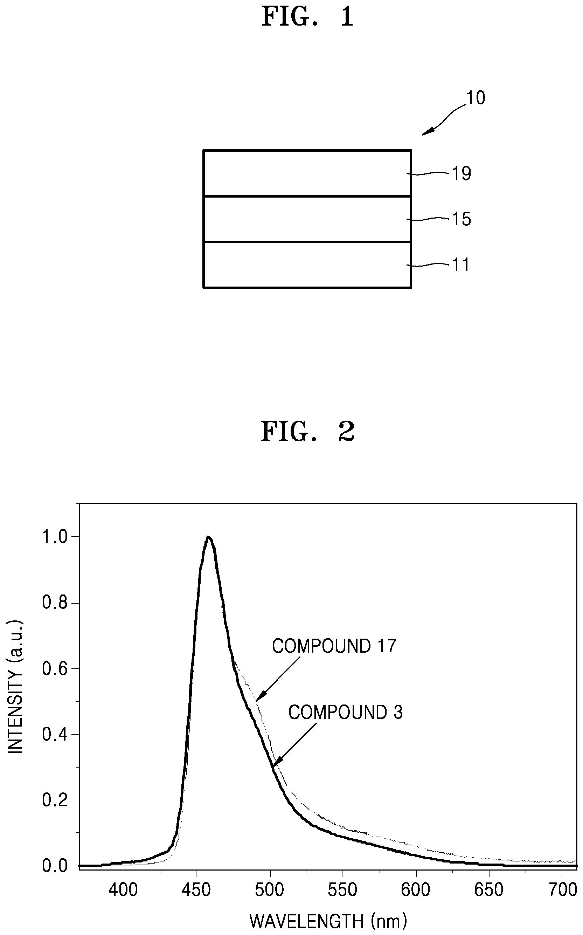

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500°C, a vacuum pressure of about 10⁻⁸ torr to about 10⁻³ torr (wherein 1 torr = 133,322 Pa), and a deposition rate of about 0.01 Angstroms per second (Å/sec) to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm (wherein 1 rpm=1/60 Hz), and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below: 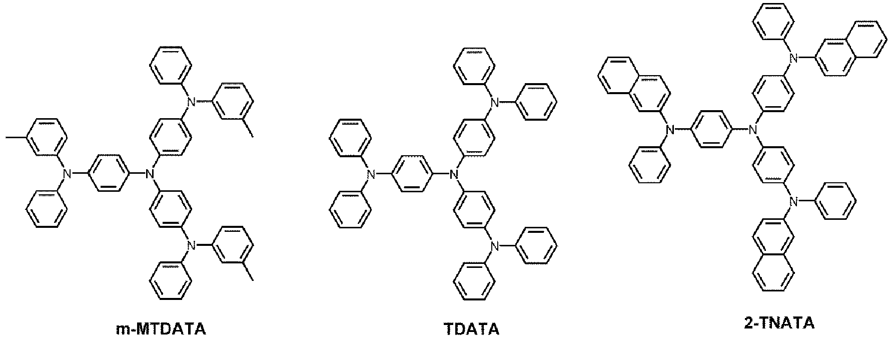 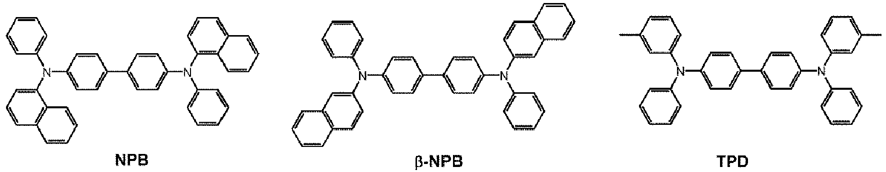 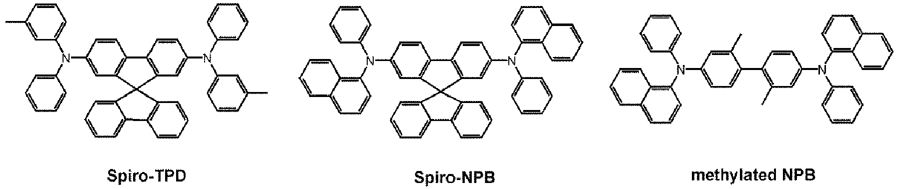 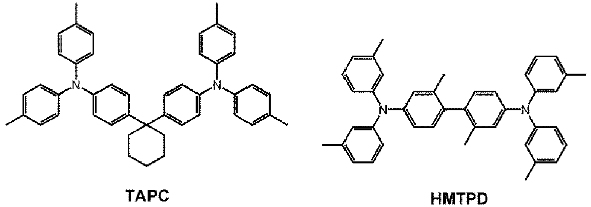 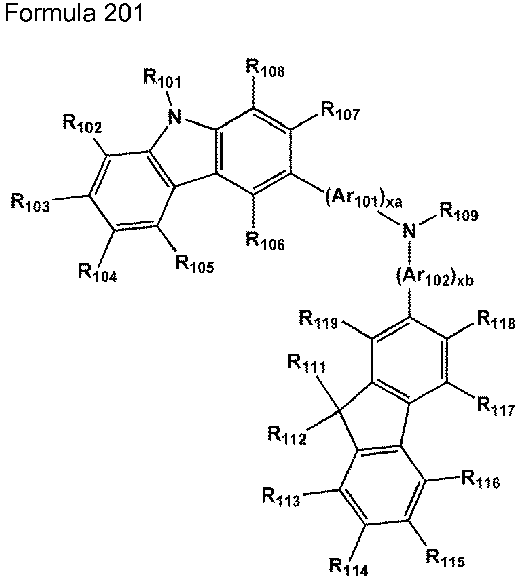 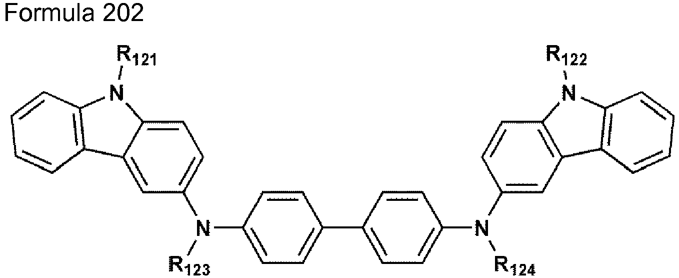 Ar₁₀₁ and Ar₁₀₂ in Formula 201 may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group.

xa and xb in Formula 201 may each independently be an integer from 0 to 5, or 0, 1 or 2. For example, xa may be 1 and xb may be 0, but xa and xb are not limited thereto.

R₁₀₁ to R₁₀₈, R₁₁₁ to R₁₁₉, and R₁₂₁ to R₁₂₄ in Formulae 201 and 202 may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, and so on), or a C₁-C₁₀ alkoxy group (for example, a methoxy group, an ethoxy group, a propoxy group, a butoxy group, a pentoxy group, and so on);
a C₁-C₁₀ alkyl group or a C₁-C₁₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, or a pyrenyl group; or
a phenyl group, a naphthyl group, an anthracenyl group, a fluorenyl group, and a pyrenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group;
but embodiments of the present disclosure are not limited thereto.

R₁₀₉ in Formula 201 may be selected from:
a phenyl group, a naphthyl group, an anthracenyl group, and a pyridinyl group; and
a phenyl group, a naphthyl group, an anthracenyl group, and a pyridinyl group, each substituted with at least one selected from a deuterium, -F, -CI, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a phenyl group, a naphthyl group, an anthracenyl group, and a pyridinyl group.

According to an embodiment, the compound represented by Formula 201 may be represented by Formula 201A below, but embodiments of the present disclosure are not limited thereto: 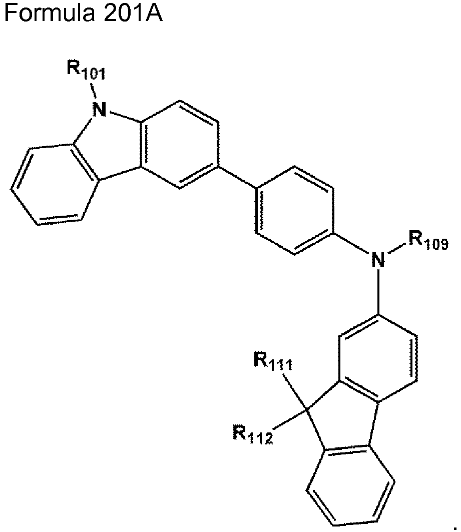 R₁₀₁, R₁₁₁, R₁₁₂, and R₁₀₉ in Formula 201A are the same as described above.

For example, the compound represented by Formula 201, and the compound represented by Formula 202 may include compounds HT1 to HT20 illustrated below, but are not limited thereto:

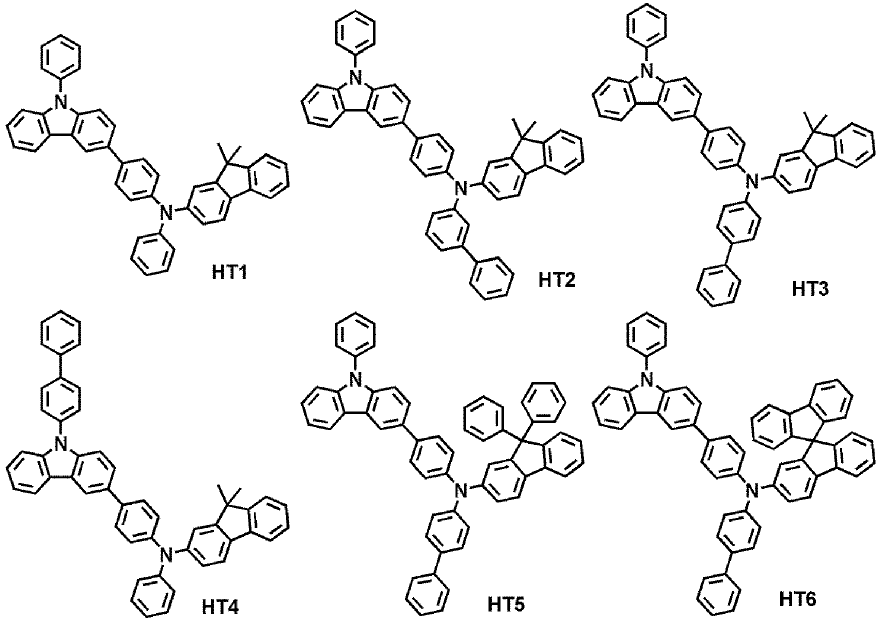

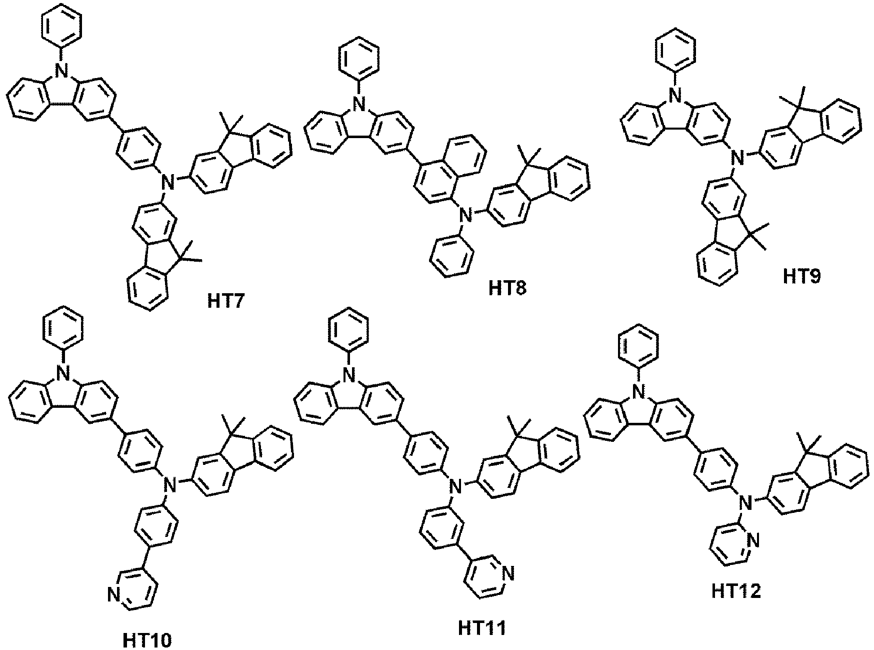

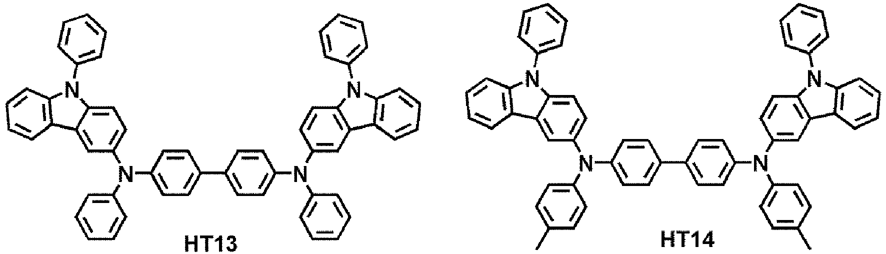

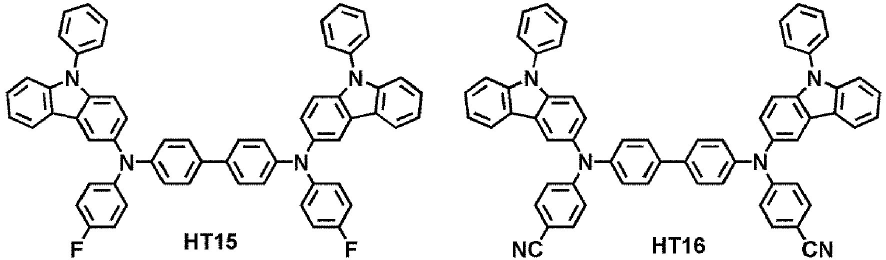

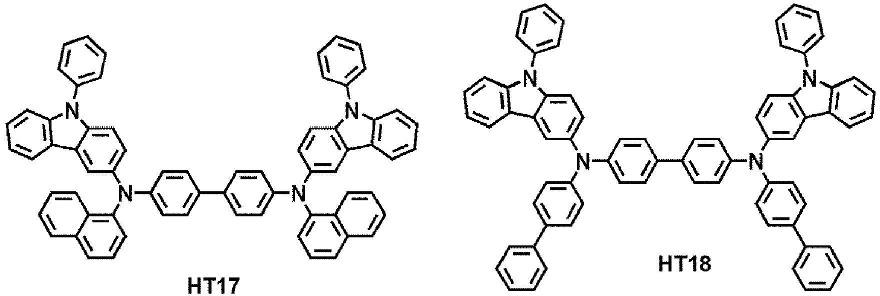

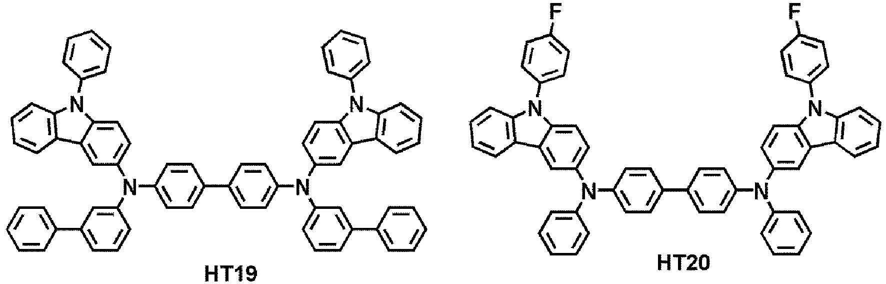

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. While not wishing to be bound by theory, it is understood that when the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto.

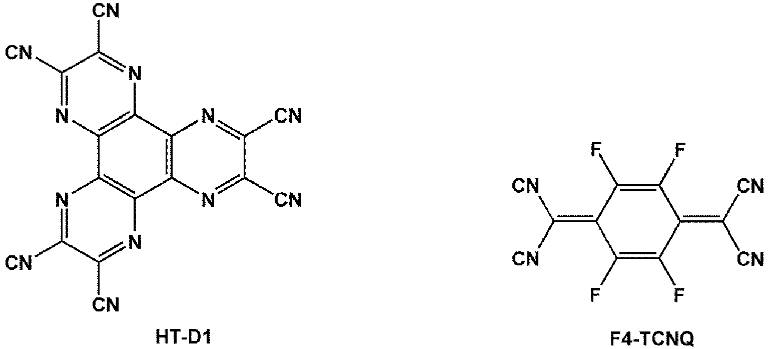

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, Compound H51 and Compound H52:

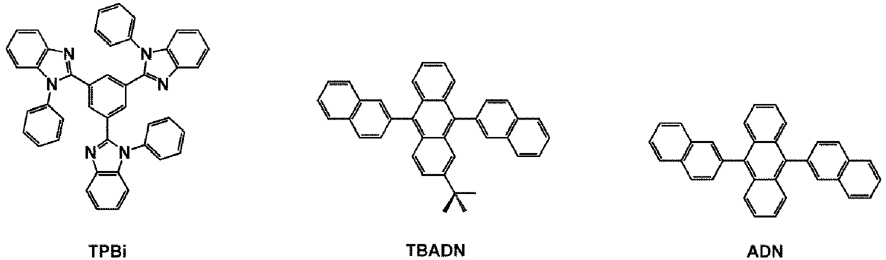

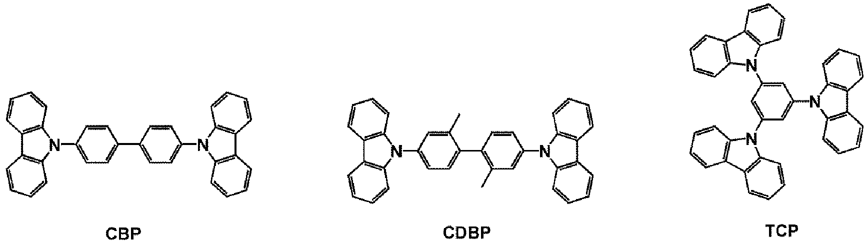

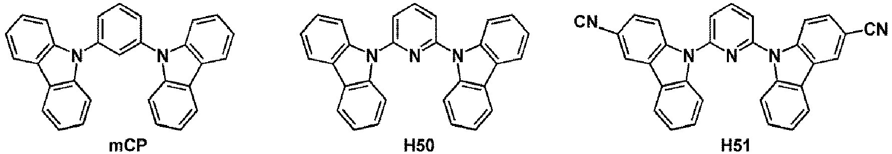

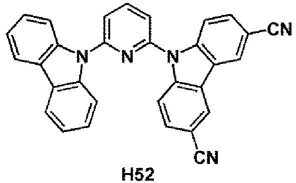

In one or more embodiments, the host may further include a compound represented by Formula 301 below.

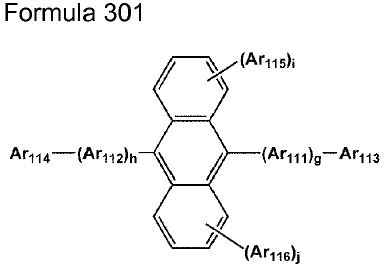

Ar₁₁₁ and Ar₁₁₂ in Formula 301 may each independently be selected from:
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

Ar₁₁₃ to Ar₁₁₆ in Formula 301 may each independently be selected from:
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.
g, h, i, and j in Formula 301 may each independently be an integer from 0 to 4, and may be, for example, 0, 1, or 2.

Ar₁₁₃ and Ar₁₁₆ in Formula 301 may each independently be selected from
a C₁-C₁₀ alkyl group, substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C1-C60 alkyl group, a C2-C60 alkenyl group, a C2-C60 alkynyl group, a C1-C60 alkoxy group, a phenyl group, a naphthyl group, an anthracenyl group, a pyrenyl group, a phenanthrenyl group, and a fluorenyl group; and 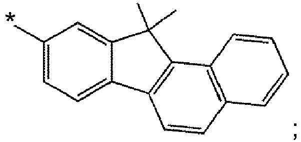 but embodiments of the present disclosure are not limited thereto.

In one or more embodiments, the host may include a compound represented by Formula 302 below:

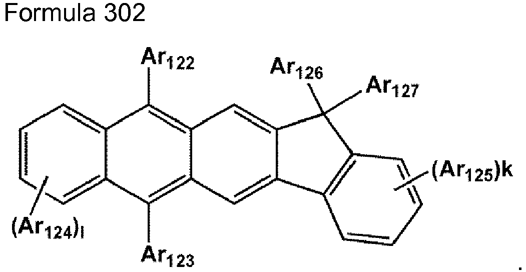

Ar₁₂₂ to Ar₁₂₅ in Formula 302 are the same as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and I in Formula 302 may each independently be an integer from 0 to 4. For example, k and I may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be located on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

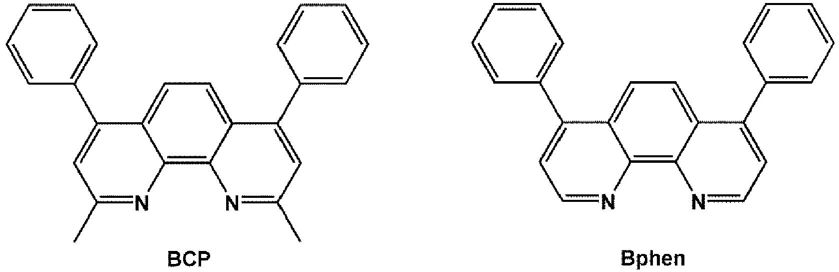

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have excellent hole blocking characteristics without a substantial increase in driving voltage.

The electron transport layer may further include at least one selected from BCP, Bphen, Alq₃, BAlq, TAZ, and NTAZ.

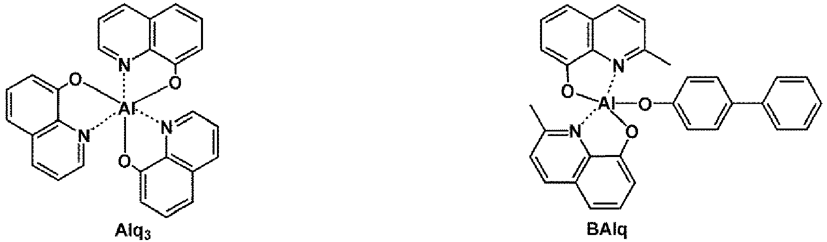

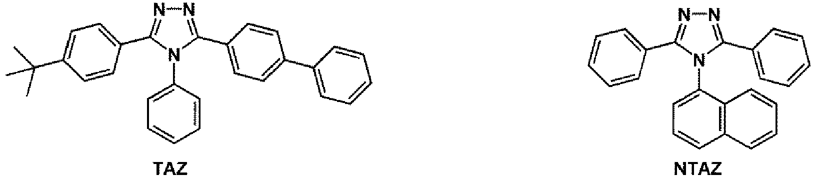

In one or more embodiments, the electron transport layer may include at least one of ET1 to ET25, but are not limited thereto:

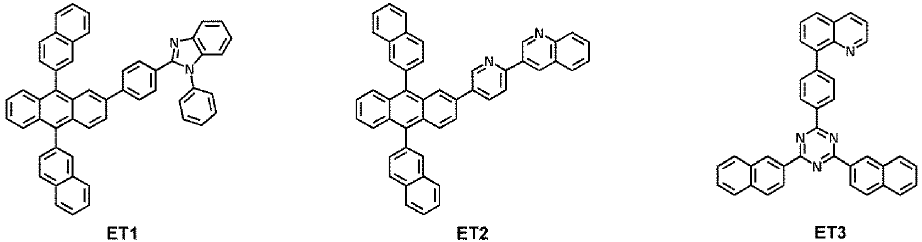

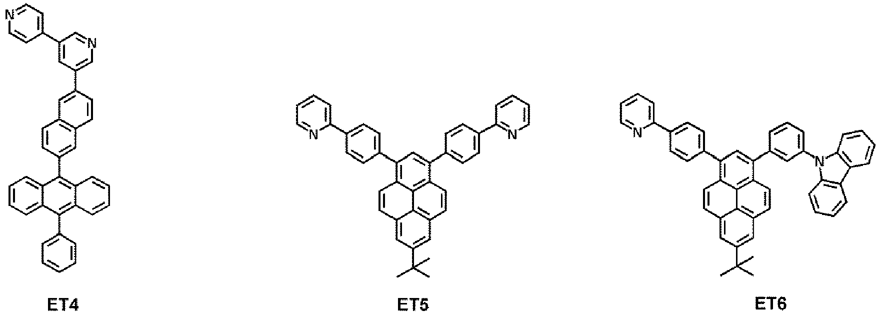

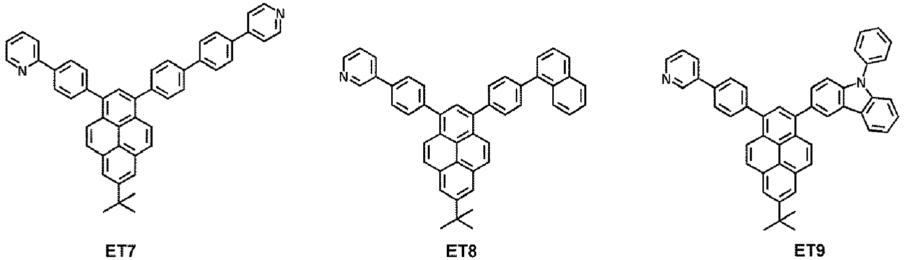

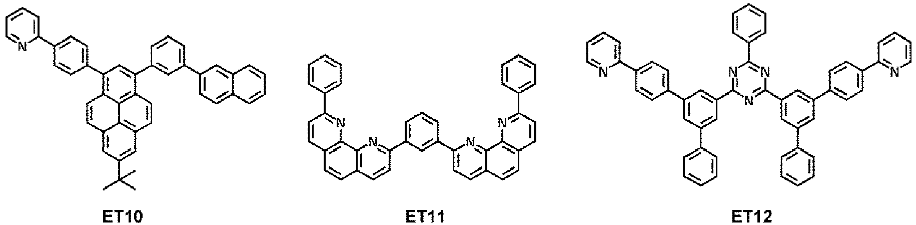

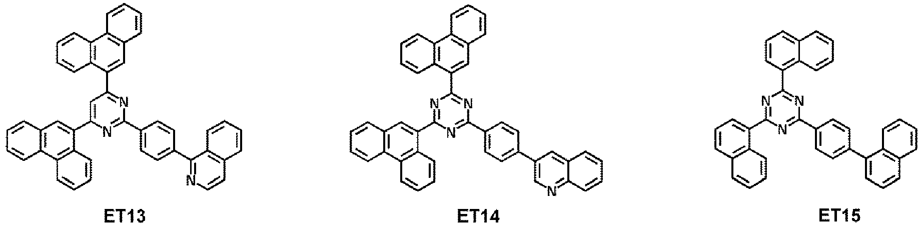

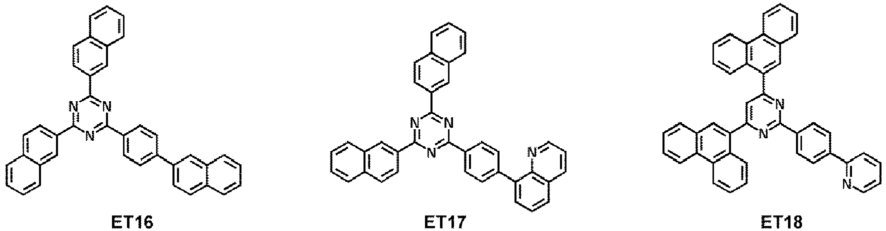

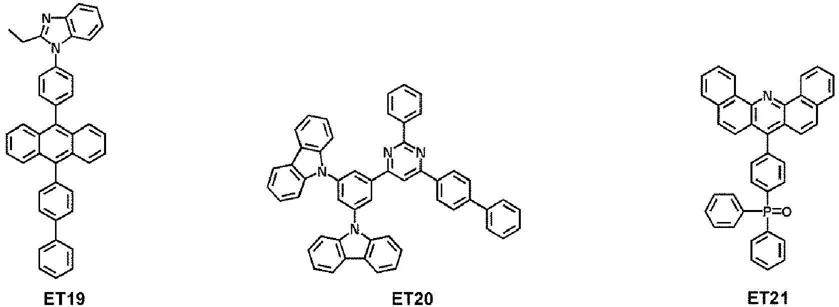

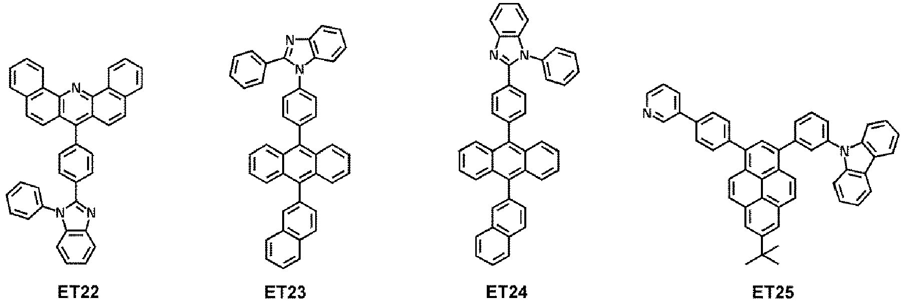

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2.

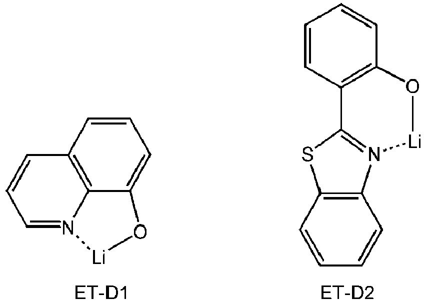

The electron transport region may include an electron injection layer (EIL) that promotes flow of electrons from the second electrode 19 thereinto.

The electron injection layer may include at least one selected from LiF, NaCl, CsF, Li₂O, and BaO.

A thickness of the electron injection layer may be in a range of about 1 Å to about 100 Å, and, for example, about 3 Å to about 90 Å. While not wishing to be bound by theory, it is understood that when a thickness of the electron injection layer is within these ranges, satisfactory electron injection characteristics may be obtained without substantial increase in driving voltage.

The second electrode 19 is located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, an organic light-emitting device has been described in connection with FIG. 1, but it may be understood that embodiments of the present disclosure are not limited thereto.

Another aspect provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. A C₁-C₆₀ alkylene group as used herein refers to a divalent group having the same structure as that of the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an iso-propyloxy group.

The term "C₂-C₆₀ alkenyl group" as used herein refers to a hydrocarbon group formed by including at least one carbon-carbon double bond in the middle or at the terminus of the C₂-C₆₀ alkyl group, and examples thereof include an ethenyl group, a propenyl group, and a butenyl group. A C₂-C₆₀ alkenylene group as used herein refers to a divalent group having the same structure as that of the C₂-C₆₀ alkenyl group.

The term "C₂-C₆₀ alkynyl group" as used herein refers to a hydrocarbon group formed by including at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as that of the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. A C₃-C₁₀ cycloalkylene group as used herein refers to a divalent group having the same structure as that of the C₃-C₁₀ cycloalkyl group.

The term "C₁-C₁₀ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a heteroaromatic system that has at least one heteroatom selected from N, O, P, Si, and S as a ring-forming atom, and 1 to 60 carbon atoms. The term "C₁-C₆₀ heteroarylene group" as used herein refers to a divalent group having a heteroaromatic system that has at least one heteroatom selected from N, O, P, Si, and S as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates -SA₁₀₃ (wherein A₁₀₃ is the C₆-C₆₀ aryl group), and the term "C₇-C₆₀ arylalkyl group" as used herein indicates -A₁₀₄A₁₀₅ (wherein A₁₀₅ is the C₆-C₅₉ aryl group and A₁₀₄ is the C₁-C₅₃ alkylene group).

The term "C₁-C₆₀ heteroaryloxy group" as used herein refers to -OA₁₀₆ (wherein A₁₀₆ is the C₂-C₆₀ heteroaryl group), the term "C₁-C₆₀ heteroarylthio group" as used herein indicates -SA₁₀₇ (wherein A₁₀₇ is the C₁-C₆₀ heteroaryl group), and the term "C₂-C₆₀ heteroarylalkyl group" as used herein refers to -A₁₀₈A₁₀₉ (A₁₀₉ is a C₁-C₅₉ heteroaryl group, and A₁₀₈ is a C₁-C₅₉ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms. The C₁-C₃₀ heterocyclic group may be a monocyclic group or a polycyclic group.

At least one substituent of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₇-C₆₀ alkyl aryl group, substituted C₆-C₆₀ aryloxy group, substituted C₆-C₆₀ arylthio group, substituted C₇-C₆₀ aryl alkyl group, substituted C₁-C₆₀ heteroaryl group, substituted C₁-C₆₀ heteroaryloxy group, substituted C₁-C₆₀ heteroarylthio group, substituted C₂-C₆₀ heteroaryl alkyl group, substituted C₂-C₆₀ alkyl heteroaryl group, substituted monovalent non-aromatic condensed polycyclic group and substituted monovalent non-aromatic condensed heteropolycyclic group is selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, a monovalent non-aromatic condensed heteropolycyclic group, -N(Q₂₁)(Q₂₂),-Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, and Q₃₁ to Q₃₉ are each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example 1: Synthesis of Compound 2

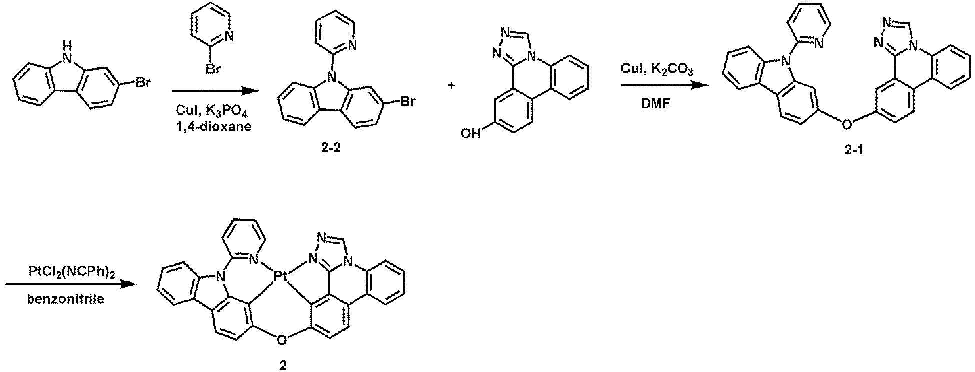

### Synthesis of Intermediate 2-2

40.6 millimoles (mmol) (10 grams, g) of 2-bromo-9H-carbazole, 61.0 mmol (9.6 g) of 2-bromopyridine, 20.3 mmol (3.9 g) of Cul, and 60.1 mmol (12.9 g) of K₃PO₄ were mixed with 150 milliliters (ml) of 1,4-dioxane, and the mixture was stirred at a temperature of 120°C for 12 hours. The obtained reaction product was cooled, and the organic layer was extracted therefrom by using a mixture including ethyl acetate and water. The reaction product was washed three times with water, dried by using magnesium sulfate, and the solvent was removed therefrom under reduced pressure. The resulting crude product was purified by silica gel column chromatography (eluent: dichloromethane and hexane) to obtain Intermediate 2-2 (yield: 83%).
MALDI-TOF (m/z): 323.02 [M]+

### Synthesis of Intermediate 2-1

21.7 mmol (7 g) of Intermediate 2-2, 21.7 mmol of [1,2,4]triazolo[1,5-f]phenanthridin-11-ol, 4.4 mmol (0.8 g) of Cul, 43.4 mmol (6.0 g) of K₂CO₃, and 21.7 mmol (1.8 g) of 1-methyl imidazole were added to 110 mL of dimethylformamide, and the mixture was stirred at a temperature of 130°C for 48 hours. The obtained reaction mixture was cooled. The organic layer was extracted therefrom by using a mixture including ethyl acetate and water. The reaction product was washed three times with water, dried by using magnesium sulfate, and subjected to silica gel column chromatography (eluent: dichloromethane and hexane), thereby obtaining Intermediate 2 -1 (yield: 29%).
MALDI-TOF (m/z): 478.16 [M]⁺

### Synthesis of Compound 2

2.1 mmol (1.0 g) of PtCl₂(NCPh)₂ and 2.1 mmol (1.0 g) of Intermediate 2-1 were mixed with 100 mL of benzonitrile, and the mixture was stirred in a nitrogen atmosphere for 24 hours. After completion of the reaction, the reaction mixture was cooled to room temperature, and the solvent was completely removed therefrom. The obtained solid was dried and subjected to silica gel column chromatography (eluent: dichloromethane and hexane) to obtain Compound 2 (yield: 25%).
MALDI-TOF (m/z): 671.11 [M]+

### Synthesis Example 2: Synthesis of Compound 3

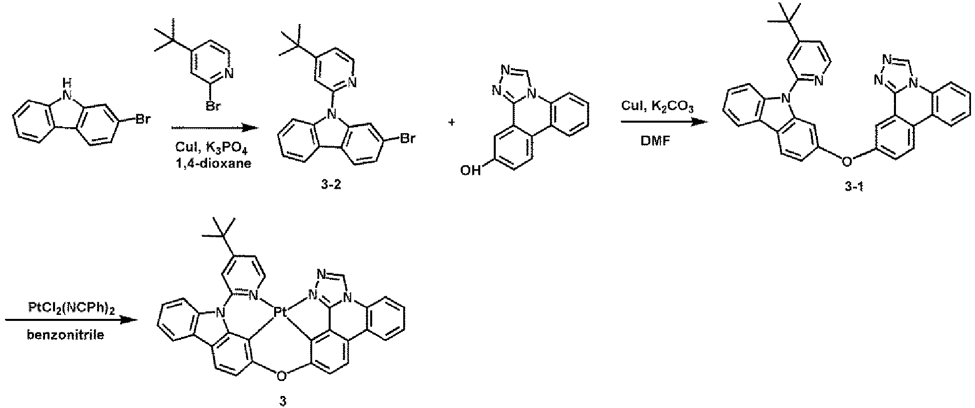

### Synthesis of Intermediate 3-2

61.0 mmol (15 g) of 2-bromo-9H-carbazole, 91.4 mmol (19.6 g) of 2-bromo-4-(tert-butyl)pyridine, 30.5 mmol (5.8 g) of Cul, 91.4 mmol (19.4 g) of K₃PO₄, and 61.0 mmol (7.0 g) of 1,2-diaminocyclohexane were mixed with 225 mL of 1,4-dioxane, and the mixture was stirred at a temperature of 120°C for 12 hours. The obtained reaction product was cooled, and the organic layer was extracted therefrom by using a mixture including ethyl acetate and water. The reaction product was washed three times with water, dried by using magnesium sulfate, and the solvent was removed therefrom under reduced pressure. The resulting crude product was purified by silica gel column chromatography (eluent: dichloromethane and hexane) to obtain Intermediate 3-2 (yield: 68%).
MALDI-TOF (m/z): 379.07 [M]+

### Synthesis of Intermediate 3-1

Intermediate 3-1 (yield of 28%) was obtained in the same manner as Intermediate 2-1 of Synthesis Example 1, except that Intermediate 3-2 was used instead of Intermediate 2-2.
MALDI-TOF (m/z): 534.22 [M]⁺

### Synthesis of Compound 3

Compound 3 (yield of 34%) was obtained in the same manner as Compound 2 of Synthesis Example 1, except that Intermediate 3-1 was used instead of Intermediate 2-1.
MALDI-TOF (m/z): 727.16 [M]+

### Synthesis Example 3: Synthesis of Compound 4

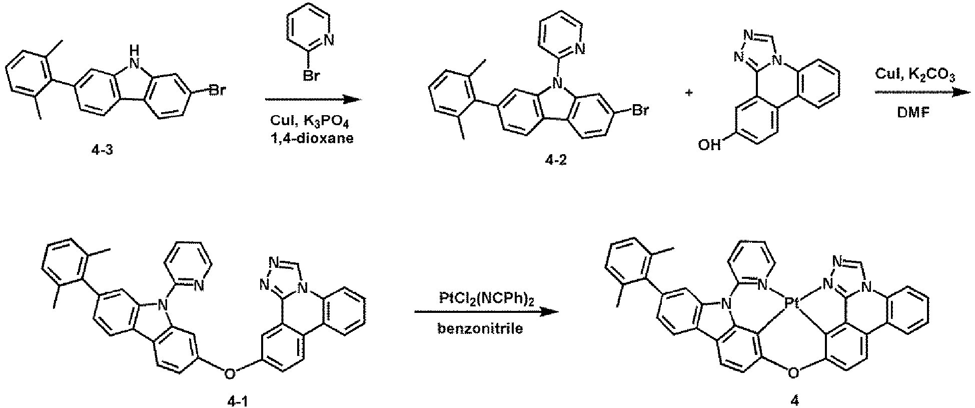

### Synthesis of Intermediate 4-2

Intermediate 4-2 was obtained in the same manner as Intermediate 2-2 of Synthesis Example 1, except that Compound 4-3 was used instead of 2-bromo-9H-carbazole, as a starting material.

### Synthesis of Intermediate 4-1

Intermediate 4-1 was obtained in the same manner as Intermediate 2-1 of Synthesis Example 1, except that Intermediate 4-2 was used instead of Intermediate 2-2. Synthesis of Compound 4

Compound 4 (yield of 34%) was obtained in the same manner as Compound 2 of Synthesis Example 1, except that Intermediate 4-1 was used instead of Intermediate 2-1.
MALDI-TOF (m/z): 775.17 [M]+

### Synthesis Example 4: Synthesis of Compound 17

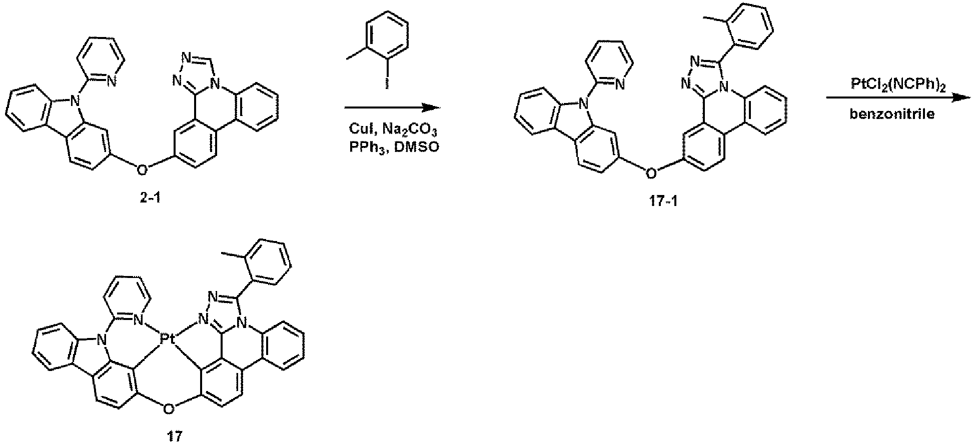

### Synthesis of Intermediate 17-1

5.9 mmol (2.8 g) of Intermediate 2-1, 6.4 mmol (1.4 g) of 1-iodotoluene, 5.9 mmol (1.1 g) of Cul, 11.7 mmol (1.2 g) of Na₂CO₃, and 1.2 mmol (0.3 g) of triphenylphosphine were mixed with 30 mL of dimethyl sulfoxide, and the mixture was stirred at a temperature of 160°C for 12 hours. The obtained reaction product was cooled, and the organic layer was extracted therefrom by using a mixture including ethyl acetate and water. The reaction product was washed three times with water, dried by using magnesium sulfate, and the solvent was removed therefrom under reduced pressure. The resulting crude product was purified by silica gel column chromatography (eluent: ethylacetate and hexane) to obtain Intermediate 17-1 (yield: 30%).
MALDI-TOF (m/z): 568.20 [M]⁺

### Synthesis of Compound 17

Compound 17 (yield of 47%) was obtained in the same manner as Compound 2 of Synthesis Example 1, except that Intermediate 17-1 was used instead of Intermediate 2-1.
MALDI-TOF (m/z): 761.16 [M]⁺

### Evaluation Example 1: T₁ energy level evaluation

The T₁ energy levels of compounds were evaluated according to the method shown in Table 2 below, and the results are summarized in Table 3.

**Table 2**

| | |
|---|---|
| T₁ energy level evaluation method | A mixture of 2-MeTHF and each compound (each compound dissolved in 3 mL of 2-MeTHF was controlled to be at a concentration of 10 millimolar, mM) was placed in a quartz cell, and the result was placed in a liquid nitrogen (77 Kelvins, K)-containing cryostat (Oxford, DN), and the phosphorescence spectrum was measured by using a luminescence measuring instrument (PTI, Quanta Master 400). From the peak wavelength of the phosphorescence spectrum, a triplet energy level was calculated. |

**Table 3**

| Compound No. | T₁ energy level (eV) |
|---|---|
| 2 | 2.71 |
| 3 | 2.71 |
| 4 | 2.69 |
| 17 | 2.70 |
| A | 2.68 |

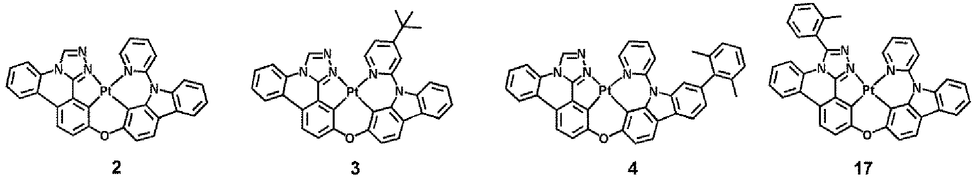

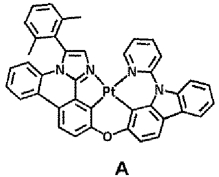

From Table 3, it is seen that Compounds 2, 3, 4 and 17 each have a T₁ energy level that is higher than that of Compound A.

### Evaluation Example 2: Photoluminescence (PL) spectrum evaluation

Compound 2 was diluted in toluene to obtain the concentration of 10 mM, and then, PL spectrum thereof was measured at room temperature by using a Xenon lamp-mounted ISC PC1 Spectrofluorometer. The same experiment was performed on each of Compounds 3, 4, and 17. Results thereof are shown in Table 4. The PL spectra of Compounds 3 and 17 are shown in FIG. 2.

**Table 4**

| Compound No. | Maximum emission wavelength (nm) | FWHM (nm) |
|---|---|---|
| 2 | 458 | 39 |
| 3 | 458 | 38 |
| 4 | 461 | 35 |
| 17 | 459 | 44 |

From Table 4, it is seen that Compounds 2, 3, 4, and 17 emit deep blue light with a small FWHM.

### Evaluation Example 3: Evaluation of PLQY

8 weight% PMMA in CH₂Cl₂ solution was mixed with a mixture including CBP and Compound 3 (Compound 3 in an amount of 10 parts by weight based on 100 parts by weight of the mixture), and the result was coated on a quartz substrate by using a spin coater, and then, heat treated in an oven at a temperature of 80°C, and cooled to room temperature, thereby obtaining a film.

The photoluminescence quantum yields in the film was evaluated by using a Hamamatsu Photonics absolute PL quantum yield measurement system equipped with a xenon light source, a monochromator, a photonic multichannel analyzer, and an integrating sphere, and using a PLQY measurement software (Hamamatsu Photonics, Ltd., Shizuoka, Japan). By doing so, the PLQY in the film of Compound 3 was confirmed.

The same experiment was performed by using Compound 17 to confirm the PLQY in the films of Compound 3 and 17. Results thereof are summarized in Table 5 below.

**Table 5**

| Compound No. | PLQY in film |
|---|---|
| 3 | 0.446 |
| 17 | 0.661 |

From Table 5, it is seen that Compounds 3 and 17 each have a high PLQY value.

### Example 1

A glass substrate with a 1,500 Å-thick ITO (Indium tin oxide) electrode (first electrode, anode) formed thereon was washed with distilled water and ultrasonic waves. When the washing with distilled water was completed, sonification washing was performed using iso-propyl alcohol, acetone, and methanol, which were separately used sequentially. The resultant was dried and transferred to a plasma washer. The resulting substrate was washed with oxygen plasma for 5 minutes and transferred to a vacuum depositing device.

Compound HT3 was vacuum deposited on the ITO electrode on the glass substrate to form a first hole injection layer having a thickness of 3,500 Å, Compound HT-D1 was vacuum deposited on the first hole injection layer to form a second hole injection layer having a thickness of 300 Å, and TAPC was vacuum deposited on the second hole injection layer to form an electron blocking layer having a thickness of 100 Å, thereby completing the formation of a hole transport region.

On the hole transport region, Compound H52 and Compound 17 (dopant, 10wt% based on total weight of Compound H52 and Compound 17) were co-deposited to form an emission layer having a thickness of 300 Å.

Thereafter, Compound ET3 was vacuum-deposited on the emission layer to form an electron transport layer having a thickness of 250 Å, ET-D1 (LiQ) was deposited on the electron transport layer to form an electron injection layer having a thickness of 5 Å, and an Al second electrode (cathode) having a thickness of 1,000 Å was formed on the electron injection layer, thereby completing the manufacture of an organic light-emitting device.

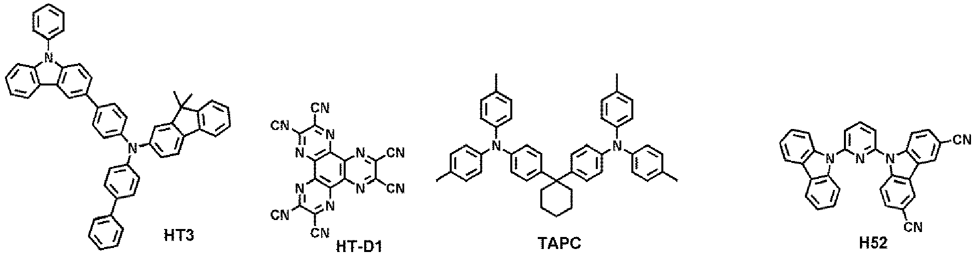

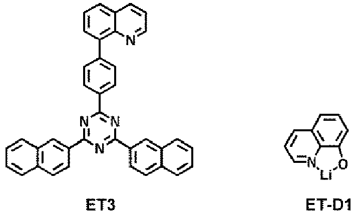

### Comparative Example A

An organic light-emitting device was manufactured in the same manner as in Example 1, except that in forming an emission layer, as a dopant, Compound A was used instead of Compound 17.

### Evaluation Example 4: Evaluation on characteristics of organic light-emitting devices.

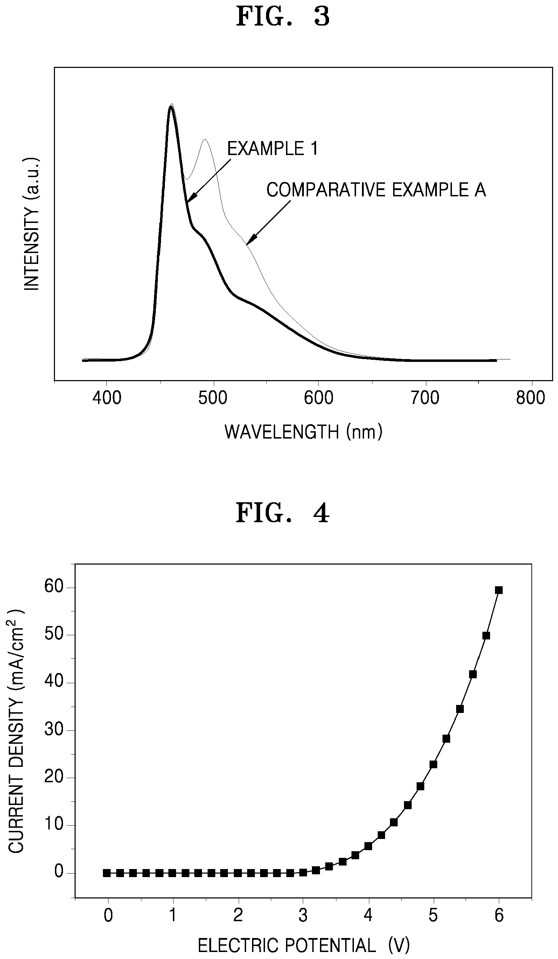

The EL spectra, CIE color coordinates, driving voltage, maximum external quantum luminescence efficiency, current efficiency and conversion efficiency of each of the organic light-emitting devices manufactured according to Example 1 and Comparative Example A were evaluated. Details of the evaluation method are provided below, and results thereof are shown in Table 6. FIG. 3 shows the EL spectra of the organic light-emitting devices of Example 1 and Comparative Example A, and FIG. 4 shows a driving voltage-current density of Example 1.

### (1) EL spectra measurement

The EL spectra of the organic light-emitting devices were measured at a luminance of 500 candelas per square meter (cd/m²) by using a luminance meter (Minolta Cs-1000A), and the obtained result was evaluated in terms of maximum emission wavelength and FWHM.

### (2) Measurement of change in current density with respect to voltage

Regarding the manufactured organic light-emitting devices, a current flowing in an organic light-emitting device was measured by using a current-voltage meter during a voltage was raised from 0 volts (V) to 10 V, and the measured current value was divided by an area

### (3) Measurement of change in luminance with respect to voltage

Regarding the manufactured organic light-emitting devices, luminance was measured by using Minolta Cs-1,000 A during a voltage was raised from 0 V to 10 V.

### (4) Conversion efficiency measurement

Current efficiency (candelas per ampere, cd/A) was measured at the same current density (10 milliamperes per square centimeter, mA/cm²) by using luminance, current density, and voltage measured according to (2) and (3). Next, the current efficiency was divided by y value of the CIE color coordinates measured in (6) to obtain conversion efficiency.

### (5) Measurement of external quantum efficiency

This evaluation was performed by using a current-voltmeter (Keithley 2400) and a luminance meter (Minolta Cs-1000A).

**Table 6**

| | Dopant | Maximum emission wavelength (nm) | FWHM (nm) | CIE Color coordinate (x, y) | Driving voltage (V) | Maximum external quantum luminescence efficiency EQEmax (%) | Conversion Efficiency (Current Efficiency / CIE_{y}) |
|---|---|---|---|---|---|---|---|
| Example 1 | 17 | 464 | 38 | 0.189,0.26 6 | 3.99 | 12.9 | 67 |
| Comparative Example A | A | 462 | 86 | 0.228,0.35 6 | 7.1 | 7.8 | 52 |

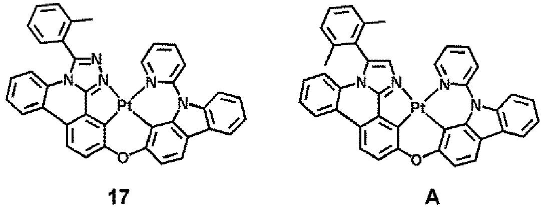

From Table 6, FIG. 3, and FIG. 4, it is seen that the organic light-emitting device of Example 1 emits, compared to the organic light-emitting device of Comparative Example A, deep blue light having a narrow FWHM and excellent color purity, and have low driving voltage, high maximum external quantum luminance efficiency, and high conversion luminance efficiency.

Organometallic compounds according to the present disclosure has excellent electrical and/or thermal stability, and thus, when used in an organic light-emitting device, it may provide improved characteristics in terms of driving voltage, luminous efficiency, external quantum efficiency, conversion efficiency, and a lifespan. Such organometallic compounds have excellent phosphorescent luminescent characteristics, and thus, when used, a diagnostic composition having a high diagnostic efficiency may be provided.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present description as defined by the following claims.

## Claims

1. An organometallic compound represented by Formula 1: 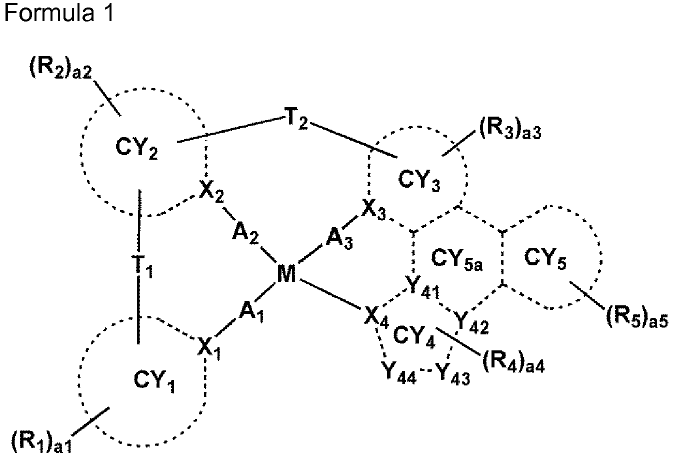
wherein, in Formula 1,
M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
X₁ to X₄, Y₄₁, and Y₄₂ are each independently C or N,
Y₄₃ and Y₄₄ are each independently C, N, O, S, or Si,
A₁ to A₃ are each independently a chemical bond, O, S, B(R'), N(R'), P(R'), C(R')(R"), Si(R')(R"), Ge(R')(R"), C(=O), B(R')(R"), N(R')(R"), or P(R')(R"), wherein, when A₁ is a chemical bond, X₁ is directly bonded to M; when A₂ is a chemical bond, X₂ is directly bonded to M; and when A₃ is a chemical bond, X₃ is directly bonded to M,
two selected from a bond between X₁ or A₁ and M, a bond between M and X₂ or A₂, a bond between X₃ or A₃ and M, and a bond between X₄ and M are coordinate bonds, and the remaining two bonds are covalent bonds,
ring CY₁ to ring CY₃ and ring CY₅ are each independently a C₅-C₃₀ carbocyclic group or a C₁-C₃₀ heterocyclic group,
ring CY₄ is a 5-membered ring, and three or more selected from X₄, Y₄₁, Y₄₂, Y₄₃, and Y₄₄ of ring CY₄ are each N,
ring CY₅ₐ is a 6-membered ring,
T₁ is a single bond, a double bond, *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', or *-C≡C-*',
T₂ is a single bond, a double bond, *⁻N(R₈)-*', *-B(R₈)-*', *-P(R₈)-*', *-C(R₈)(R₉)-*', *-Si(R₈)(R₉)*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C≡C-*',
R₁ to R₉, R', and R" are each independently selected from hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₇-C₆₀ aryl alkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroaryl alkyl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and-P(=O)(Q₈)(Q₉),
a1 to a3 and a5 are each independently an integer of 0 to 20,
a4 is an integer from 0 to 2,
two of a plurality of neighboring groups R₁ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of a plurality of neighboring groups R₅ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two of R₁ to R₉, R', and R" are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₁,
* and *" each indicate a binding site to a neighboring atom,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₇-C₆₀ aryl alkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroaryl alkyl group, the substituted C₂-C₆₀ alkyl heteroaryl group, the substituted monovalent non-aromatic condensed polycyclic group, and the substituted monovalent non-aromatic condensed heteropolycyclic group is selected from:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I,-CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -B(Q₁₆)(Q₁₇) and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂,-CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, a monovalent non-aromatic condensed heteropolycyclic group, -N(Q₂₁)(Q₂₂),-Si(Q₂₃)(Q₂₄)(Q₂₅), -B(Q₂₆)(Q₂₇), and -P(=O)(Q₂₆)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉);
wherein Q₁ to Q₉, Q₁₁ to Q₁₉, Q₂₁ to Q₂₉, and Q₃₁ to Q₃₉ are each independently selected from hydrogen, deuterium, -F, -CI, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C₆-C₆₀ aryloxy group, a C₆-C₆₀ arylthio group, a C₇-C₆₀ aryl alkyl group, a C₁-C₆₀ heteroaryl group, a C₁-C₆₀ heteroaryloxy group, a C₁-C₆₀ heteroarylthio group, a C₂-C₆₀ heteroaryl alkyl group, a C₂-C₆₀ alkyl heteroaryl group, a monovalent non-aromatic condensed polycyclic group, and a monovalent non-aromatic condensed heteropolycyclic group.

2. The organometallic compound of claim 1, wherein
M is Pt, Pd, or Au; and/or
wherein
ring CY₁ is an oxazole group, an isoxazole group, an oxadiazole group, an isoxadiazole group, an oxatriazole group, a thiazole group, an isothiazole group, a thiadiazole group, an isothiadiazole group, a thiatriazole group, a pyrazole group, an imidazole group, a triazole group, a tetrazole group, an azasilole group, a diazasilole group, a triazasilole group, a benzimidazole group, a benzoxazole group, a benzthiazole group, a benzene group, a pyridine group, a pyrimidine group, a pyrazine group, a pyridazine group, a triazine group, a carbazole group, or an azacarbazole group,
ring CY₂ is a benzene group, a pyridine group, a pyrimidine group, a pyrazine group, a pyridazine group, a triazine group, a carbazole group, or an azacarbazole group,
ring CY₃ and ring CY₅ are each independently a benzene group, a pyridine group, a pyrimidine group, a pyrazine group, a pyridazine group, or a triazine group, and
ring CY₄ is a triazole group or a tetrazole group; and/or
wherein
R₁ to R₉, R', and R" are each independently selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-N(Q₁)(Q₂), -Si(Q₃)(Q₄)(Q₅), -B(Q₆)(Q₇) and -P(=O)(Q₈)(Q₉); and
Q₁ to Q₉ are each independently selected from:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CH₃, -CD₂CD₃, -CD₂CD₂H, and -CD₂CDH₂;
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a C₁-C₁₀ alkyl group, and a phenyl group.

3. The organometallic compound of claim 1 or 2, wherein the organometallic compound satisfies
a) one of Condition 1, Condition 2, and Condition 3;
b) one of Condition 4 and Condition 5; or
c) one of Condition 1, Condition 2, and Condition 3, and one of Condition 4 and Condition 5:
Condition 1
A₁ and A₂ are each a chemical bond,
a moiety represented by 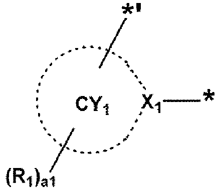 is represented by Formula A1-1,
T₁ is *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', or *-C≡C-*', a moiety represented by 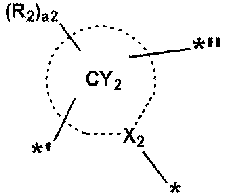 is represented by Formula A2-1,
Condition 2
A₁ and A₂ are each a chemical bond,
a moiety represented by 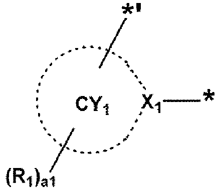 is represented by Formula A1-2,
T₁ is a single bond, a moiety represented by 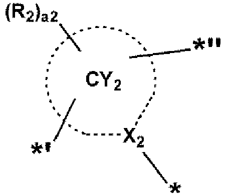 is represented by Formula A2-1,
Condition 3
A₁ and A₂ are each a chemical bond,
a moiety represented by 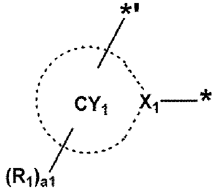 is represented by Formula A1-1,
T₁ is a single bond, a moiety represented by 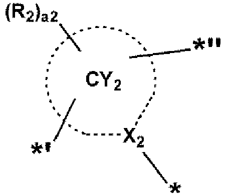 is represented by Formula A2-3,
Condition 4
A₂ and A₃ are each a chemical bond,
a moiety represented by 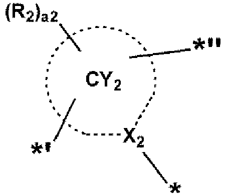 is represented by Formula A2-1,
T₂ is *-N(R₈)-*', *-B(R₈)-*', *-P(R₈)-*', *-C(R₈)(R₉)*', *-Si(R₈)(R₉)*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C≡C-*',
Condition 5
A₂ and A₃ are each a chemical bond,
a moiety represented by 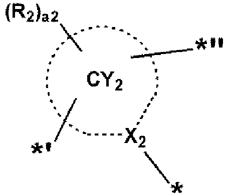 is represented by Formula A2-2,
T₂ is a single bond, 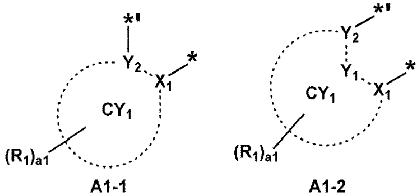 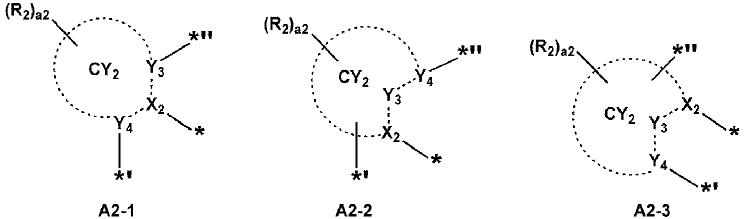
wherein, in Formulae A1-1, A1-2, A2-1, A2-2, and A2-3,
X₁, X₂, ring CY₁, ring CY₂, R₁, R₂, a1, and a2 are the same as described in claim 1, Y₁ to Y₄ are each independently C or N, a bond between X₁ and Y₁, a bond between X₁ and Y₂, a bond between Y₁ and Y₂, a bond between X₂ and Y₄, a bond between X₂ and Y₃, and a bond between Y₃ and Y₄ are each independently a single bond or a double bond,
regarding Formulae A1-1 and A1-2, * indicates a binding site to A₁ or M in Formula 1 and *' indicates a binding site to T₁ in Formula 1, and
regarding Formulae A2-1, A2-2, and A2-3, * indicates a binding site to A₂ or M in Formula 1, *' indicates a binding site to T₁ in Formula 1, and *" indicates a binding site to T₂ in Formula 1.

4. The organometallic compound of any one of claims 1 to 3, wherein
a moiety represented by 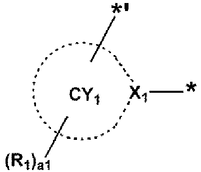 is represented by one of Formulae A1 - 1 (1) to A1-1(54) and A1-2(1) to A1-2(74): 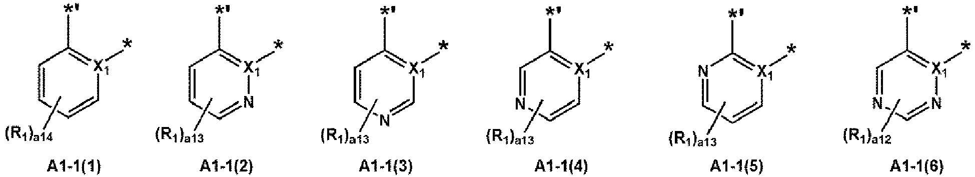 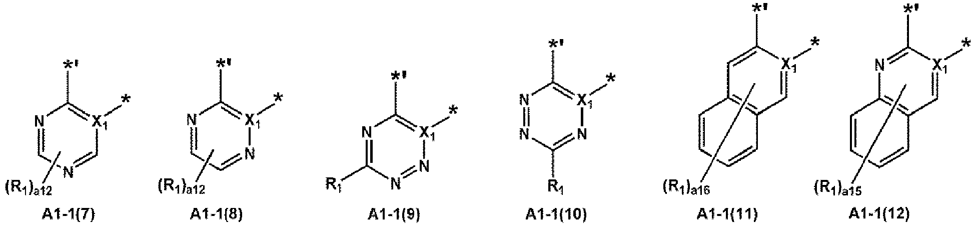 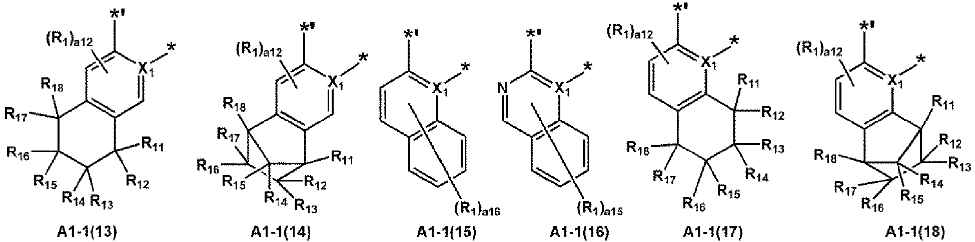 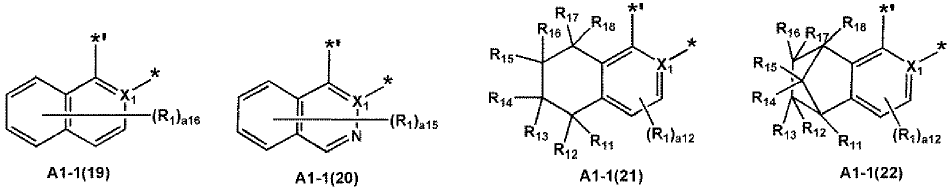 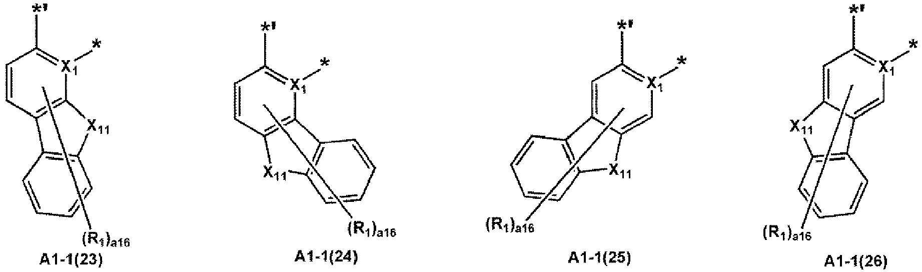 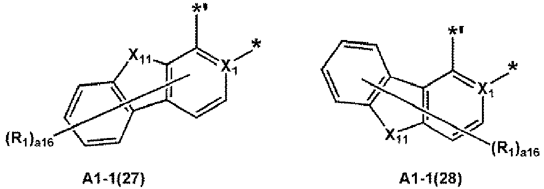 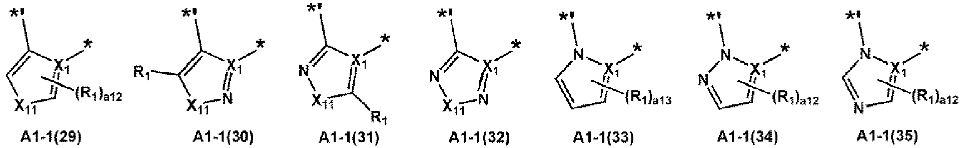 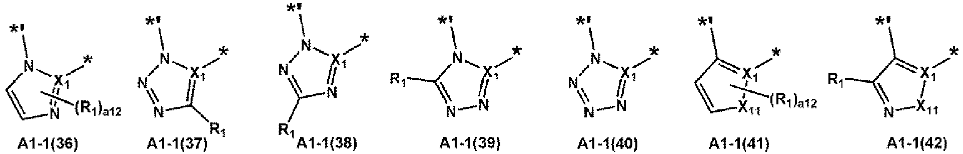 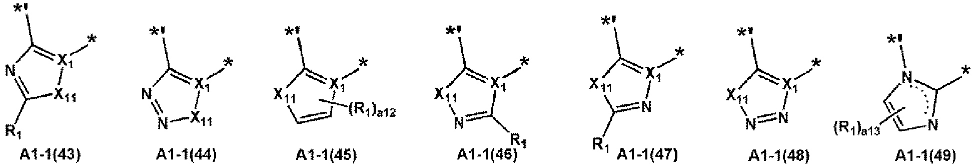 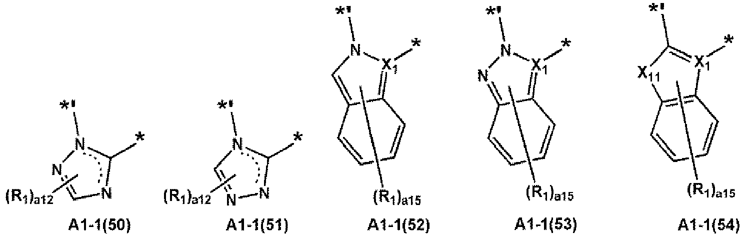 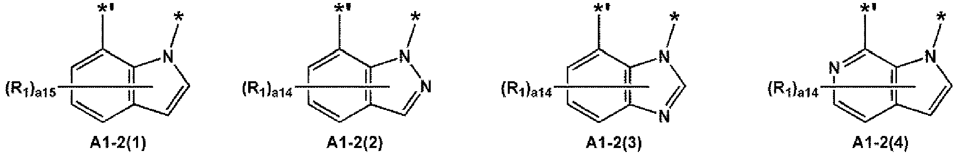 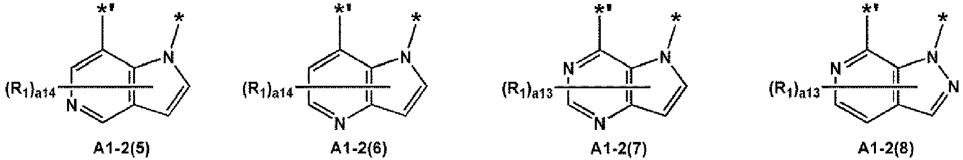 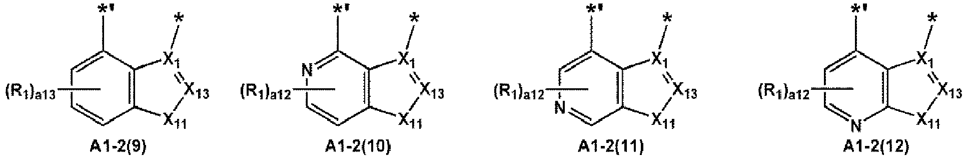 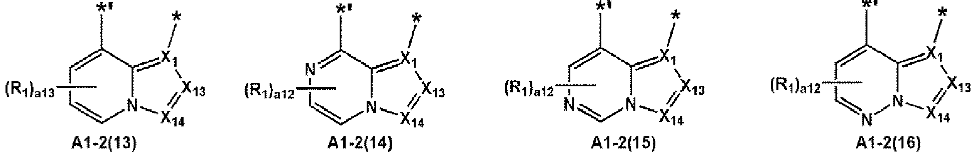 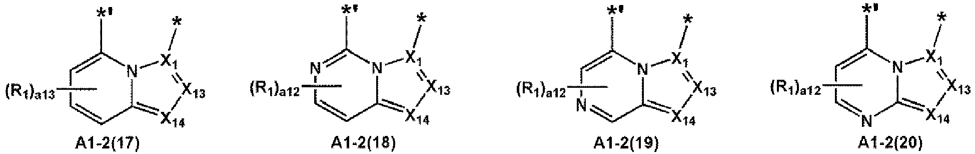 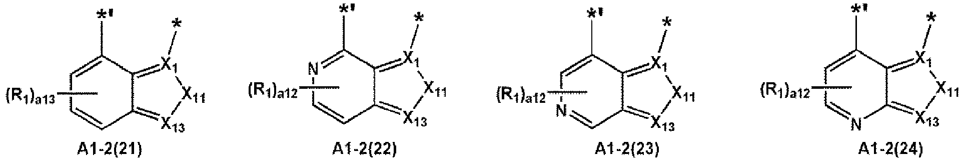 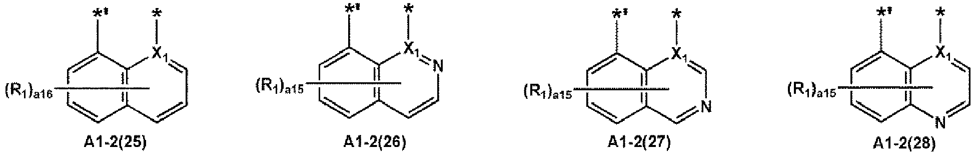 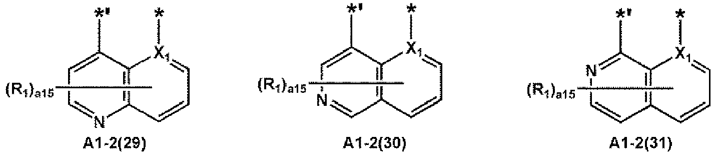 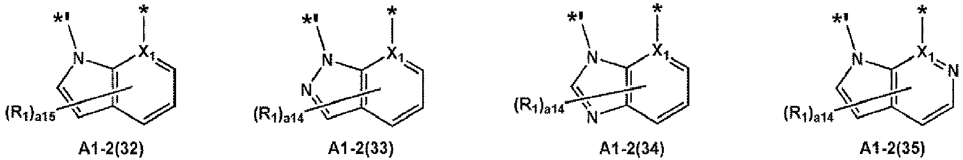 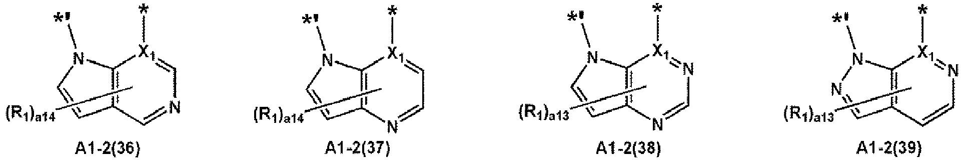 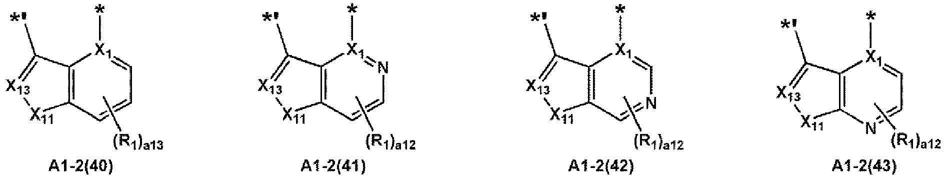 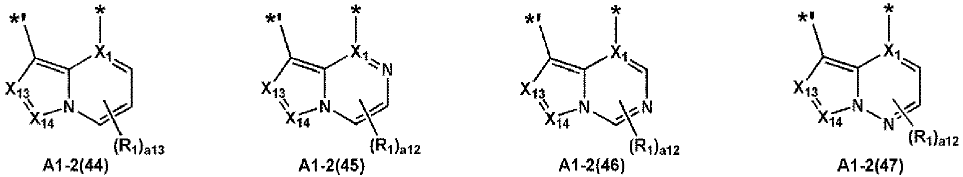 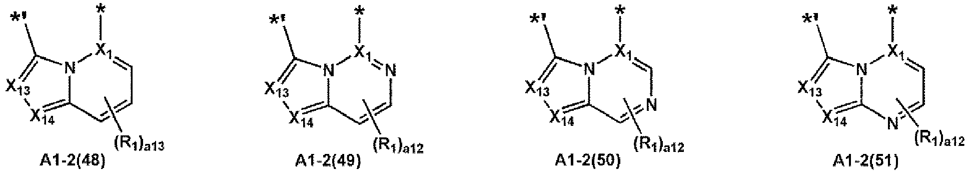 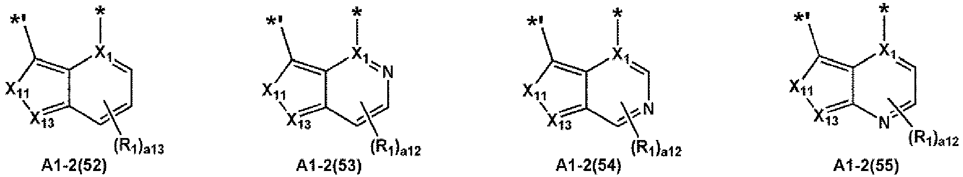 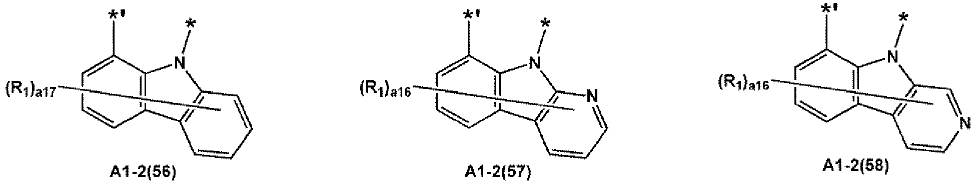 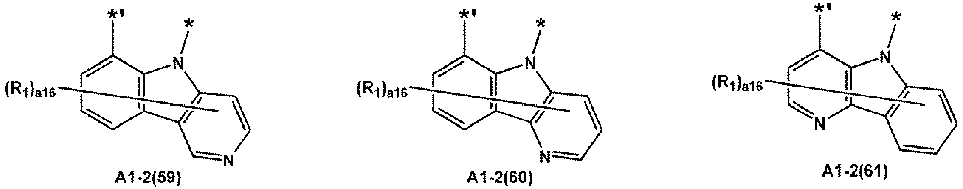 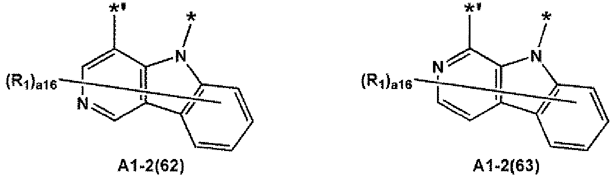 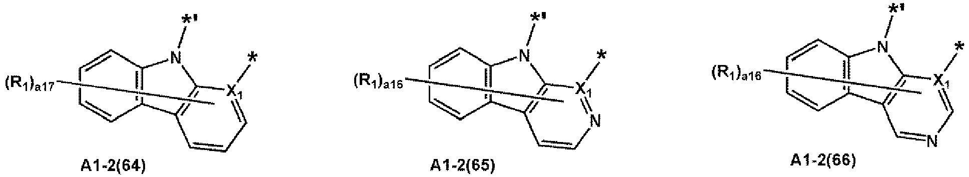 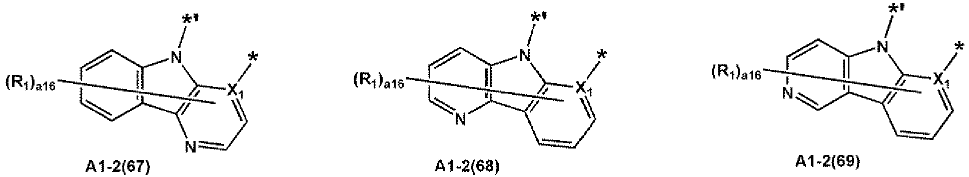 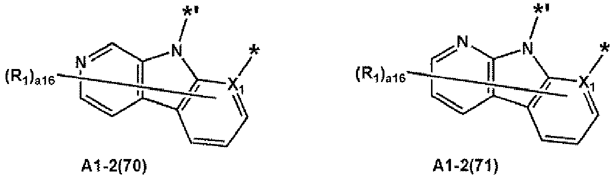 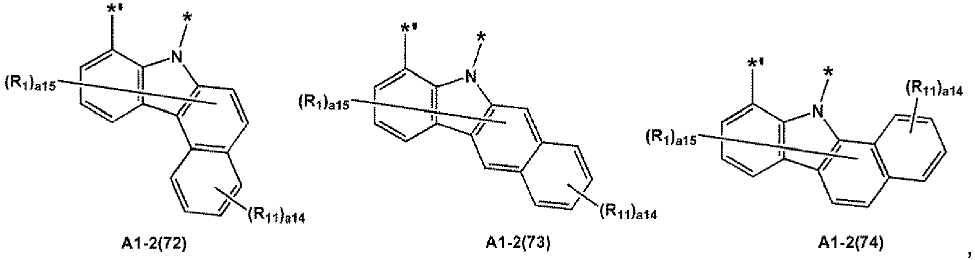
wherein, in Formulae A1-1(1) to A1-1(54) and A1-2(1) to A1-2(74),
X₁ and R₁ are the same as described in connection with claim 1,
X₁₁ is O, S, N(R₁₁), C(R₁₁)(R₁₂), or Si(R₁₁)(R₁₂),
X₁₃ is N or C(R₁₃),
X₁₄ is N or C(R₁₄),
R₁₁ to R₁₈ are the same as described in connection with R₁ in claim 1,
a17 is an integer from 0 to 7,
a16 is an integer from 0 to 6,
a15 is an integer from 0 to 5,
a14 is an integer from 0 to 4,
a13 is an integer from 0 to 3,
a12 is an integer from 0 to 2,
* indicates a binding site to A₁ or M in Formula 1, and
*' indicates a binding site to T₁ in Formula 1.

5. The organometallic compound of any one of claims 1 to 4, wherein
a moiety represented by 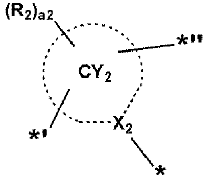 is represented by one of Formulae A2-1(1) to A2-1(17), A2-2(1) to A2-2(58), and A2-3(1) to A2-3(62): 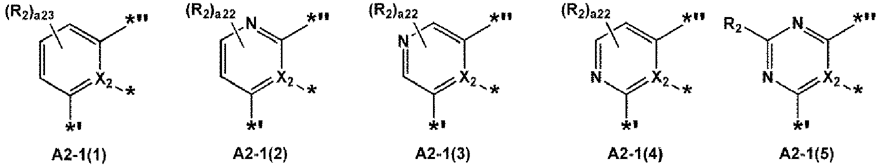 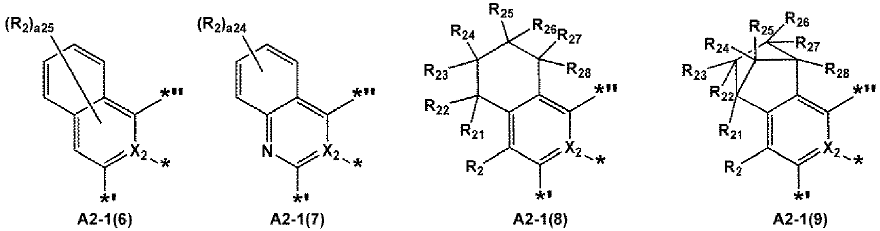 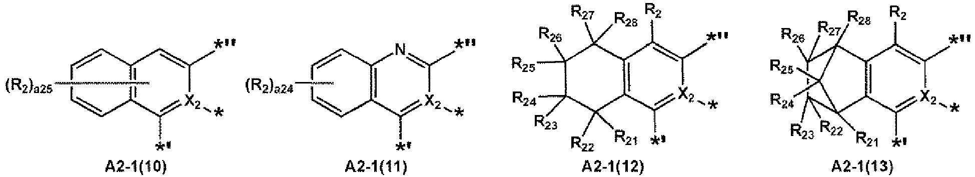 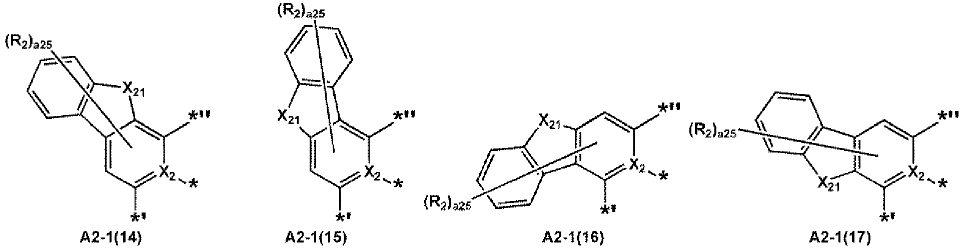 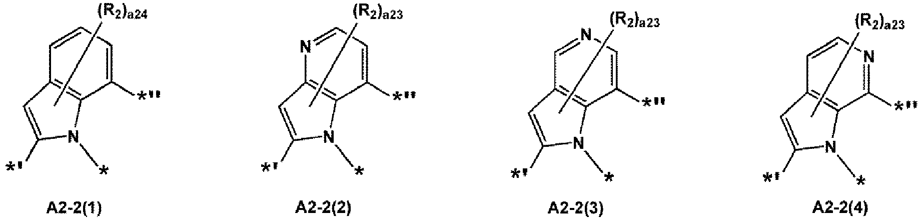 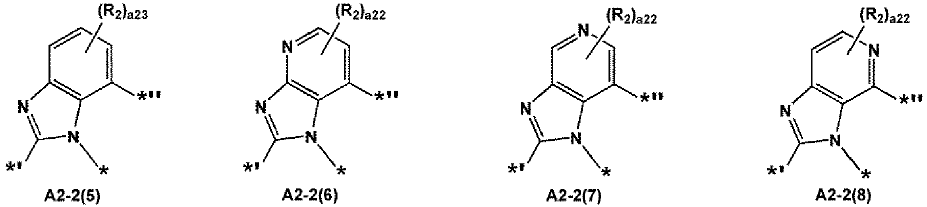 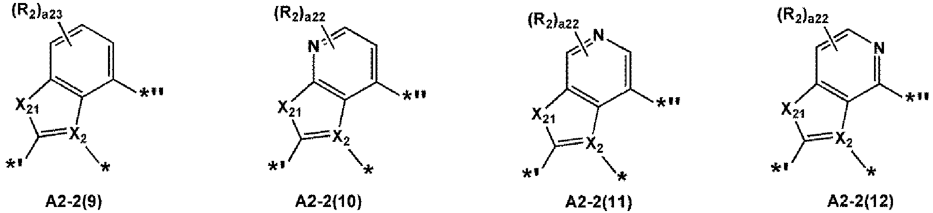 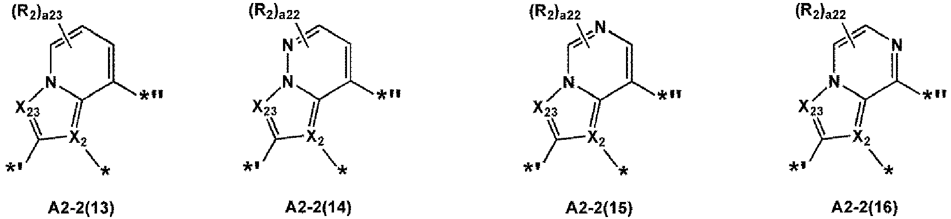 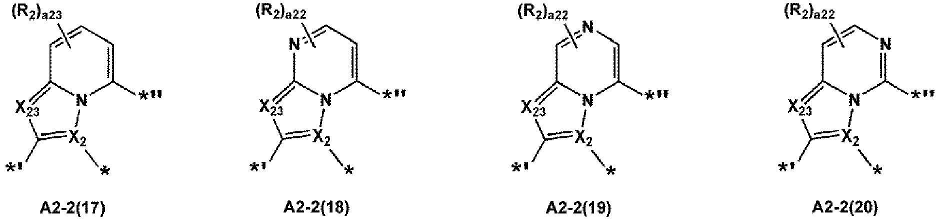 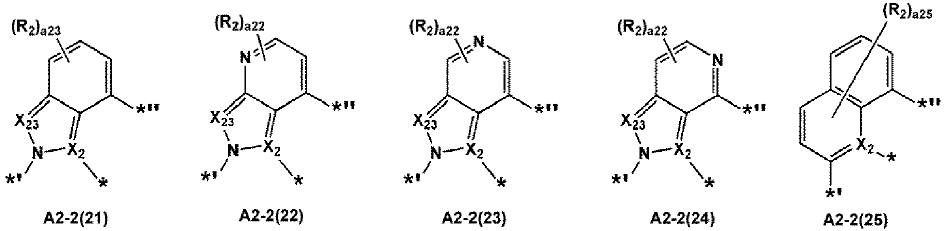 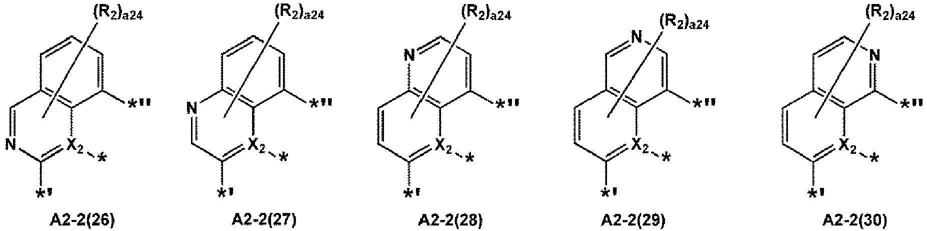 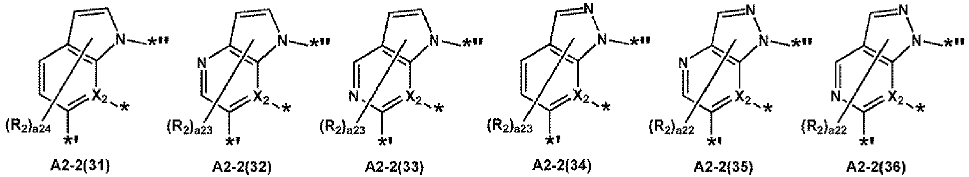 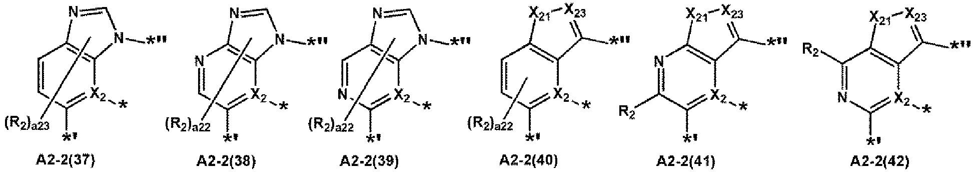 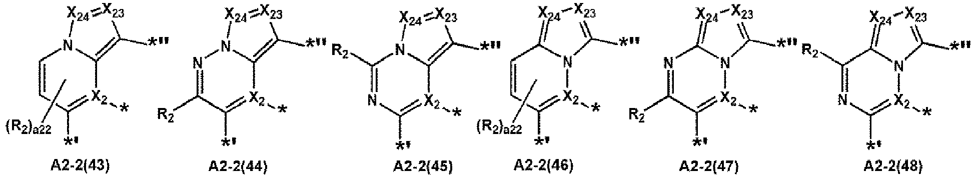 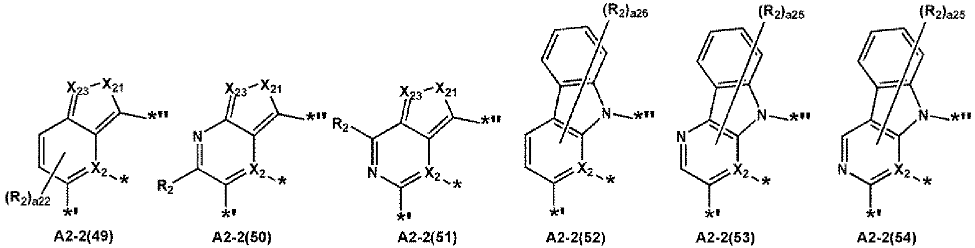 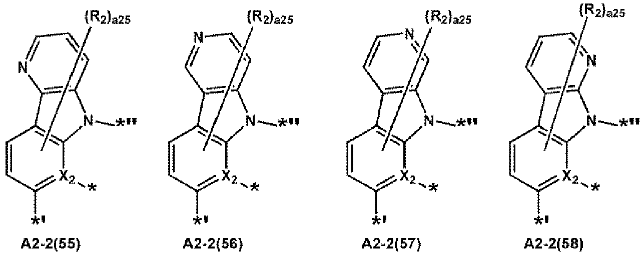 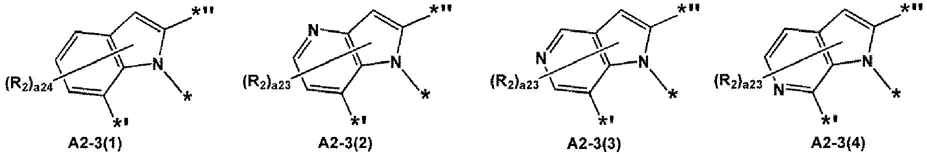 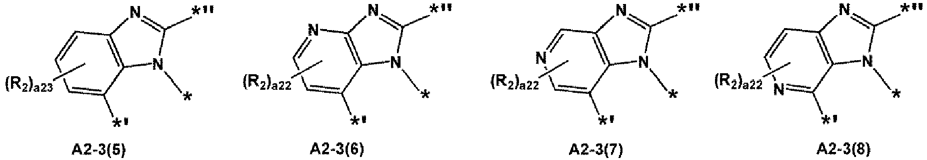 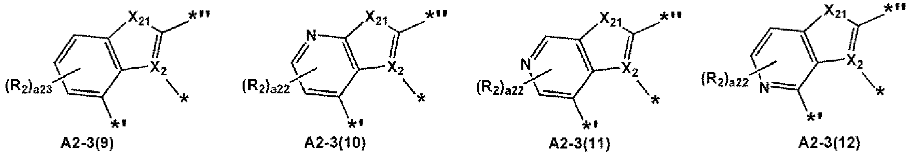 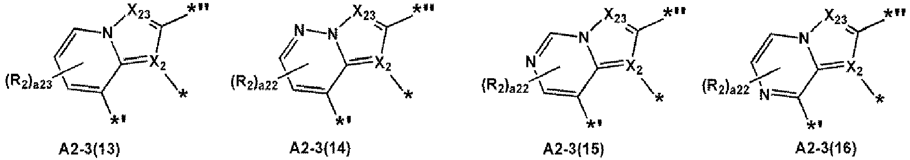 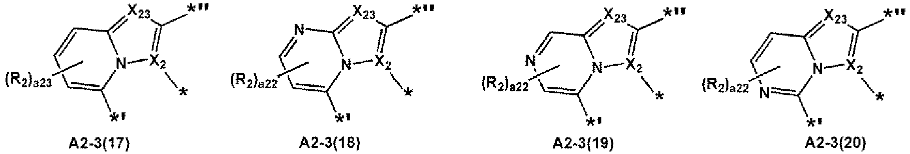 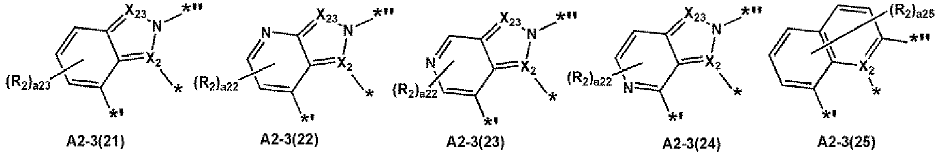 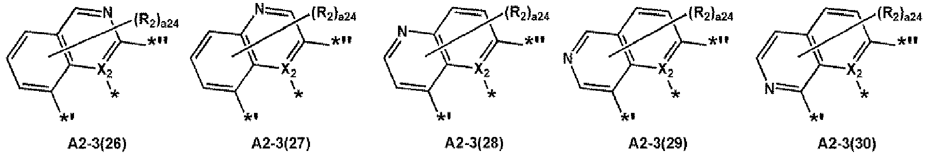 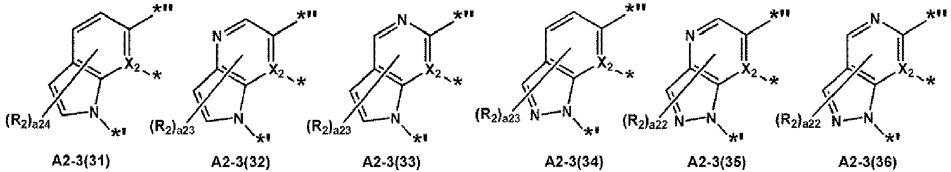 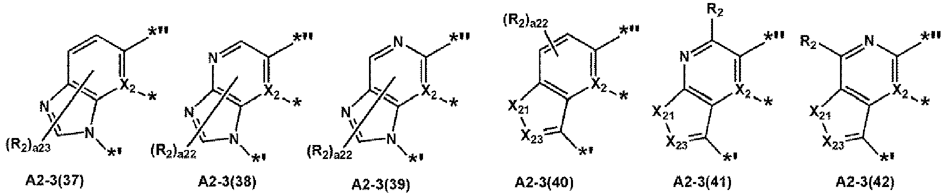 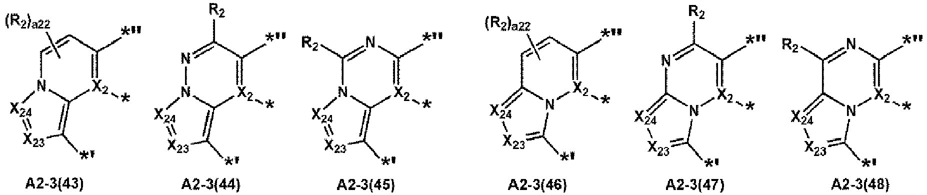 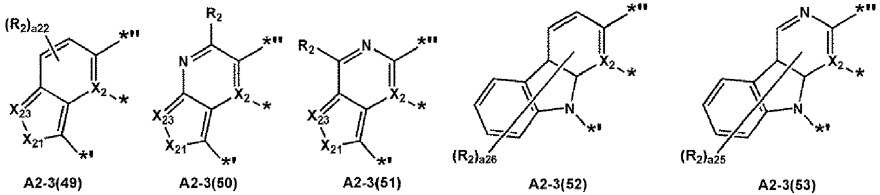 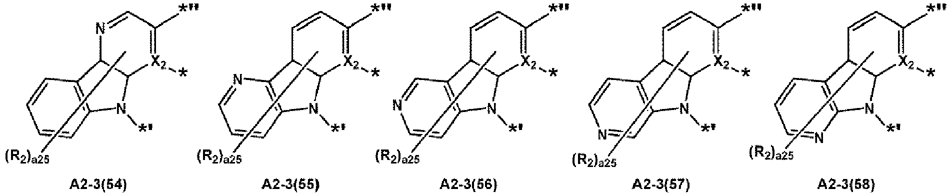 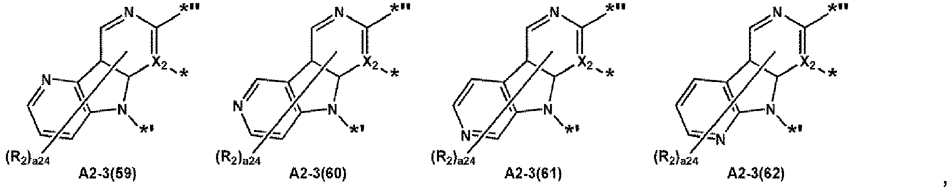
wherein, in Formulae A2-1(1) to A2-1(17), A2-2(1) to A2-2(58), and A2-3(1) to A2-3(62),
X₂ and R₂ are the same as described in connection with claim 1,
X₂₁ is O, S, N(R₂₁), C(R₂₁)(R₂₂), or Si(R₂₁)(R₂₂),
X₂₃ is N or C(R₂₃),
X₂₄ is N or C(R₂₄),
R₂₁ to R₂₈ are the same as described in connection with R₂ in claim 1,
a26 is an integer from 0 to 6,
a25 is an integer from 0 to 5,
a24 is an integer from 0 to 4,
a23 is an integer from 0 to 3,
a22 is an integer from 0 to 2,
* indicates a binding site to A₂ or M in Formula 1,
*' indicates a binding site to T₁ in Formula 1, and
*" indicates a binding site to T₂ in Formula 1.

6. The organometallic compound of any one of claims 1 to 5, wherein
a moiety represented by 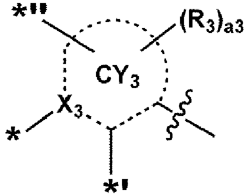 is represented by one of Formulae A3-1(1) to A3-1(12): 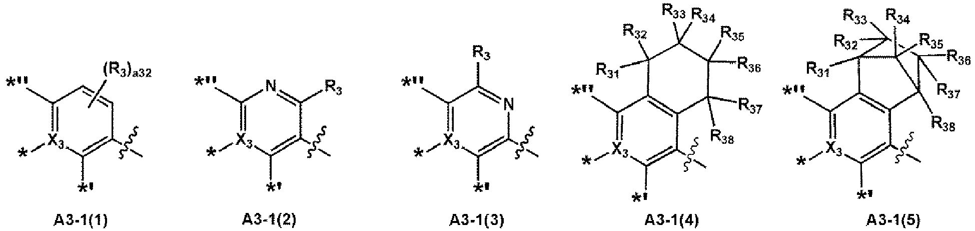 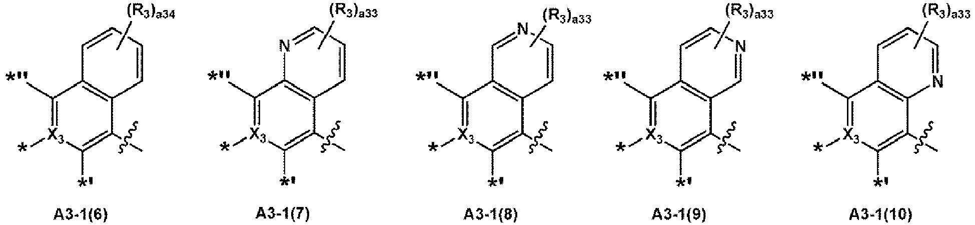 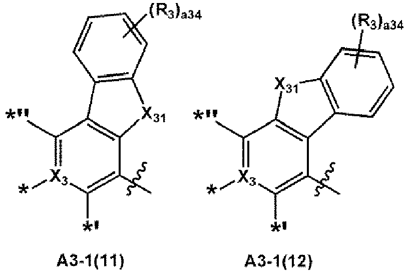
wherein, in Formulae A3-1(1) to A3-1(12),
X₃ and R₃ are the same as described in connection with claim 1,
X₃₁ is O, S, N(R₃₁), C(R₃₁)(R₃₂), or Si(R₃₁)(R₃₂),
R₃₁ to R₃₈ are the same as described in connection with R₃ in claim 1, a34 is an integer from 0 to 4,
a33 is an integer from 0 to 3,
a32 is an integer from 0 to 2,
* indicates a binding site to A₃ or M in Formula 1,
*" indicates a binding site to T₂ in Formula 1,
*' indicates a binding site to Y₄₁ in Formula 1, and
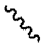 indicates a binding site to ring CY₅ in Formula 1.

7. The organometallic compound of any one of claims 1 to 6, wherein
a moiety represented by 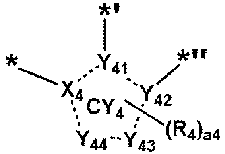 is represented by one of Formulae A4-1(1) to A4-1(12): 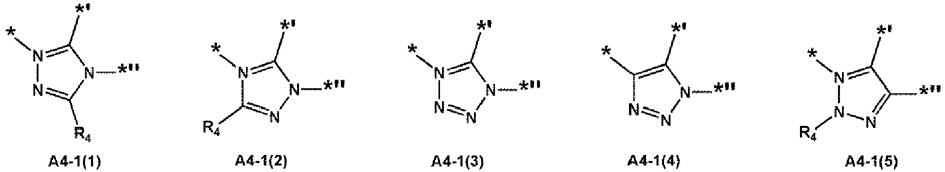 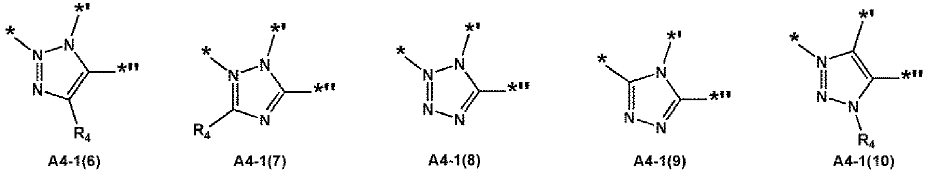 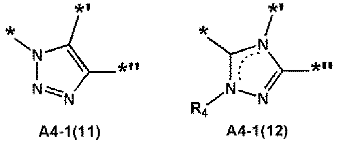
wherein, in Formulae A4-1(1) to A4-1(12),
X₄ and R₄ are the same as described in connection with claim 1,
* indicates a binding site to M in Formula 1,
*' indicates a binding site to ring CY₃ in Formula 1, and
*" indicates a binding site to ring CY₅ in Formula 1.

8. The organometallic compound of any one of claims 1 to 7, wherein
a moiety represented by 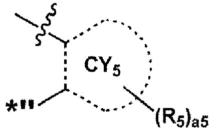 is represented by one of Formulae A5-1(1) to A5-1(8): 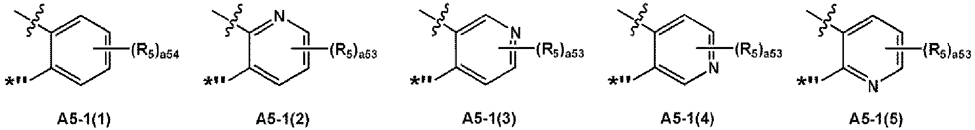 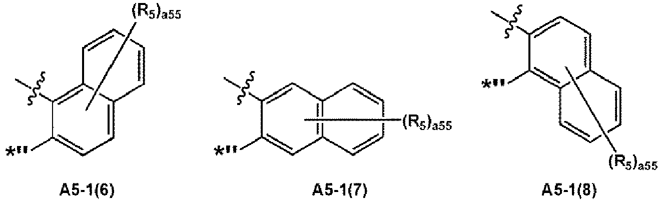
wherein, in Formulae A5-1(1) to A5-1(8),
R₅ is the same as described in connection with claim 1,
a55 is an integer from 0 to 5,
a54 is an integer from 0 to 4,
a53 is an integer from 0 to 3,
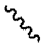 indicates a binding site to ring CY₃ in Formula 1, and
*" indicates a binding site to Y₄₂ in Formula 1.

9. The organometallic compound of any one of claims 1 to 8, wherein
a moiety represented by 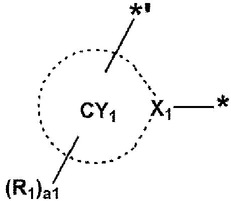 is represented by one of Formulae CY1-1 to CY1-59,
a moiety represented by 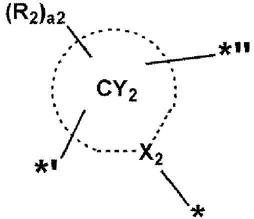 is represented by one of Formulae CY2-1 to CY2-34,
a moiety represented by 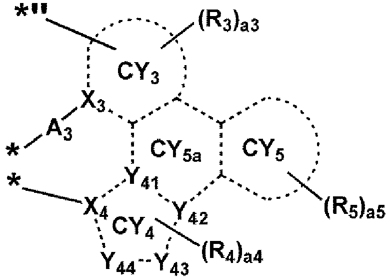 is represented by one of Formulae CY3-1 to CY3-6: 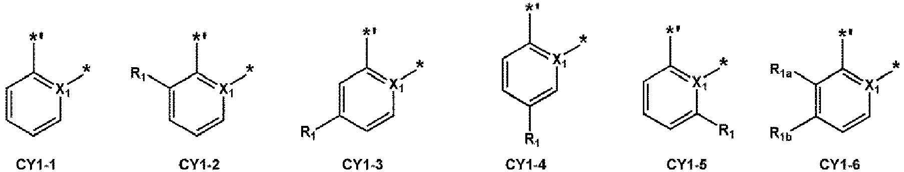 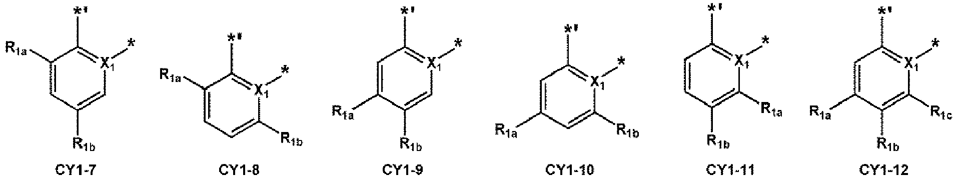 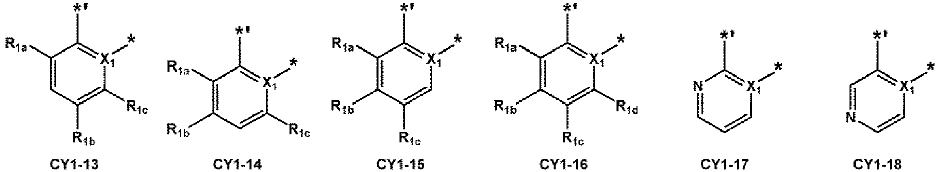 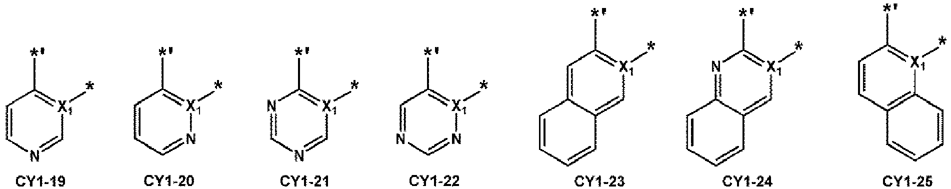 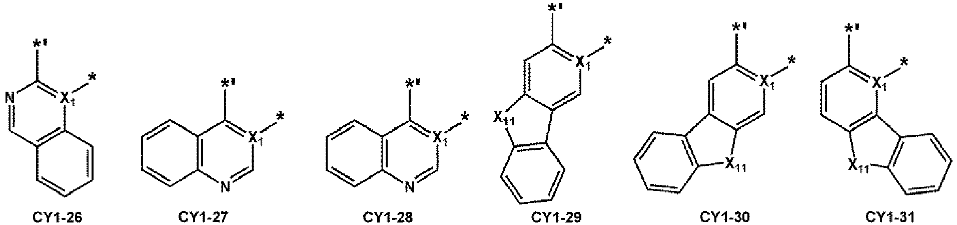 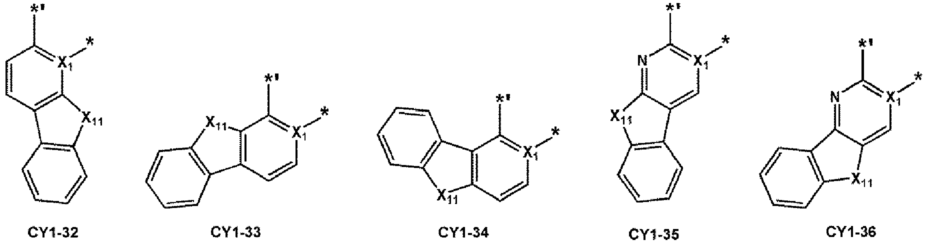 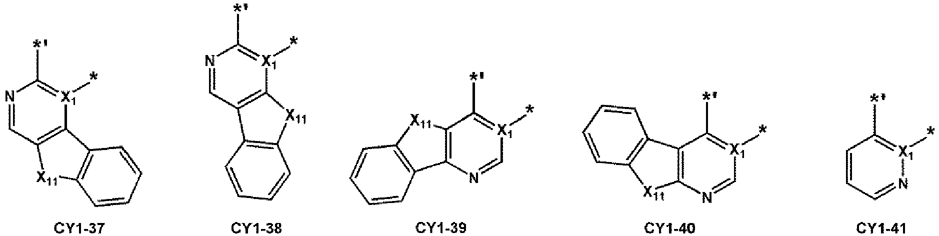 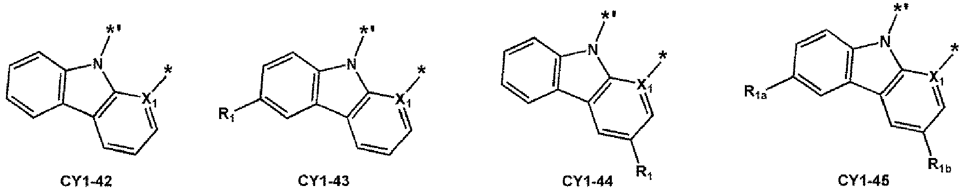 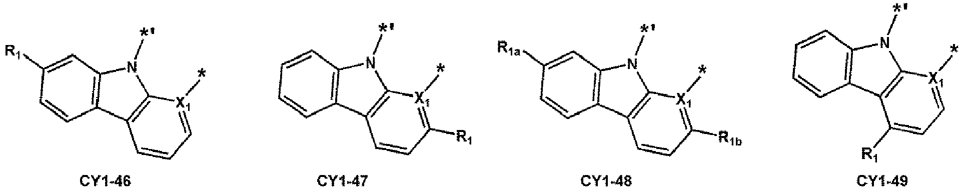 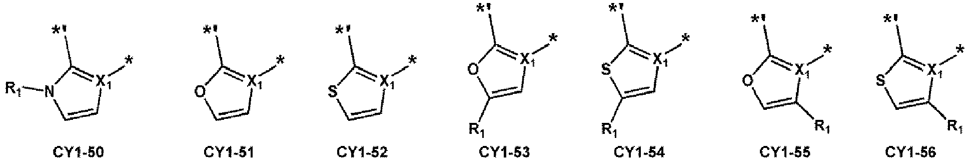 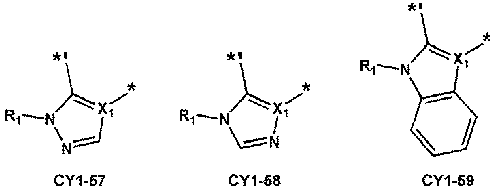 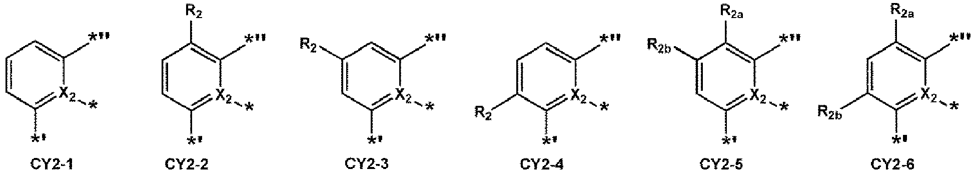 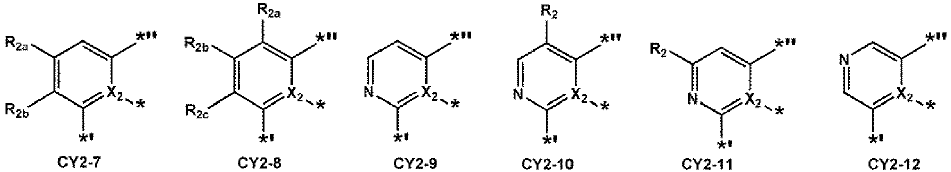 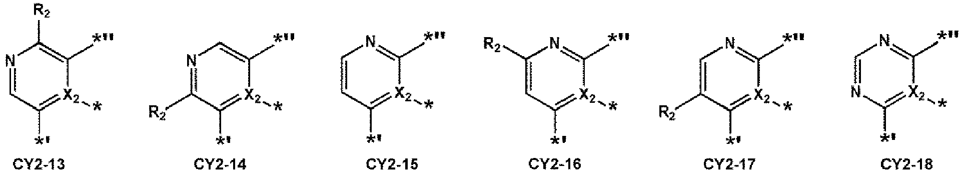 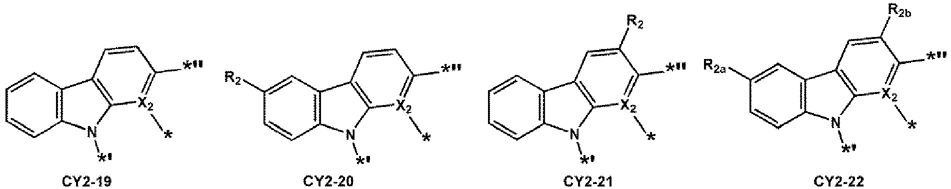 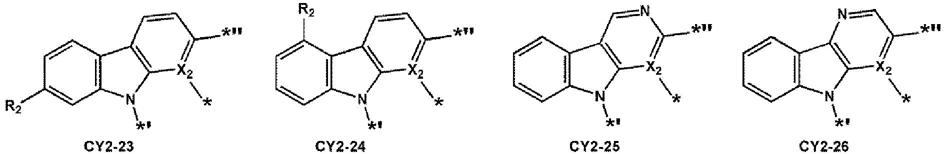 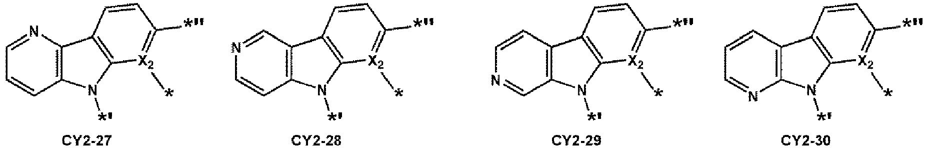 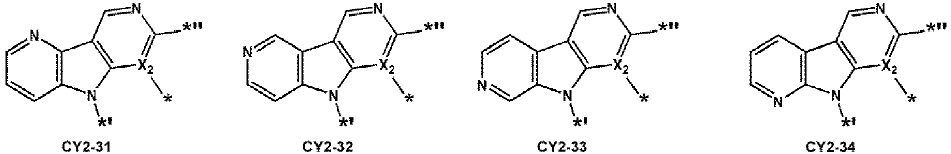 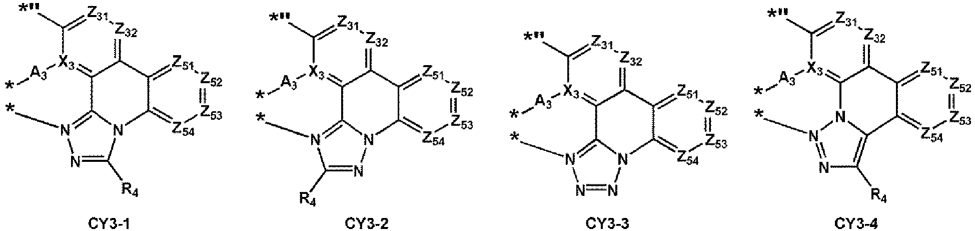 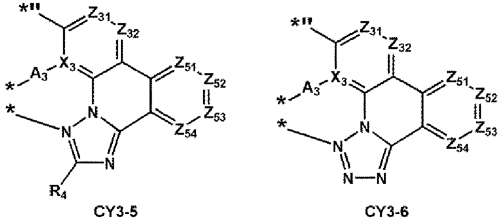
wherein, in Formulae CY1-1 to CY1-59, CY2-1 to CY2-34, and CY3-1 to CY3-6,
A₃, X₁ to X₃, and R₁ to R₄ are the same as described in connection with claim 1,
X₁₁ is O, S, N(R₁₁), C(R₁₁)(R₁₂), or Si(R₁₁)(R₁₂),
R₁ₐ to R_{1d}, R₁₁, and R₁₂ are the same as described in connection with R₁,
R₂ₐ to R_{2c} are the same as described in connection with R₂,
Z₃₁ is N or C(R₃₁), and Z₃₂ is N or C(R₃₂),
R₃₁ and R₃₂ are the same as described in connection with R₃,
Z₅₁ is N or C(R₅₁), Z₅₂ is N or C(R₅₂), Z₅₃ is N or C(R₅₃), Z₅₄ is N or C(R₅₄),
R₅₁ to R₅₄ are the same as described in connection with R₅,
each of R₁, R₂, R₁ₐ to R_{1d}, and R₂ₐ to R_{2c} is not hydrogen,
regarding Formulae CY1-1 to CY1-59, * indicates a binding site to A₁ or M in Formula 1, and *' indicates a binding site to T₁ in Formula 1,
regarding Formulae CY2-1 to CY2-34, * indicates a binding site to A₂ or M in Formula 1, *' indicates a binding site to T₁ in Formula 1, and *" indicates a binding site to T₂ in Formula 1, and
regarding Formulae CY3-1 to CY3-6, two * indicate each a binding site to M in Formula 1, and *" indicates a binding site to T₂ in Formula 1.

10. The organometallic compound of any one of claims 1 to 9, wherein the organometallic compound is represented by Formula 1-1 or 1-2: 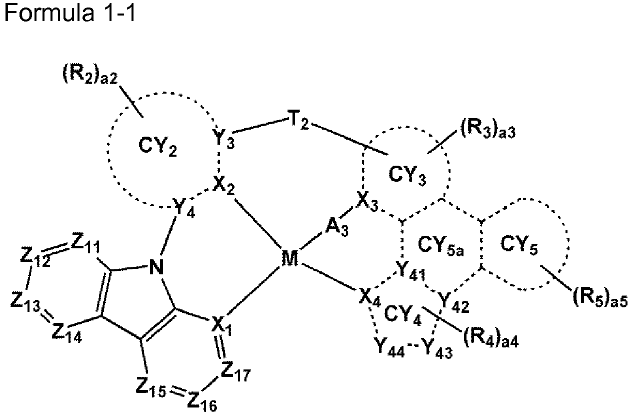 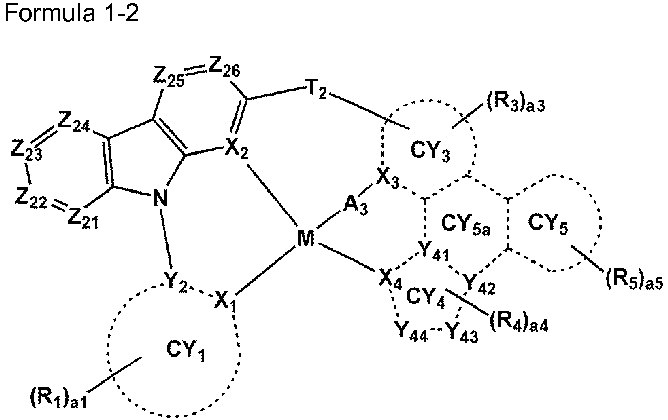
wherein, in Formulae 1-1 and 1-2,
M, X₁ to X₄, Y₄₁ to Y₄₄, A₃, ring CY₁ to CY₅, ring CY₅ₐ, R₁ to R₅, and a1 to a5 are the same as described in connection with claim 1,
T₂ is *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', or *-C(=S)-*', and R₈ and R₉ are the same as described in connection with claim 1,
Y₂ to Y₄ are each independently C or N,
a bond between X₂ and Y₃, a bond between X₂ and Y₄, and a bond between X₁ and Y₂ are each independently a single bond or a double bond,
Z₁₁ is N or C(R₁₁), Z₁₂ is N or C(R₁₂), Z₁₃ is N or C(R₁₃), Z₁₄ is N or C(R₁₄), Z₁₅ is N or C(R₁₅), Z₁₆ is N or C(R₁₆), Z₁₇ is N or C(R₁₇), Z₂₁ is N or C(R₂₁), Z₂₂ is N or C(R₂₂), Z₂₃ is N or C(R₂₃), Z₂₄ is N or C(R₂₄), Z₂₅ is N or C(R₂₅), Z₂₆ is N or C(R₂₆),
R₁₁ to R₁₇ are the same as described in connection with R₁ in claim 1, and
R₂₁ to R₂₆ are the same as described in connection with R₂ in claim 1;
preferably wherein
the organometallic compound is one of Compounds 1 to 196:

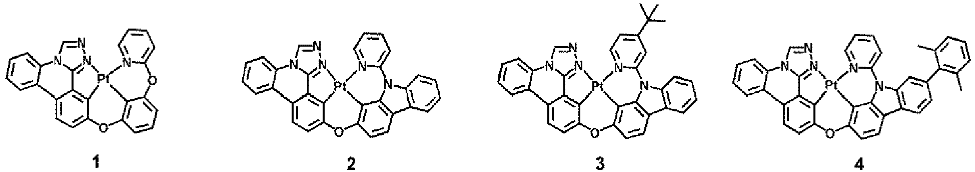

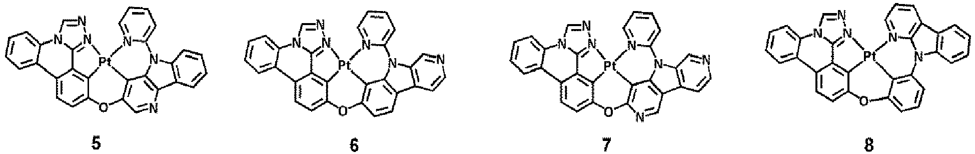

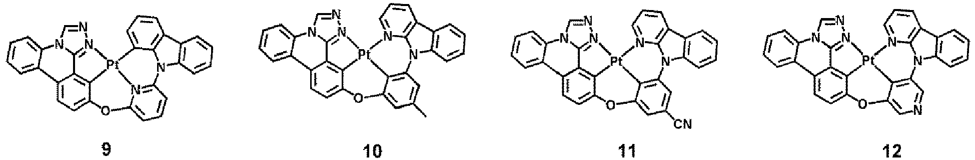

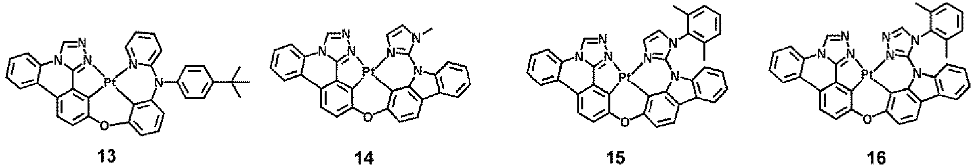

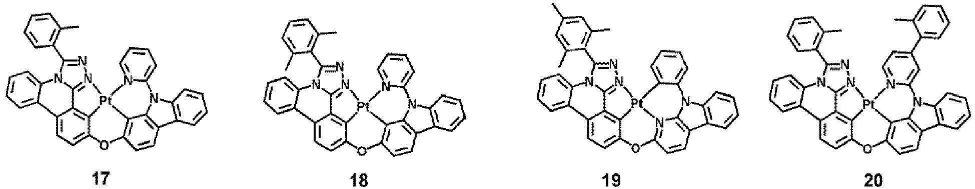

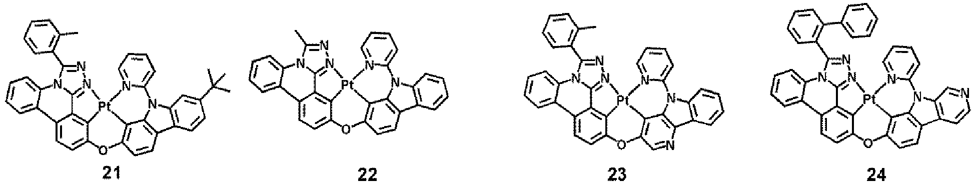

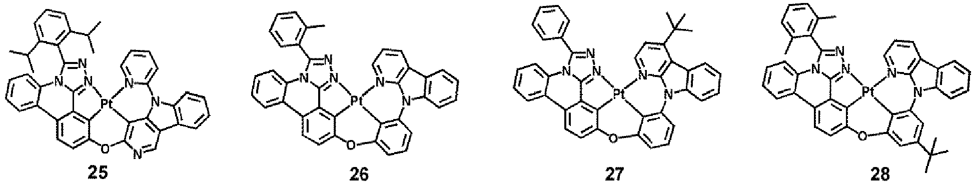

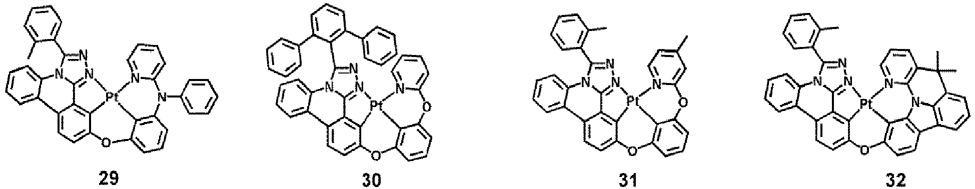

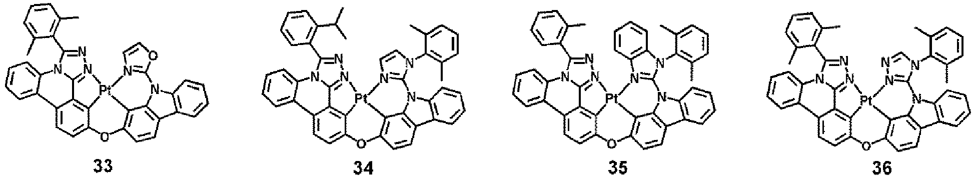

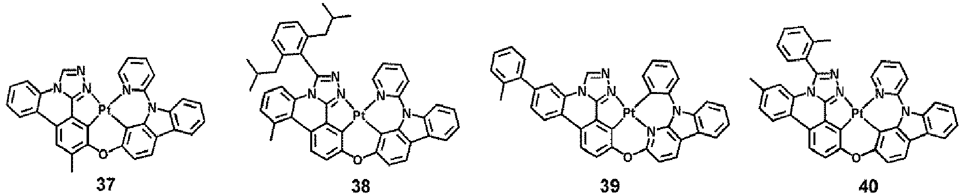

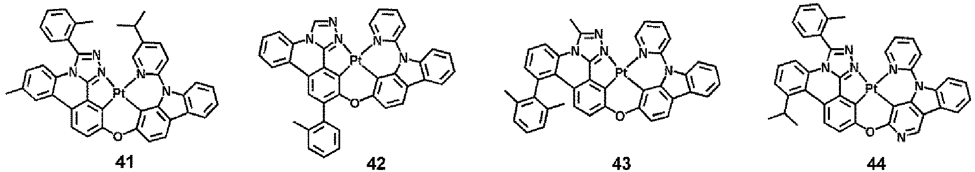

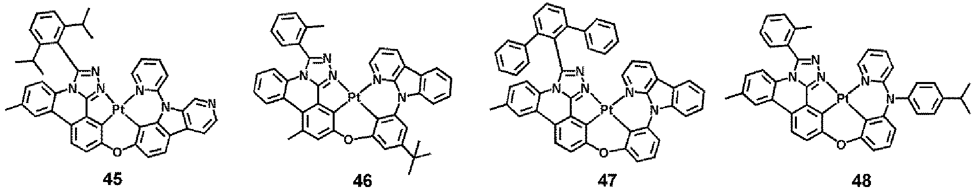

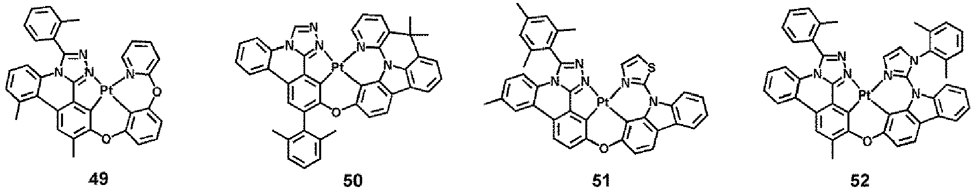

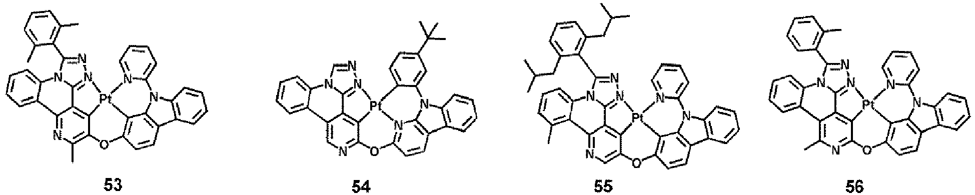

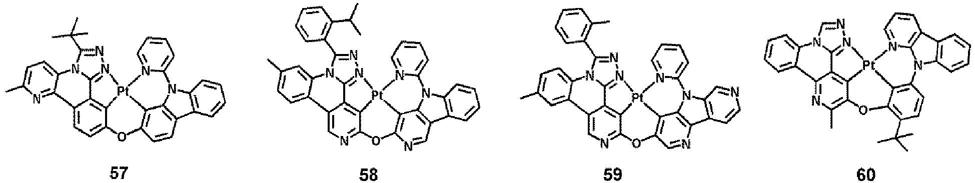

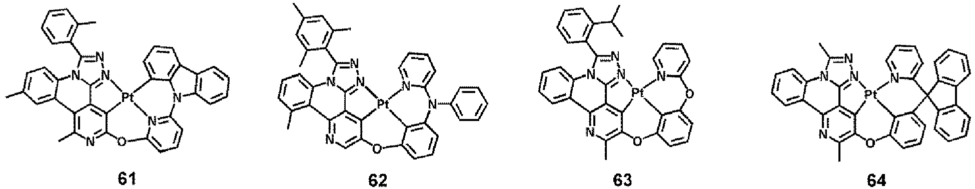

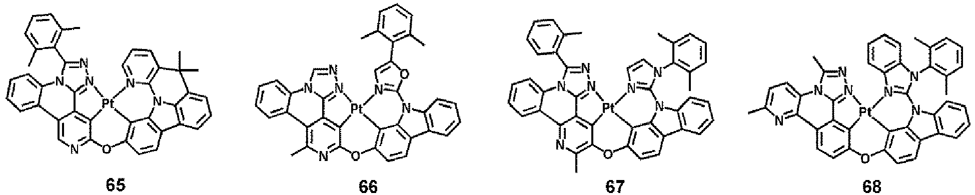

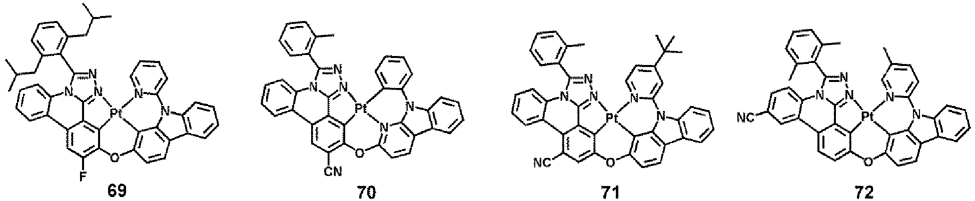

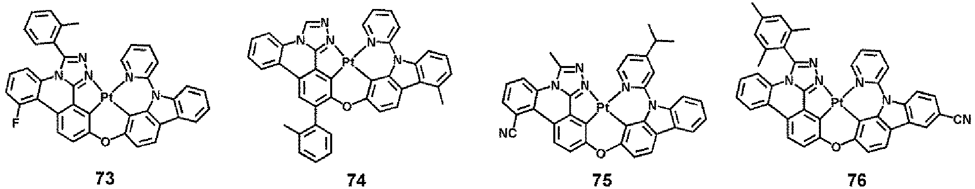

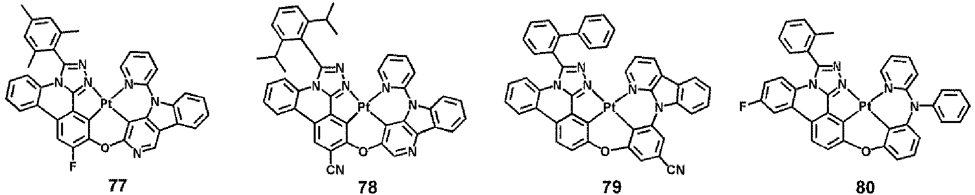

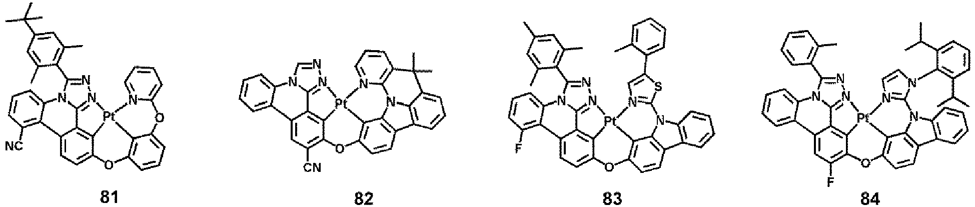

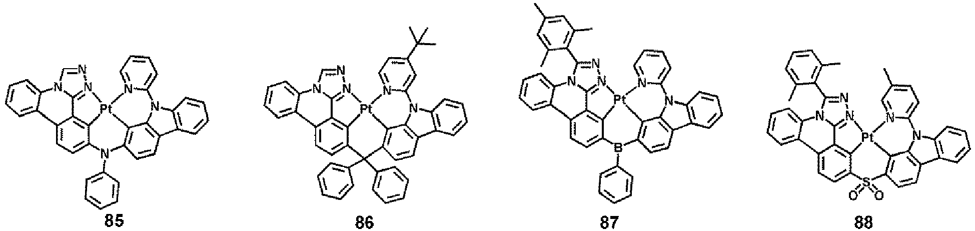

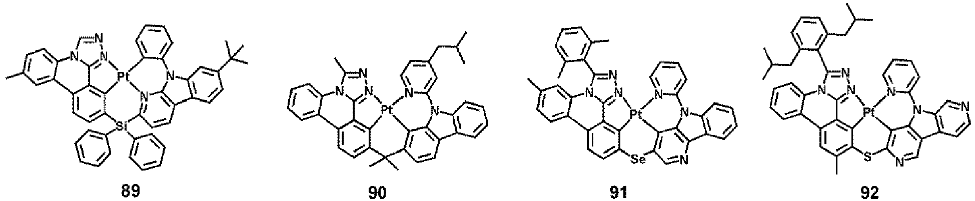

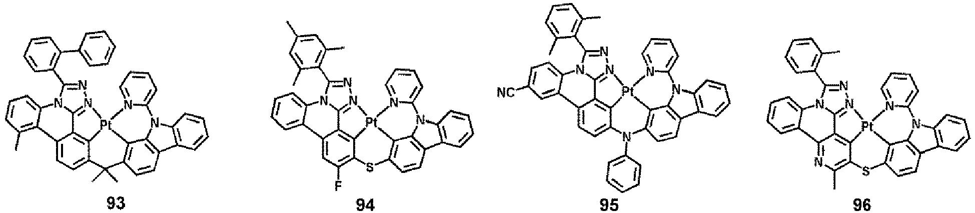

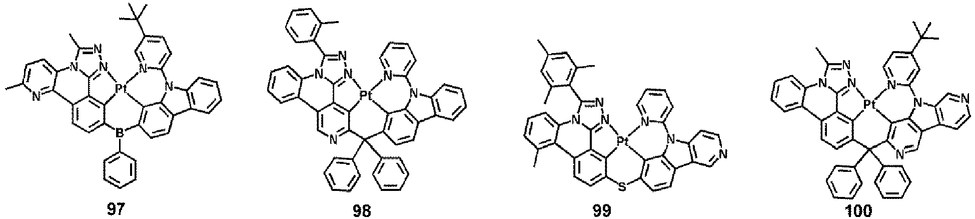

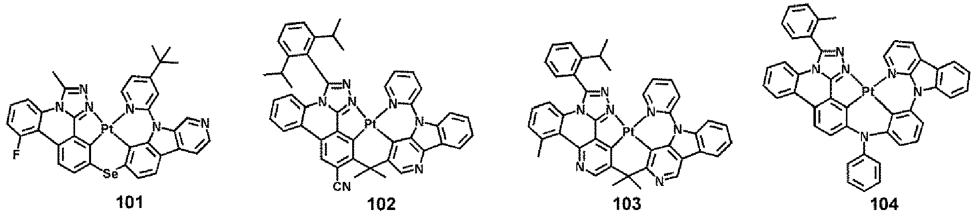

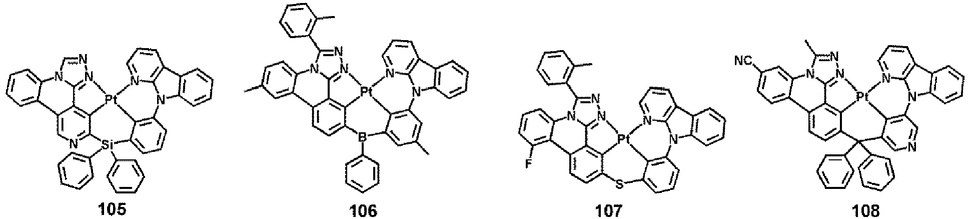

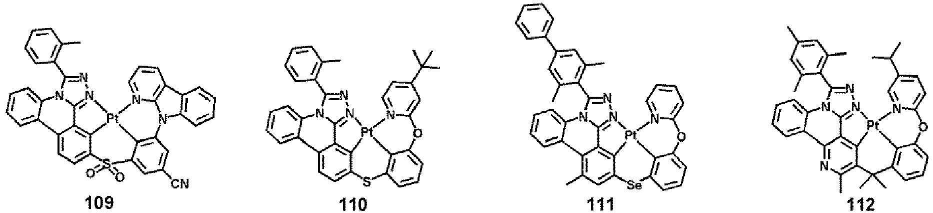

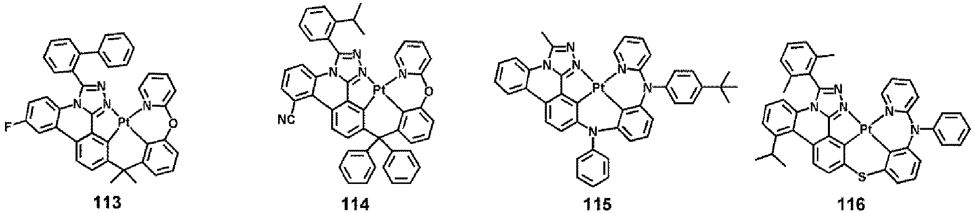

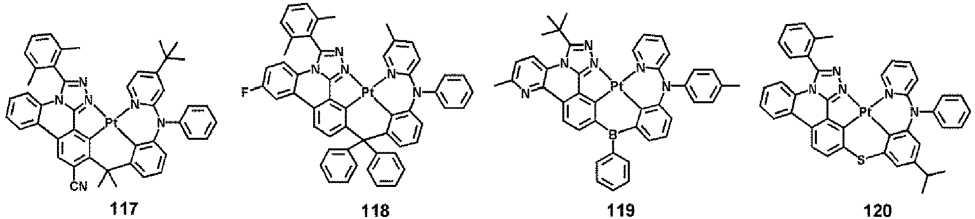

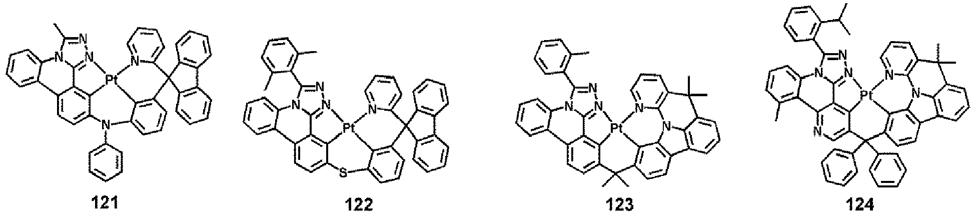

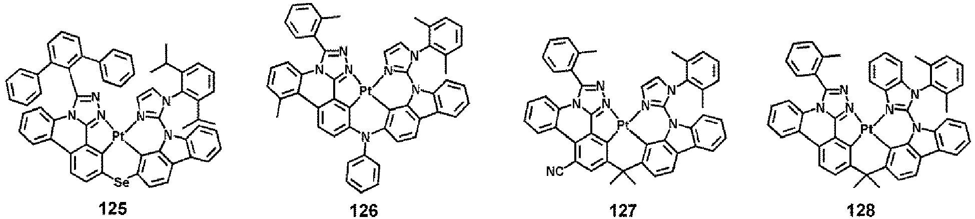

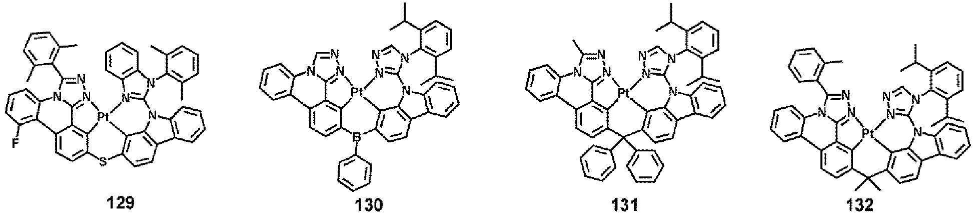

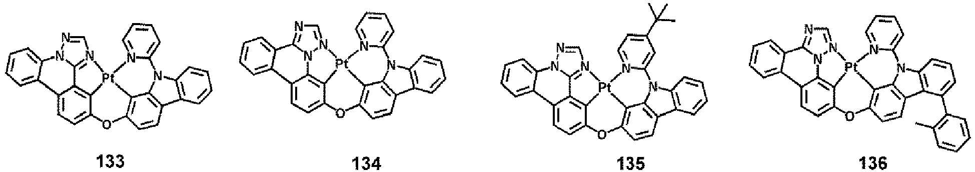

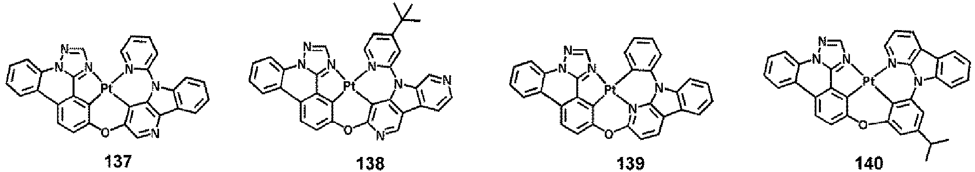

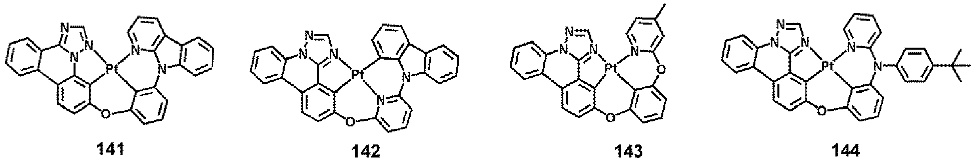

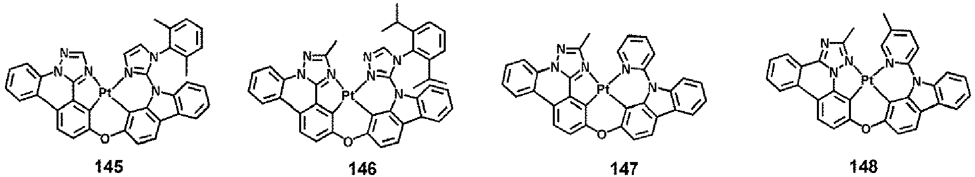

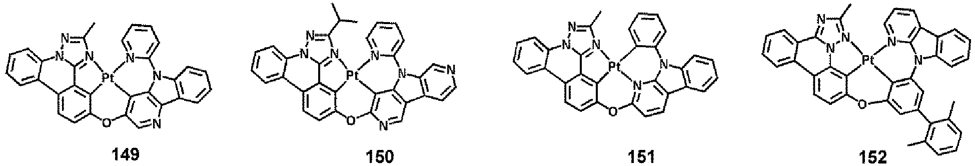

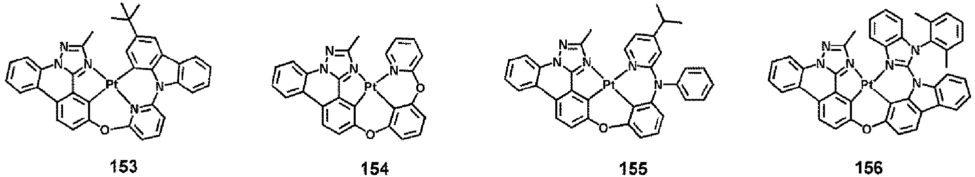

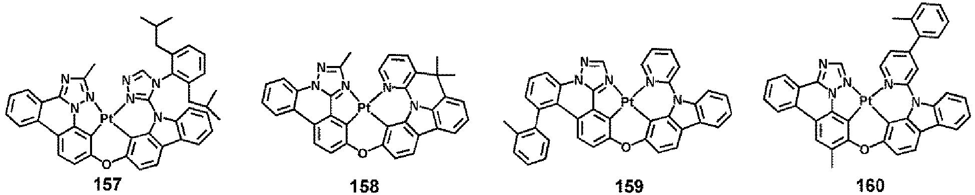

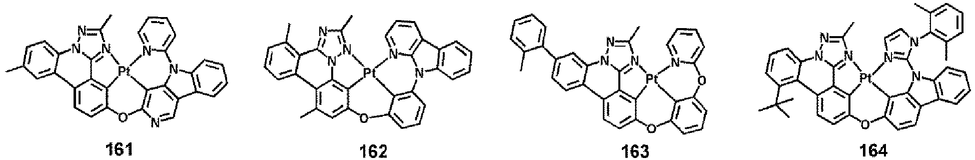

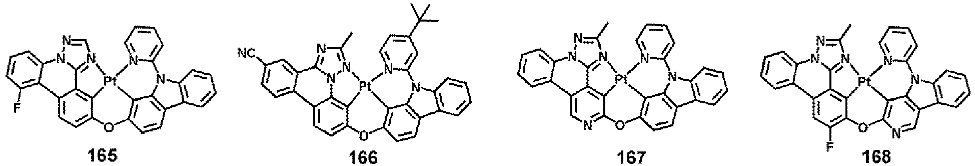

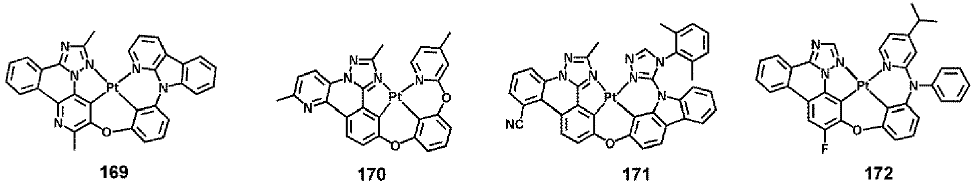

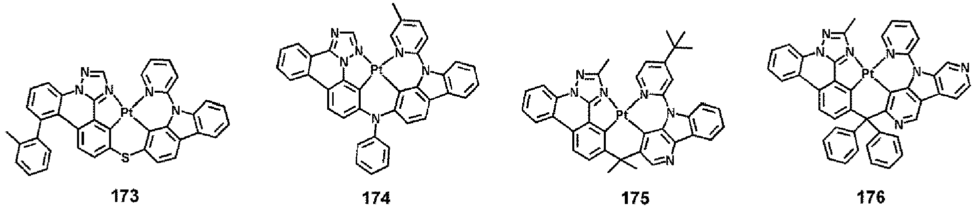

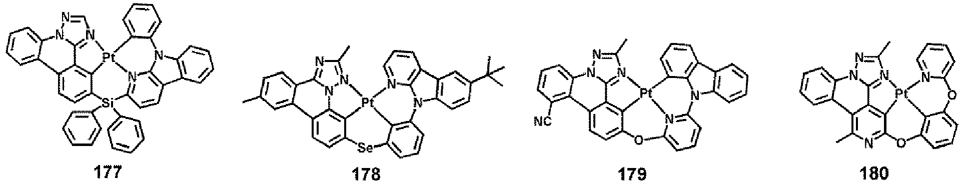

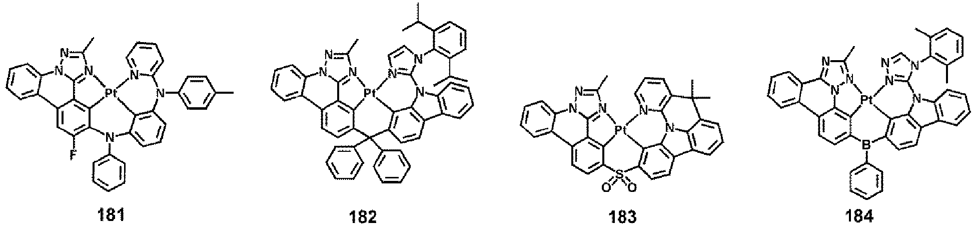

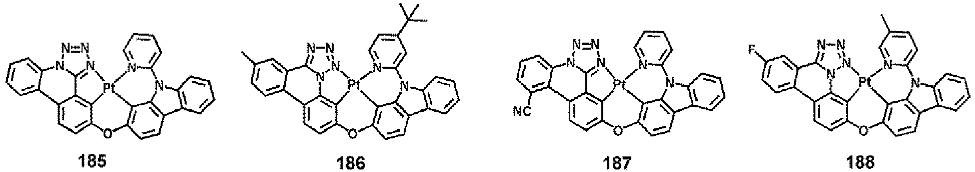

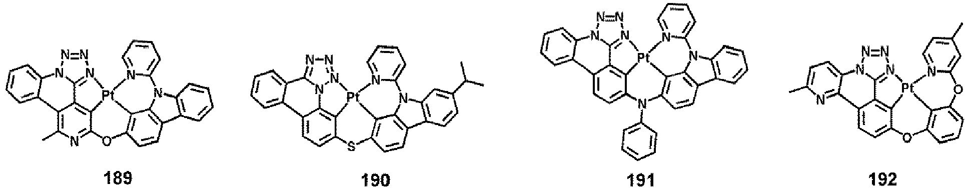

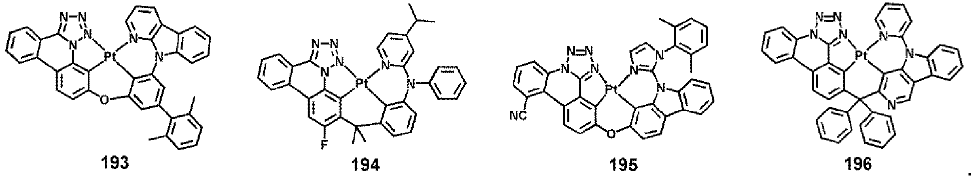

11. The organometallic compound of any one of claims 1 to 10, wherein
a peak of a photoluminescence spectrum of the organometallic compound has a maximum emission wavelength from 420 nanometers to 500 nanometers, and a full width at half maximum (FWHM) from 30 nanometers to 80 nanometers.

12. An organic light-emitting device comprising:
a first electrode;
a second electrode; and
an organic layer located between the first electrode and the second electrode
wherein the organic layer comprises an emission layer and at least one of the organometallic compound of any one of claims 1 to 11;
preferably wherein
the first electrode is an anode,
the second electrode is a cathode,
the organic layer further includes a hole transport region located between the first electrode and the emission layer and an electron transport region located between the emission layer and the second electrode,
the hole transport region includes a hole injection layer, a hole transport layer, an electron blocking layer, a buffer layer, or any combination thereof, and
the electron transport region includes a hole blocking layer, an electron transport layer, an electron injection layer, or any combination thereof.

13. The organic light-emitting device of claim 12, wherein
the organometallic compound is included in the emission layer.

14. The organic light-emitting device of claim 13, wherein
light emitted from the emission layer is blue light, and
wherein the blue light has a CIE y coordinate in the range of 0.10 to 0.340; and/or
wherein the emission layer further includes a host and the amount of the host is greater than the amount of the organometallic compound.

15. A diagnostic composition comprising at least one of the organometallic compound of any one of claims 1 to 11.

## Patentansprüche

1. Organometallische Verbindung, die durch die Formel 1 dargestellt ist: 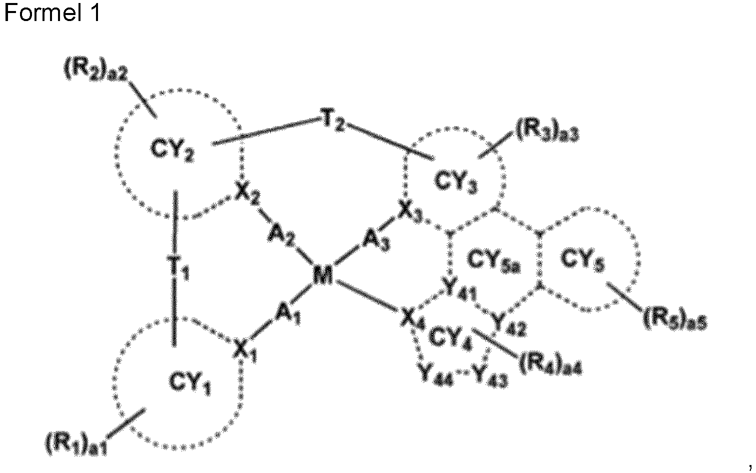 wobei in Formel 1 folgendes gilt:
M ist Beryllium (Be), Magnesium (Mg), Aluminium (Al), Calcium (Ca), Titan (Ti), Mangan (Mn), Cobalt (Co), Kupfer (Cu), Zink (Zn), Gallium (Ga), Germanium (Ge), Zirconium (Zr), Ruthenium (Ru), Rhodium (Rh), Palladium (Pd), Silber (Ag), Rhenium (Re), Platin (Pt) oder Gold (Au);
X₁ bis X₄, Y₄₁ und Y₄₂ sind unabhängig jeweils C oder N;
Y₄₃ und Y₄₄ sind jeweils unabhängig C, N, O, S oder Si;
A₁ bis A₃ sind jeweils unabhängig eine chemische Bindung, O, S, B(R'), N(R'), P(R'), C(R')(R"), Si(R')(R"), Ge(R')(R"), C(=O), B(R')(R"), N(R')(R") oder P(R')(R"), wobei, wenn A₁ eine chemische Bindung ist, X₁ direkt an M gebunden ist; A₂ eine chemische Bindung ist, X₂ direkt an M gebunden ist; und A₃ eine chemische Bindung ist, X₃ direkt an M gebunden ist;
zwei ausgewählte aus einer Bindung zwischen X₁ oder A₁ und M, einer Bindung zwischen M und X₂ oder A₂, einer Bindung zwischen X₃ oder A₃ und M und einer Bindung zwischen X₄ und M sind koordinative Bindungen, und wobei die verbleibenden anderen zwei Bindungen kovalente Bindungen sind;
Ring CY₁ bis Ring CY₃ und Ring CY₅ sind jeweils unabhängig eine C₅-C₃₀ carbocyclische Gruppe oder eine C₁-C₃₀ heterocyclische Gruppe;
Ring CY₄ ist ein 5-gliedriger Ring, und wobei drei oder mehr ausgewählte aus X₄, Y₄₁, Y₄₂, Y₄₃ und Y₄₄ von Ring CY₄ jeweils N sind;
Ring CYsa ist ein 6-gliedriger Ring;
T₁ ist eine Einzelbindung, eine Doppelbindung, *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂₋*', *-C(R₆)=*', *=C(R₆)-*', *-C(R₆)=C(R₇)-*', *-C(=S)-*' oder *-C≡C-*';
T₂ ist eine Einzelbindung, eine Doppelbindung, *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*' oder *-C≡C-*';
R₁ bis R₉, R' und R" sind jeweils unabhängig ausgewählt aus Wasserstoff, Deuterium, -F, -Cl, -Br, -I, -SF₅, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₇-C₆₀-Alkylarylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₇-C₆₀-Arylalkylgruppe, einer substituierten oder unsubstituierten C₁-C₆₀-Heteroarylgruppe, einer substituierten oder unsubstituierten C₁-C₆₀-Heteroaryloxygruppe, einer substituierten oder unsubstituierten C₁-C₆₀-Heteroarylthiogruppe, einer substituierten oder unsubstituierten C₂-C₆₀-Heteroarylalkylgruppe, einer substituierten oder unsubstituierten C₂-C₆₀-Alkylheteroarylgruppe, einer substituierten oder unsubstituierten monovalenten nichtaromatischen kondensierten polycyclischen Gruppe, einer substituierten oder unsubstituierten monovalenten nichtaromatischen kondensierten heteropolycyclischen Gruppe, -N(Q₁)(Q₂), -Si(Q₃)(Q₄)(Q₅), -B(Q₆)(Q₇) und -P(=O)(Q₈)(Q₉);
a1 bis a3 und a5 sind jeweils unabhängig eine ganze Zahl von 0 bis 20;
a4 ist eine ganze Zahl von 0 bis 2;
zwei einer Mehrzahl benachbarter Gruppen R₁ sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
zwei einer Mehrzahl benachbarter Gruppen R₂ sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
zwei einer Mehrzahl benachbarter Gruppen R₃ sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
zwei einer Mehrzahl benachbarter Gruppen R₄ sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
zwei einer Mehrzahl benachbarter Gruppen R₅ sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
zwei aus R₁ bis R₉, R' und R" sind optional miteinander verknüpft, um eine C₅-C₃₀ carbocyclische Gruppe zu bilden, unsubstituiert oder substituiert mit mindestens einem R₁₀ₐ oder einer C₁-C₃₀ heterocyclischen Gruppe, unsubstituiert oder substituiert mit mindestens einem R₁₀ₐ;
R₁₀ₐ der Beschreibung in Bezug auf R₁ entspricht;
* und *" jeweils eine Bindungsstelle an ein benachbartes Atom anzeigen;
mindestens ein Substituent der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₆-C₆₀-Aryloxygruppe, der substituierten C₆-C₆₀-Arylthiogruppe, der substituierten C₇-C₆₀-Arylalkylgruppe, der substituierten C₁-C₆₀-Heteroarylgruppe, der substituierten C₁-C₆₀-Heteroaryloxygruppe, der substituierten C₁-C₆₀-Heteroarylthiogruppe, der substituierten C₂-C₆₀-Heteroarylalkylgruppe, der substituierten C₂-C₆₀-Alkylheteroarylgruppe, der substituierten monovalenten nichtaromatischen kondensierten polycyclischen Gruppe und der substituierten monovalenten nichtaromatischen kondensierten heteropolycyclischen Gruppe ist ausgewählt aus:
Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem ausgewählt aus Deuterium, -F, -Cl, -Br, -I, -CD₃, -CD₂H, -CDH₂, -CF₃, -CF₂H,-CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₇-C₆₀-Arylalkylgruppe, einer C₁-C₆₀-Heteroarylgruppe, einer C₁-C₆₀-Heteroaryloxygruppe, einer C₁-C₆₀-Heteroarylthiogruppe, einer C₂-C₆₀-Heteroarylalkylgruppe, einer C₂-C₆₀-Alkylheteroarylgruppe, einer monovalenten nichtaromatischen kondensierten polycyclischen Gruppe, einer monovalenten nichtaromatischen kondensierten heteropolycyclischen Gruppe, -N(Q₁₁)(Q₁₂),-Si(Q₁₃)(Q₁₄)(Q₁₅), -B(Q₁₆)(Q₁₇) und -P(=O)(Q₁₈)(Q₁₉);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₇-C₆₀-Arylalkylgruppe, einer C₁-C₆₀-Heteroarylgruppe, einer C₁-C₆₀-Heteroaryloxygruppe, einer C₁-C₆₀-Heteroarylthiogruppe, einer C₂-C₆₀-Heteroarylalkylgruppe, einer monovalenten nichtaromatischen kondensierten polycyclischen Gruppe und einer monovalenten nichtaromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₇-C₆₀-Arylalkylgruppe, einer C₁-C₆₀-Heteroarylgruppe, einer C₁-C₆₀-Heteroaryloxygruppe, einer C₁-C₆₀-Heteroarylthiogruppe, einer C₂-C₆₀-Heteroarylalkylgruppe, einer C₂-C₆₀-Alkylheteroarylgruppe, einer monovalenten nichtaromatischen kondensierten polycyclischen Gruppe und einer monovalenten nichtaromatischen kondensierten heteropolycyclischen Gruppe, jeweils substituiert mit mindestens einem ausgewählt aus Deuterium, -F, -Cl, -Br, -I, -CD₃, -CD₂H, -CDH₂,-CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₇-C₆₀-Arylalkylgruppe, einer C₁-C₆₀-Heteroarylgruppe, einer C₁-C₆₀-Heteroaryloxygruppe, einer C₁-C₆₀-Heteroarylthiogruppe, einer C₂-C₆₀-Heteroarylalkylgruppe, einer C₂-C₆₀-Alkylheteroarylgruppe, einer monovalenten nichtaromatischen kondensierten polycyclischen Gruppe, einer monovalenten nichtaromatischen kondensierten heteropolycyclischen Gruppe, -N(Q₂₁)(Q₂₂),-Si(Q₂₃)(Q₂₄)(Q₂₅), -B(Q₂₆)(Q₂₇) und -P(=O)(Q₂₈)(Q₂₉); und
-N(Q₃₁)(Q₃₂), -Si(Q₃₃)(Q₃₄)(Q₃₅), -B(Q₃₆)(Q₃₇) und -P(=O)(Q₃₈)(Q₃₉);
wobei Q₁ bis Q₉, Q₁₁ bis Q₁₉, Q₂₁ bis Q₂₉ und Q₃₁ bis Q₃₉ jeweils unabhängig ausgewählt sind aus -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe, substituiert mit mindestens einem ausgewählt aus einer C₁-C₆₀-Alkylgruppe und einer C₆-C₆₀-Arylgruppe, einer C₆-C₆₀-Aryloxygruppe, einer C₆-C₆₀-Arylthiogruppe, einer C₇-C₆₀-Arylalkylgruppe, einer C₁-C₆₀-Heteroarylgruppe, einer C₁-C₆₀-Heteroaryloxygruppe, einer C₁-C₆₀-Heteroarylthiogruppe, einer C₂-C₆₀-Heteroarylalkylgruppe, einer C₂-C₆₀-Alkylheteroarylgruppe, einer monovalenten nichtaromatischen kondensierten polycyclischen Gruppe und einer monovalenten nichtaromatischen kondensierten heteropolycyclischen Gruppe.

2. Organometallische Verbindung nach Anspruch 1, wobei folgendes gilt:
M ist Pt, Pd oder Au; und/oder
wobei folgendes gilt:
Ring CY₁ ist eine Oxazolgruppe, eine Isoxazolgruppe, eine Oxadiazolgruppe, eine Isoxadiazolgruppe, eine Oxatriazolgruppe, eine Thiazolgruppe, eine Isothiazolgruppe, eine Thiadiazolgruppe, eine Isothiadiazolgruppe, eine Thiatriazolgruppe, eine Pyrazolgruppe, eine Imidazolgruppe, eine Triazolgruppe, eine Tetrazolgruppe, eine Azasilolgruppe, eine Diazasilolgruppe, eine Triazasilolgruppe, eine Benzimidazolgruppe, eine Benzoxazolgruppe, eine Benzthiazolgruppe, eine Benzolgruppe, eine Pyridingruppe, eine Pyrimidingruppe, eine Pyrazingruppe, eine Pyridazingruppe, eine Triazingruppe, eine Carbazolgruppe oder eine Azacarbazolgruppe;
Ring CY₂ ist eine Benzolgruppe, eine Pyridingruppe, eine Pyrimidingruppe, eine Pyrazingruppe, eine Pyridazingruppe, eine Triazingruppe, eine Carbazolgruppe oder eine Azacarbazolgruppe;
Ring CY₃ und Ring CY₅ sind jeweils unabhängig eine Benzolgruppe, eine Pyridingruppe, eine Pyrimidingruppe, eine Pyrazingruppe, eine Pyridazingruppe oder eine Triazingruppe; und
Ring CY₄ ist eine Triazolgruppe oder eine Tetrazolgruppe; und/oder wobei folgendes gilt:
R₁ bis R₉, R' und R" sind jeweils unabhängig ausgewählt aus:
Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, -SF₅, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem ausgewählt aus Deuterium, -F, -Cl, -Br, -I, -CD₃, -CD₂H, -CDH₂,-CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer C₁-C₂₀-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer C₁-C₂₀-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit einem ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer C₁-C₂₀-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und
-N(Q₁)(Q₂), -Si(Q₃)(Q₄)(Q₅), -B(Q₆)(Q₇) und -P(=O)(Q₈)(Q₉);
wobei Q₁ bis Q₉ jeweils unabhängig ausgewählt sind aus:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CH₃, -CD₂CD₃, -CD₂CD₂H und-CD2_{c}DH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe und eine Naphthylgruppe; und
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe und eine Naphthylgruppe, jeweils substituiert mit mindestens einem ausgewählt aus Deuterium, einer C₁-C₁₀-Alkylgruppe und einer Phenylgruppe.

3. Organometallische Verbindung nach Anspruch 1 oder 2, wobei die organometallische Verbindung folgendes erfüllt:
a) einen aus Zustand 1, Zustand 2 und Zustand 3;
b) einen aus Zustand 4 und Zustand 5; oder
c) einen aus Zustand 1, Zustand 2 und Zustand 3 sowie einen aus Zustand 4 und Zustand 5:
Zustand 1
A₁ und A₂ sind jeweils eine chemische Bindung,
ein Anteil, dargestellt durch 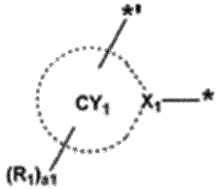 ist durch Formel A1-1 dargestellt, wobei T₁ *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*' oder *-C≡C-*' ist,
ein Anteil, dargestellt durch 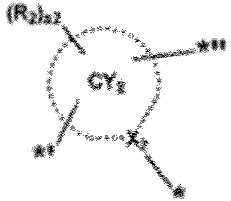 ist durch Formel A2-1 dargestellt,
Zustand 2
A₁ und A₂ sind jeweils eine chemische Bindung,
ein Anteil, dargestellt durch 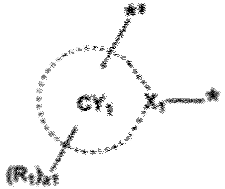 ist durch Formel A1-2 dargestellt, wobei T₁ eine Einzelbindung ist,
ein Anteil, dargestellt durch 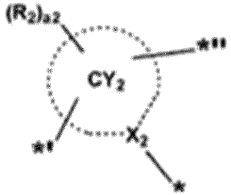 ist durch Formel A2-1 dargestellt,
Zustand 3
A₁ und A₂ sind jeweils eine chemische Bindung,
ein Anteil, dargestellt durch 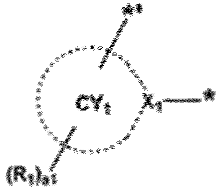 ist durch Formel A1-1 dargestellt, wobei T₁ eine Einzelbindung ist,
ein Anteil, dargestellt durch 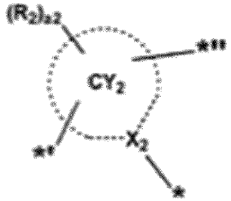 ist durch Formel A2-3 dargestellt,
Zustand 4
A₂ und A₃ sind jeweils eine chemische Bindung,
ein Anteil, dargestellt durch 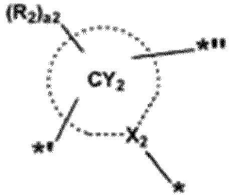 ist durch Formel A2-1 dargestellt, wobei T₂ *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*' oder *-C≡C-*' ist,
Zustand 5
A₂ und A₃ sind jeweils eine chemische Bindung,
ein Anteil, dargestellt durch 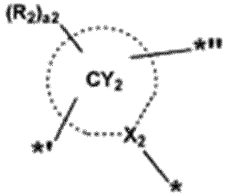 ist durch Formel A2-2 dargestellt, wobei T₂ eine Einzelbindung ist, 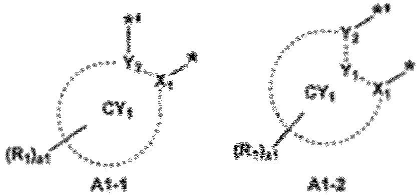 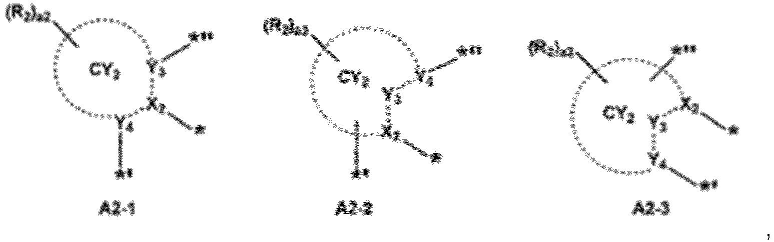 wobei in den Formeln A1-1, A1-2, A2-1, A2-2 und A2-3 folgendes gilt:
X₁, X₂, Ring CY₁, Ring CY₂, R₁, R₂, a1 und a2 entsprechen der Beschreibung aus Anspruch 1, Y₁ bis Y₄ sind jeweils unabhängig C oder N, eine Bindung zwischen X₁ und Y₁, eine Bindung zwischen X₁ und Y₂, eine Bindung zwischen Y₁ und Y₂, eine Bindung zwischen X₂ und Y₄, eine Bindung zwischen X₂ und Y₃ und eine Bindung zwischen Y₃ und Y₄ sind jeweils unabhängig eine Einzelbindung oder eine Doppelbindung;
wobei in Bezug auf die Formeln A1-1 und A1-2 * jeweils eine Bindungsstelle an A₁ oder M in Formel 1 anzeigt, und wobei *' eine Bindungsstelle an T₁ in Formel 1 anzeigt; und
wobei in Bezug auf die Formeln A2-1, A2-2 und A2-3 * eine Bindungsstelle an A₂ oder M in Formel 1 anzeigt, wobei *' eine Bindungsstelle an T₁ in Formel 1 anzeigt, und wobei *" eine Bindungsstelle an T₂ in Formel 1 anzeigt.

4. Organometallische Verbindung nach einem der Ansprüche 1 bis 3, wobei ein Anteil dargestellt durch 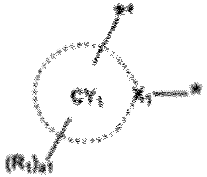 dargestellt ist durch eine der Formeln A1-1(1) bis A1-1(54) und A₁-2(1) bis A₁-2(74): 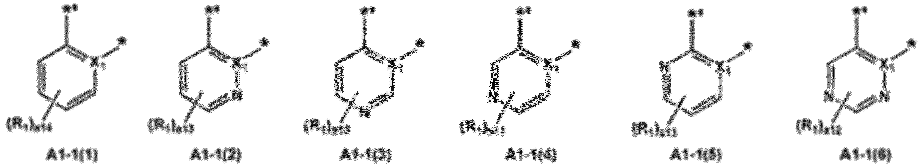 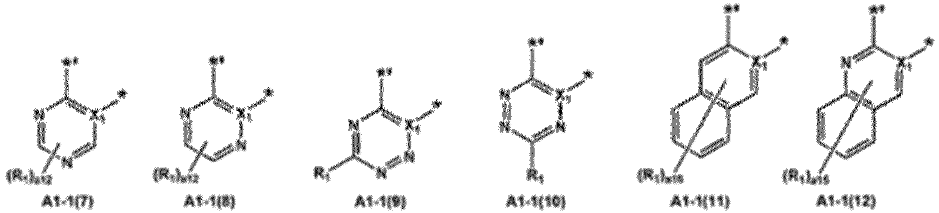 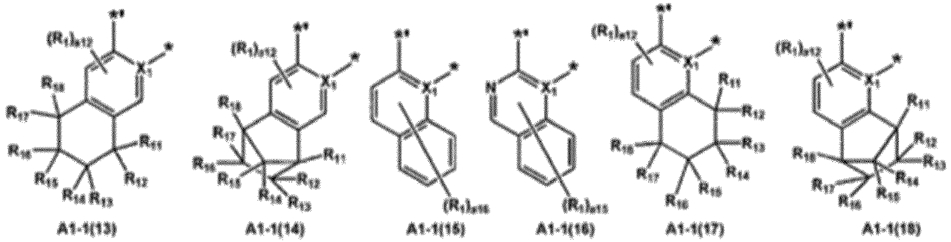 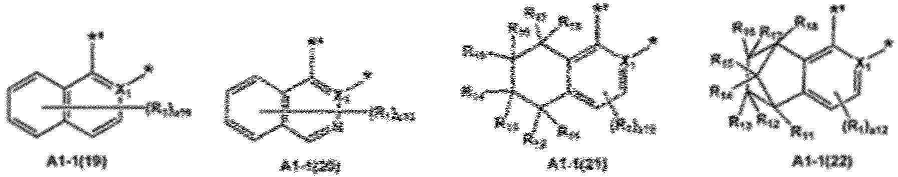 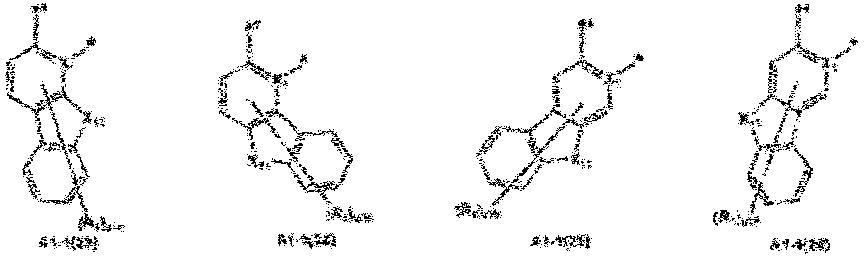 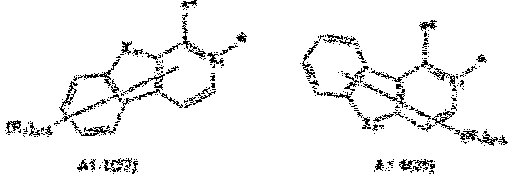 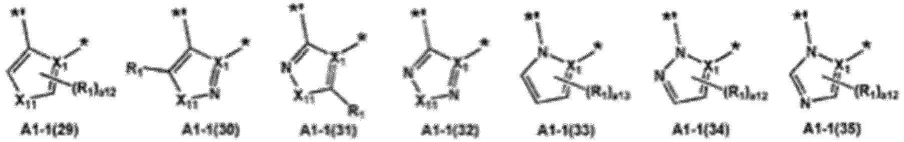 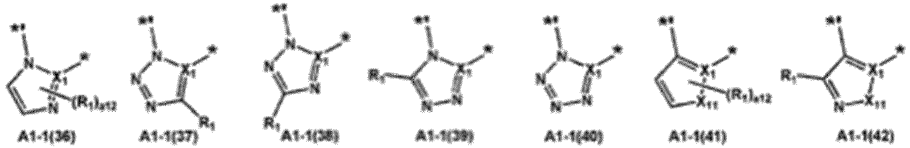 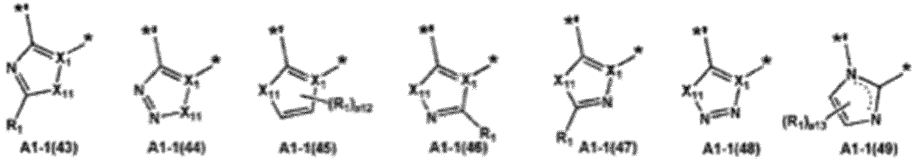 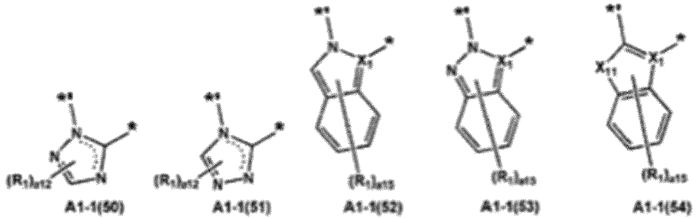 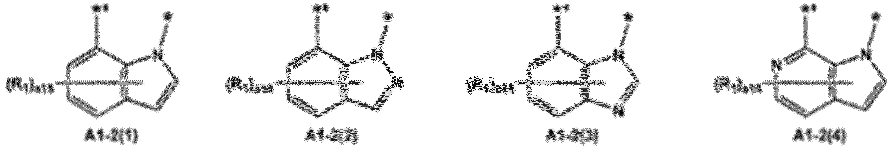 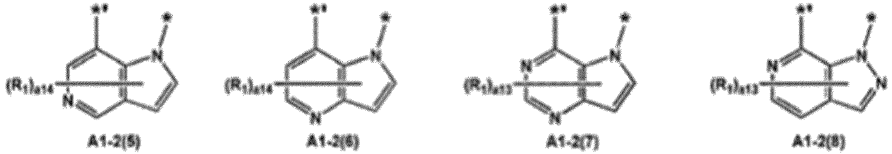 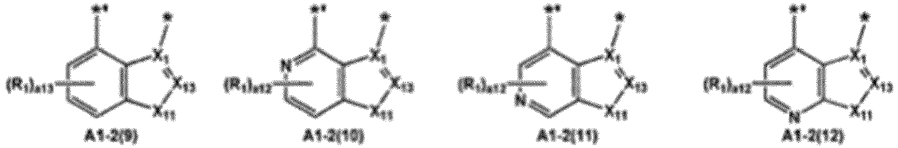 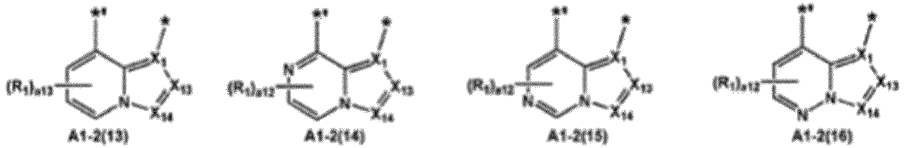 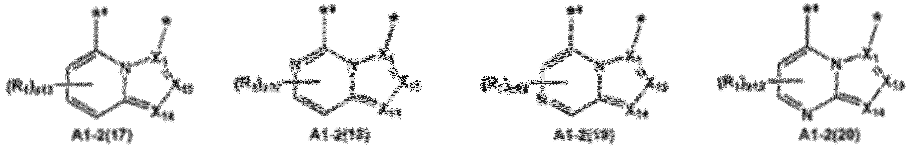 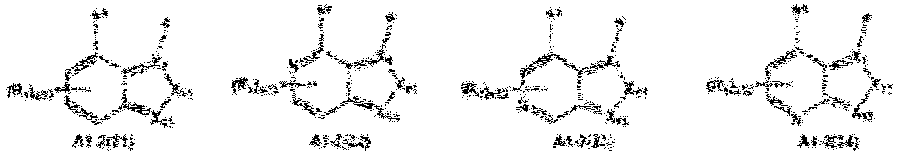 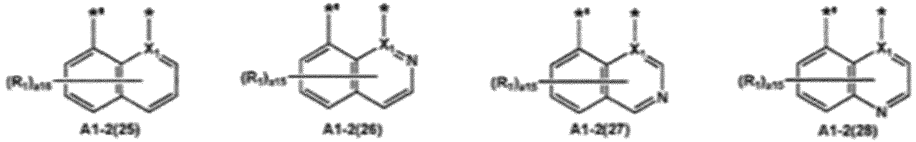 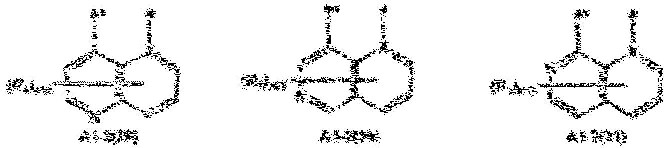 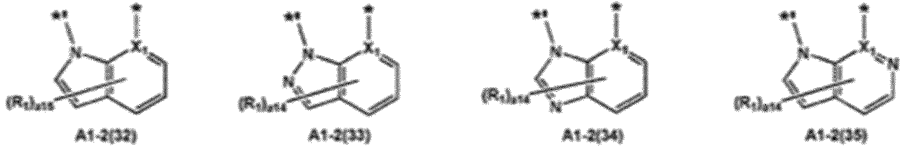 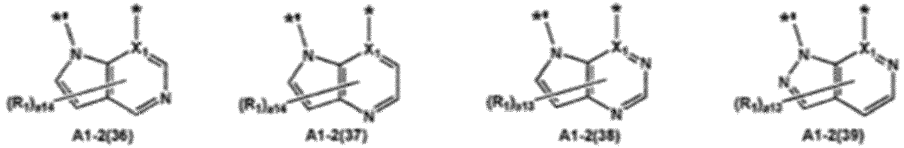 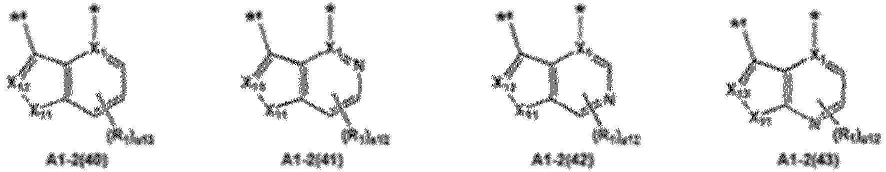 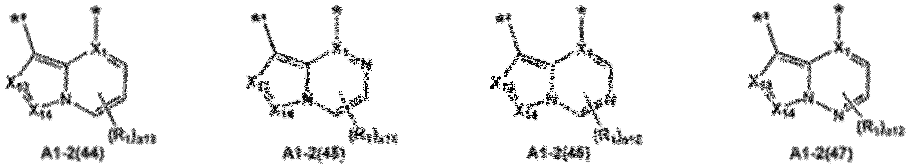 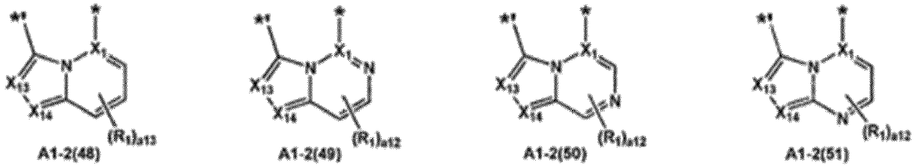 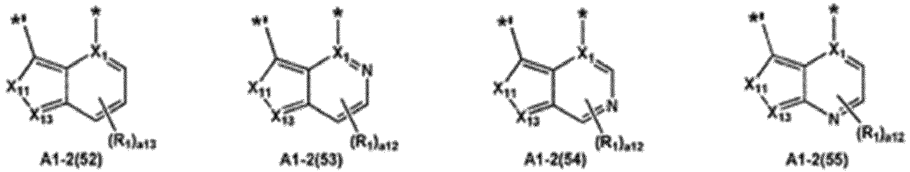 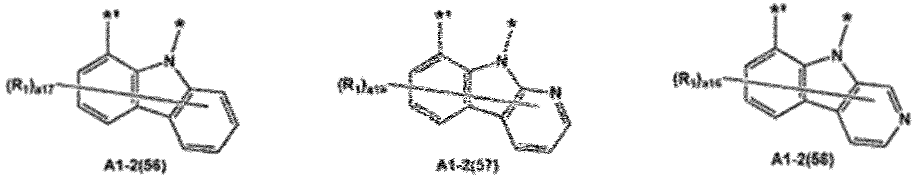 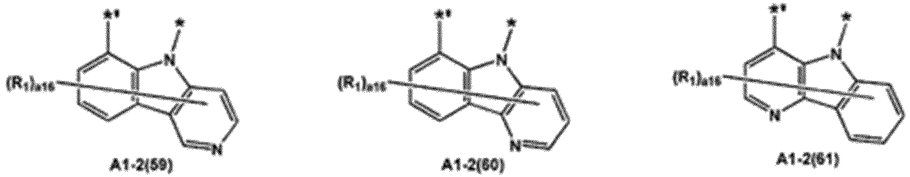 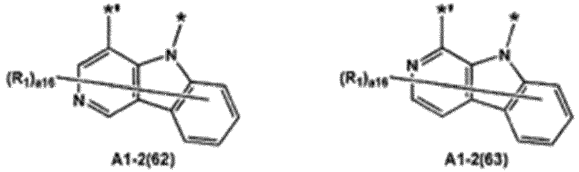 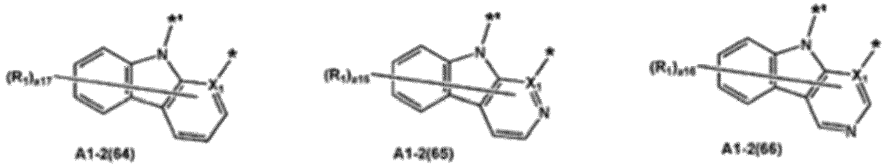 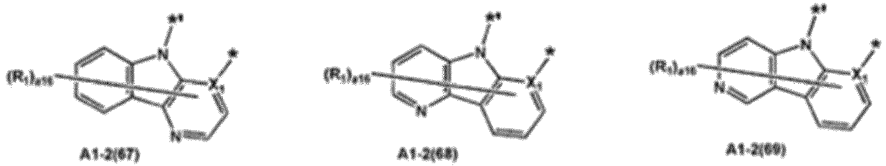 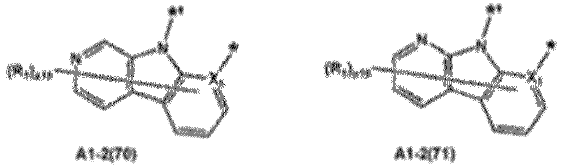 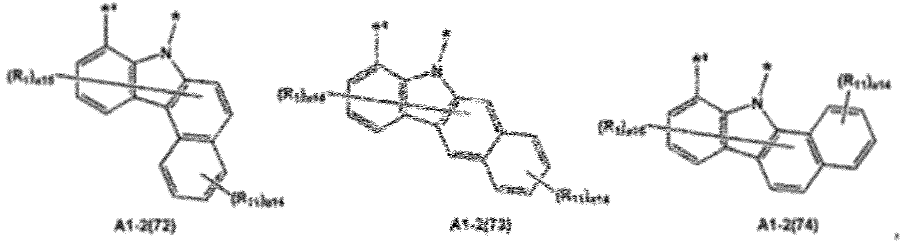 wobei in den Formeln A1-1(1) bis A1-1(54) und A₁-2(1) bis A₁-2(74) folgendes gilt:
X₁ und R₁ entsprechen der Beschreibung aus Anspruch 1;
X₁₁ ist O, S, N(R₁₁), C(R₁₁)(R₁₂) oder Si(R₁₁)(R₁₂);
X₁₃ ist N oder C(R₁₃);
X₁₄ ist N oder C(R₁₄);
R₁₁ bis R₁₈ entsprechen der Beschreibung in Bezug auf R₁ in Anspruch 1;
a17 ist eine ganze Zahl von 0 bis 7;
a16 ist eine ganze Zahl von 0 bis 6;
a15 ist eine ganze Zahl von 0 bis 5;
a14 ist eine ganze Zahl von 0 bis 4;
a13 ist eine ganze Zahl von 0 bis 3;
a12 ist eine ganze Zahl von 0 bis 2;
* steht für eine Bindungsstelle an A₁ oder M in Formel 1; und
*' steht für eine Bindungsstelle an T₁ in Formel 1.

5. Organometallische Verbindung nach einem der Ansprüche 1 bis 4, wobei
ein Anteil dargestellt durch 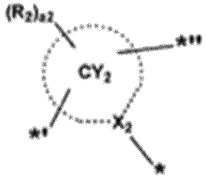 dargestellt ist durch eine der Formeln A2-1(1) bis A2-1(17), A2-2(1) bis A2-2(58) und A2-3(1) bis A2-3(62): 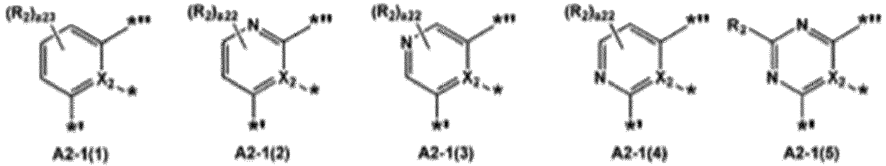 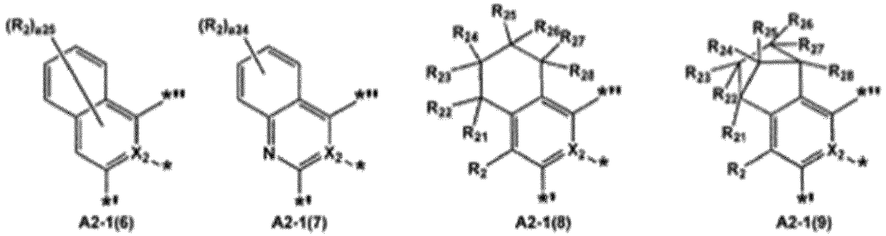 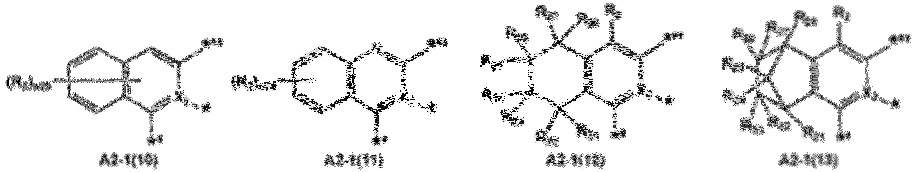 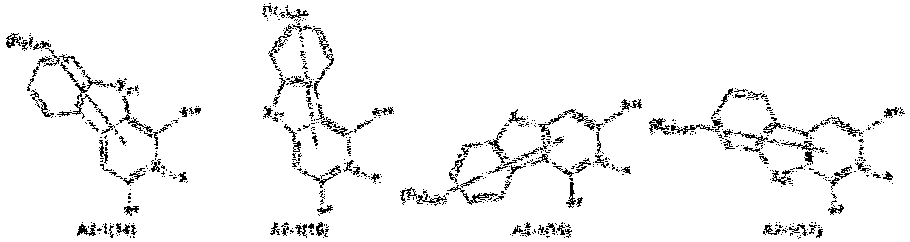 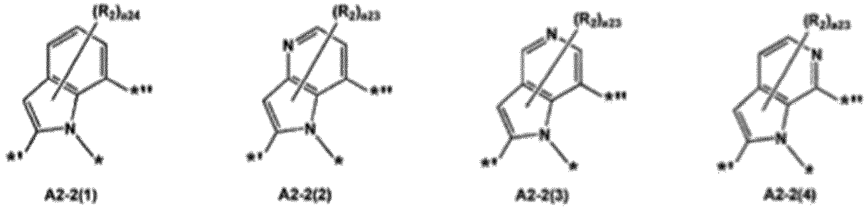 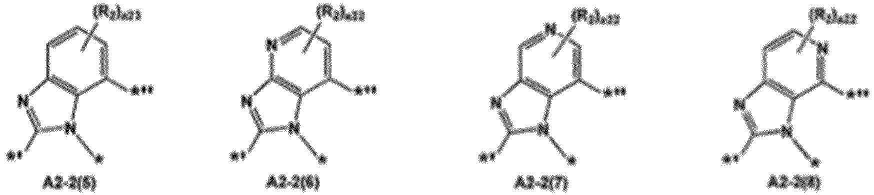 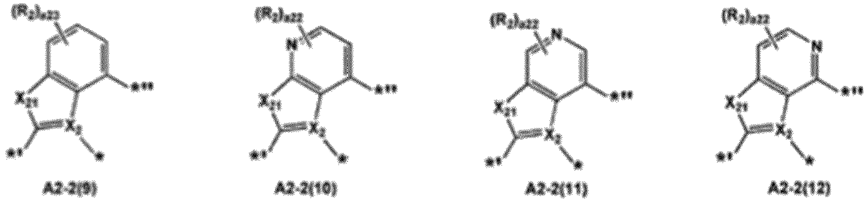 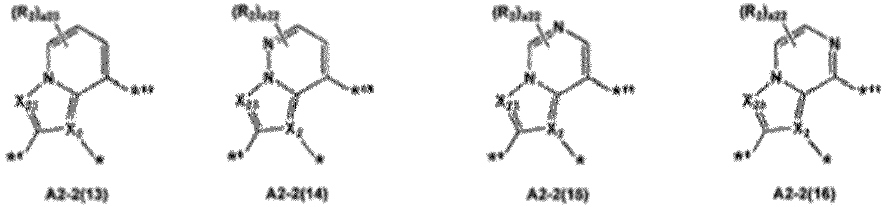 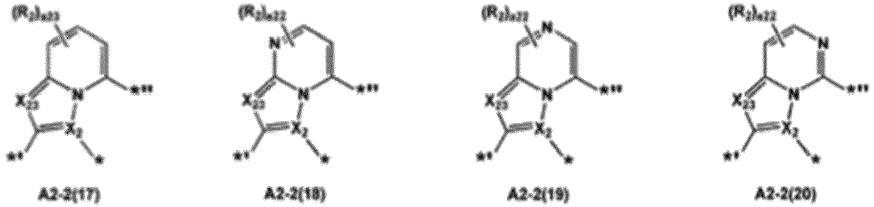 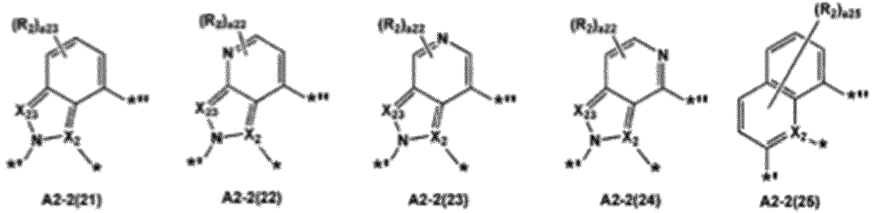 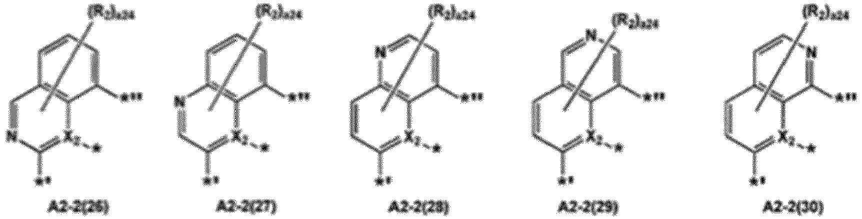 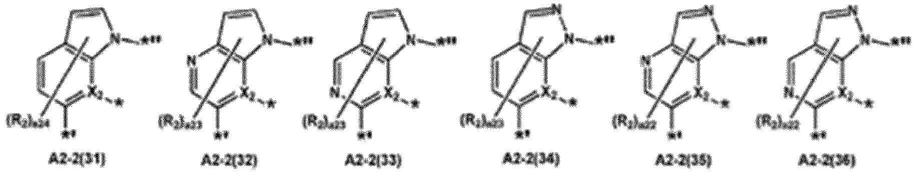 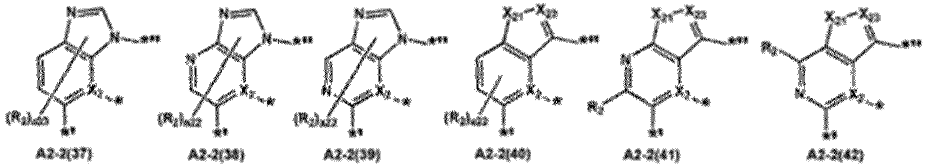 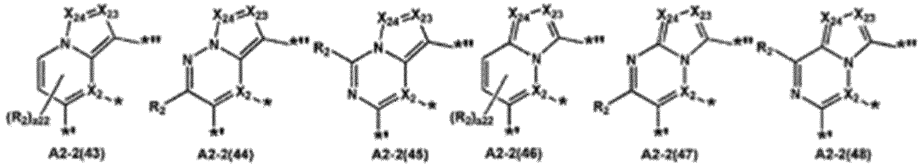 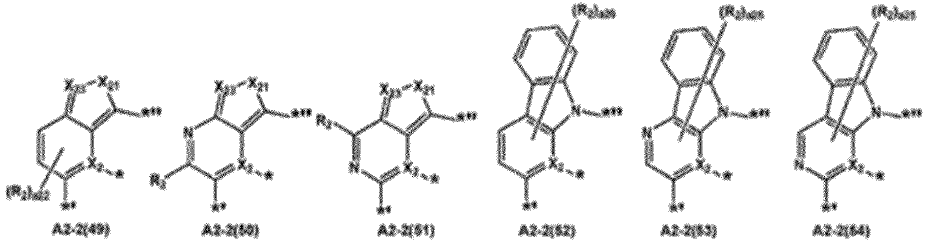 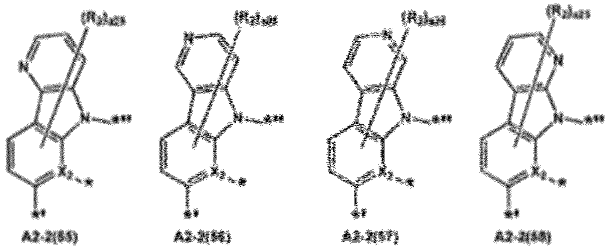 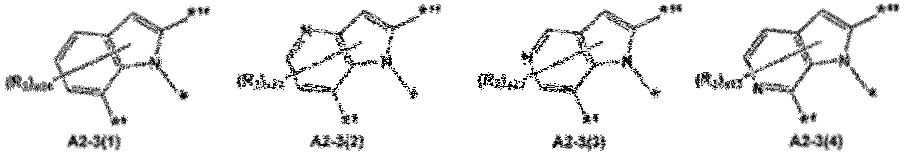 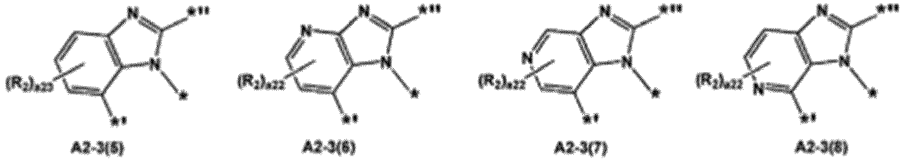 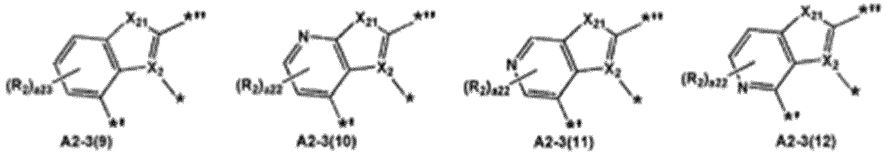 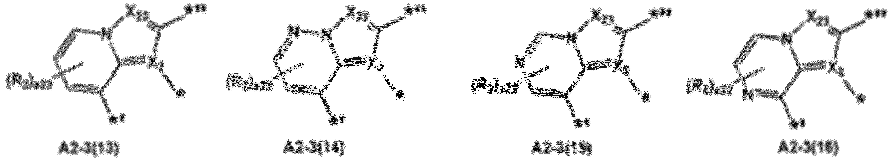 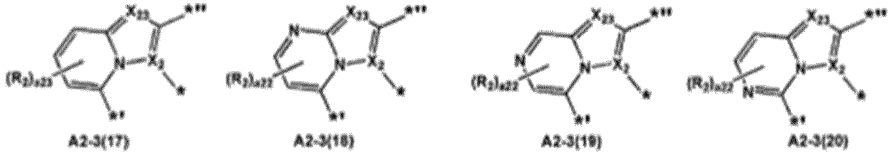 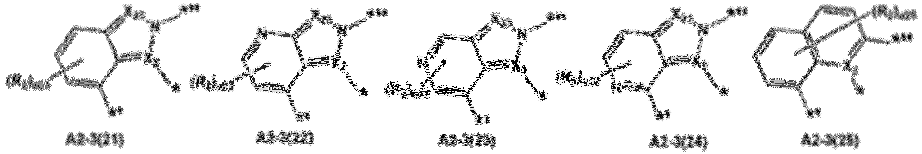 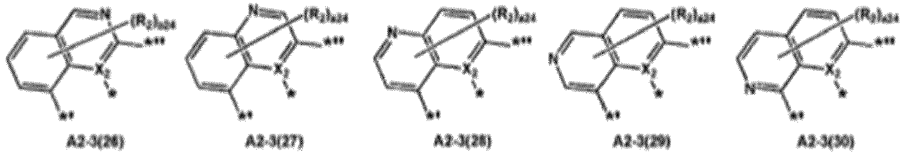 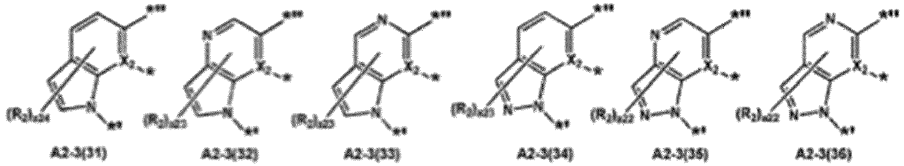 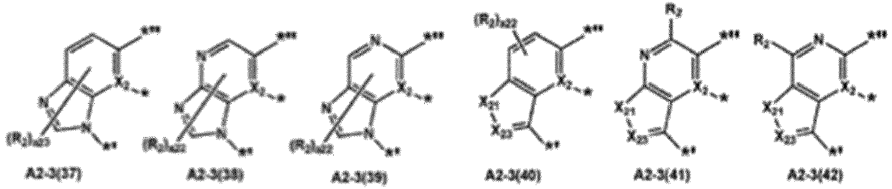 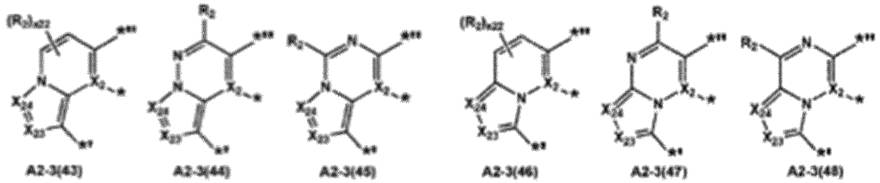 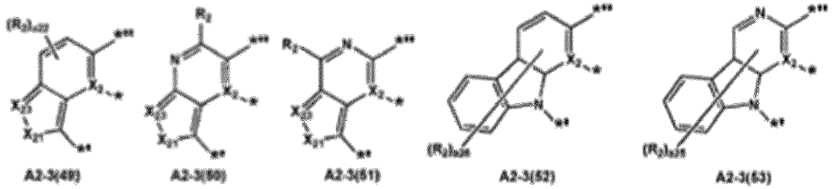 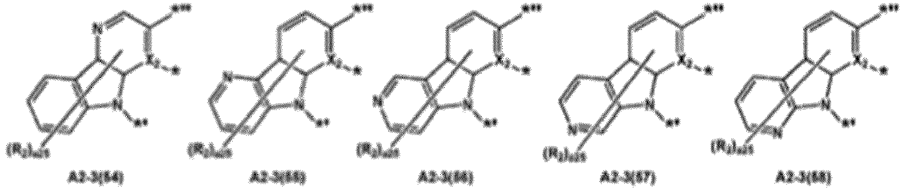 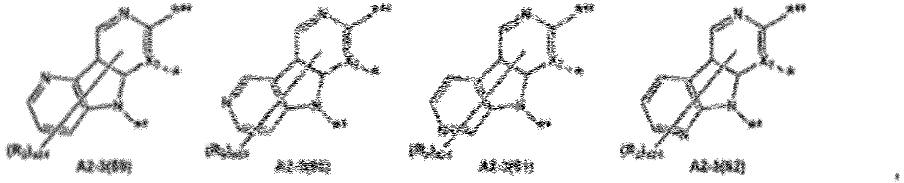 wobei in den Formeln A2-1(1) bis A2-1(17), A2-2(1) bis A2-2(58) und A2-3(1) bis A2-3(62) folgendes gilt:
X₂ und R₂ entsprechen der Beschreibung in Bezug auf Anspruch 1;
X₂₁ ist O, S, N(R₂₁), C(R₂₁)(R₂₂) oder Si(R₂₁)(R₂₂);
X₂₃ ist N oder C(R₂₃);
X₂₄ ist N oder C(R₂₄);
R₂₁ bis R₂₈ entsprechen der Beschreibung in Bezug auf R₂ in Anspruch 1;
a26 ist eine ganze Zahl von 0 bis 6;
a25 ist eine ganze Zahl von 0 bis 5;
a24 ist eine ganze Zahl von 0 bis 4;
a23 ist eine ganze Zahl von 0 bis 3;
a22 ist eine ganze Zahl von 0 bis 2;
* steht für eine Bindungsstelle an A₂ oder M in Formel 1 ;
*' steht für eine Bindungsstelle an T₁ in Formel 1; und
*" steht für eine Bindungsstelle an T₂ in Formel 1.

6. Organometallische Verbindung nach einem der Ansprüche 1 bis 5, wobei
ein Anteil dargestellt durch 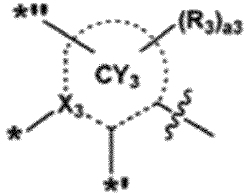 dargestellt ist durch eine der Formeln A3-1(1) bis A3-1(12): 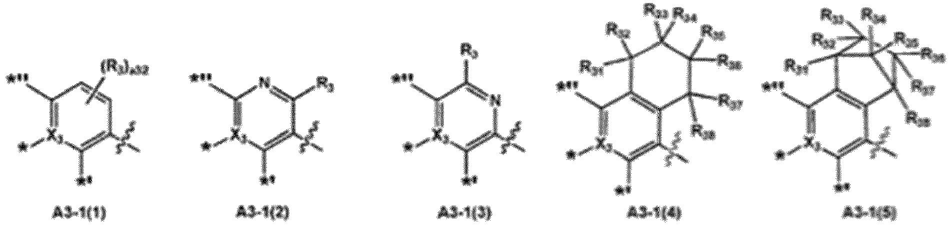 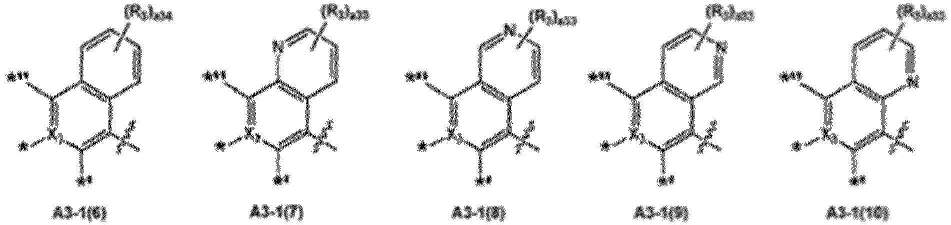 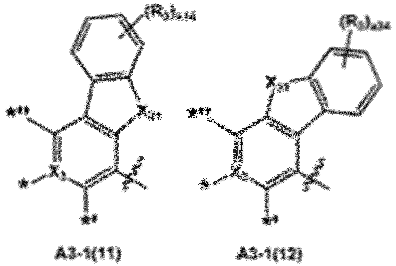 wobei in den Formeln A3-1(1) bis A3-1(12) folgendes gilt:
X₃ und R₃ entsprechen der Beschreibung in Bezug auf Anspruch 1;
X₃₁ ist O, S, N(R₃₁), C(R₃₁)(R₃₂) oder Si(R₃₁)(R₃₂);
R₃₁ bis R₃₈ entsprechen der Beschreibung in Bezug auf R₃ in Anspruch 1;
a34 ist eine ganze Zahl von 0 bis 4;
a33 ist eine ganze Zahl von 0 bis 3;
a32 ist eine ganze Zahl von 0 bis 2;
* steht für eine Bindungsstelle an A₃ oder M in Formel 1 ;
*" steht für eine Bindungsstelle an T₂ in Formel 1; und
*' steht für eine Bindungsstelle an Y₄₁ in Formel 1; und
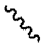 steht für eine Bindungsstelle an Ring CY₅ in Formel 1.

7. Organometallische Verbindung nach einem der Ansprüche 1 bis 6, wobei
ein Anteil dargestellt durch 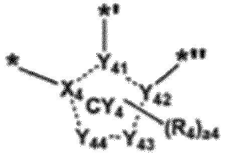 dargestellt ist durch eine der Formeln A4-1(1) bis A4(1(12): 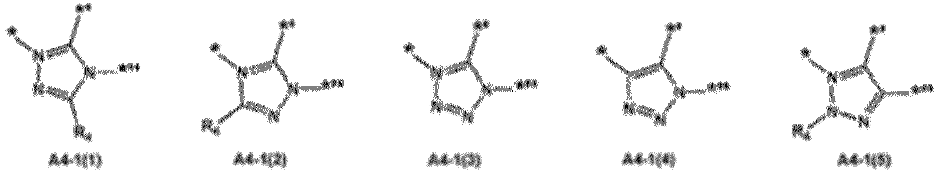 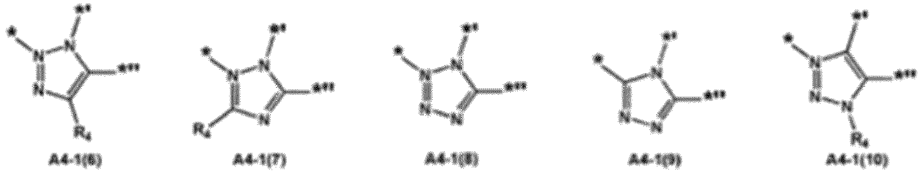 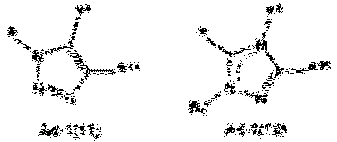 wobei in den Formeln A4-1(1) bis A4-1(12) folgendes gilt:
X₄ und R₄ entsprechen der Beschreibung in Bezug auf Anspruch 1;
* steht für eine Bindungsstelle an M in Formel 1;
*' steht für eine Bindungsstelle an Ring CY₃ in Formel 1; und
*" steht für eine Bindungsstelle an Ring CY₅ in Formel 1.

8. Organometallische Verbindung nach einem der Ansprüche 1 bis 7, wobei
ein Anteil dargestellt durch 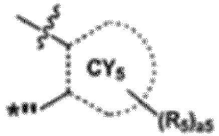 dargestellt ist durch eine der Formeln A5-1(1) bis A5-1(8): 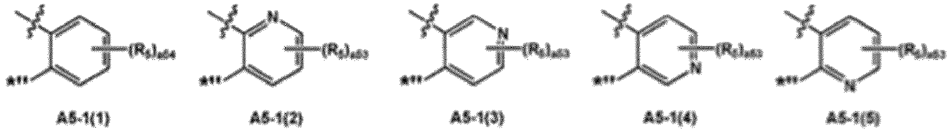 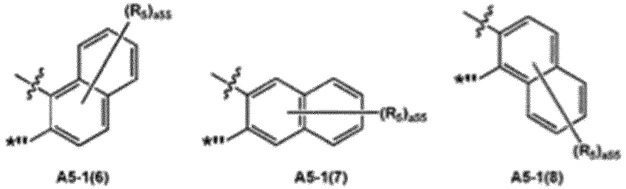 wobei in den Formeln A5-1(1) bis A5-1(8) folgendes gilt:
R₅ entspricht der Beschreibung in Bezug auf Anspruch 1;
a55 ist eine ganze Zahl von 0 bis 5;
a54 ist eine ganze Zahl von 0 bis 4;
a53 ist eine ganze Zahl von 0 bis 3;
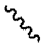 steht für eine Bindungsstelle an Ring CY₃ in Formel 1;
*" steht für eine Bindungsstelle an Y₄₂ in Formel 1.

9. Organometallische Verbindung nach einem der Ansprüche 1 bis 8, wobei
ein Anteil dargestellt durch 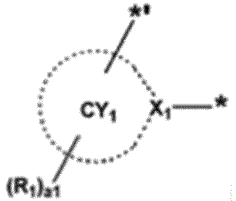 dargestellt ist durch eine der Formeln CY1-1 bis CY1-59,
ein Anteil dargestellt durch 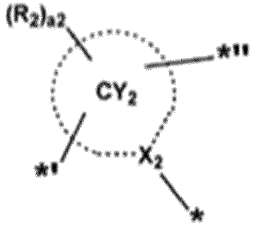 dargestellt ist durch eine der Formeln CY2-1 bis CY2-34,
ein Anteil dargestellt durch 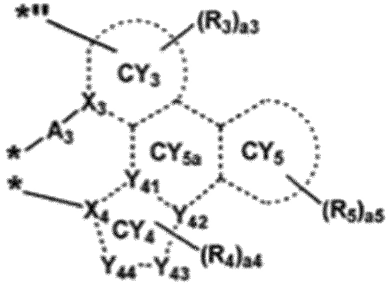 dargestellt ist durch eine der Formeln CY3-1 bis CY3-6: 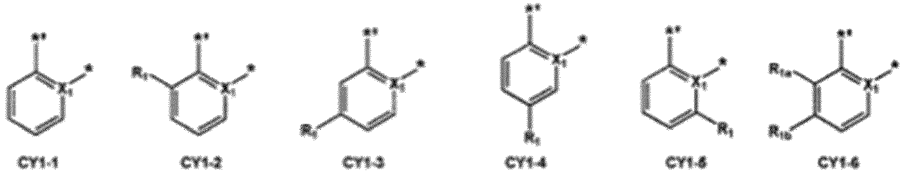 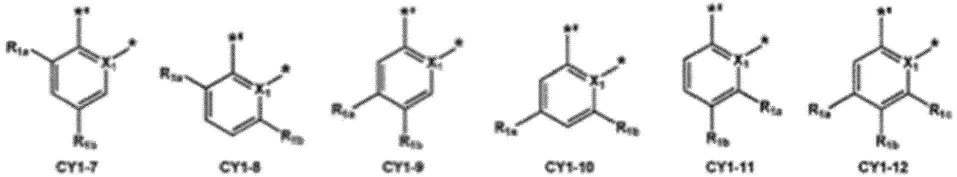 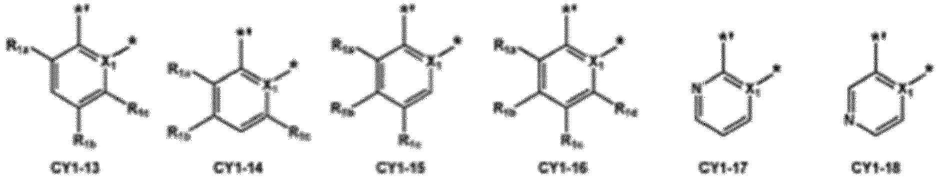 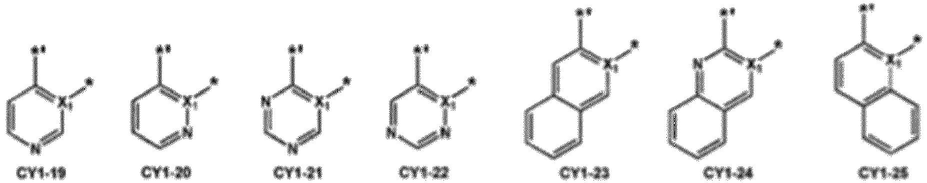 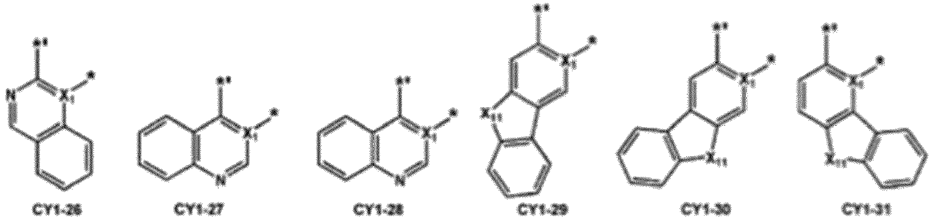 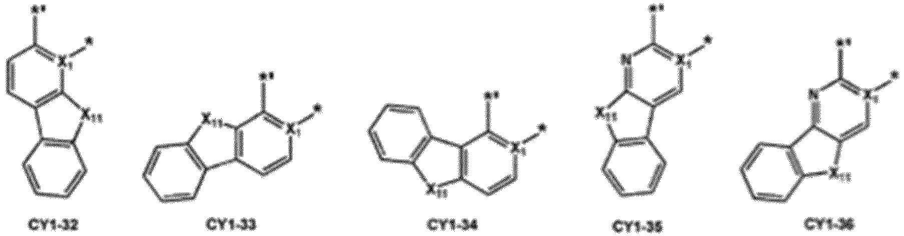 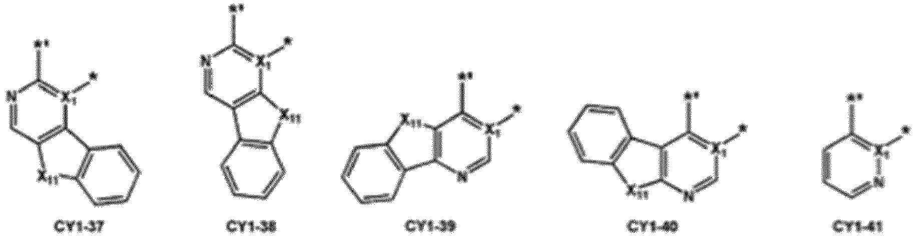 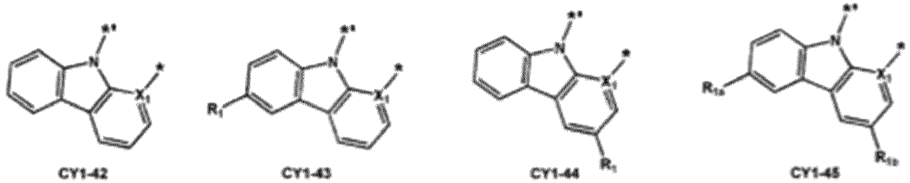 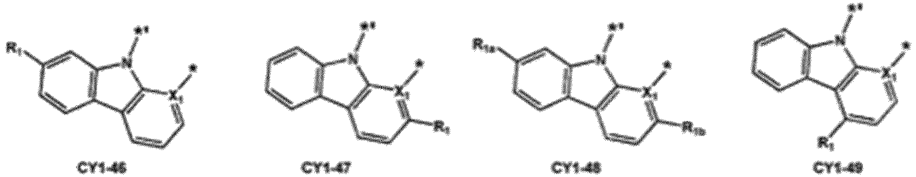 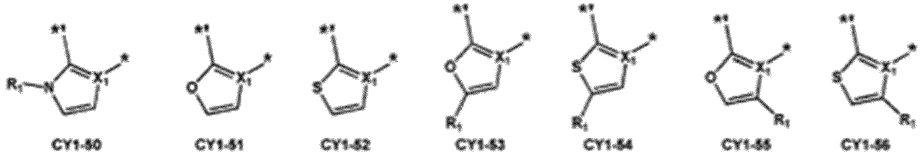 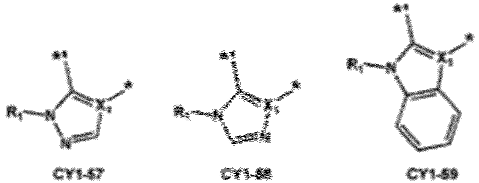 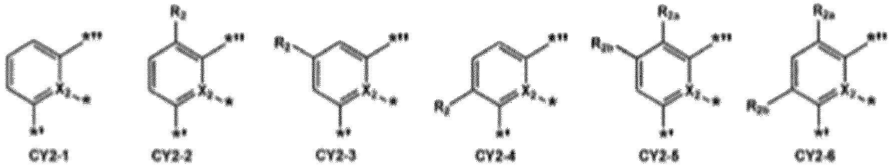 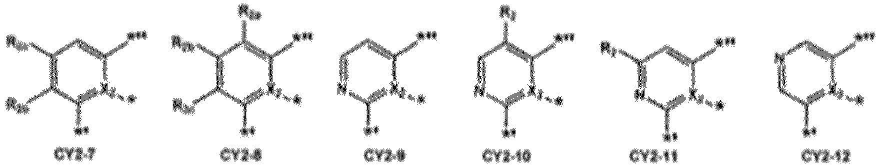 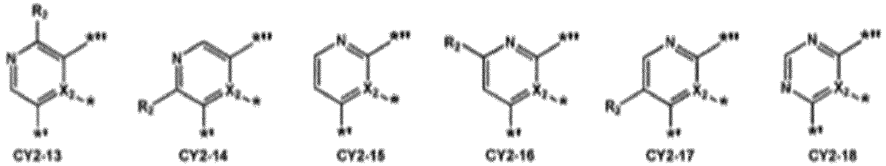 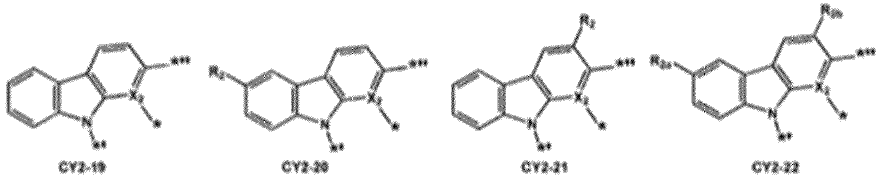 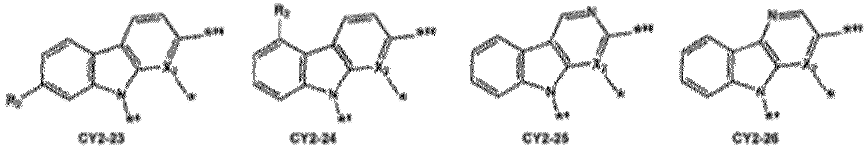 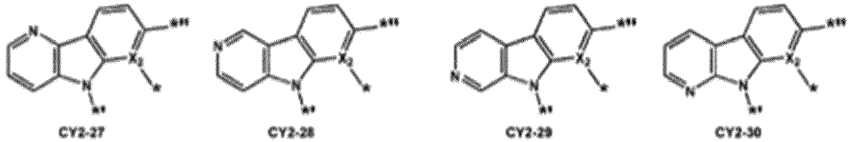 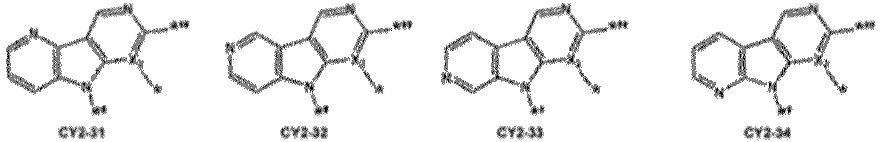 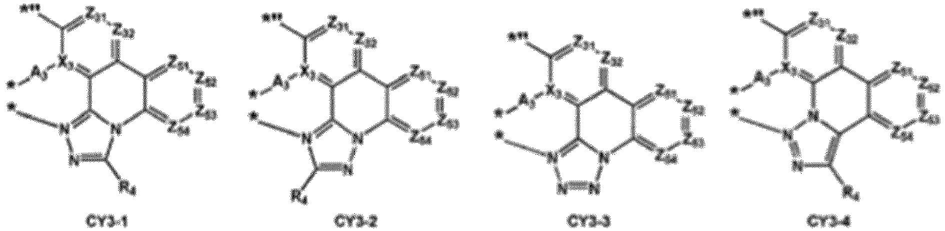 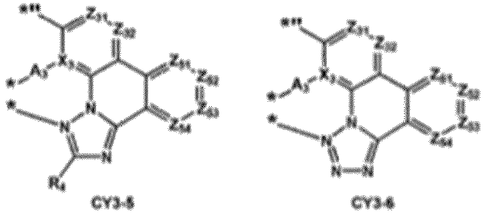 wobei in den Formeln CY1-1 bis CY1-59, CY2-1 bis CY2-34 und CY3-1 bis CY3-6 folgendes gilt:
A₃, X₁ bis X₃ und R₁ bis R₄ entsprechen der Beschreibung in Bezug auf Anspruch 1;
X₁₁ ist O, S, N(R₁₁), C(R₁₁)(R₁₂) oder Si(R₁₁)(R₁₂);
R₁ₐ bis R_{1d}, R₁₁ und R₁₂ entsprechen der Beschreibung in Bezug auf R₁;
R₂ₐ bis R_{2c} entsprechen der Beschreibung in Bezug auf R₂;
Z₃₁ ist N oder C(R₃₁) und Z₃₂ ist N oder C(R₃₂);
R₃₁ und R₃₂ entsprechen der Beschreibung in Bezug auf R₃;
Z₅₁ ist N oder C(R₅₁), Z₅₂ ist N oder C(R₅₂), Z₅₃ ist N oder C(R₅₃), Z₅₄ ist N oder C(R₅₄);
R₅₁ bis R₅₄ entsprechen der Beschreibung in Bezug auf R₅;
jedes R₁, R₂, R₁ₐ bis R_{1d} und R₂ₐ bis R_{2c} ist nicht Wasserstoff;
in Bezug auf die Formeln CY1-1 bis CY1-59 steht * für eine Bindungsstelle an A₁ oder M in Formel 1 und *' steht für eine Bindungsstelle an T₁ in Formel 1;
in Bezug auf die Formeln CY2-1 bis CY2-34 steht * für eine Bindungsstelle an A₂ oder M in Formel 1, *' steht für eine Bindungsstelle an T₁ in Formel 1 und *" steht für eine Bindungsstelle an T₂ in Formel 1; und
in Bezug auf die Formeln CY3-1 bis CY3-6 stehen zwei * jeweils für eine Bindungsstelle an M in Formel 1 und *" steht für eine Bindungsstelle an T₂ in Formel 1.

10. Organometallische Verbindung nach einem der Ansprüche 1 bis 9, wobei die organometallische Verbindung durch Formel 1-1 oder 1-2 dargestellt ist: 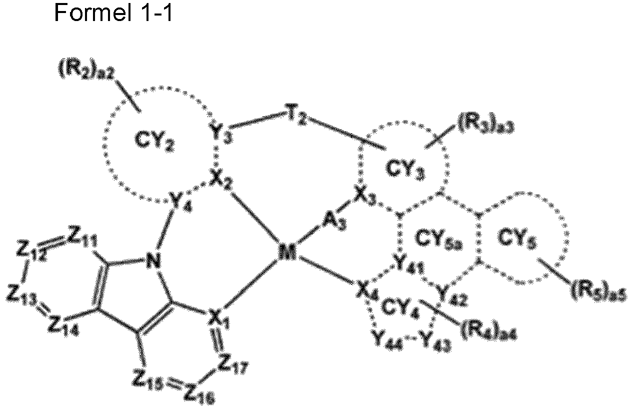 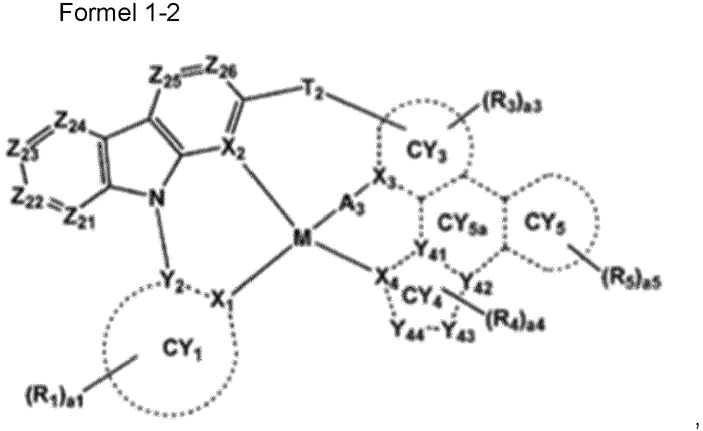 wobei in den Formeln 1-1 und 1-2 folgendes gilt:
M, X₁ bis X₄, Y₄₁ bis Y₄₄, A₃, Ring CY₁ bis CY₅, Ring CY₅ₐ, R₁ bis R₅ und a1 bis a5 entsprechen jeweils der Beschreibung in Bezug auf Anspruch 1;
T₂ ist *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*' oder*-C(=S)-*', und R₈ und R₉ entsprechen der Beschreibung in Bezug auf Anspruch 1;
Y₂ bis Y₄ sind jeweils unabhängig C oder N;
eine Bindung zwischen X₂ und Y₃, eine Bindung zwischen X₂ und Y₄ und eine Bindung zwischen X₁ und Y₂ sind jeweils unabhängig eine Einzelbindung oder eine Doppelbindung;
Z₁₁ ist N oder C(R₁₁), Z₁₂ ist N oder C(R₁₂), Z₁₃ ist N oder C(R₁₃), Z₁₄ ist N oder C(R₁₄), Z₁₅ ist N oder C(R₁₅), Z₁₆ ist N oder C(R₁₆), Z₁₇ ist N oder C(R₁₇), Z₂₁ ist N oder C(R₂₁), Z₂₂ ist N oder C(R₂₂), Z₂₃ ist N oder C(R₂₃), Z₂₄ ist N oder C(R₂₄), Z₂₅ ist N oder C(R₂₅), Z₂₆ ist N oder C(R₂₆);
R₁₁ bis R₁₇ entsprechen der Beschreibung in Bezug auf R₁ in Anspruch 1; und
R₂₁ bis R₂₆ entsprechen der Beschreibung in Bezug auf R₂ in Anspruch 1;
wobei die organometallische Verbindung vorzugsweise eine der Verbindungen 1 bis 196 ist:

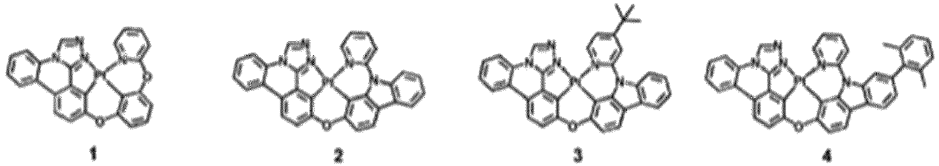

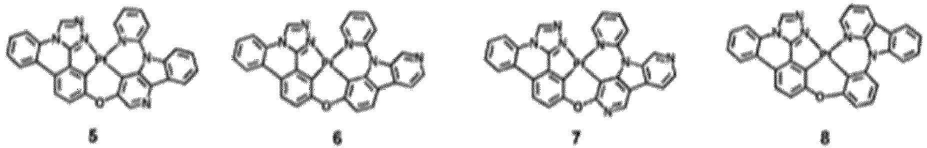

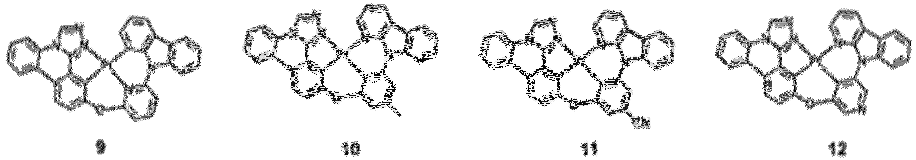

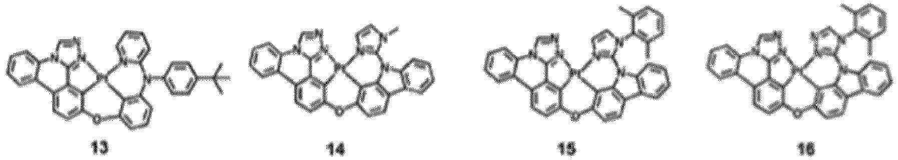

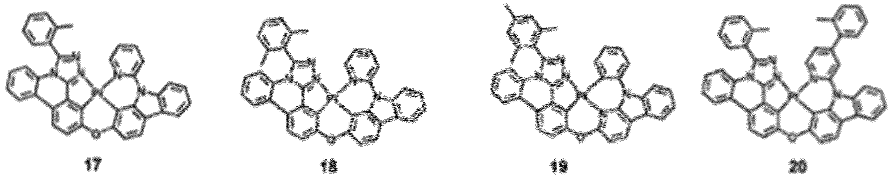

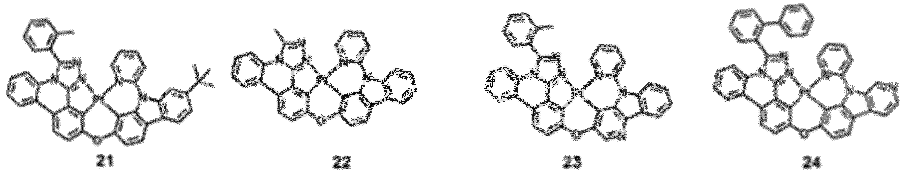

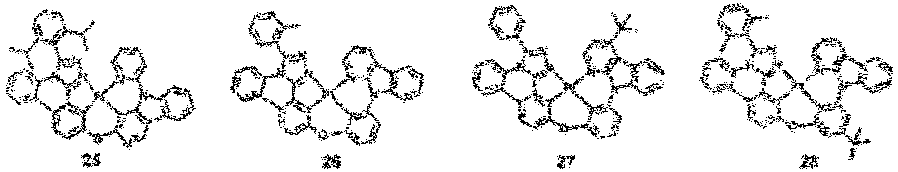

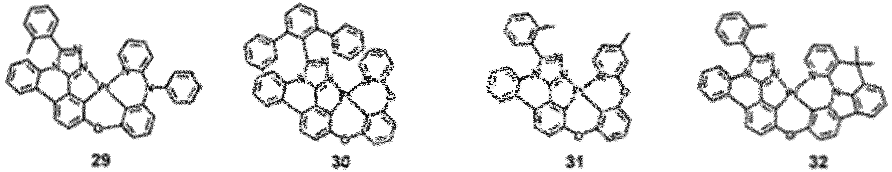

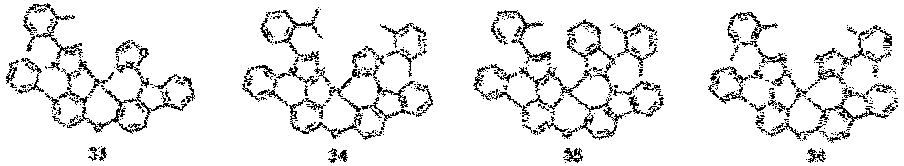

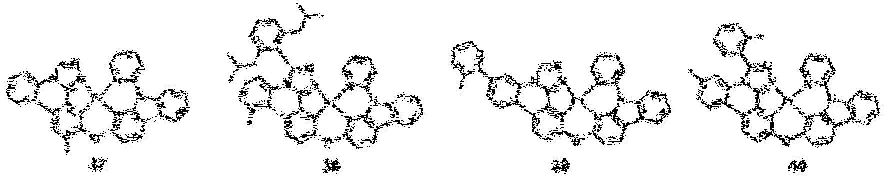

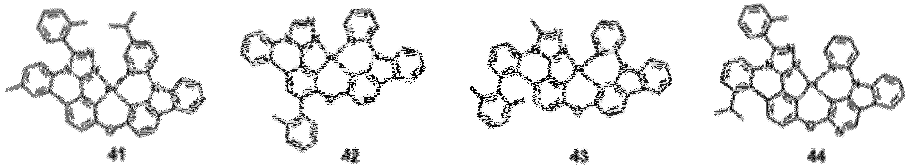

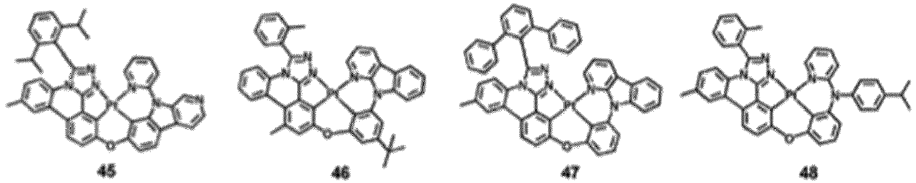

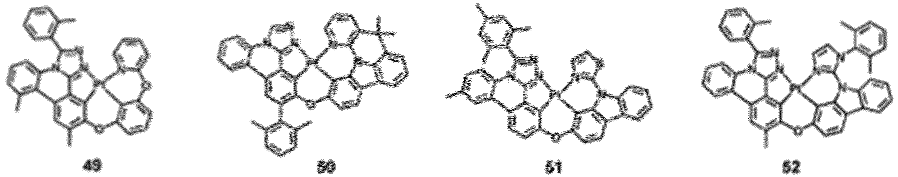

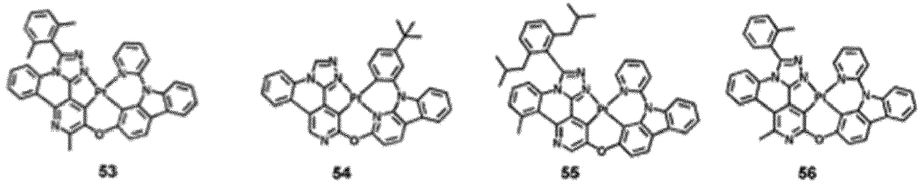

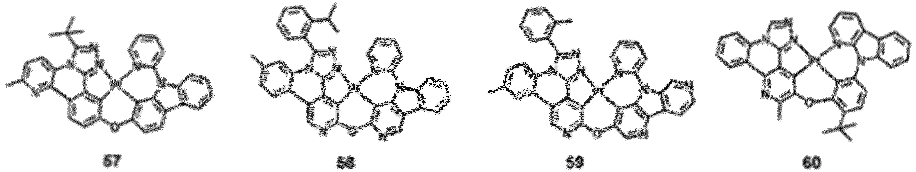

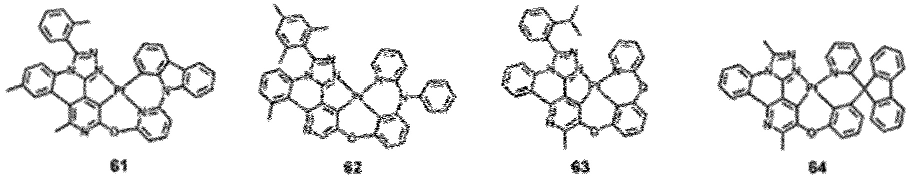

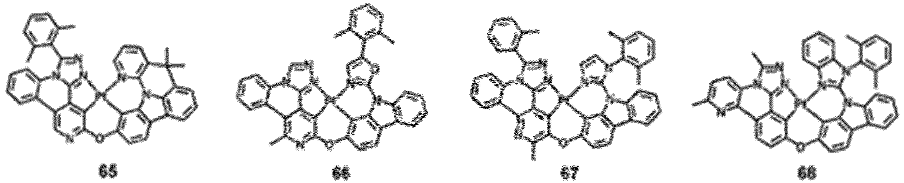

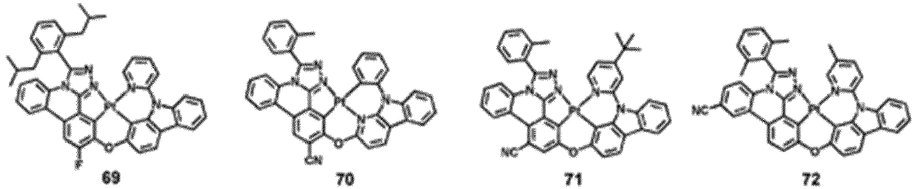

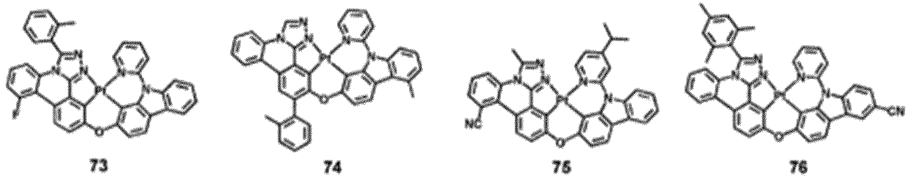

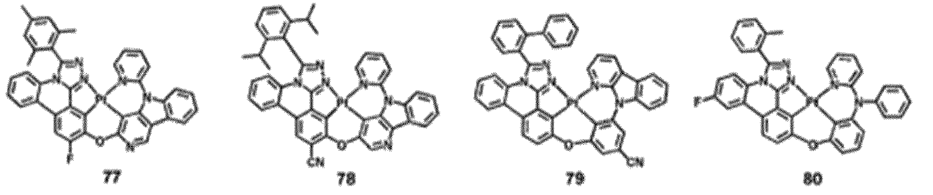

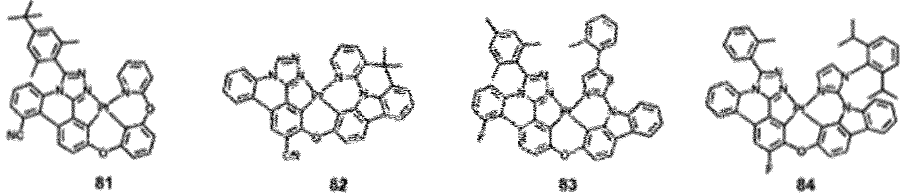

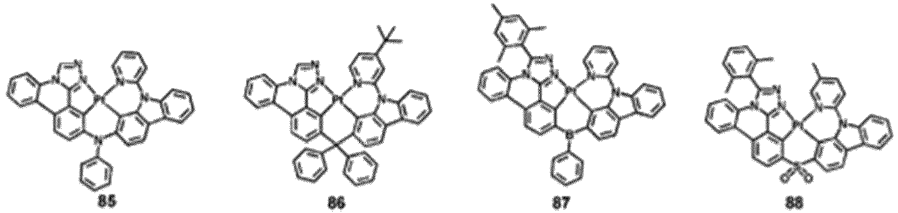

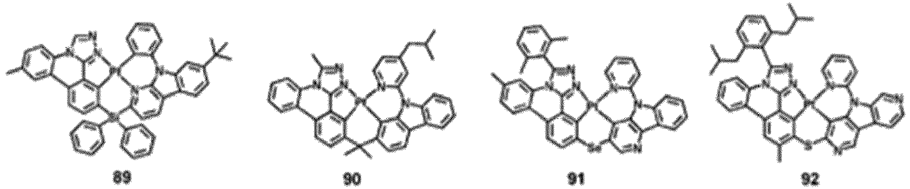

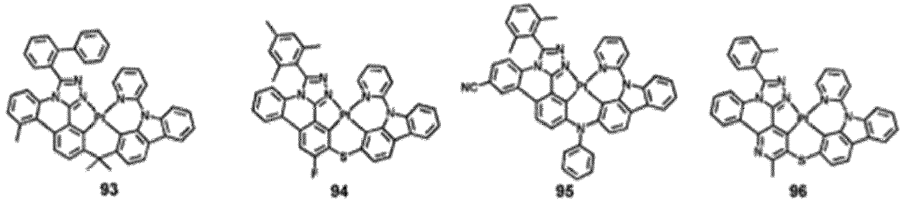

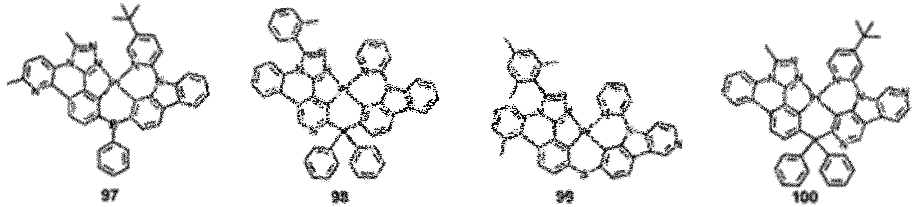

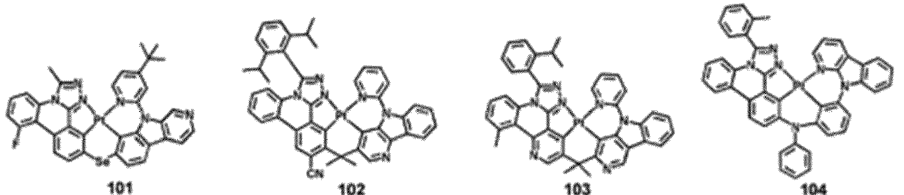

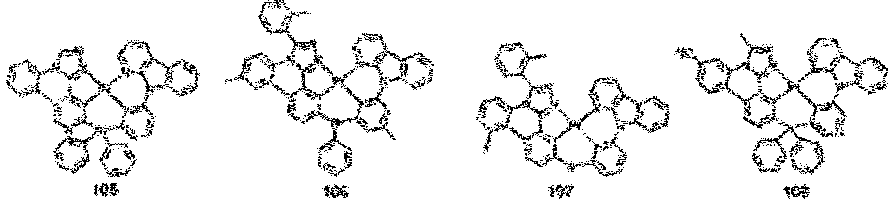

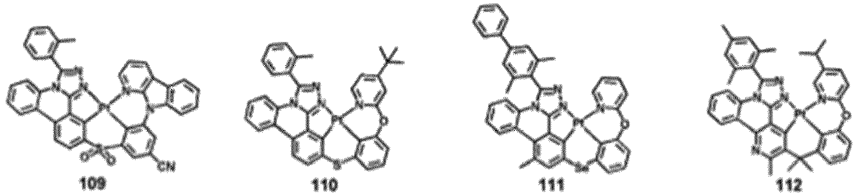

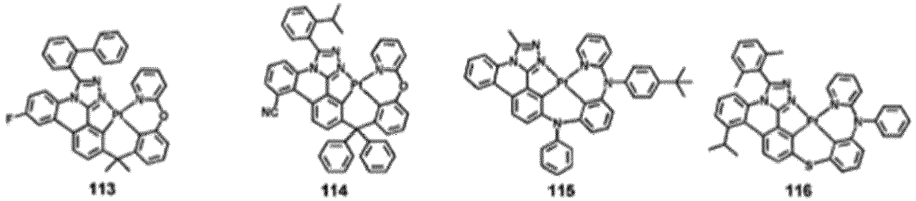

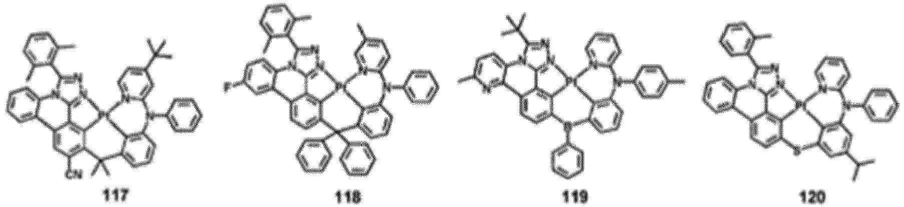

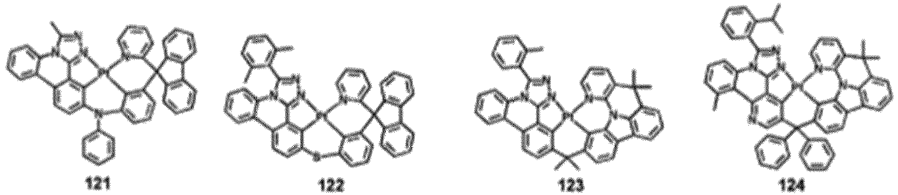

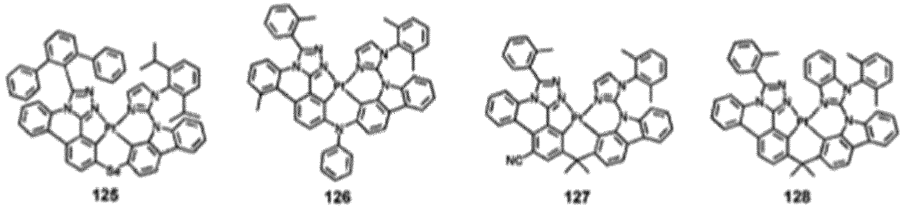

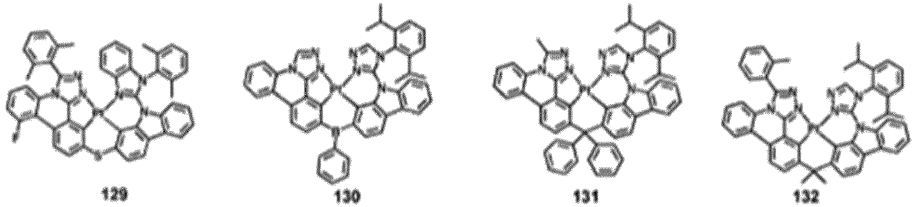

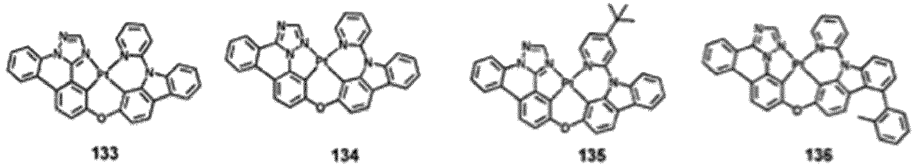

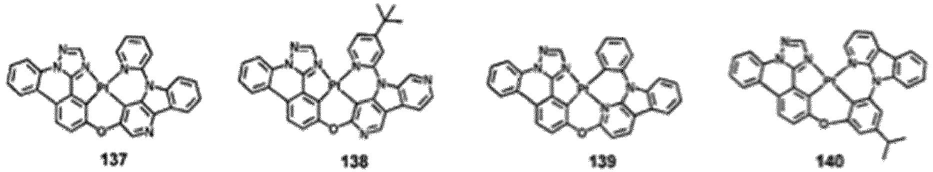

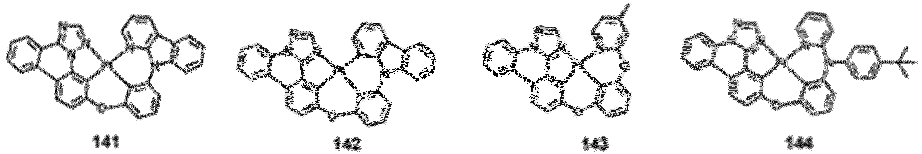

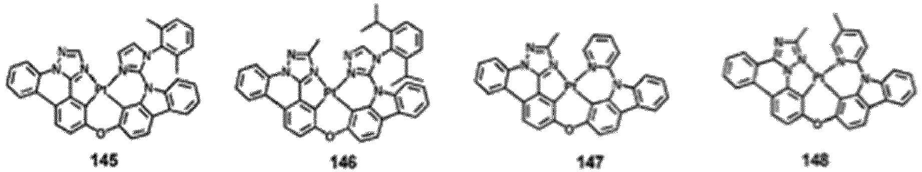

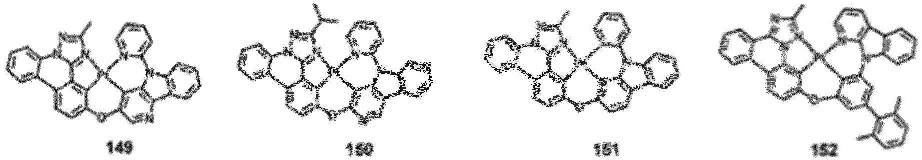

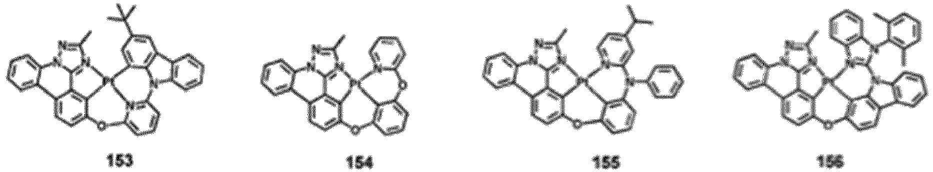

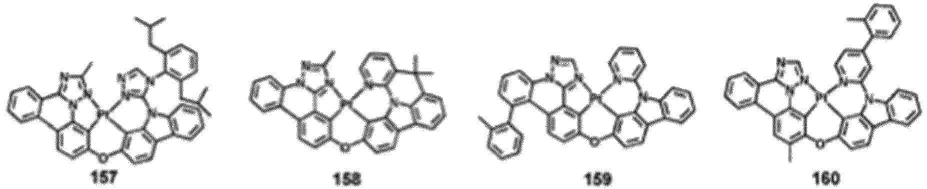

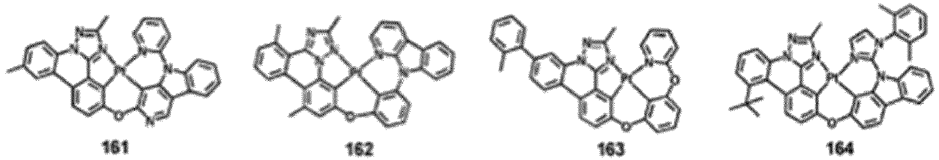

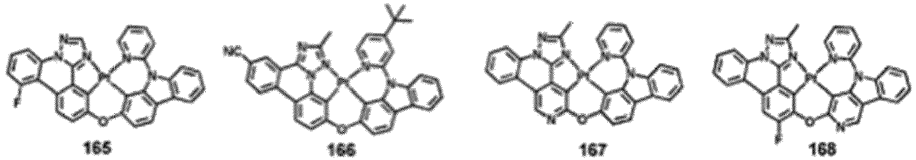

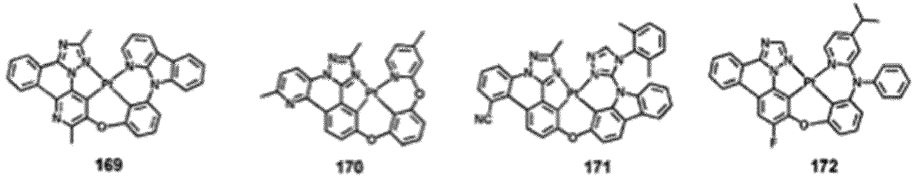

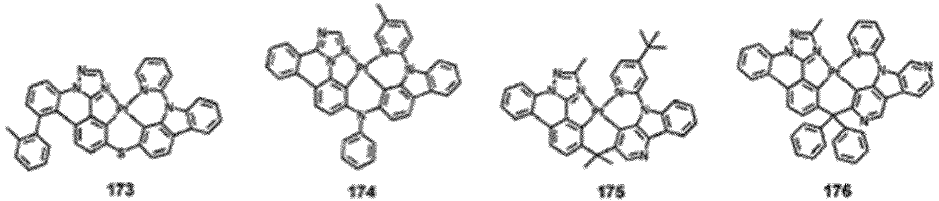

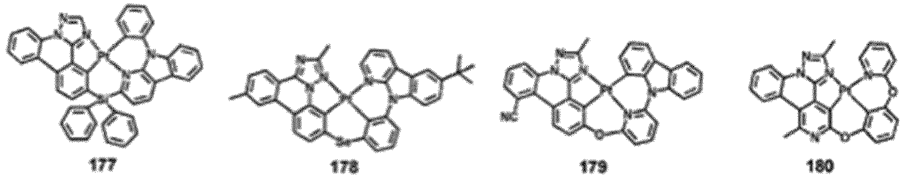

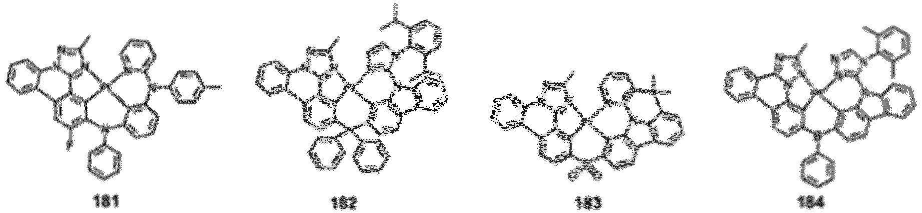

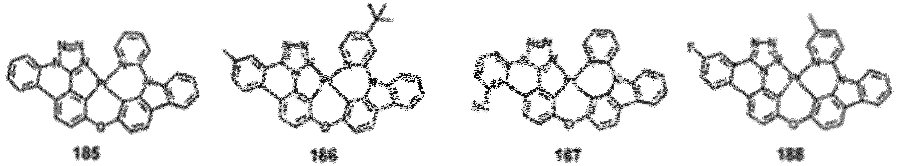

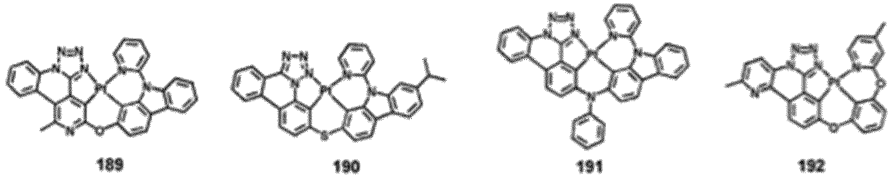

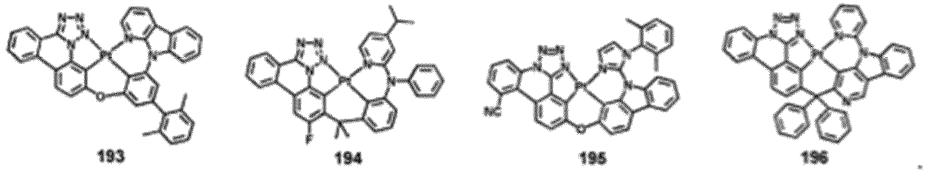

11. Organometallische Verbindung nach einem der Ansprüche 1 bis 10, wobei
eine Spitze eines Photolumineszenzspektrum der organischen Verbindung eine maximale Emissionswellenlänge von 420 Nanometern bis 500 Nanometern aufweist sowie eine Halbwertsbreite (FWHM) von 30 Nanometern bis 80 Nanometern.

12. Organische lichtemittierende Vorrichtung, umfassend:
eine erste Elektrode;
eine zweite Elektrode; und
eine organische Schicht, die sich zwischen der ersten Elektrode und der zweiten Elektrode befindet;
wobei die organische Schicht eine Emissionsschicht umfasst und mindestens eine organische Verbindung nach einem der Ansprüche 1 bis 11;
wobei vorzugsweise
die erste Elektrode eine Anode ist;
die zweite Elektrode eine Kathode ist;
die organische Schicht ferner eine Lochtransportregion aufweist, die sich zwischen der ersten Elektrode und der Emissionsschicht befindet, und eine Elektronentransportregion, die sich zwischen der Emissionsschicht und der zweiten Elektrode befindet;
die Lochtransportregion eine Lochinjektionsschicht, eine Lochtransportschicht, eine Elektronensperrschicht, eine Pufferschicht oder eine beliebige Kombination davon aufweist; und
die Elektronentransportregion eine Lochsperrschicht, eine Elektronentransportschicht, eine Elektroneninjektionsschicht oder eine beliebige Kombination davon aufweist.

13. Organische lichtemittierende Vorrichtung nach Anspruch 12, wobei die organometallische Verbindung in der Emissionsschicht enthalten ist.

14. Organische lichtemittierende Vorrichtung nach Anspruch 13, wobei
das von der Emissionsschicht emittierte Licht blaues Licht ist, und
wobei das blaue Licht eine CIE Y-Koordinate im Bereich von 0,10 bis 0,340 aufweist; und oder
wobei die Emissionsschicht ferner einen Wirt aufweist, und wobei die Menge des Wirts größer ist als die Menge der organometallischen Verbindung.

15. Diagnostische Zusammensetzung, die mindestens eine organometallische Verbindung nach einem der Ansprüche 1 bis 11 umfasst.

## Revendications

1. Composé organométallique représenté par la Formule 1 : 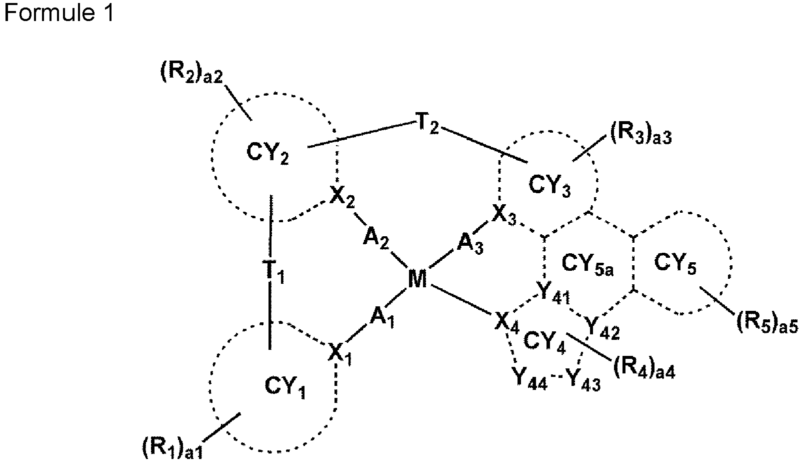 dans lequel, dans la Formule 1,
M est le béryllium (Be), le magnésium (Mg), l'aluminium (Al), le calcium (Ca), le titane (Ti), le manganèse (Mn), le cobalt (Co), le cuivre (Cu), le zinc (Zn), le gallium (Ga), le germanium (Ge), le zirconium (Zr), le ruthénium (Ru), le rhodium (Rh), le palladium (Pd), l'argent (Ag), le rhénium (Re), le platine (Pt), ou l'or (Au),
X₁ à X₄, Y₄₁, et Y₄₂ sont chacun indépendamment C ou N,
Y₄₃ et Y₄₄ sont chacun indépendamment C, N, O, S, ou Si,
A₁ à A₃ sont chacun indépendamment une liaison chimique, O, S, B(R'), N(R'), P(R'), C(R')(R"), Si(R')(R"), Ge(R')(R"), C(=O), B(R')(R"), N(R')(R"), ou P(R')(R"), lorsqu'A₁ est une liaison chimique, X₁ étant directement relié à M ; lorsqu'A₂ est une liaison chimique, X₂ étant directement relié à M ; et lorsqu'A₃ est une liaison chimique, X₃ étant directement relié à M,
deux choisies parmi une liaison entre X₁ ou A₁ et M, une liaison entre M et X₂ ou A₂, une liaison entre X₃ ou A₃ et M, et une liaison entre X₄ et M sont des liaisons coordonnées, et les deux liaisons restantes sont des liaisons covalentes,
le cycle CY₁ au cycle CY₃ et le cycle CY₅ sont chacun indépendamment un groupe carbocyclique en C₅-C₃₀ ou un groupe hétérocyclique en C₁-C₃₀,
le cycle CY₄ est un cycle à 5 chaînons, et trois ou plus choisis parmi X₄, Y₄₁, Y₄₂, Y₄₃, et Y₄₄ du cycle CY₄ sont chacun N,
le cycle CY₅ₐ est un cycle à 6 chaînons,
T₁ est une simple liaison, une double liaison, *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)-*', *-C(=S)-*', ou *-C≡C-*',
T₂ est une simple liaison, une double liaison, *-N(R₈)-*', *-B(R₈)-*', *-P(R₈)-*', *-C(R₈)(R₉)-*', *- Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', ou *-C≡C-*',
R₁ à R₉, R' et R" sont chacun choisis indépendamment parmi l'hydrogène, le deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe aryloxy en C₆-C₆₀ substitué ou non substitué, un groupe arylthio en C₆-C₆₀ substitué ou non substitué, un groupe arylalkyle en C₇-C₆₀ substitué ou non substitué, un groupe hétéroaryle en C₁-C₆₀ substitué ou non substitué, un groupe hétéroaryloxy en C₁-C₆₀ substitué ou non substitué, un groupe hétéroarylthio en C₁-C₆₀ substitué ou non substitué, un groupe hétéroarylalkyle en C₂-C₆₀ substitué ou non substitué, un groupe alkylhétéroaryle en C₂-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅),-B(Q₆)(Q₇), et -P(=O)(Q₈)(Q₉),
a1 à a3 et a5 sont chacun indépendamment un entier de 0 à 20,
a4 est un entier de 0 à 2,
deux d'une pluralité de groupes R₁ voisins sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
deux d'une pluralité de groupes R₂ voisins sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
deux d'une pluralité de groupes R₃ voisins sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
deux d'une pluralité de groupes R₄ voisins sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
deux d'une pluralité de groupes R₅ voisins sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
deux de R₁ à R₉, R' et R" sont éventuellement reliés l'un avec l'autre pour former un groupe carbocyclique en C₅-C₃₀ non substitué ou substitué avec au moins un R₁₀ₐ ou un groupe hétérocyclique en C₁-C₃₀ non substitué ou substitué avec au moins un R₁₀ₐ,
R₁₀ₐ est le même que décrit en connexion avec R₁,
* et *" indiquent chacun un site de liaison à un atome voisin,
au moins un substituant du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe alkylaryle en C₇-C₆₀ substitué, du groupe aryloxy en C₆-C₆₀ substitué, du groupe arylthio en C₆-C₆₀ substitué, du groupe arylalkyle en C₇-C₆₀ substitué, du groupe hétéroaryle en C₁-C₆₀ substitué, du groupe hétéroaryloxy en C₁-C₆₀ substitué, du groupe hétéroarylthio en C₁-C₆₀ substitué, du groupe hétéroarylalkyle en C₂-C₆₀ substitué, du groupe alkylhétéroaryle en C₂-C₆₀ substitué, du groupe polycyclique condensé non aromatique monovalent substitué, et du groupe hétéropolycyclique condensé non aromatique monovalent substitué est choisi parmi :
le deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun substitués avec au moins un choisi parmi le deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe arylalkyle en C₇-C₆₀, un groupe hétéroaryle en C₁-C₆₀, un groupe hétéroaryloxy en C₁-C₆₀, un groupe hétéroarylthio en C₁-C₆₀, un groupe hétéroarylalkyle en C₂-C₆₀, un groupe alkylhétéroaryle en C₂-C₆₀, un groupe polycylique condensé non aromatique monovalent, un groupe hétéropolycyclique condensé non aromatique monovalent, -N(Q₁₁)(Q₁₂), - Si(Q₁₃)(Q₁₄)(Q₁₅), -B(Q₁₆)(Q₁₇) et -P(=O)(Q₁₈)(Q₁₉) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe arylalkyle en C₇-C₆₀, un groupe hétéroaryle en C₁-C₆₀, un groupe hétéroaryloxy en C₁-C₆₀, un groupe hétéroarylthio en C₁-C₆₀, un groupe hétéroarylalkyle en C₂-C₆₀, un groupe polycyclique condensé non aromatique monovalent, et un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe arylalkyle en C₇-C₆₀, un groupe hétéroaryle en C₁-C₆₀, un groupe hétéroaryloxy en C₁-C₆₀, un groupe hétéroarylthio en C₁-C₆₀, un groupe hétéroarylalkyle en C₂-C₆₀, un groupe alkylhétéroaryle en C₂-C₆₀, un groupe polycyclique condensé non aromatique monovalent, et un groupe hétéropolycyclique condensé non aromatique monovalent, chacun substitués avec au moins un choisi parmi le deutérium, -F, -Cl, -Br, -I, -CD₃, -CD₂H, -CDH₂, - CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe arylalkyle en C₇-C₆₀, un groupe hétéroaryle en C₁-C₆₀, un groupe hétéroaryloxy en C₁-C₆₀, un groupe hétéroarylthio en C₁-C₆₀, un groupe hétéroarylalkyle en C₂-C₆₀, un groupe alkylhétéroaryle en C₂-C₆₀, un groupe polycyclique condensé non aromatique monovalent, un groupe hétéropolycyclique condensé non aromatique monovalent,-N(Q₂₁)(Q₂₂), Si(Q₂₃)(Q₂₄)(Q₂₅), -B(Q₂₆)(Q₂₇), et -P(=O)(Q₂₈)(Q₂₉) ; et
-N(Q₃₁)(Q₃₂), -Si(Q₃₃)(Q₃₄)(Q₃₅), -B(Q₃₆)(Q₃₇), et -P(=O)(Q₃₈)(Q₃₉) ;
Q₁ à Q₉, Q₁₁ à Q₁₉, Q₂₁ à Q₂₉, et Q₃₁ à Q₃₉ étant chacun choisis indépendamment parmi l'hydrogène, le deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryle en C₆-C₆₀ substitué avec au moins un choisi parmi un groupe alkyle en C₁-C₆₀ et un groupe aryle en C₆-C₆₀, un groupe aryloxy en C₆-C₆₀, un groupe arylthio en C₆-C₆₀, un groupe arylalkyle en C₇-C₆₀, un groupe hétéroaryle en C₁-C₆₀, un groupe hétéroaryloxy en C₁-C₆₀, un groupe hétéroarylthio en C₁-C₆₀, un groupe hétéroarylalkyle en C₂-C₆₀, un groupe alkylhétéroaryle en C₂-C₆₀, un groupe polycyclique condensé non aromatique monovalent, et un groupe hétéropolycyclique condensé non aromatique monovalent.

2. Composé organométallique de la revendication 1, dans lequel
M est Pt, Pd, ou Au ; et/ou
dans lequel
le cycle CY₁ est un groupe oxazole, un groupe isoxazole, un groupe oxadiazole, un groupe isoxadiazole, un groupe oxatriazole, un groupe thiazole, un groupe isothiazole, un groupe thiadiazole, un groupe isothiadiazole, un groupe thiatriazole, un groupe pyrazole, un groupe imidazole, un groupe triazole, un groupe tétrazole, un groupe azasilole, un groupe diazasilole, un groupe triazasilole, un groupe benzimidazole, un groupe benzoxazole, un groupe benzthiazole, un groupe benzène, un groupe pyridine, un groupe pyrimidine, un groupe pyrazine, un groupe pyridazine, un groupe triazine, un groupe carbazole, ou un groupe azacarbazole,
le cycle CY₂ est un groupe benzène, un groupe pyridine, un groupe pyrimidine, un groupe pyrazine, un groupe pyridazine, un groupe triazine, un groupe carbazole, ou un groupe azacarbazole,
le cycle CY₃ et le cycle CY₅ sont chacun indépendamment un groupe benzène, un groupe pyridine, un groupe pyrimidine, un groupe pyrazine, un groupe pyridazine, ou un groupe triazine, et
le cycle CY₄ est un groupe triazole ou un groupe tétrazole ; et/ou dans lequel
R₁ à R₉, R', et R" sont chacun choisis indépendamment parmi :
l'hydrogène, le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci,-SF₅, un groupe alkyle en C₁-C₂₀, et un groupe alcoxy en C₁-C₂₀ ;
un groupe alkyle en C₁-C₂₀ et un groupe alcoxy en C₁-C₂₀, chacun substitués avec au moins un choisi parmi le deutérium, -F, -Cl, -Br, -I, -CD₃, -CD₂H, -CDH₂, -CF₃,-CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₁₀, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe naphtyle, un groupe pyridinyle, et un groupe pyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle en C₁-C₂₀, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle en C₁-C₂₀, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitués avec au moins un choisi parmi le deutérium, -F, -Cl, -Br, -I, -CD₃, - CD₂H, -CDH₂, -CF₃, -CF₂H,-CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle en C₁-C₂₀, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et
-N(Q₁)(Q₂), -Si(Q₃)(Q₄)(Q₅), -B(Q₆)(Q₇) et -P(=O)(Q₈)(Q₉) ; et
Q₁ à Q₉ sont chacun choisis indépendamment parmi :
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CH₃, -CD₂CD₃, -CD₂CD₂H, et-CD₂CDH₂ ;
un groupe n-propyle, un groupe iso-propyle, un groupe n-butyle, un groupe iso-butyle, un groupe sec- butyle, un groupe tert-butyle, un groupe n-pentyle, un groupe iso-pentyle, un groupe sec-pentyle, un groupe tert-pentyle, un groupe phényle, et un groupe naphtyle ; et
un groupe n-propyle, un groupe iso-propyle, un groupe n-butyle, un groupe iso-butyle, un groupe sec- butyle, un groupe tert-butyle, un groupe n-pentyle, un groupe iso-pentyle, un groupe sec-pentyle, un groupe tert-pentyle, un groupe phényle, et un groupe naphtyle, chacun substitués avec au moins un choisi parmi le deutérium, un groupe alkyle en C₁-C₁₀, et un groupe phényle.

3. Composé organométallique de la revendication 1 ou 2, dans lequel le composé organométallique satisfait
a) une parmi la Condition 1, la Condition 2 et la Condition 3 ;
b) une parmi la Condition 4 et la Condition 5 ; ou
c) une parmi la Condition 1, la Condition 2, et la Condition 3, et une parmi la Condition 4 et la Condition 5 ;
Condition 1
A₁ et A₂ sont chacun une liaison chimique,
une fraction représentée par 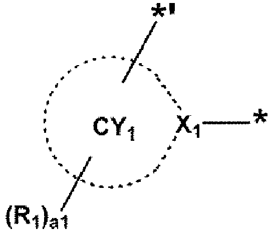 est représentée par la Formule A1-1,
T₁ est *-N(R₆)-*', *-B(R₆)-*', *-P(R₆)-*', *-C(R₆)(R₇)-*', *-Si(R₆)(R₇)-*', *-Ge(R₆)(R₇)-*', *-S-*', *-Se-*', *-O-*', *-C(=O)-*', *-S(=O)-*', *-S(=O)₂-*', *-C(R₆)=*', *=C(R₆)-*', *-C(R₆)=C(R₇)- *-C(=S)-*', ou *-C≡C-*',
une fraction représentée par 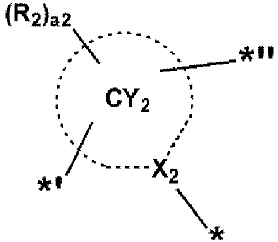 est représentée par la Formule A2-1,
Condition 2
A₁ et A₂ sont chacun une liaison chimique,
une fraction représentée par 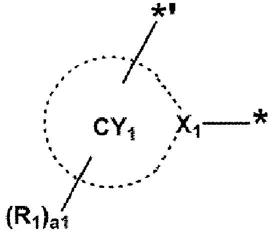 est représentée par la formule A1-2,
T₁ est une simple liaison,
une fraction représentée par 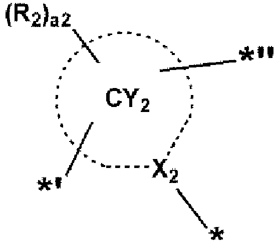 est représentée par la Formule A2-1,
Condition 3
A₁ et A₂ sont chacun une liaison chimique,
une fraction représentée par 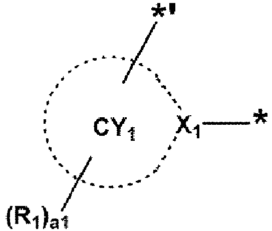 est représentée par la Formule A1-1,
T₁ est une simple liaison,
une fraction représentée par 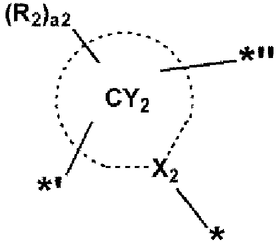 est représentée par la Formule A2-3,
Condition 4 A₂ et A₃ sont chacun une liaison chimique,
une fraction représentée par 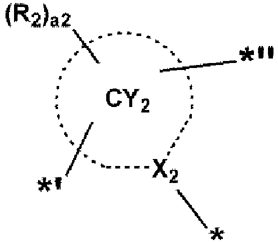 est représentée par la Formule A2-1,
T₂ est *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', ou *-C≡C-*',
Condition 5
A₂ et A₃ sont chacun une liaison chimique,
une fraction représentée par 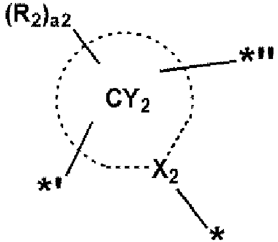 est représentée par la Formule A2-2,
T₂ est une simple liaison, 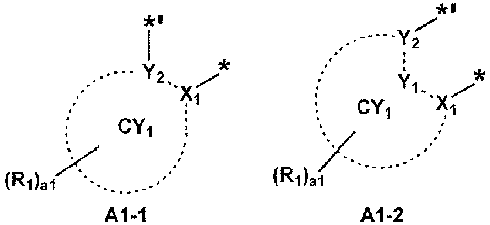 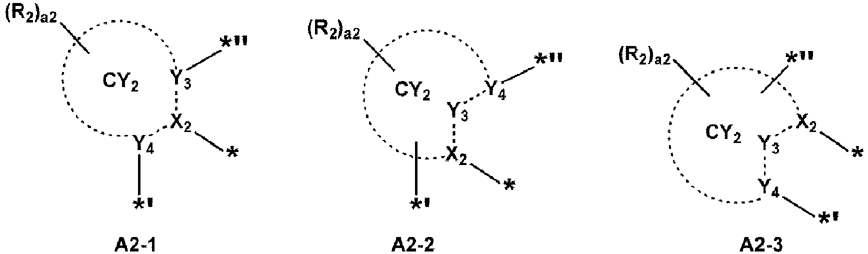 dans lequel, dans les Formules A1-1, A1-2, A2-1, A2-2, et A2-3,
X₁, X₂, le cycle CY₁, le cycle CY₂, R₁, R₂, a1, et a2 sont les mêmes que décrits dans la revendication 1,
Y₁ à Y₄ sont chacun indépendamment C ou N, une liaison entre X₁ et Y₁, une liaison entre X₁ et Y₂, une liaison entre Y₁ et Y₂, une liaison entre X₂ et Y₄, une liaison entre X₂ et Y₃, et une liaison entre Y₃ et Y₄ sont chacune indépendamment une simple liaison ou une double liaison,
en ce qui concerne les Formules A1-1 et A1-2, * indique un site de liaison à A₁ ou M dans la Formule 1 et *' indique un site de liaison à T₁ dans la Formule 1, et
en ce qui concerne les Formules A2-1, A2-2, et A2-3, * indique un site de liaison à A₂ ou M dans la Formule 1, *' indique un site de liaison à T₁ dans la Formule 1, et *" indique un site de liaison à T₂ dans la Formule 1.

4. Composé organométallique de l'une quelconque des revendications 1 à 3, dans lequel
une fraction représentée par 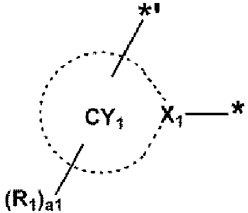 est représentée par une des Formules A1-1(1) à A1-1(54) et A1-2(1) à A1-2(74) : 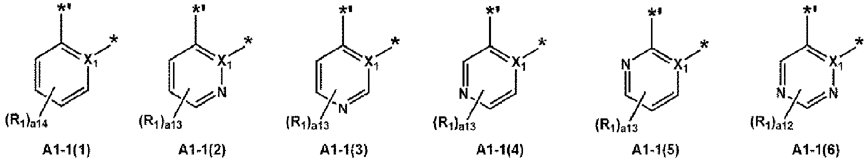 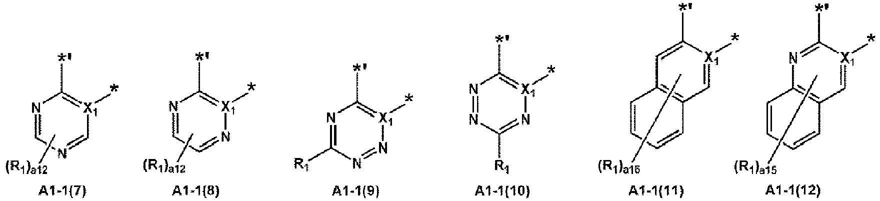 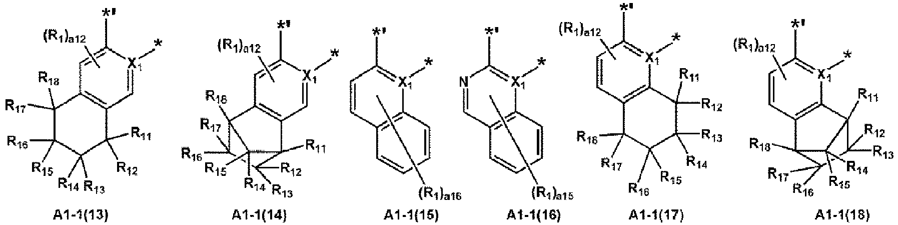 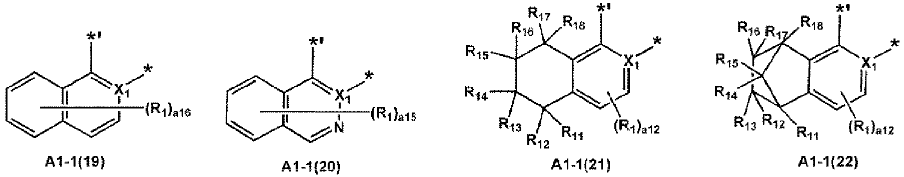 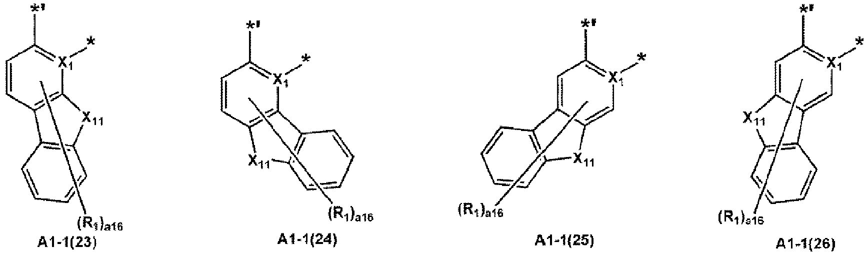 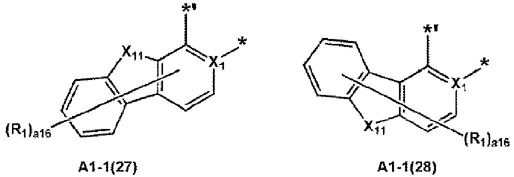 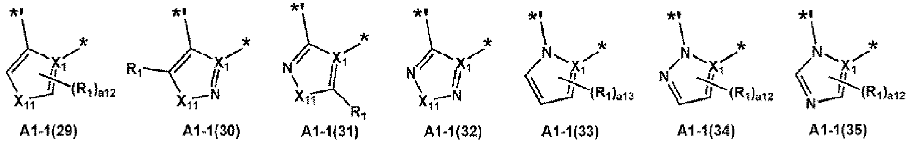 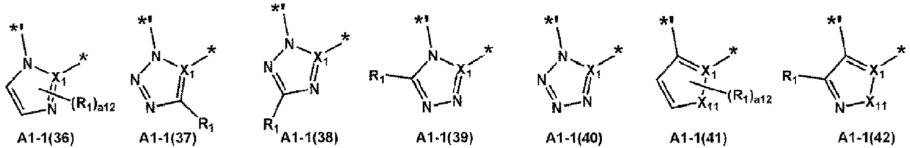 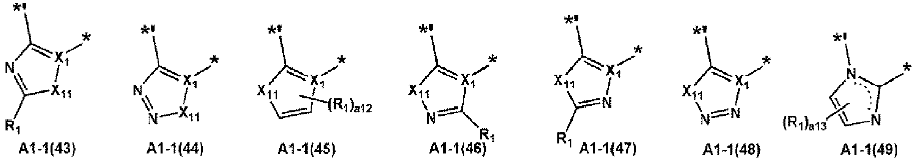 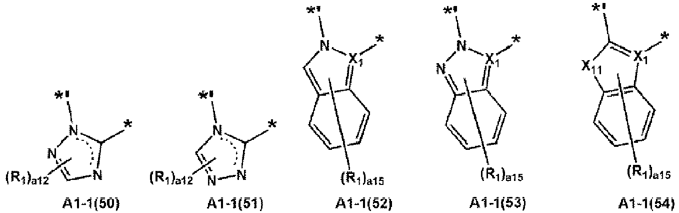 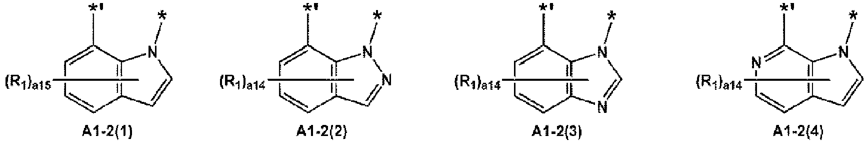 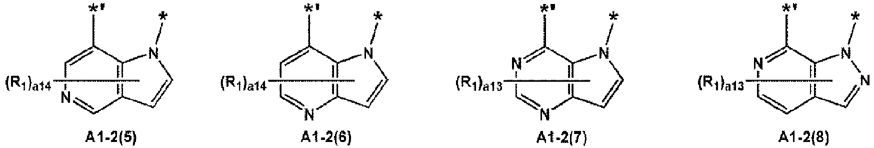 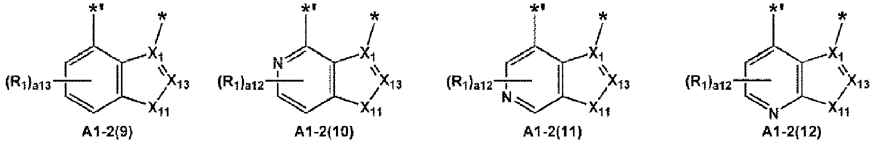 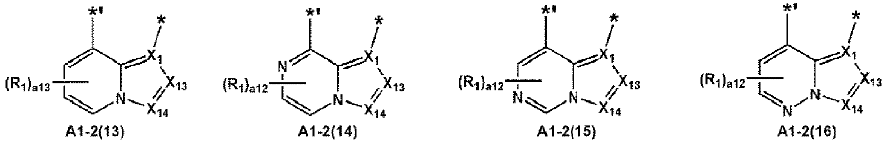 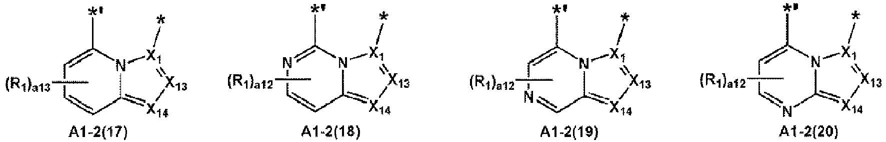 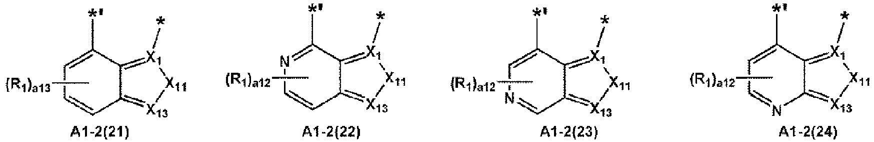 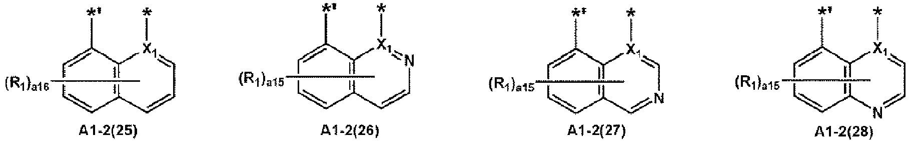 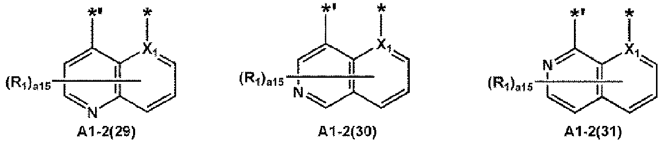 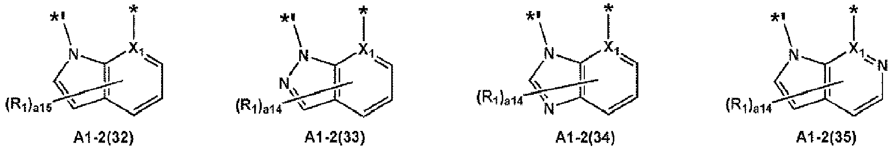 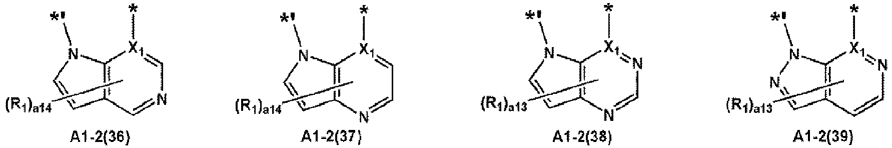 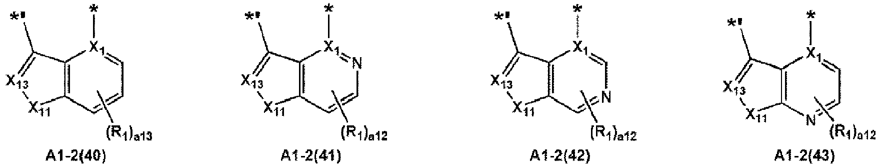 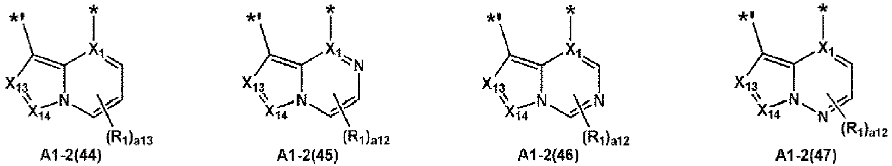 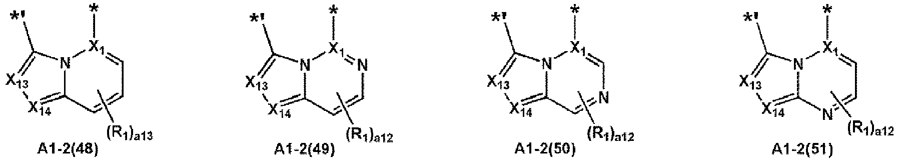 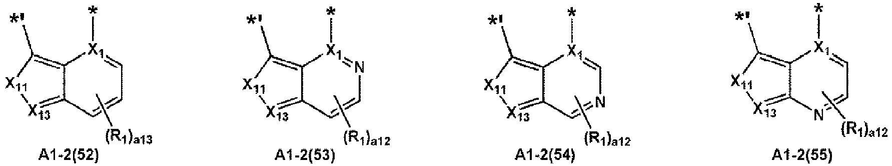 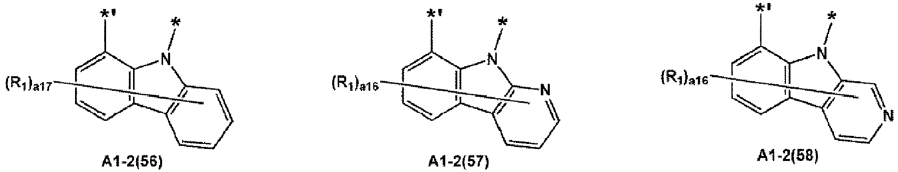 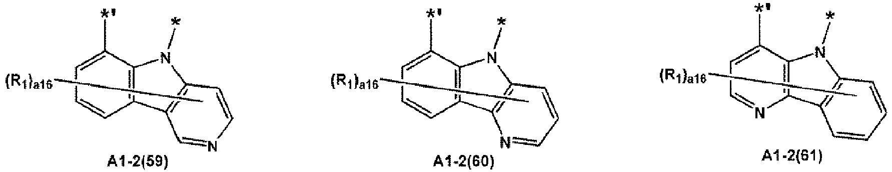 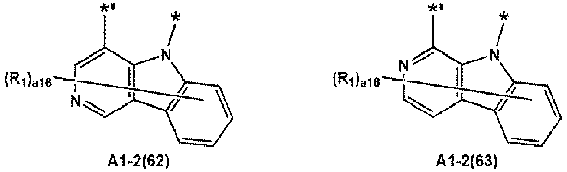 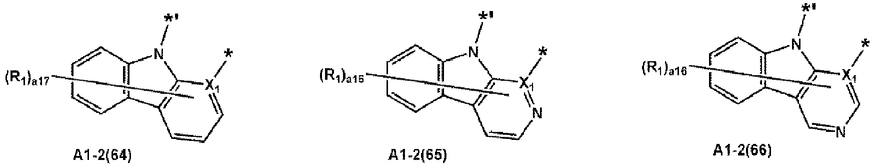 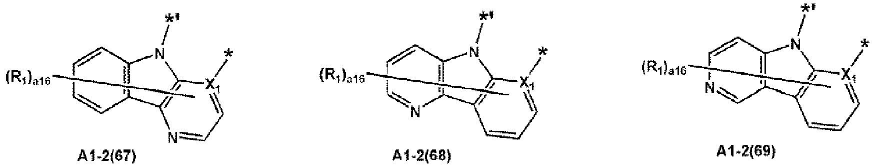 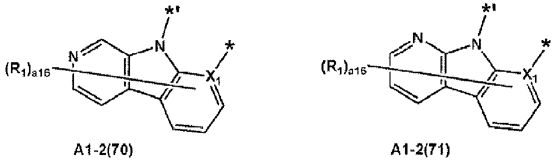 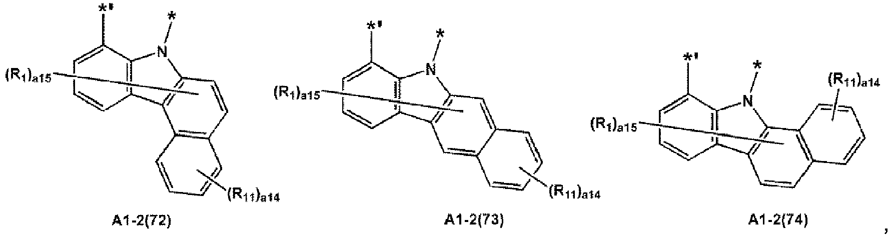
dans lequel, dans les Formules A1-1(1) à A1-1(54) et A1-2(1) à A1-2(74),
X₁ et R₁ sont les mêmes que décrits en connexion avec la revendication 1,
X₁₁ est O, S, N(R₁₁), C(R₁₁)(R₁₂), ou Si(R₁₁)(R₁₂),
X13 est N ou C(R₁₃),
X14 est N ou C(R₁₄),
R₁₁ à R₁₈ sont les mêmes que décrits en connexion avec R₁ dans la revendication 1,
a17 est un entier de 0 à 7,
a16 est un entier de 0 à 6,
a15 est un entier de 0 à 5,
a14 est un entier de 0 à 4,
a13 est un entier de 0 à 3,
a12 est un entier de 0 à 2,
* indique un site de liaison à A₁ ou M dans la Formule 1, et
*' indique un site de liaison à T₁ dans la Formule 1.

5. Composé organométallique de l'une quelconque des revendications 1 à 4, dans lequel
une fraction représentée par 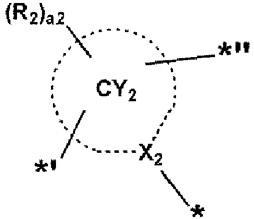 est représentée par une des formules A2-1(1) à A2-1(17), A2-2(1) à A2-2(58), et A2-3(1) à A2-3(62) : 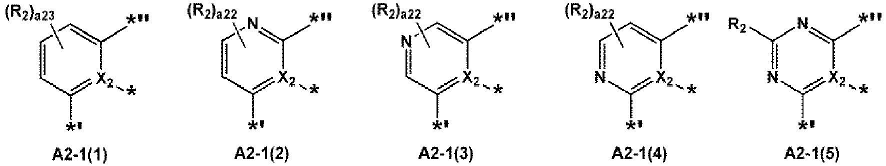 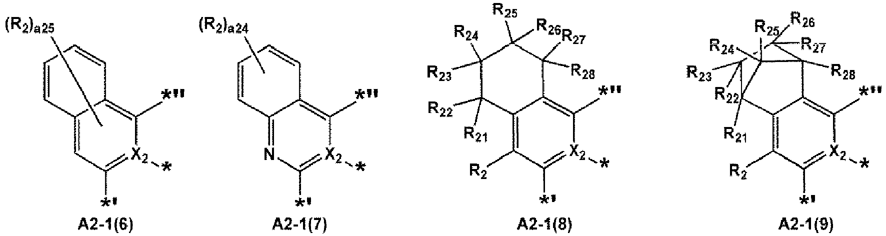 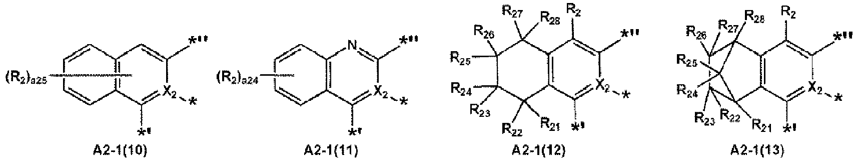 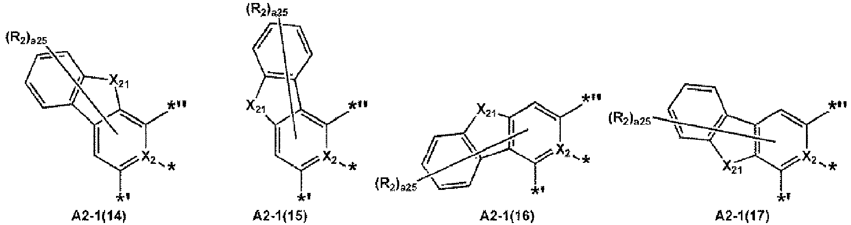 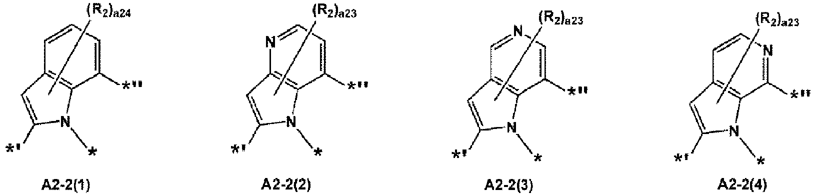 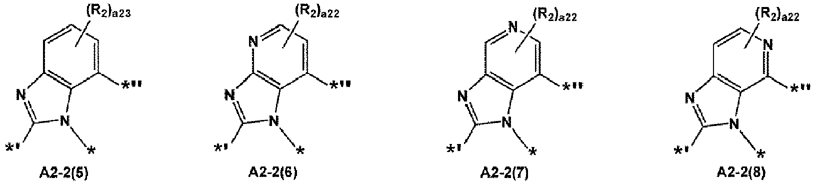 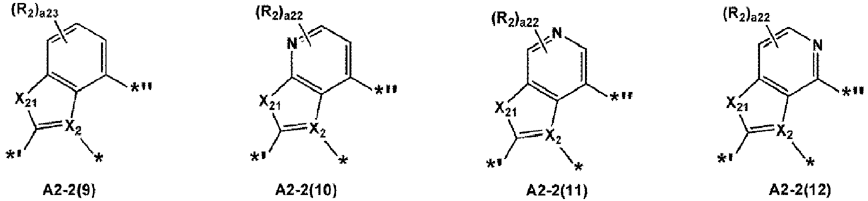 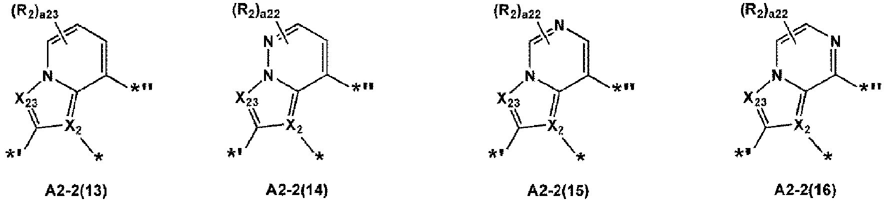 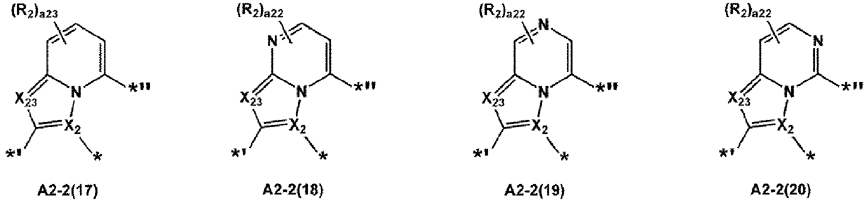 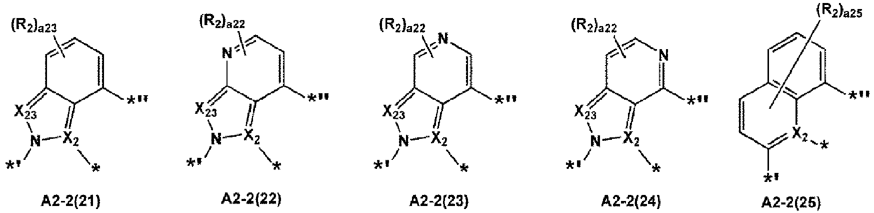 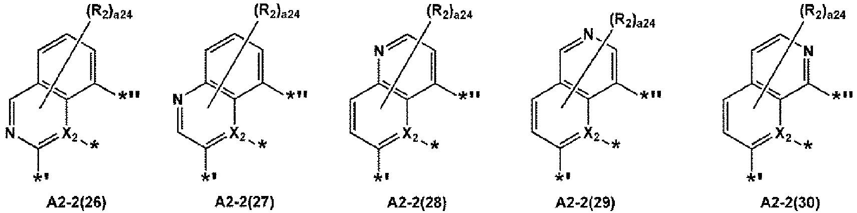 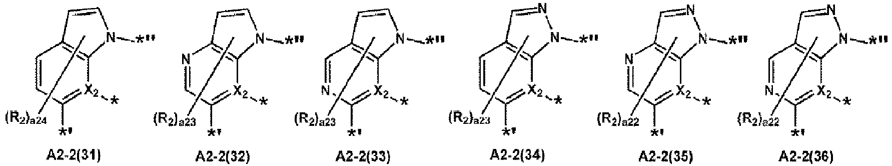 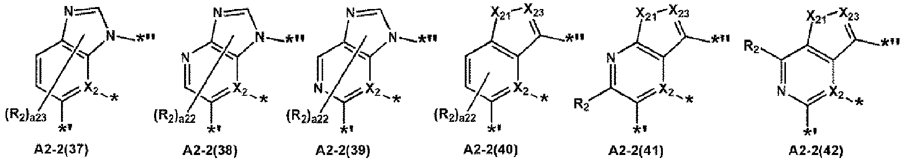 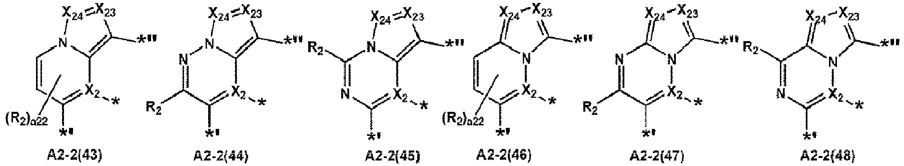 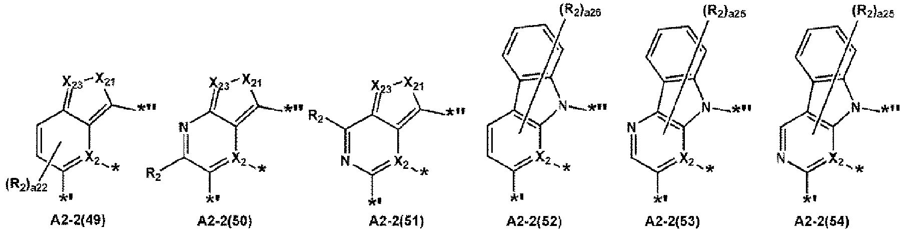 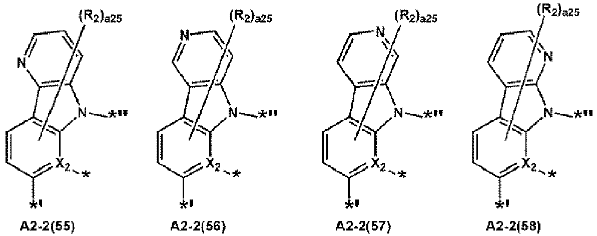 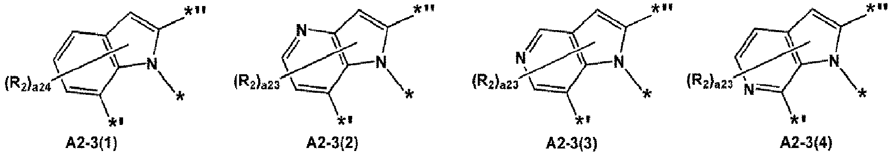 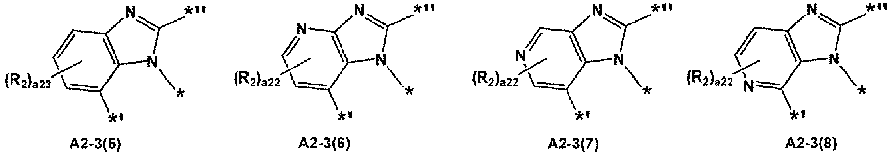 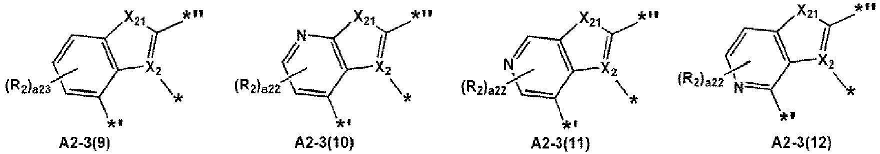 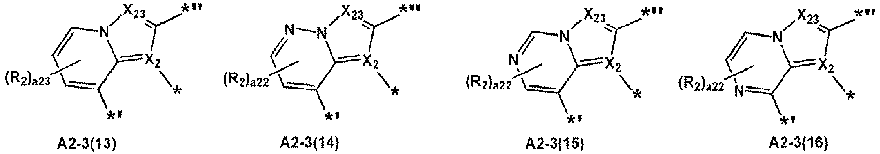 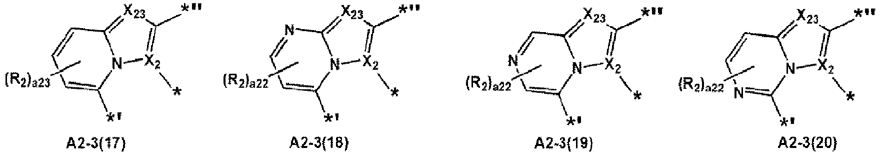 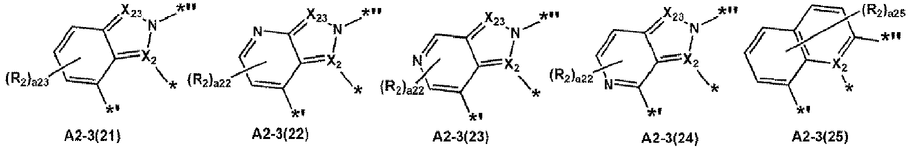 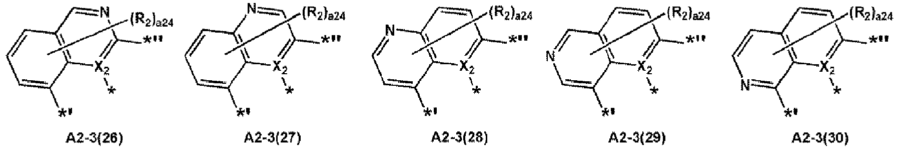 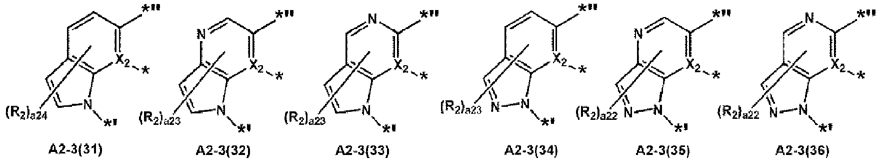 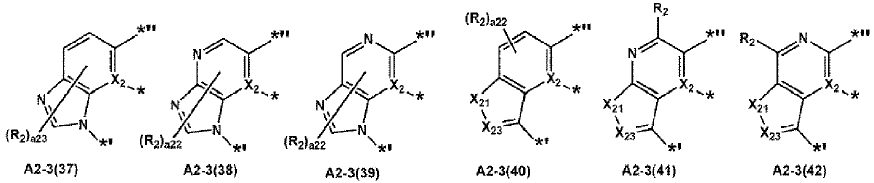 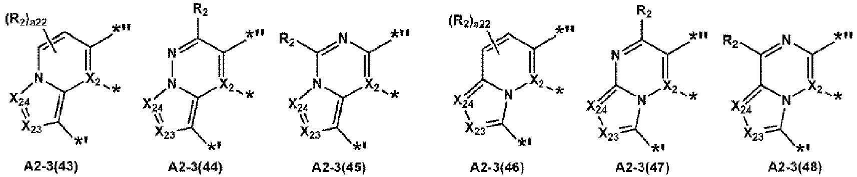 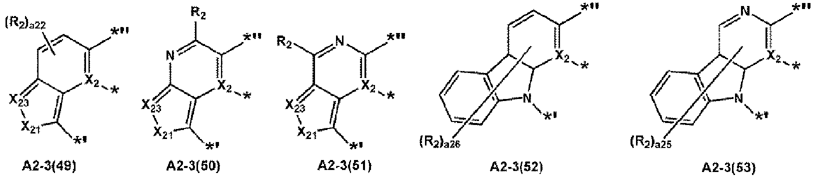 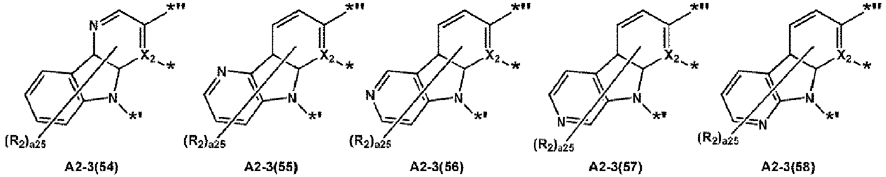 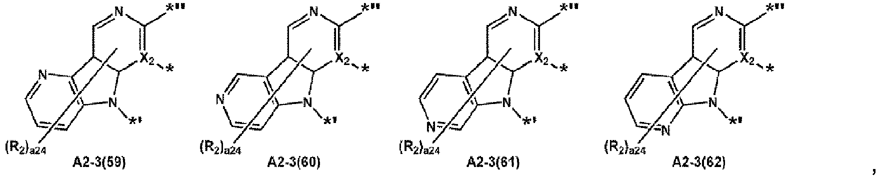
dans lequel, dans les formules A2-1(1) à A2-1(17), A2-2(1) à A2-2(58), et A2-3(1) à A2-3(62),
X₂ et R₂ sont les mêmes que décrits en connexion avec la revendication 1,
X₂₁ est O, S, N(R₂₁), C(R₂₁)(R₂₂), ou Si(R₂₁)(R₂₂),
X₂₃ est N ou C(R₂₃),
X₂₄ est N ou C(R₂₄),
R₂₁ à R₂₈ sont les mêmes que décrits en connexion avec R₂ dans la revendication 1, a26 est un entier de 0 à 6,
a25 est un entier de 0 à 5,
a24 est un entier de 0 à 4,
a23 est un entier de 0 à 3,
a22 est un entier de 0 à 2,
* indique un site de liaison à A₂ ou M dans la Formule 1,
*' indique un site de liaison à T₁ dans la Formule 1, et
*" indique un site de liaison à T₂ dans la Formule 1.

6. Composé organométallique de l'une quelconque des revendications 1 à 5, dans lequel
une fraction représentée par 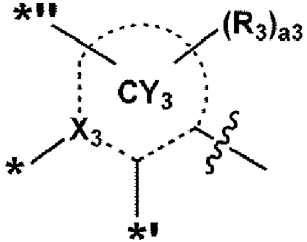 est représentée par une des Formules A3-1(1) à A3-1(12) : 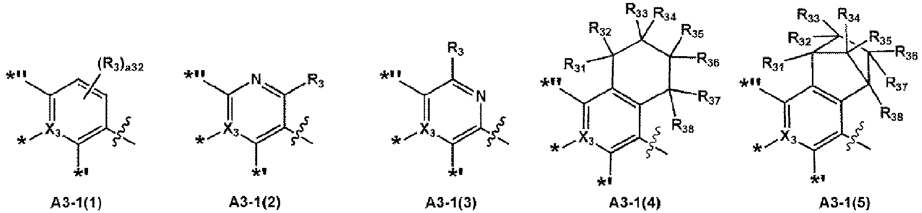 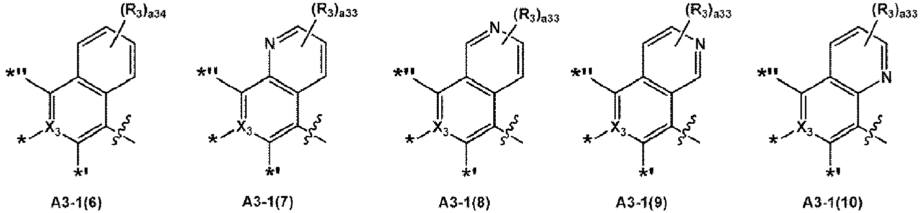 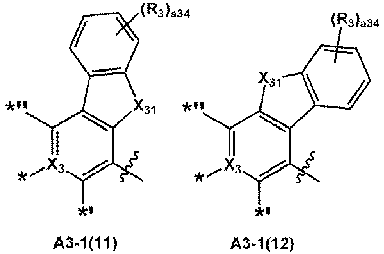
dans lequel, dans les Formules A3-1(1) à A3-1(12),
X₃ et R₃ sont les mêmes que décrits en connexion avec la revendication 1,
X31 est O, S, N(R₃₁), C(R₃₁)(R₃₂), ou Si(R₃₁)(R₃₂),
R₃₁ à R₃₈ sont les mêmes que décrits en connexion avec R₃ dans la revendication 1, a34 est un entier de 0 à 4,
a33 est un entier de 0 à 3,
a32 est un entier de 0 à 2,
* indique un site de liaison à A₃ ou M dans la Formule 1,
*" indique un site de liaison à T₂ dans la Formule 1,
*' indique un site de liaison à Y₄₁ dans la Formule 1, et
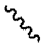 indique un site de liaison au cycle CY₅ dans la Formule 1.

7. Composé organométallique de l'une quelconque des revendications 1 à 6, dans lequel
une fraction représentée par 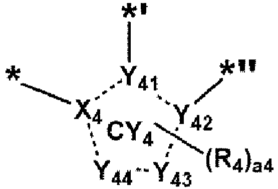 est représentée par une des Formules A4-1(1) à A4-1(12) : 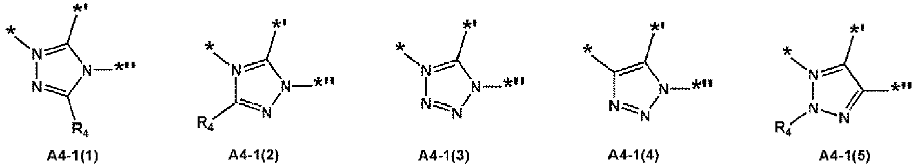 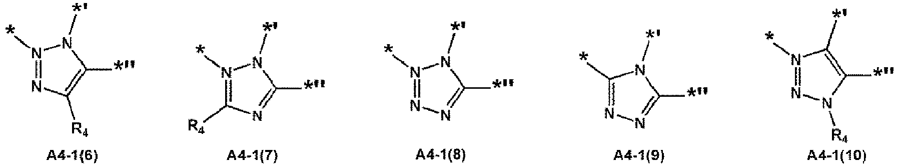 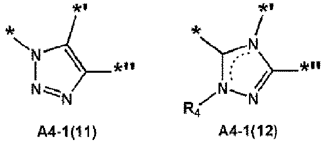
dans lequel, dans les Formules A4-1(1) à A4-1(12),
X₄ et R₄ sont les mêmes que décrits en connexion avec la revendication 1,
* indique un site de liaison à M dans la Formule 1,
*' indique un site de liaison au cycle CY₃ dans la Formule 1, et
*" indique un site de liaison au cycle CY₅ dans la Formule 1.

8. Composé organométallique de l'une quelconque des revendications 1 à 7, dans lequel
une fraction représentée par 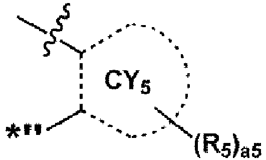 est représentée par une des Formules A5-1(1) à A5-1(8) : 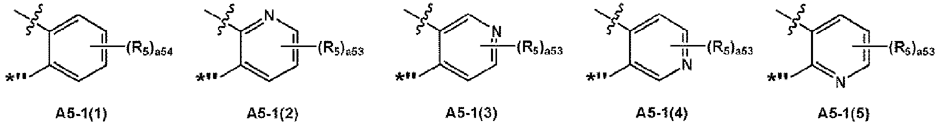 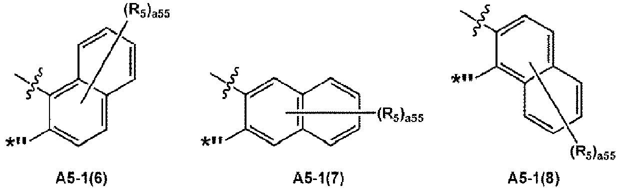
dans lequel, dans les formules A5-1(1) à A5-1(8),
R₅ est le même que décrit en connexion avec la revendication 1,
a55 est un entier de 0 à 5,
a54 est un entier de 0 à 4,
a53 est un entier de 0 à 3,
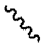 indique un site de liaison au cycle CY₃ dans la Formule 1, et
*" indique un site de liaison à Y₄₂ dans la Formule 1.

9. Composé organométallique de l'une quelconque des revendications 1 à 8, dans lequel
une fraction représentée par 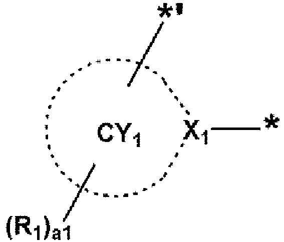 est représentée par une des Formules CY1-1 à CY1-59,
une fraction représentée par 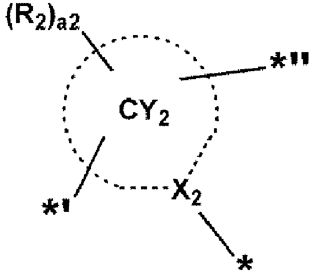 est représentée par une des Formules CY2-1 à CY2-34,
une fraction représentée par 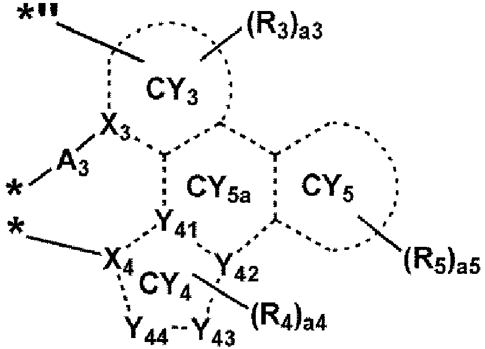 est représentée par une des Formules CY3-1 à CY3-6 : 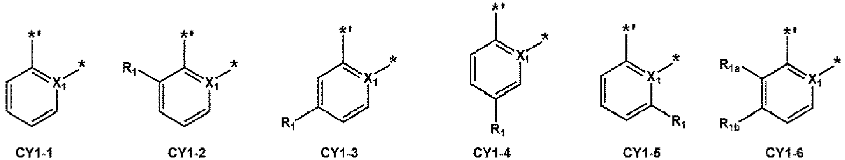 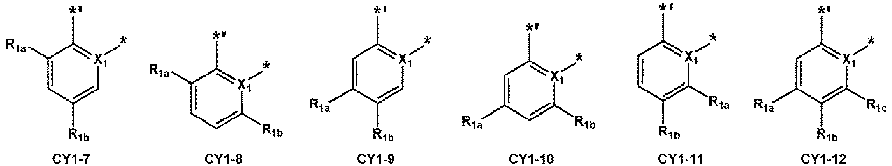 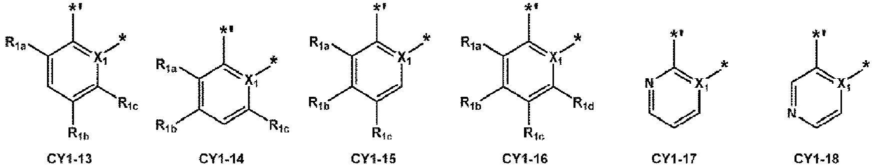 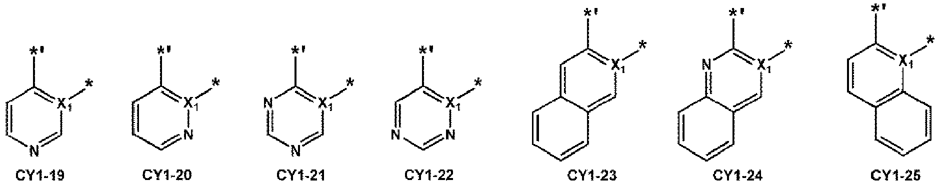 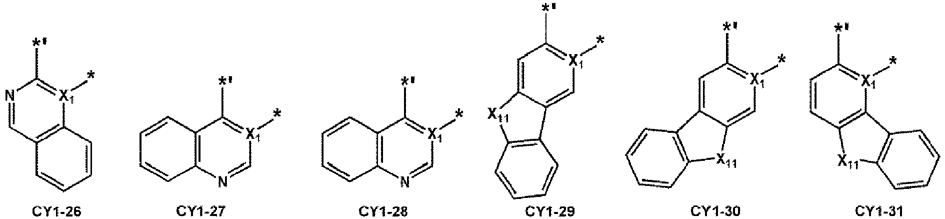 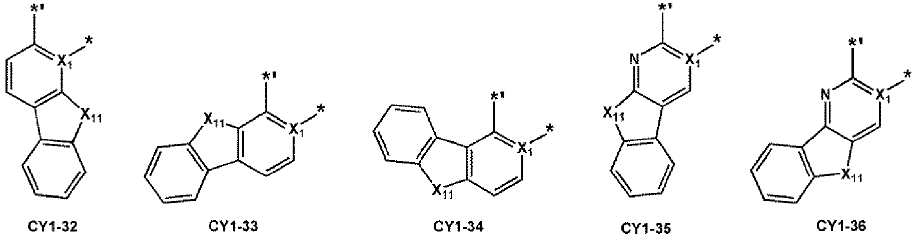 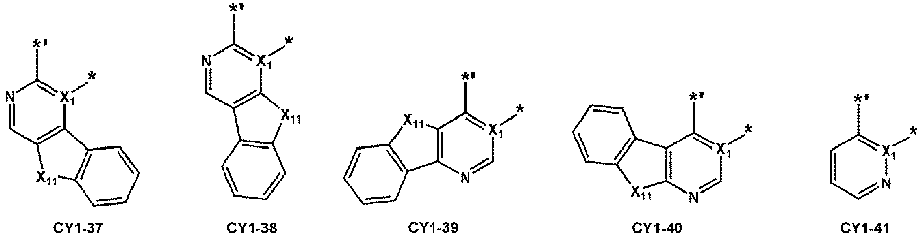 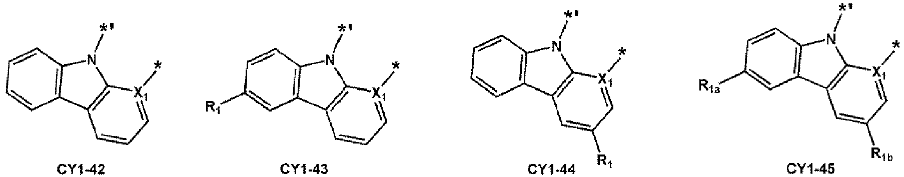 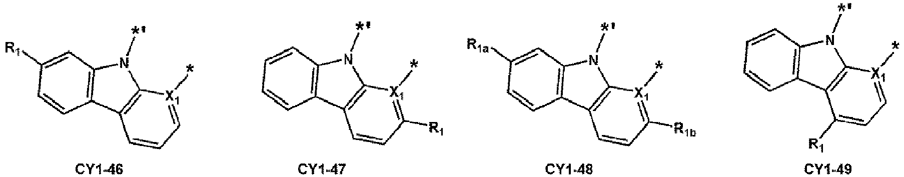 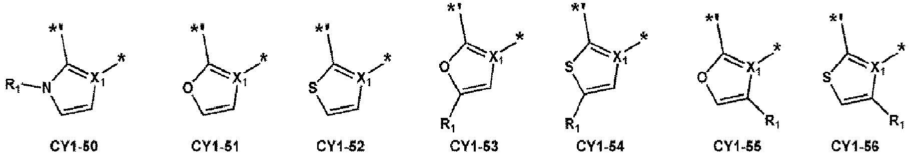 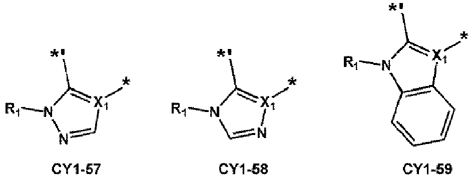 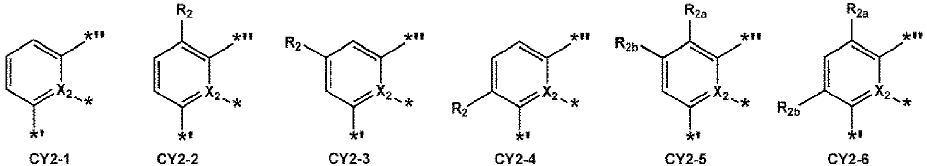 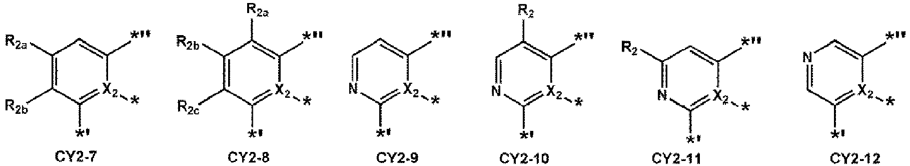 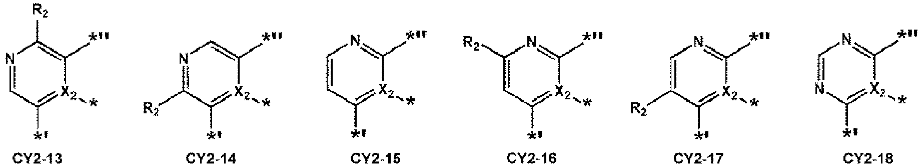 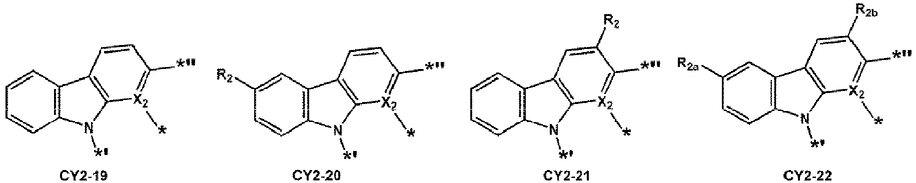 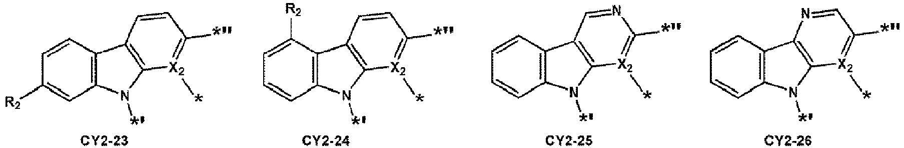 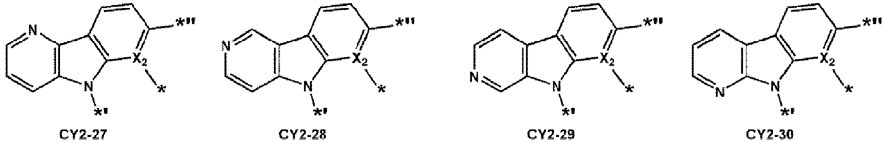 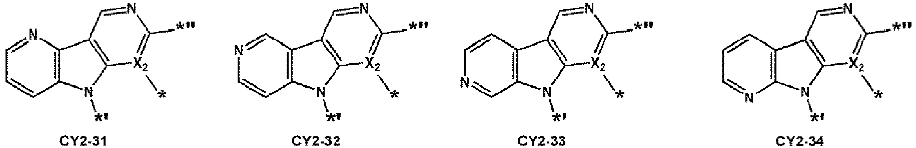 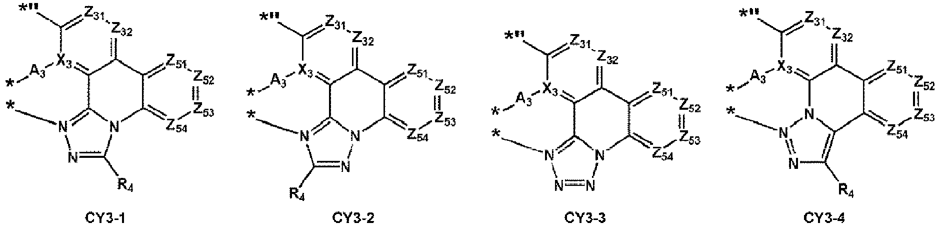 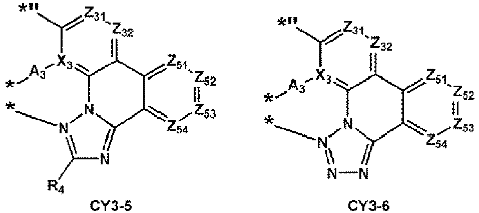
dans lequel, dans les Formules CY1-1 à CY1-59, CY2-1 à CY2-34, et CY3-1 à CY3-6,
A₃, X₁ à X₃, et R₁ à R₄ sont les mêmes que décrits en connexion avec la revendication 1,
X₁₁ est O, S, N(R₁₁), C(R₁₁)(R₁₂), ou Si(R₁₁)(R₁₂),
R₁ₐ à R_{1d}, R₁₁, et R₁₂ sont les mêmes que décrits en connexion avec R₁,
R₂ₐ à R_{2c} sont les mêmes que décrits en connexion avec R₂,
Z₃₁ est N ou C(R₃₁), et Z₃₂ est N ou C(R₃₂),
R₃₁ et R₃₂ sont les mêmes que décrits en connexion avec R₃,
Z₅₁ est N ou C(R₅₁), Z₅₂ est N ou C(R₅₂), Z₅₃ est N ou C(R₅₃), Z₅₄ est N ou C(R₅₄),
R₅₁ à R₅₄ sont les mêmes que décrits en connexion avec R₅,
chacun de R₁, R₂, R₁ₐ à R_{1d}, et R₂ₐ à R_{2c} n'est pas l'hydrogène,
en ce qui concerne les Formules CY1-1 à CY1-59, * indique un site de liaison à A₁ ou M dans la Formule 1, et *' indique un site de liaison à T₁ dans la Formule 1,
en ce qui concerne les Formules CY2-1 à CY2-34, * indique un site de liaison à A₂ ou M dans la Formule 1, *' indique un site de liaison à T₁ dans la Formule 1, et *" indique un site de liaison à T₂ dans la Formule 1, et
en ce qui concerne les Formules CY3-1 à CY3-6, deux * indiquent chacun un site de liaison à M dans la Formule 1, et *" indique un site de liaison à T₂ dans la Formule 1.

10. Composé organométallique de l'une quelconque des revendications 1 à 9, dans lequel le composé organométallique est représenté par la Formule 1-1 ou 1-2 : 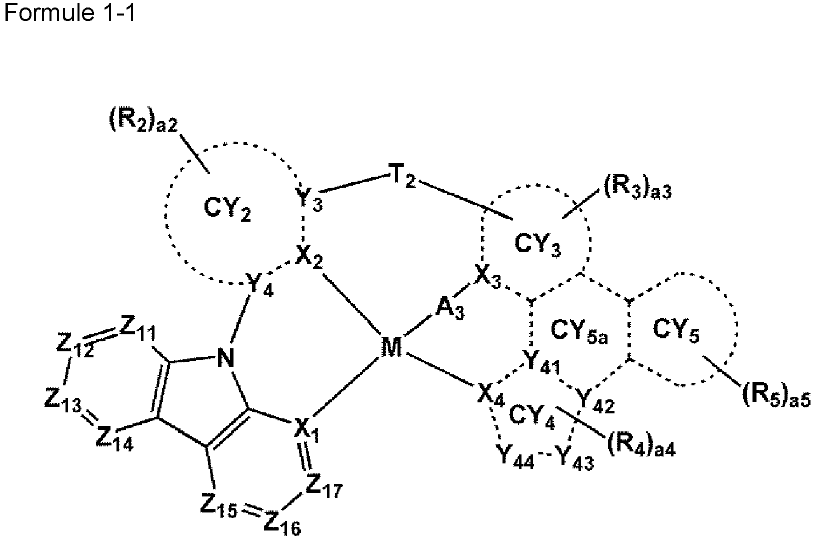 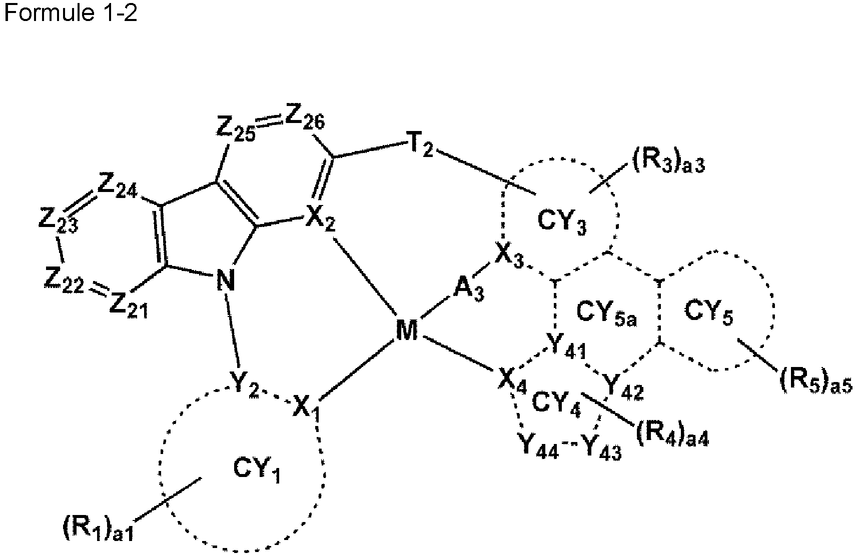
dans lequel, dans les Formules 1-1 et 1-2,
M, X₁ à X₄, Y₄₁ à Y₄₄, A₃, le cycle CY₁ au cycle CY₅, le cycle CY₅ₐ, R₁ à R₅, et a1 à a5 sont les mêmes que décrits en connexion avec la revendication 1,
T₂ est *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', ou *-C(=S)-*',
et R₈ et R₉ sont les mêmes que décrits en connexion avec la revendication 1,
Y₂ à Y₄ sont chacun indépendamment C ou N,
une liaison entre X₂ et Y₃, une liaison entre X₂ et Y₄, et une liaison entre X₁ et Y₂ sont chacune indépendamment une simple liaison ou une double liaison,
Z₁₁ est N ou C(R₁₁), Z₁₂ est N ou C(R₁₂), Z₁₃ est N ou C(R₁₃), Z₁₄ est N ou C(R₁₄), Z₁₅ est N ou C(R₁₅), Z₁₆ est N ou C(R₁₆), Z₁₇ est N ou C(R₁₇), Z₂₁ est N ou C(R₂₁), Z₂₂ est N ou C(R₂₂), Z₂₃ est N ou C(R₂₃), Z₂₄ est N ou C(R₂₄), Z₂₅ est N ou C(R₂₅), Z₂₆ est N ou C(R₂₆),
R₁₁ à R₁₇ sont les mêmes que décrits en connexion avec R₁ dans la revendication 1, et
R₂₁ à R₂₆ sont les mêmes que décrits en connexion avec R₂ dans la revendication 1 ; de préférence dans lequel
le composé organométallique est un des Composés 1 à 196 :

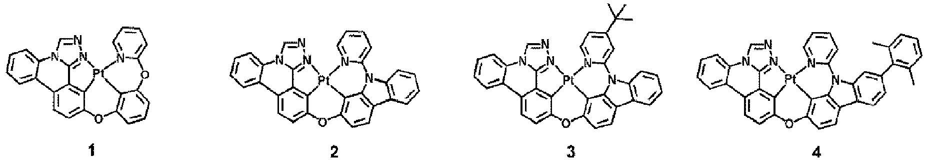

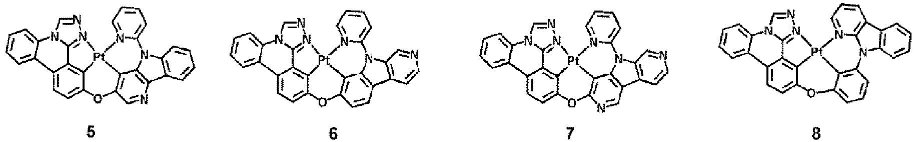

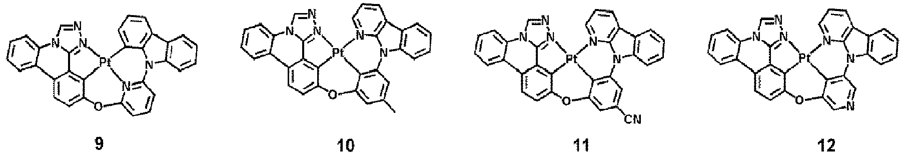

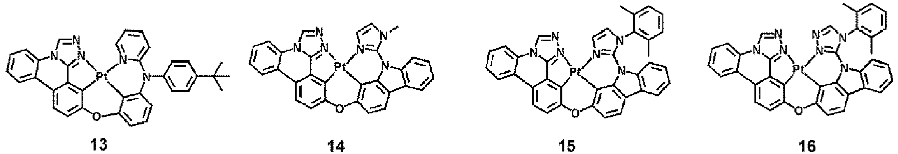

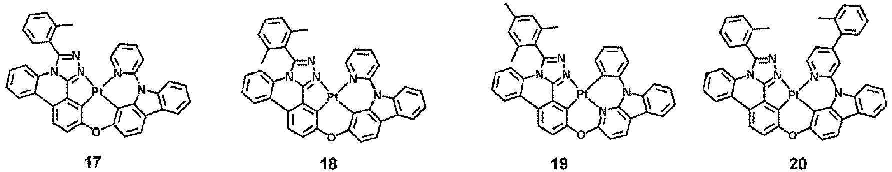

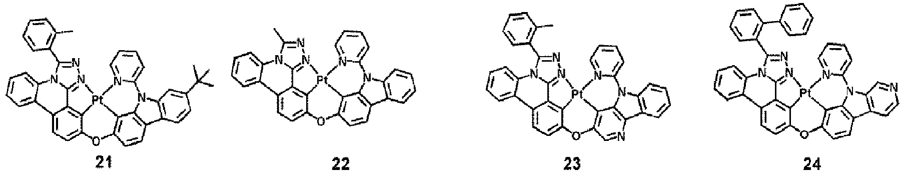

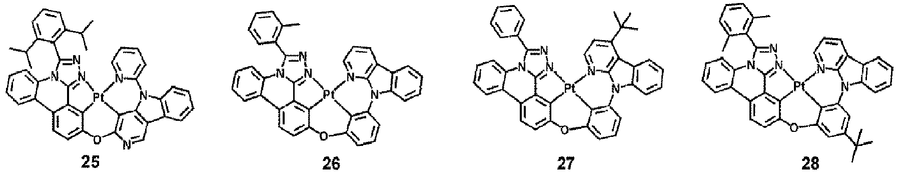

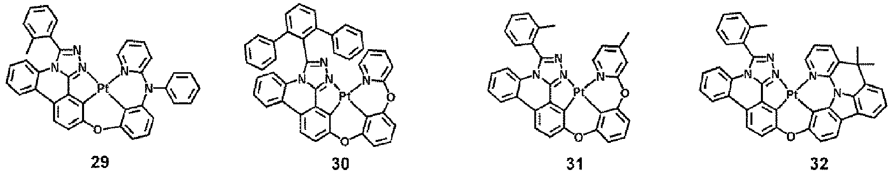

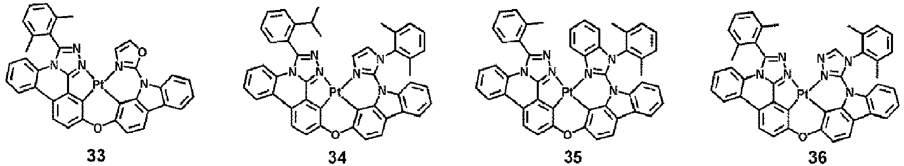

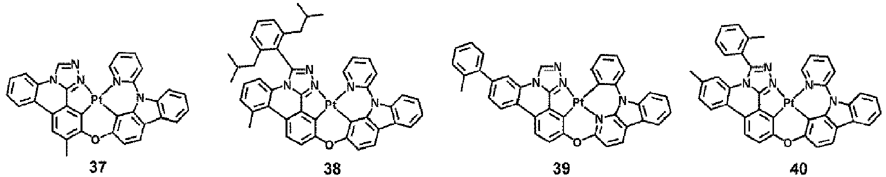

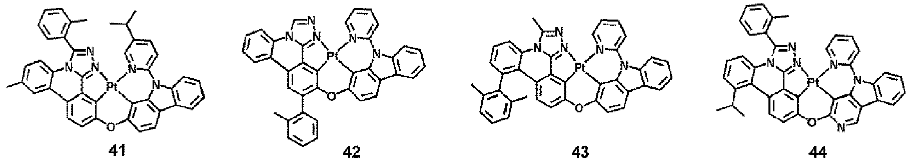

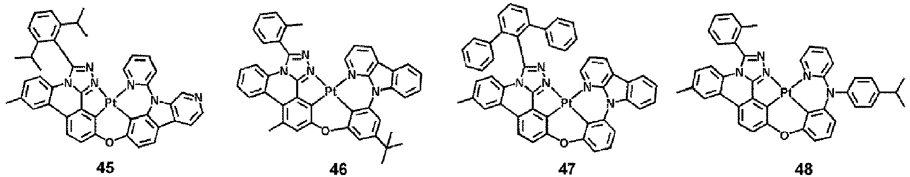

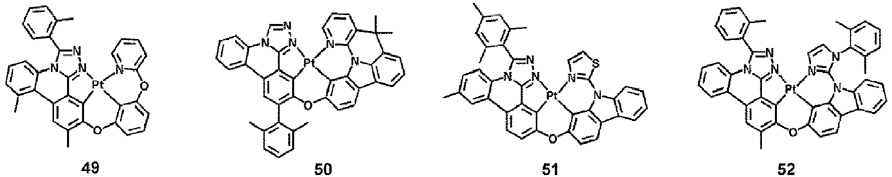

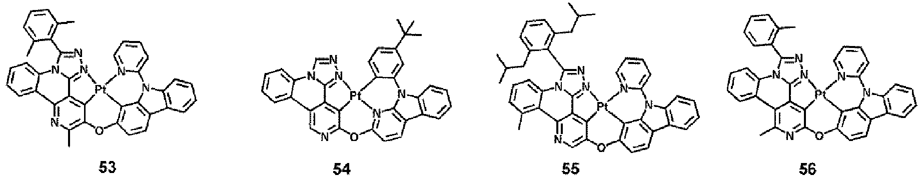

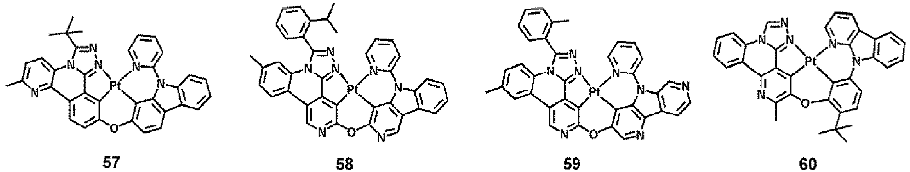

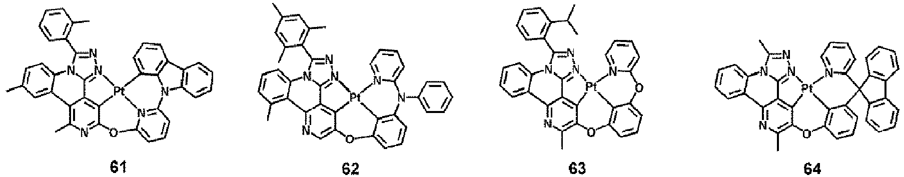

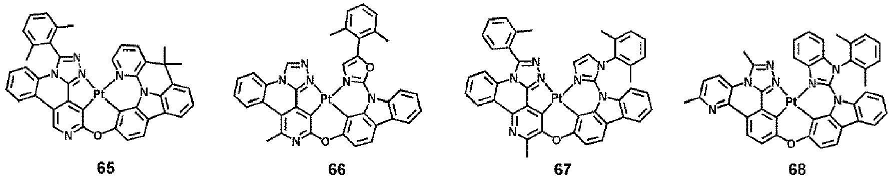

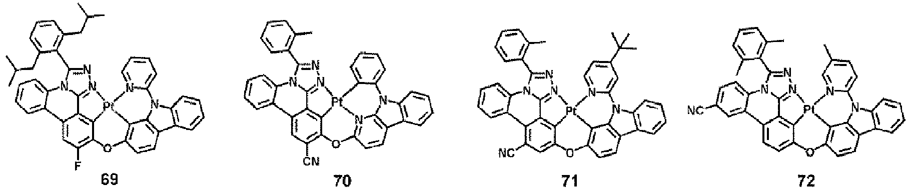

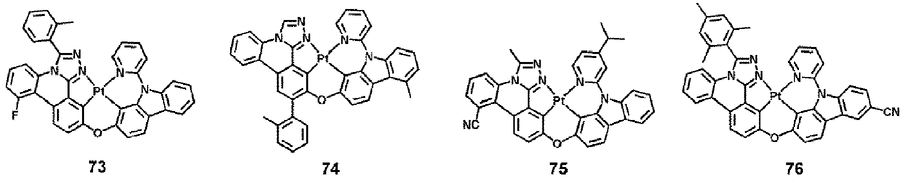

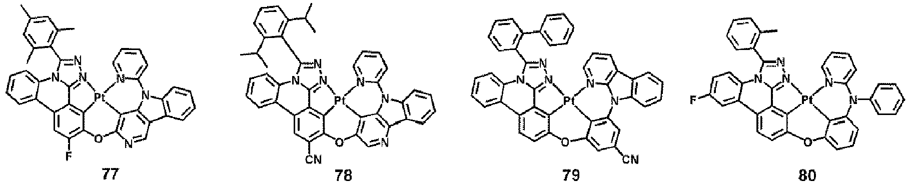

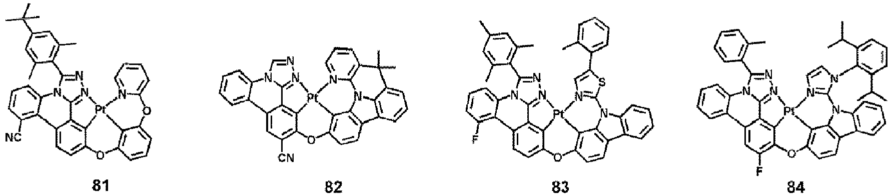

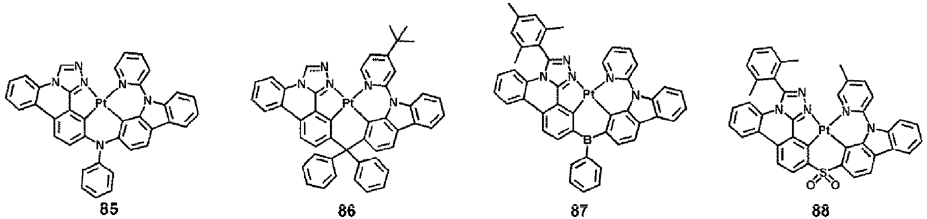

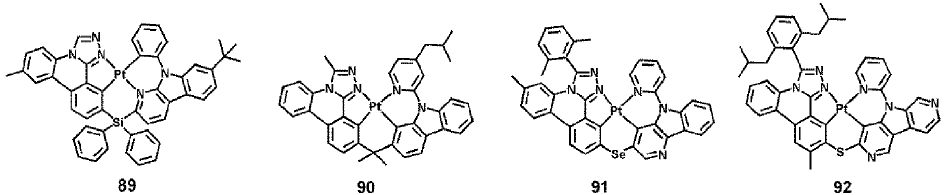

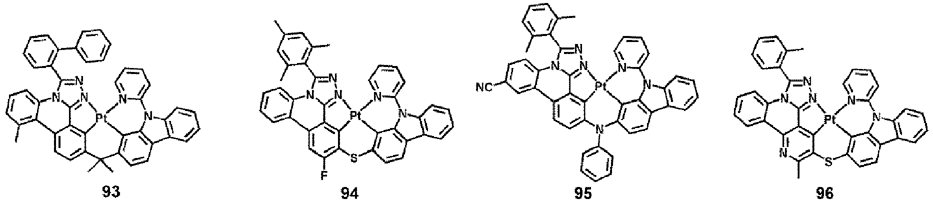

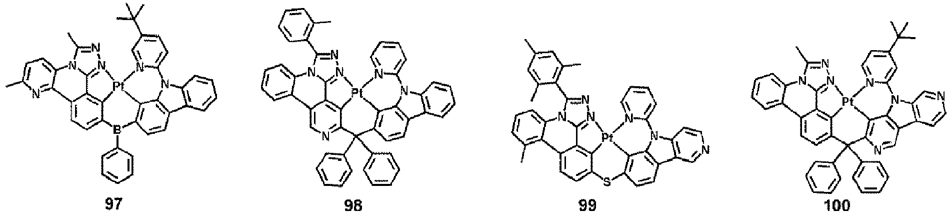

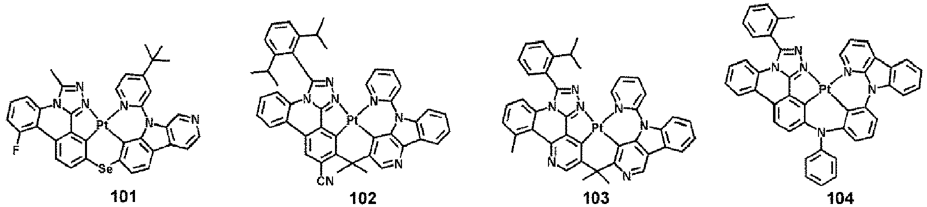

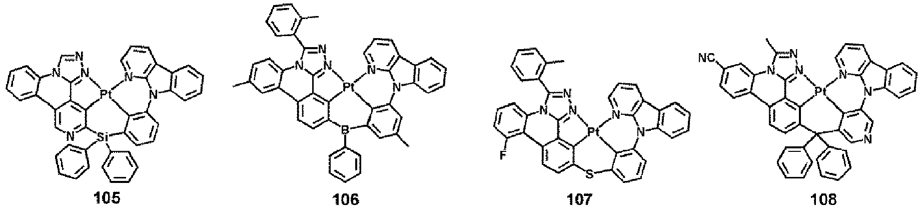

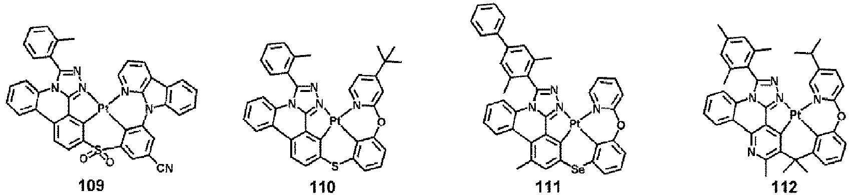

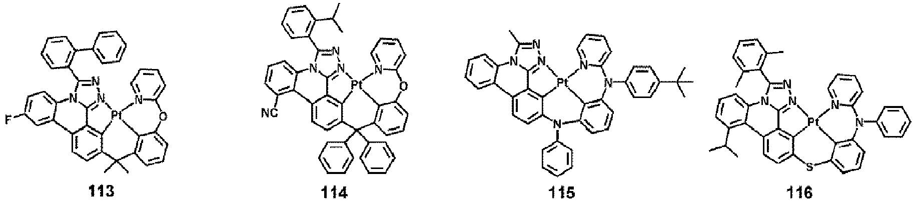

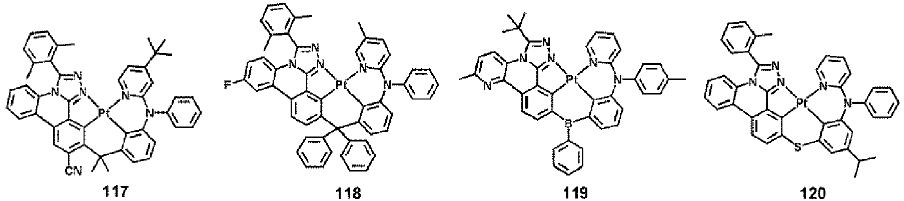

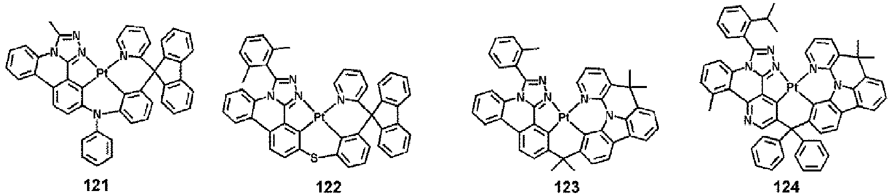

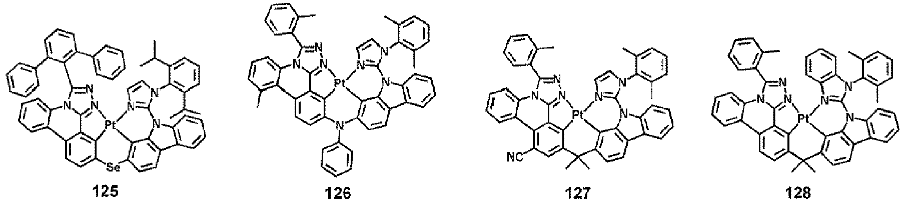

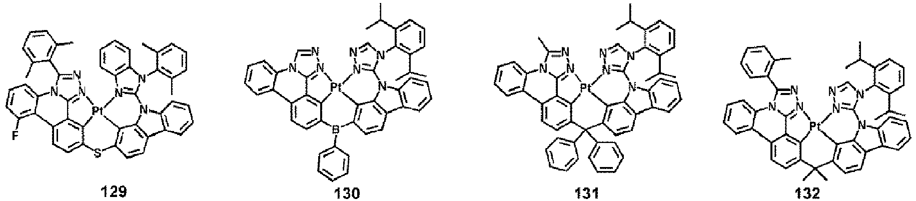

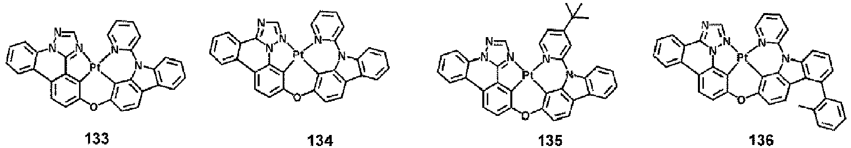

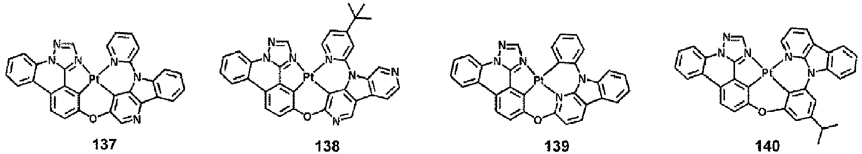

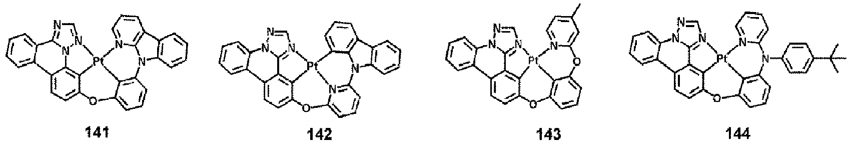

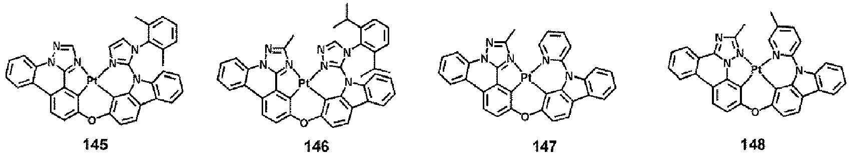

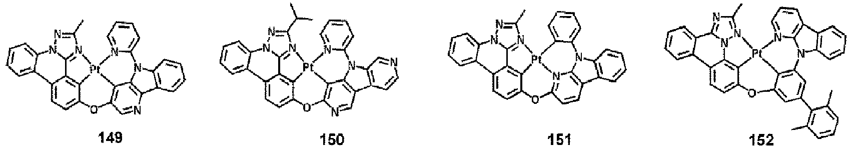

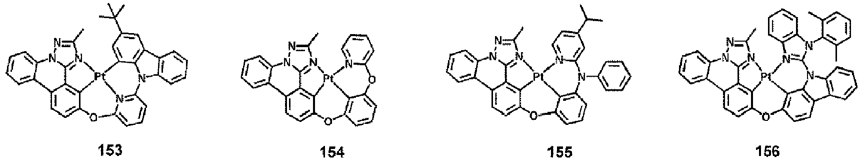

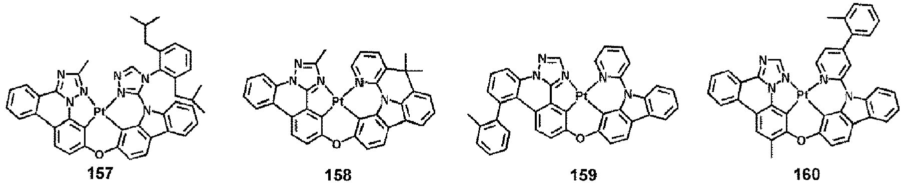

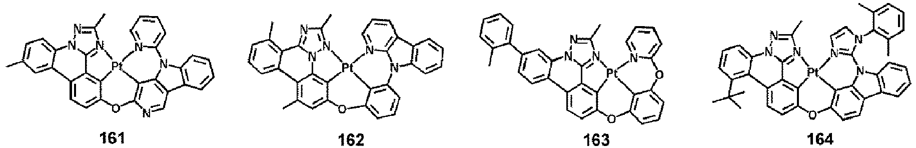

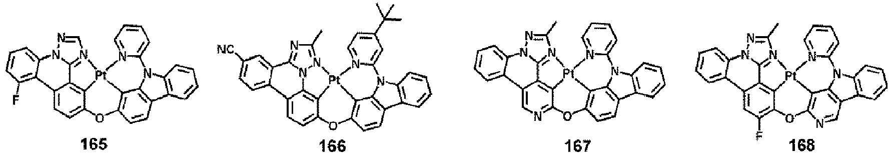

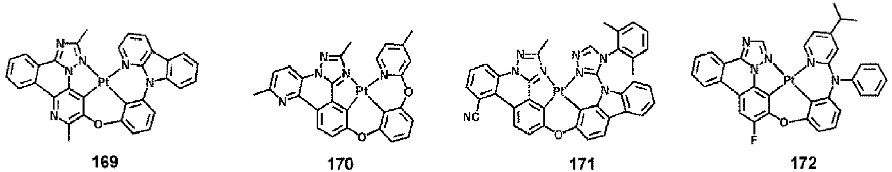

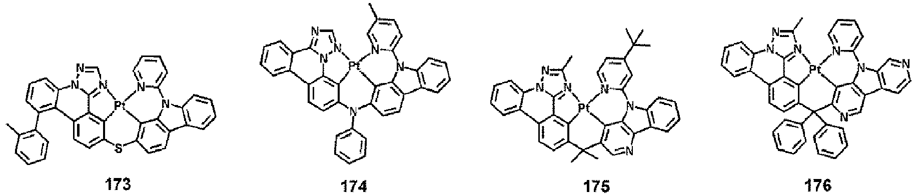

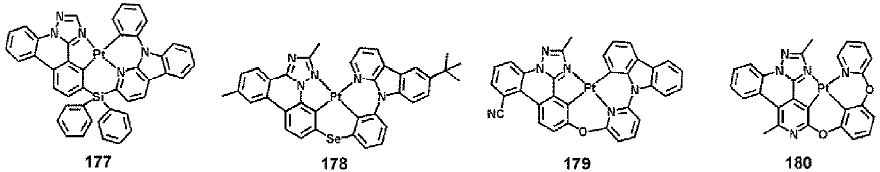

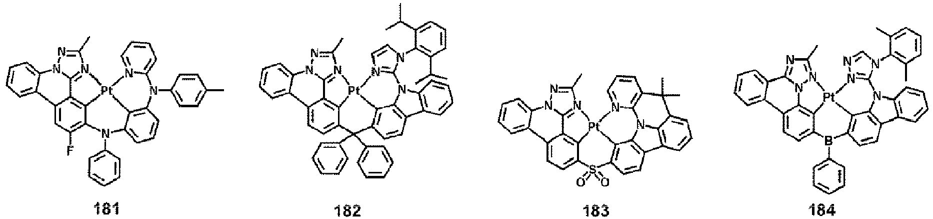

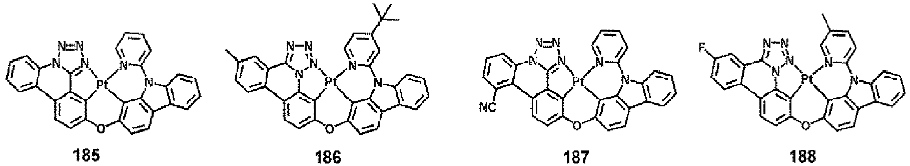

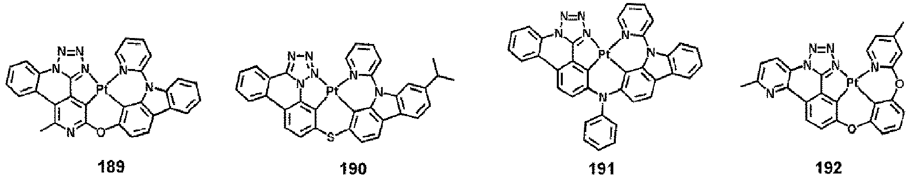

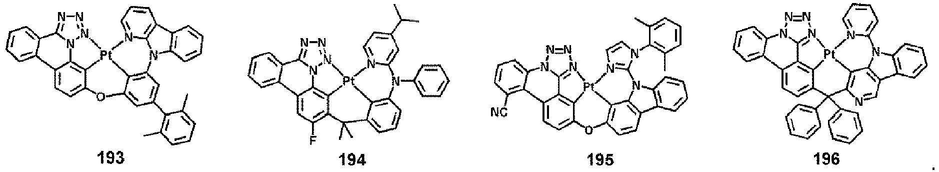

11. Composé organométallique de l'une quelconque des revendications 1 à 10, dans lequel un pic d'un spectre de photoluminescence du composé organométallique a une longueur d'onde d'émission maximale de 420 nanomètres à 500 nanomètres, et une largeur à mi-hauteur (FWHM) de 30 nanomètres à 80 nanomètres.

12. Dispositif électroluminescent organique comprenant :
une première électrode ;
une deuxième électrode ; et
une couche organique située entre la première électrode et la deuxième électrode, dans lequel la couche organique comprend une couche d'émission et au moins un composé organométallique de l'une quelconque des revendications 1 à 11 ;
de préférence dans lequel
la première électrode est une anode,
la deuxième électrode est une cathode,
la couche organique inclut en outre une région de transport de trous située entre la première électrode et la couche d'émission et une région de transport d'électrons située entre la couche d'émission et la deuxième électrode,
la région de transport de trous inclut une couche d'injection de trous, une couche de transport de trous, une couche de blocage d'électrons, une couche de tampon, ou une combinaison quelconque de celles-ci, et
la région de transport d'électrons inclut une couche de blocage de trous, une couche de transport d'électrons, une couche d'injection d'électrons, ou une combinaison quelconque de celles-ci.

13. Dispositif électroluminescent organique de la revendication 12, dans lequel le composé organométallique est inclus dans la couche d'émission.

14. Dispositif électroluminescent organique de la revendication 13, dans lequel la lumière émise à partir de la couche d'émission est une lumière bleue, et
dans lequel la lumière bleue a une coordonnée CIE y dans la plage allant de 0,10 à 0,340 ; et/ou
dans lequel la couche d'émission inclut en outre un hôte et la quantité de l'hôte est supérieure à la quantité du composé organométallique.

15. Composition de diagnostic comprenant au moins un composé organométallique de l'une quelconque des revendications 1 à 11.
